(19) 

Europäisches
Patentamt
European
Patent Office
Office européen
des brevets

(11) **EP 2 615 364 A1**

(12) **EUROPEAN PATENT APPLICATION**
published in accordance with Art. 153(4) EPC

(43) Date of publication:
**17.07.2013 Bulletin 2013/29**

(21) Application number: **11823650.4**

(22) Date of filing: **08.09.2011**

(51) Int Cl.:
*F21S 2/00* (2006.01)     *F21S 10/00* (2006.01)
*F21Y 101/02* (2006.01)

(86) International application number:
**PCT/JP2011/070523**

(87) International publication number:
**WO 2012/033176 (15.03.2012 Gazette 2012/11)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.08.2011  JP 2011186451
09.03.2011  JP 2011051854
09.09.2010  JP 2010202493**

(71) Applicant: **Mitsubishi Chemical Corporation
Chiyoda-ku
Tokyo 100-8251 (JP)**

(72) Inventors:
• **KODAMA,Hiroya
Yokohama-shi
Kanagawa 227-8502 (JP)**
• **KIJIMA,Naoto
Yokohama-shi
Kanagawa 227-8502 (JP)**

• **TAKEDA,Toru
Tokyo 108-0014 (JP)**
• **HATTORI,Eiji
Tokyo 108-0014 (JP)**
• **KATSUMOTO,Tadahiro
Yokohama-shi
Kanagawa 227-8502 (JP)**
• **YOKOO,Toshiaki
Yokohama-shi
Kanagawa 227-8502 (JP)**
• **YOYASU, Fumiko
Yokohama-shi
Kanagawa 227-8502 (JP)**
• **KOJIMA,Takashi
Yokohama-shi
Kanagawa 227-8502 (JP)**

(74) Representative: **HOFFMANN EITLE
Patent- und Rechtsanwälte
Arabellastrasse 4
81925 München (DE)**

(54) **LIGHT EMITTING DEVICE, ILLUMINATING SYSTEM, AND ILLUMINATING METHOD**

(57)     There are provided a light emission apparatus capable of suppressing reduction in inappropriate luminous flux due to the adjustment of the color temperature while ensuring excellent color rendering properties, capable of controlling the emission intensity and the color temperature so as to generate the light with a color temperature appropriate for the desired emission intensity, and capable of suppressing manufacturing costs, and an illumination system using the light emission apparatus. Further, there is also provided an illumination method capable of emitting the light with the color temperature appropriate for the desired emission intensity by controlling the emission intensity and the color temperature while suppressing manufacturing costs of the light emission apparatus. The light emission apparatus includes: a wiring board (2); a plurality of LED chips (3) that are disposed on an LED chip mounting surface of the wiring board and are grouped into a plurality of LED groups; a wavelength conversion member (5) that is disposed at a position corresponding to the LED chip mounting surface of the wiring board (2), converts a wavelength of light emitted by the corresponding LED chips (3), and emits first-order light with a different color temperature for each wavelength conversion region; a current supply section (15) that supplies a driving current to the LED chips (3) independently for each LED group through the wiring board (2); and a control section (16) that controls the current amount supplied for each LED group in response to a control signal which is input from outside. The control section (16) independently controls timing of starting to light the LED groups in accordance with the light control level.

*FIG.7*

LIGHT EMISSION APPARATUS — 11

LIGHT EMITTING SECTION — 1

D1    D2

3a    3b

3a    3b

15c —

Q1    Q2

CURRENT SUPPLY SECTION — 15

15b

VOLTAGE CURRENT CONVERSION CIRCUIT

Vs    Vs    $V_{DIM(DC)}$    15a

RECTIFIER CIRCUIT

16c — SELECTION CIRCUIT

16b — MEMORY

16a — PHASE ANGLE DETECTOR

16 — CONTROL SECTION

12

13 — LIGHT CONTROL SECTION

$V_{DIM(AC)}$    $V_{DIM(AC)}$

— 14

$V_{AC}$

**Description**

Technical Field

The present invention relates to a light emission apparatus using LED chips, which emit light with wavelengths in a predetermined wavelength range from the visible light region to the near-ultraviolet region, and a wavelength conversion member which converts the wavelength of the light emitted by the LED chips, and an illumination system using the apparatus. The present invention also relates to an illumination method for forming desired synthetic light by converting the wavelength of the light emitted by the plurality of LED chips using the wavelength conversion member and synthesizing the light.

Background Art

As light sources of light emission apparatuses, incandescent bulbs and fluorescent lamps have come into widespread use. Recently, in addition to these light sources, a light emission apparatus, in which a semiconductor light emitting element such as a light emitting diode (LED) or an organic EL (OLED) is used as a light source, has been developed and used. In such a semiconductor light emitting element, it is possible to obtain various emission colors. Hence, a light emission apparatus, in which a plurality of semiconductor light emitting elements with different emission colors are combined and the respective emission colors are synthesized so as to generate radiant light with a desired color, has been also recently developed and used.

For example, Patent Literature 1 discloses a light emission apparatus in which red LEDs using LED chips having a red emission color, green LEDs using the LED chips having a green emission color, and blue LEDs using the LED chips having a blue emission color are combined, and desired white light is emitted by adjusting driving currents supplied to the respective LEDs and synthesizing the light emitted by the respective LEDs.

Originally, the emission spectrum width of LED chips themselves is relatively narrow. Hence, when the light emitted by the LED chips themselves is used in illumination as it is, a problem arises in that color rendering properties that are important matters in typical illumination light deteriorate. Therefore, in order to solve such a problem, there is provided an LED that converts a wavelength of the light emitted by LED chips using a wavelength conversion member such as a phosphor so as to emit light generated through wavelength conversion. For example, Patent Literature 2 discloses a light emission apparatus in which such LEDs are combined.

The light emission apparatus of Patent Literature 2 uses, in addition to blue LEDs using the LED chips having a blue emission color, green LEDs, in which a green phosphor excited by the light emitted from the LED chips is combined with the same LED chips, and red LEDs in which a red phosphor excited by the light emitted from the LED chips is combined with the same LED chips. The light emitted by the light emission apparatus ensures excellent color rendering properties by synthesizing the light respectively emitted by the blue LEDs, green LEDs, and red LEDs. In addition, by adjusting the optical output of each LED, it is possible to change the color of the light, which is emitted by the light emission apparatus, into various colors.

Grenerally, it is preferable that a light emission apparatus or an illumination apparatus be able to perform adjustment so as to generate white light with various color temperatures. However, in a similar manner to the light emission apparatus of Patent Literature 2, when a desired emission color is obtained by synthesizing the light respectively emitted by the blue LEDs, green LEDs, and red LEDs, for example, if the color temperature of the white light is intended to be changeable in a predetermined range, complex control for appropriately adjusting the driving currents supplied to the respective LEDs is necessary.

Further, in recent years, in light emission apparatuses other than incandescent bulbs, there has been a demand to generate the white light with desired emission intensity and color temperature by changing the emission intensity and the color temperature at the same time. That is, there has been a demand for control that can obtain white light having an optimum color temperature with respect to an optimum for the desired emission intensity by controlling the emission intensity and the color temperature at the same time. However, in such a light emission apparatus of Patent Literature 2, it is possible to generate white light with the desired color temperature through a complex control operation, but it is difficult to perform control so as to generate white light having the color temperature with respect to an optimum for the desired emission intensity mentioned above. In order to cope with such demands, for example, Patent Literature 3 discloses a light emission apparatus having desired emission intensity and color temperature by controlling the emission intensity and the color temperature at the same time.

The light emission apparatus of Patent Literature 3 uses: a plurality of light-emitting sources that emit white light with different color temperatures; a light control unit that controls the light by controlling a voltage waveform supplied from an alternating current voltage source so as to obtain a desired emission intensity; a phase angle detector that detects a phase angle relative to a light control level; a driver control section that determines the amounts of the driving currents supplied to the respective light-emitting sources on the basis of the phase angle information supplied from the phase angle detection unit; and a driver that supplies predetermined driving currents to the respective light-emitting sources in accordance with the instructions of the driver control section. As described above, in the light emission apparatus of Patent Literature 3, the amount of driving current supplied for each light-emitting source is determined on the basis of the phase angle information relating to the emission intensity. Hence, it is possible to generate the white light with the color temperature appropriate for the emission intensity.

Further, an illumination apparatus of Patent Literature 4 uses: a first light emission apparatus that emits white light with a first color temperature; and a second light emission apparatus that emits white light with a second color temperature higher than the second color temperature. In addition, each emission color of the first and second light emission apparatuses is determined such that a deviation Δuv from a black-body radiation locus in a chromaticity diagram of the CIE (1976) L*u*v* color coordinate system is in a range of -0.02 to +0.02. By adjusting the intensities of the light emitted by the respective first and second light emission apparatus, it is possible to change a color temperature of synthetic light emitted from the illumination apparatus in a range from the first color temperature to the second color temperature, and it is possible to generate white light which is natural without sense of discomfort.

The chromaticity of the white light emitted from such an illumination apparatus moves in the line, which connects the chromaticity point of the light emitted by the first light emission apparatus with the chromaticity point of the light emitted by the second light emission apparatus, in the XY chromaticity diagram of the CIE (1931) XYZ color coordinate system. Hence, it is possible to generate favorable white light without great deviation from the black-body radiation locus and sense of discomfort. However, in the XY chromaticity diagram, the black-body radiation locus is an upwardly convex curve. In contrast, the line, which connects the chromaticity point of the light emitted by the first light emission apparatus with the chromaticity point of the light emitted by the second light emission apparatus, is a straight line. Hence, at a certain color temperature, the deviation from the black-body radiation locus is large. Accordingly, in such an illumination apparatus, there is still much room for improvement in order to generate favorable white light.

Therefore, Patent Literature 4 also proposes an illumination apparatus in which the above-mentioned point is considered. That is, there is proposed an illumination apparatus using, in addition to the first and second light emission apparatuses, a third light emission apparatus of an emission color of which the color temperature is in the middle between the first color temperature and the second color temperature and the deviation Δuv from the black-body radiation locus is in the range of -0.02 to +0.02. In the illumination apparatus, by adjusting the intensities of the light respectively emitted by the first to third light emission apparatus, the chromaticity of the white light emitted from the illumination apparatus can be changed to be further satisfactorily approximate to the black-body radiation locus.

Citation List

Patent Literature

Patent Literature 1: JP-A-2006-4839
Patent Literature 2: JP-A-2007-122950
Patent Literature 3: US Patent No. 7288902
Patent Literature 4: WO 2009/063915

Summary of Invention

Technical Problem

In the light emission apparatus disclosed in Patent Literature 3, all the light-emitting sources emit light in the entire range of the light control level. Hence, it is necessary to consider synthesis of the light emitted from a plurality of light-emitting sources in the entire range of the light control level, and thus a problem arises in that, in order to generate the white light with the desired color temperature, a process of calculating the driving currents supplied to the respective light-emitting sources becomes complicated every time. Such a problem more frequently arises when the number of light-emitting sources increases. Further, in the light emission apparatus disclosed in Patent Literature 3, the above-mentioned process of calculating the driving currents becomes complicated every time, and thus load on the driver control section and the driver increases. In order to reduce the load on the driver control section and the driver, the driver control section and the driver with high processing capabilities are necessary, while a problem arises in that manufacturing costs of the light emission apparatus increase.

Further, in the illumination apparatus of Patent Literature 4, the color temperature of the white light emitted from the illumination apparatus is set to be variable. However, when the color temperature of the white light is changed, the luminance is unlikely to be appropriately changed in accordance with the change. For example, the luminance may be excessively high when the color temperature is low, or the luminance may be excessively low when the color temperature is high. For this reason, a problem arises in that the change of the color temperature may give a sense of discomfort to a person.

Further, the illumination apparatus uses the first light emission apparatus that emits the white light with the first color temperature as a lower limit of the color temperature range. Hence, when the white light with the first color temperature is emitted from the illumination apparatus, only the white light emitted from the first light emission apparatus is used, and thus the second and third light emission apparatuses are turned off. Accordingly, when the white light with the first color temperature is emitted from the illumination apparatus as described above, or when the white light with a color temperature close to the first color temperature is emitted, a problem arises in that the total luminous flux of the illumination light obtained from the illumination apparatus excessively deteriorates.

The present invention has been made in view of such a problem, and its object is to provide a light emission apparatus capable of suppressing reduction in luminous flux inappropriate for adjustment of the color temperature while ensuring excellent color rendering properties, that is, a light emission apparatus capable of controlling the emission intensity and the color temperature so as to generate the light with a color temperature appropriate for the desired emission intensity and suppressing manufacturing costs, and an illumination system using the light emission apparatus. Further, its object is to provide an illumination method capable of emitting the light with the color temperature appropriate for the desired emission intensity by controlling the emission intensity and the color temperature while suppressing manufacturing costs of the light emission apparatus.

Solution to Problem

In order to achieve the object, a light emission apparatus according the present invention corresponds to a light emission apparatus of which a luminance is changed in accordance with change of a light control level, the light emission apparatus including: a wiring board; a plurality of LED chips that are disposed on an LED chip mounting surface of the wiring board and emit light with a predetermined wavelength range of a wavelength region ranging from a visible light region to a near-ultraviolet region, wherein the plurality of LED chips are grouped into a plurality of LED groups; a wavelength conversion member that is disposed at a position corresponding to the LED chip mounting surface of the wiring board, and is partitioned into a plurality of wavelength conversion regions corresponding to the plurality of LED chips, where the plurality of wavelength conversion regions are grouped into a plurality of wavelength conversion regions corresponding to the LED groups, and each wavelength conversion region has a different wavelength conversion characteristic, converts a wavelength of light emitted by the corresponding LED chips, and emits first-order light with a different color temperature; a current supply section that supplies a driving current to the LED chips independently for each of the LED groups through the wiring board; and a control section that controls the current supplied for each of the LED groups in response to a control signal input from outside, wherein the control section independently controls timing of starting to light the LED groups in accordance with the light control level.

The light emission apparatus may be configured so that the control section sequentially lights on the LED groups, in accordance with an increase in a total amount of the currents which are supplied from the current supply section to the plurality of LED groups.

The light emission apparatus may be configured so that the plurality of LED chips are grouped into three or more LED groups.

The light emission apparatus may be configured so that, in accordance with the increase in the total amount of the currents which are supplied from the current supply section to the plurality of LED groups, the control section sequentially lights on the LED groups in an order from an LED group which corresponds to the wavelength conversion region emitting the first-order light with a lower color temperature, to an LED group which corresponds to the wavelength conversion region emitting the first-order light with a higher color temperature.

The light emission apparatus may be configured so that the control section increases the number of LED groups which are being lighted on, in accordance with the increase in the total amount of the currents which are supplied from the current supply section to the plurality of LED groups.

The light emission apparatus may be configured so that the control section includes a phase angle detector that receives a control signal as a voltage waveform of which a conduction phase angle changes in accordance with the light control level and detects the conduction phase angle, and a selection circuit that selects an LED group to be lighted on in accordance with the conduction phase angle.

The light emission apparatus may be configured so that the control section receives a control signal as a voltage waveform in which an amplitude voltage value changes in accordance with the light control level, and selects an LED group to be lighted on in accordance with the amplitude voltage value.

In order to achieve the object, a light emission apparatus according the present invention corresponds to a light emission apparatus, including: a wiring board; a plurality of LED chips that are disposed on an LED chip mounting surface of the wiring board and emit light with a predetermined wavelength range of a wavelength region ranging from a visible light region to a near-ultraviolet region, wherein the plurality of LED chips are grouped into a plurality of LED groups; a wavelength conversion member that is disposed at a position corresponding to the LED chip mounting surface of the wiring board, and is partitioned into a plurality of wavelength conversion regions corresponding to the plurality of LED chips, where the plurality of wavelength conversion regions are grouped into a plurality of wavelength conversion regions corresponding to the LED groups, and each wavelength conversion region has a different wavelength conversion characteristic, converts a wavelength of light emitted by the corresponding LED chips, and emits first-order light with a different color temperature; a current supply section that supplies a driving current to the LED chips independently for each of the LED groups through the wiring board; and a control section that controls an amount of the current supplied for each of the LED groups in response to a control signal which is input from outside, wherein the control section sequentially lights on the LED groups, in accordance with an increase in a luminance of synthetic white light which is formed by synthesizing first-order light emitted from the plurality of wavelength conversion regions.

The light emission apparatus may be configured so that, in accordance with the increase in the luminance of the synthetic white light, the control section sequentially lights on the LED groups in an order from an LED group which corresponds to the wavelength conversion region emitting the first-order light with a lower color temperature, to an LED group which corresponds to the wavelength conversion region emitting the first-order light with a higher color temperature.

The light emission apparatus may be configured so that the plurality of LED chips and the wavelength changing member are separately provided from one another, a plurality of light emitting units are formed of the respective LED groups and the respective wavelength conversion regions corresponding to the LED groups, and each of the plurality of light emitting units is integrally provided, and the light emitting units form a light emitting unit group.

The light emission apparatus may be configured so that the wavelength changing member is provided to cover the plurality of LED chips, a plurality of light emitting units are formed of the respective LED groups and the respective wavelength conversion regions corresponding to the LED groups, and each of the plurality of light emitting units is individually provided, and the light emitting units form a light emitting unit group.

The light emission apparatus may be configured so that the plurality of LED chips and the wavelength conversion member form one package, and a plurality of packages are provided.

Further, as a specific configuration of an illumination system, it includes: a wiring board; a plurality of LED chips that are disposed on an LED chip mounting surface of the wiring board and emit light with a predetermined wavelength range of a wavelength region ranging from a visible light region to a near-ultraviolet region, wherein the plurality of LED chips are grouped into a plurality of LED groups; a wavelength conversion member that is disposed at a position corresponding to the LED chip mounting surface of the wiring board, and is partitioned into a plurality of wavelength conversion regions corresponding to the plurality of LED chips, where the plurality of wavelength conversion regions are grouped into a plurality of wavelength conversion regions corresponding to the LED groups, and each wavelength conversion region has a different wavelength conversion characteristic, converts a wavelength of light emitted by the corresponding LED chips, and emits first-order light with a different color temperature; a current supply section that supplies a driving current to the LED chips independently for each of the LED groups through the wiring board; an instruction section that gives an instruction to generate synthetic white light with a desired luminance by synthesizing the first-order light; a light control section that outputs a control signal for changing a luminance of the synthetic white light in response to the instruction from the instruction section; and a control section that controls an amount of the current supplied for each of the LED groups in response to a control signal which is output from the light control section, wherein the control section sequentially lights on the LED groups, in accordance with an increase in the luminance of the synthetic white light.

The illumination system may be configured so that, in accordance with the increase in the luminance of the synthetic white light, the control section sequentially lights on the LED groups in an order from an LED group which corresponds to the wavelength conversion region emitting the first-order light with a lower color temperature, to an LED group which corresponds to the wavelength conversion region emitting the first-order light with a higher color temperature.

The illumination system may be configured so that the control section increases the number of LED groups which are being lighted on, in accordance with the increase in the luminance of the synthetic white light.

The illumination system may be configured so that the control signal output from the light control section is a voltage waveform, and a conduction phase angle of the voltage waveform changes in accordance with the instruction from the instruction section, and the control section includes a phase angle detector that detects the conduction phase angle, and a selection circuit that selects an LED group to be lighted on in accordance with the conduction phase angle.

The illumination system may be configured so that the control signal output from the light control section is a voltage waveform, and an amplitude voltage value of the voltage waveform changes in accordance with the instruction from the instruction section, and the control section selects an LED group to be lighted on in accordance with the amplitude voltage value.

The illumination system may be configured so that the control section increases a sum of the driving currents, each of which is supplied for each of the LED groups, in accordance with change of a light control level toward increasing the luminance of the synthetic white light.

The illumination system may be configured so that the control section changes a target luminous flux $\phi$ in

accordance with a target correlation color temperature T, and sets the target correlation color temperature and a target total luminous flux such that a constant A0, at which the following inequality expression is established, is present:

$$-80743 \cdot (1000/T)^5 + 164973 \cdot (1000/T)^4 - 135260 \cdot (1000/T)^3 + 57994 \cdot (1000/T)^2 - 13995 \cdot (1000/T) + 1632.9 < \phi/A0 < \exp\{-342.11 \cdot (1000/T)^3 + 450.43 \cdot (1000/T)^2 - 212.19 \times (1000/T) + 39.47\}.$$

Further, an illumination method to achieve the object, includes: supplying a current independently to each LED group of a plurality of LED chips grouped into a plurality of LED groups so as to cause each LED group to emit light; supplying the light emitted by the LED chip to a wavelength conversion member that is partitioned into a plurality of wavelength conversion regions corresponding to the plurality of LED chips, where the plurality of wavelength conversion regions are grouped into a plurality of wavelength conversion regions corresponding to the LED groups, wherein each wavelength conversion region has a different wavelength conversion characteristic, and emits first-order light with a different color temperature; and forming synthetic white light by synthesizing the first-order light, wherein the LED groups are sequentially lighted on by controlling an amount of the current supplied for each LED group in accordance with an increase in a luminance of the synthetic white light.

The illumination method may be configured so that, in accordance with the increase in the luminance of the synthetic white light, the LED groups are sequentially lighted on in an order from an LED group corresponding to the wavelength conversion region emitting the first-order light with a lower color temperature to an LED group corresponding to the wavelength conversion region emitting the first-order light with a higher color temperature.

Further, in order to achieve the object, a light emission apparatus according to the present invention includes: a light emitting unit group that is formed of two or more light emitting units, each of which emits light with a different chromaticity, wherein the light emitting unit group emits synthetic light which is formed by synthesizing first-order light emitted from the respective light emitting units; and control means for controlling light emission of each light emitting unit such that a chromaticity point of the synthetic light emitted from the light emitting unit group is positioned on a control curve which is set in advance in a range from a first color temperature in an XY chromaticity diagram of a CIE (1931) XYZ color coordinate system to a second color temperature higher than the first color temperature, wherein the control means includes a target value setting section that sets one parameter of a target total luminous flux $\phi$ and a target correlation color temperature T of the synthetic light emitted from the light emitting unit group and sets the other parameter in accordance with the one parameter, and an emission control section that controls light emission of each light emitting unit such that a color temperature and a total luminous flux of the synthetic light emitted from the light emitting unit group are equal to the target total luminous flux $\phi$ and the target correlation color temperature T set by the target value setting section, and the target setting section sequentially changes the target correlation color temperature T in at least a range from 3500 K to 4500 K, and sets the target total luminous flux $\phi$ at 4500 K not less than twice and not more than thirty times the target total luminous flux $\phi$ at 3500 K in correspondence with a desired illuminance of an irradiated object, which is irradiated with the synthetic light, with respect to the light emission apparatus.

The light emission apparatus may be configured so that the target setting section sets the target total luminous flux $\phi$ such that an illuminance of the irradiated object at 3500 K is in a range from 100 Lux to 500 Lux and an illuminance of the irradiated object at 4500 K is in a range from 300 Lux to 40000 Lux.

The light emission apparatus may be configured so that the target setting section sequentially changes the target correlation color temperature T in a range from 2000 K to 4500 K, and sets the target total luminous flux $\phi$ at 4500 K not less than ten times and not more than one hundred times the target total luminous flux $\phi$ at 2000 K in correspondence with a range of the desired illuminance.

The light emission apparatus may be configured so that the target setting section sets the target total luminous flux $\phi$ such that an illuminance of the irradiated object at 2000 K is in a range from 15 Lux to 20 Lux and an illuminance of the irradiated object at 4500 K is in a range from 300 Lux to 40000 Lux.

The light emission apparatus may be configured so that the target value setting section sets the target total luminous flux $\phi$, in a setting range from a lower limit to an upper limit of the target correlation color temperature T, such that a constant A0, at which the following inequality expression is established, is present:

$$-80743 \cdot (1000/T)^5 + 164973 \cdot (1000/T)^4 - 135260 \cdot (1000/T)^3 + 57994 \cdot (1000/T)^2 - 13995 \cdot (1000/T) + 1632.9 < \phi/A0 < \exp\{-342.11 \cdot (1000/T)^3 + 450.43 \cdot (1000/T)^2 - 212.19 \times (1000/T) + 39.47\}.$$

As a specific configuration, it is preferable that the number of the light emitting units is three or more.

Further, in order to achieve the object, a light emission apparatus according to the present invention includes: a light emitting unit group that is formed of three or more light emitting units, each of which emits light with a different chromaticity, wherein the light emitting unit group emits synthetic light which is formed by synthesizing first-order light emitted from the respective light emitting units; and control means for controlling light emission of each light emitting unit such that a chromaticity point of the synthetic light emitted from the light emitting unit group is positioned on an upwardly convex control curve which is set in advance in a range from a first color temperature in an XY chromaticity diagram of a CIE (1931) XYZ color coordinate system to a second color temperature higher than the first color temperature, wherein the control means includes a target value setting section that sets a target correlation color temperature T and a target total luminous flux $\phi$ of the synthetic light emitted from the light emitting unit group, and an emission control section that controls light emission of each light emitting unit such that a color temperature and a total luminous flux of the synthetic light emitted from the light emitting unit group are equal to the target correlation color temperature T and the target total luminous flux $\phi$ set by the target value setting section, the target value setting section changes the target luminous flux $\phi$ in accordance with the target correlation color temperature T, and sets the target correlation color temperature T and a target total luminous flux $\phi$ such that a constant A0, at which the following inequality expression is established, is present:

$$-80743 \cdot (1000/T)^5 + 164973 \cdot (1000/T)^4 - 135260 \cdot (1000/T)^3 + 57994 \cdot (1000/T)^2 - 13998$$
$$\cdot (1000/T) + 1632.9 < \phi/A0 <$$
$$\exp\{-342.11 \cdot (1000/T)^3 + 450.43 \cdot (1000/T)^2 - 212.19 \times (1000/T) + 39.47\},$$

XY chromaticity diagram, chromaticity of the first-order light emitted by each light emitting unit is determined such that the control curve is included in a polygon defined by vertices of chromaticity points of the first-order light emitted by the respective light emitting units.

Advantageous Effects of Invention

According to the light emission apparatus of the present invention, it is possible to generate the light with the color temperature appropriate for the desired emission intensity by controlling the emission intensity and the color temperature, and to suppress the manufacturing costs thereof.

Further, in the above-mentioned light emission apparatus, when the corresponding LED groups are sequentially lighted on in accordance with the increase in the total amount of the currents supplied to the plurality of LED groups, it is possible to increase the luminance of the synthetic white light emitted from the light emission apparatus, and change the color temperature of the corresponding synthetic white light appropriate for the increase in the corresponding luminance.

Further, in the above-mentioned light emission apparatus, when the plurality of LED chips are grouped into three or more LED groups, the synthetic white light emitted from the light emission apparatus can be changed in accordance with the black-body radiation locus in the xy chromaticity diagram of the CIE (1932) XYZ color coordinate system.

Furthermore, in the above-mentioned light emission apparatus, in accordance with the increase in the luminance of the synthetic white light, the control section sequentially lights on the LED groups in an order from an LED group which corresponds to the wavelength conversion region emitting the first-order light with the lower color temperature, to an LED group which corresponds to the wavelength conversion region emitting the first-order light with the higher color temperature. In this case, it is possible to increase the luminance of the synthetic white light emitted from the light emission apparatus, and change the color temperature of the corresponding synthetic white light appropriate for the increase in the corresponding luminance.

In addition, in the above-mentioned light emission apparatus, in accordance with the increase in the total amount of the currents supplied to the LED groups, the number of LED groups, which are being lighted on, increases. In this case, while increasing the luminance of the synthetic white light emitted from the light emission apparatus, it is possible to change the color temperature of the synthetic white light.

Moreover, in the light emission apparatus according to the present invention, the above-mentioned control signal is a voltage waveform. Hence, by using an existing illumination system, it is possible to use the light emission apparatus according to the present invention.

A further specific configuration of the light emission apparatus is as follows. The plurality of LED chips and the wavelength conversion member are provided to be separated from one another, the plurality of light emitting units are formed of the respective LED groups and the respective wavelength conversion regions corresponding to the LED groups, each of the plurality of light emitting units is integrally provided, and the light emitting units form a light emitting unit group. In this case, it is easy to treat the light emitting unit group, and thus it is possible to reduce the number of manufacturing processes and the manufacturing costs of the light emission apparatus.

A further specific configuration of the light emission apparatus is as follows. The wavelength conversion member is provided to cover the plurality of LED chips, the plurality of light emitting units are formed of the respective LED groups and the respective wavelength conversion regions corresponding to the LED groups, each of the plurality of light emitting units is individually provided, and the light emitting units form a light emitting unit group. In this case, a degree of freedom of arrangement of the light emitting units increases.

According to the illumination system of the present invention, it is possible to generate the light with the color temperature appropriate for the desired emission intensity by controlling the emission intensity and the color temperature, and to suppress the manufacturing costs thereof.

Further, in the above-mentioned illumination system, in accordance with the increase in the luminance of the synthetic white light, the control section sequentially lights on the LED groups in an order from an LED group which corresponds to the wavelength conversion region emitting the first-order light with the lower color temperature, to an LED group which corresponds to the wavelength conversion region emitting the first-order light with the higher color temperature. Hence, when increasing the luminance of the synthetic white light supplied from the corresponding illumination system, it is possible to change the color temperature of the corresponding synthetic white light appropriate for the increase in the corresponding luminance.

Furthermore, according to the illumination method of the present invention, it is possible to emit the light with the color temperature appropriate for the desired emission intensity by controlling the emission intensity and the color temperature while suppressing manufacturing costs of the light emission apparatus.

In addition, in the above-mentioned illumination method, in accordance with the increase in the luminance of the synthetic white light, the LED groups are sequentially lighted on in an order from the LED group corresponding to the wavelength conversion region emitting the first-order light with the lower color temperature to the LED group corresponding to the wavelength conversion region emitting the first-order light with the higher color temperature. In this case, the synthetic white light generated by the illumination method has a color temperature appropriate for the desired luminance obtained by the light control.

In the light emission apparatus according to the present invention, the light emitting unit group is formed of three or more light emitting units, each of which emits first-order light with a different chromaticity, and the control means controls light emission of each light emitting unit such that the chromaticity point of the synthetic light emitted from the light emitting unit group is positioned on the upwardly convex control curve which is set in advance in the range from the first color temperature to the second color temperature in the XY chromaticity diagram of the CIE (1931) XYZ color coordinate system. At this time, in the XY chromaticity diagram, chromaticity of the first-order light emitted by each light emitting unit is determined such that the control curve is included in a polygon, which is formed by connecting the respective chromaticity points of the first-order light emitted by the respective light emitting units. Hence, it is possible to control the light, which is emitted from the light emission apparatus, such that it has the desired chromaticity. For example, by performing the color control and the light control on the basis of the black-body radiation locus, it is possible to provide more comfortable illumination.

Further, the emission control section controls the light emission of each light emitting unit such that the color temperature of the synthetic light emitted from the light emitting unit group is equal to the target correlation color temperature set by the target value setting section of the control means. Hence, the amount of emission control of the light emitting unit corresponding to the target correlation color temperature is stored in advance in the storage device for each light emitting unit. Thereby, it is possible to eliminate the necessity to repeatedly calculate the amount of emission control from the target correlation color temperature, and thus it is possible to reduce calculation load on the control means.

Furthermore, when the emission control section controls light emission of each light emitting unit on the basis of the target correlation color temperature which is set by the target value setting section, the emission control section also controls the total luminous flux of the synthetic light emitted from the light emitting unit group. Hence, when changing the color temperature of the illumination light of the illumination apparatus into various values, it is also possible to control the total luminous flux of the illumination light in accordance with the purpose of use of the illumination apparatus or user's request. For example, in a case of the incandescent bulb, when the luminance thereof is changed, as the luminance becomes lower, the color temperature becomes lower. Therefore, by changing the illumination light of the illumination apparatus in a similar manner to change of the illumination light generated by such an incandescent bulb, it is possible to eliminate sense of discomfort at the time of adjusting the illumination light. Alternatively, in accordance with the purpose of use of the illumination apparatus, the luminance may not be intended to be excessively reduced even at a low color temperature. However, it is possible to change such illumination light.

In addition, the control section changes the target luminous flux $\phi$ in accordance with the target correlation color temperature T, and sets the target correlation color temperature T and the target total luminous flux $\phi$ such that the constant A0, at which the following inequality expression is established, is present:

$$-80743 \cdot (1000/T)^5 + 164973 \cdot (1000/T)^4 - 135260 \cdot (1000/T)^3 + 57994 \cdot (1000/T)^2 - 13995 \cdot (1000/T) + 1632.9 < \phi/A0 <$$

$$\exp\{-342.11 \cdot (1000/T)^3 + 450.43 \cdot (1000/T)^2 - 212.19 \times (1000/T) + 39.47\}.$$

In the XY chromaticity diagram, the chromaticity of the first-order light emitted by each light emitting unit is determined such that the control curve is included in the polygon defined by vertices of the chromaticity points of the first-order light emitted by respective light emitting units. Hence, the light, which is generated from the light emission apparatus, is made to provide a sense of comfort all the time when the color temperature is changed.

BRIEF DESCRIPTION OF DRAWINGS

Fig. 1 is a perspective view illustrating a configuration of a light emission source in a light emission apparatus according to a first example of the present invention.
Fig. 2 is a schematic top plan view of the light emission source of Fig. 1.
Fig. 3 is a schematic cross-sectional view taken along the line III-III of Fig. 2.
Fig. 4 is an enlarged cross-sectional view of a principal section in Fig. 3.
Fig. 5 is a diagram of an enlarged principal section illustrating a relationship between a control curve and a chromaticity point of each light emitting unit of the light emitting section according to the first example in the xy chromaticity diagram of the CIE (1931) XYZ color coordinate system.
Fig. 6 is a table showing film thicknesses and mixture ratios of phosphors of fluorescent members used in the first example.
Fig. 7 is an electric circuit diagram illustrating an overview of an electric circuit configuration of an illumination system according to the first example.
Fig. 8 is a schematic diagram illustrating an example of an instruction section (operation section) used in the illumination system according to the first example.
Fig. 9 is a graph illustrating a relationship between the light control level of the illumination system according to the first example and the emission intensity of the synthetic white light obtained at the corresponding light control level thereof.
Fig. 10 is a graph illustrating a relationship between the total luminous flux of the synthetic white light and the color temperature of the synthetic white light obtained by the illumination system according to the first example.
Fig. 11 is a table showing simulation results of the illumination system according to the first example.
Fig. 12 is a graph showing the simulation results of the illumination system according to the first example.
Fig. 13 is a graph showing the simulation results of the illumination system according to the first example.
Fig. 14 is a graph showing the simulation results of the illumination system according to the first example.
Figs. 15(a) to 15(d) are schematic diagrams illustrating modified examples of pattern shapes of wavelength conversion regions and LED groups used in the light emission apparatus according to the first example of the present invention.
Fig. 16 is a perspective view illustrating a configuration of a modified example of the light emission source in the light emission apparatus according to the first example of the present invention.
Figs. 17(a) and 17(b) are schematic diagrams illustrating cell regions used in the modified example of the light emission apparatus according to the first example of the present invention.
Fig. 18 is a schematic diagram partially illustrating an example of arrangement of the cell regions in the light emitting section of Fig. 16.
Fig. 19 is a perspective view illustrating a configuration of a light emission source in a light emission apparatus according to a second example of the present invention.
Fig. 20 is a schematic top plan view of the light emission source of Fig. 19.
Fig. 21 is a diagram of an enlarged principal section illustrating a relationship between a control curve and a chromaticity point of each light emitting unit of the light emitting section in the xy chromaticity diagram of the CIE (1931) XYZ color coordinate system.
Fig. 22 is a table showing film thicknesses and mixture ratios of phosphors of fluorescent members used in the second example.
Fig. 23 is an electric circuit diagram illustrating an overview of an electric circuit configuration of an illumination system according to the second example.
Fig. 24 is a graph illustrating a relationship between the light control level of the illumination system according to the second example and the emission intensity of the synthetic white light obtained at the corresponding light control level thereof.

Fig. 25 is a graph illustrating a relationship between the total luminous flux of the synthetic white light and the color temperature of the synthetic white light obtained by the illumination system according to the second example.

Fig. 26 is a table showing simulation results of the illumination system according to the second example.

Fig. 27 is a graph showing the simulation results of the illumination system according to the second example.

Fig. 28 is a graph showing the simulation results of the illumination system according to the second example.

Fig. 29 is a graph showing the simulation results of the illumination system according to the second example.

Fig. 30 is a schematic diagram illustrating a modified example of pattern shapes of wavelength conversion regions and LED groups used in the light emission apparatus according to the second example of the present invention.

Fig. 31 is a perspective view illustrating a configuration of a light emission source in a light emission apparatus according to a third example of the present invention.

Fig. 32 is a schematic top plan view of the light emission source of Fig. 31.

Fig. 33 is a diagram of an enlarged principal section illustrating a relationship between a control curve and a chromaticity point of each light emitting unit of the light emitting section in the xy chromaticity diagram of the CIE (1931) XYZ color coordinate system.

Fig. 34 is a table showing film thicknesses and mixture ratios of phosphors of fluorescent members used in the third example.

Fig. 35 is an electric circuit diagram illustrating an overview of an electric circuit configuration of an illumination system according to the third example.

Fig. 36 is a graph illustrating a relationship between the light control level of the illumination system according to the third example and the emission intensity of the synthetic white light obtained at the corresponding light control level thereof.

Fig. 37 is a graph illustrating a relationship between the total luminous flux of the synthetic white light and the color temperature of the synthetic white light obtained by the illumination system according to the third example.

Fig. 38 is a table showing simulation results of the illumination system according to the third example.

Fig. 39 is a graph showing the simulation results of the illumination system according to the third example.

Fig. 40 is a graph showing the simulation results of the illumination system according to the third example.

Fig. 41 is a graph showing the simulation results of the illumination system according to the third example.

Fig. 42 is a schematic diagram illustrating a modified example of pattern shapes of wavelength conversion regions and LED groups used in the light emission apparatus according to the third example of the present invention.

Fig. 43(a) is a graph illustrating relationships between the total luminous fluxes of and the color temperatures of the synthetic white light emitted from the light emission apparatus when the driving current is applied to the light emission apparatus according to the second example, and Fig. 43(b) is a graph illustrating relationships between the total luminous fluxes of and the color temperatures of the synthetic white light emitted from the light emission apparatus when the driving current is applied to the light emission apparatus according to the third example.

Fig. 44 is a perspective view illustrating a basic configuration of a light emitting section in a light emission apparatus according to a fourth example of the present invention.

Fig. 45 is a top plan view of the light emitting secti.on of Fig. 44.

Fig. 46 is a cross-sectional view taken along the line XXXXVI-XXXXVI of Fig. 45.

Fig. 47 is a schematic top plan view of a modified example of the light emitting section in the light emission apparatus according to the fourth example.

Fig. 48 is a schematic top plan view of a modified example of the light emitting section in the light emission apparatus according to the fourth example.

Fig. 49 is a diagram of an enlarged principal section illustrating a relationship between a control curve and a chromaticity point of each light emitting unit of the light emitting section in the xy chromaticity diagram of the CIE (1931) XYZ color coordinate system.

Fig. 50 is a graph illustrating a relationship between the total luminous flux of the synthetic white light and the color temperature of the synthetic white light obtained by the illumination system of Fig. 49.

Fig. 51 is a perspective view illustrating an overview of an overall configuration of a light emitting section in an illumination apparatus according to a fifth example of the present invention.

Fig. 52 is a top plan view of the light emitting section of Fig. 51.

Fig. 53 is a cross-sectional view of the light emitting section taken along the line LIII-LIII of Fig. 52.

Fig. 54 is an enlarged view of a principal section of a cross-section of the light emitting section shown in Fig. 53.

Fig. 55 is a table showing an example of the numbers of the cell regions of the wavelength conversion regions in the light emitting section of Fig. 51.

Fig. 56 is a schematic diagram partially illustrating an example of arrangement of the cell regions in the light emitting section of Fig. 51.

Fig. 57 is a diagram of an enlarged principal section illustrating a relationship between a control curve and a chromaticity point of each light emitting unit of the light emitting section in the XY chromaticity diagram of the CIE (1931) XYZ color coordinate system.

Fig. 58 is an electric circuit diagram illustrating an overview of an electric circuit configuration of an illumination apparatus according to the fifth example.

Fig. 59 is a schematic diagram illustrating an example of an operation unit used in the illumination apparatus according to the fifth example.

Fig. 60 is a graph illustrating relationships of color temperatures of the illumination light, supply powers of the light emitting units, total supply powers, and total luminous fluxes of the illumination light which are obtained by the illumination apparatus according to the fifth example.

Fig. 61 is an electric circuit diagram illustrating a modified example of the electric circuit configuration of the illumination apparatus according to the fifth example.

Fig. 62 is a table showing an example of the supply powers of the light emitting units corresponding to the target color temperatures in a case of using the electric circuit configuration of Fig. 61.

Fig. 63 is a diagram of an enlarged principal section illustrating a different example of the relationship between the control curve and the chromaticity point of each light emitting unit of the light emitting section in the XY chromaticity diagram of the CIE (1931) XYZ color coordinate system.

Fig. 64 is a diagram of an enlarged principal section illustrating a different example of the relationship between the control curve and the chromaticity point of each light emitting unit of the light emitting section in the XY chromaticity diagram of the CIE (1931) XYZ color coordinate system.

Fig. 65 is a top plan view illustrating a first modified example of a fluorescent member in the illumination apparatus according to the fifth example.

Fig. 66 is a top plan view illustrating one cell region as a second modified example of the fluorescent member in the illumination apparatus according to the fifth example.

Fig. 67 is a schematic diagram partially illustrating an example of arrangement of the cell regions of Fig. 66 in the fluorescent member of the second modified example.

Fig. 68 is a top plan view illustrating a third modified example of a fluorescent member in the illumination apparatus according to the fifth example.

Fig. 69 is a schematic diagram illustrating an operation unit used in a first modified example of the emission control performed by the illumination apparatus.

Fig. 70 is a graph illustrating an example of a relationship between the total luminous flux and the color temperature of the illumination light of the illumination apparatus in the first modified example of the emission control performed by the illumination apparatus.

Fig. 71 is a table illustrating an example of the supply powers of the light emitting units corresponding to the target color temperatures, for making the change in the total luminous flux and the color temperature of the illumination light of the illumination apparatus comfortable.

Fig. 72 is a graph illustrating relationships between the color temperatures and the total luminous fluxes when the electric powers shown in the table of Fig. 71 are supplied to the light emitting units.

Fig. 73 is a perspective view illustrating a basic configuration of a light emitting section in an illumination apparatus according to a sixth example of the present invention.

Fig. 74 is a top plan view of the light emitting section of Fig. 73.

Fig. 75 is a cross-sectional view of the first light emitting section taken along the line LXXV-LXXV of Fig. 74.

Fig. 76 is a cross-sectional view of the second light emitting section taken along the line LXXV-LXXV of Fig. 74.

Fig. 77 is an electric circuit diagram illustrating an overview of an electric circuit configuration of the illumination apparatus according to the sixth example.

Fig. 78 is a schematic diagram illustrating an example of arrangement of the first light emitting section and the second light emitting section in the illumination apparatus according to the sixth example.

Fig. 79 is a top plan view illustrating a schematic configuration of a light emitting section in an illumination apparatus according to a seventh example.

Fig. 80 is a top plan view illustrating an overall configuration of a light emitting section in an illumination apparatus according to a seventh example.

Fig. 81 is an electric circuit diagram illustrating an overview of an electric circuit configuration of the illumination apparatus according to the seventh example.

Fig. 82 is a cross-sectional view illustrating a basic configuration of a light emitting unit in an illumination apparatus according to an eighth example.

Fig. 83 is a schematic diagram illustrating an example of arrangement of first to fourth light emitting units in the illumination apparatus according to the eighth example.

Fig. 84 is a graph illustrating a relationship between the color temperature and the illuminance in a case of supplying the electric powers shown in the table of Fig. 71 to the light emitting units.

DESCRIPTION OF EMBODIMENTS

Hereinafter, referring to the drawings, embodiments of the present invention will be described in detail on the basis of several examples. In addition, the present invention is not limited to the description below, and may be arbitrarily modified without departing from the technical scope of the invention. Further, all the drawings used in description of the examples schematically illustrate the light emission apparatuses according to the present invention. In order to facilitate understanding, the drawings may be partially emphasized, enlarged, reduced, or omitted, and thus the scale sizes, the shapes, and the like of the components may not exactly reflect those in actual situations. Furthermore, all the various numerical values used in the examples are exemplary values, and thus can be changed to various different values.

<First Example>

(Configuration of Light Emitting Section)

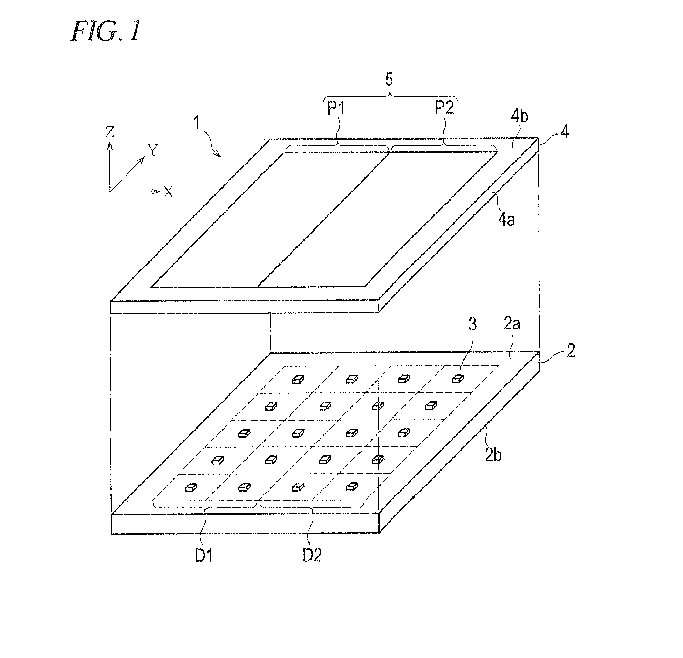

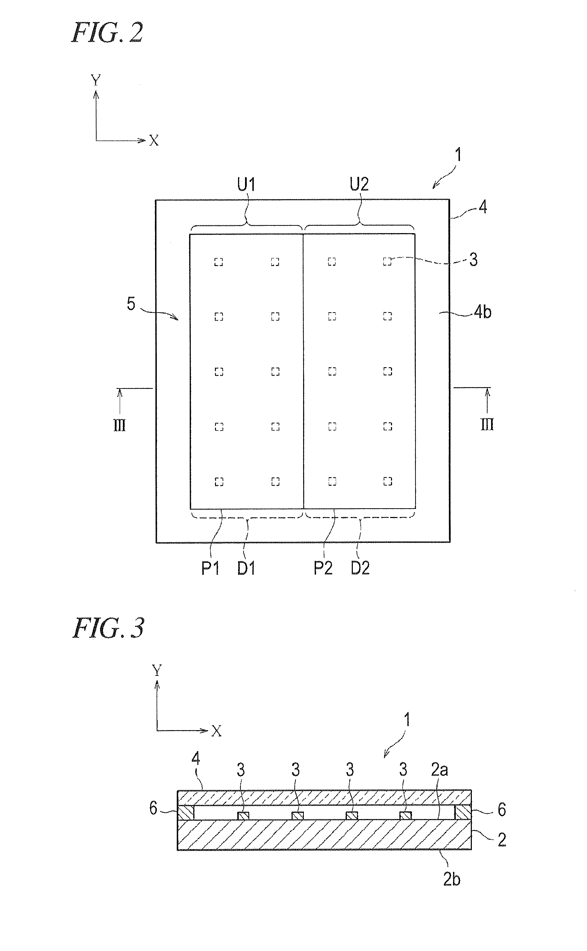

Fig. 1 is a perspective view illustrating an overview of an overall configuration of a light emitting section 1 in the light emission apparatus (illumination apparatus) according to the present example. Fig. 2 is a top plan view of the light emitting section 1 of Fig. 1. Note that, in Figs. 1 and 2, the widthwise direction of the light emitting section 1 is defined as an X direction, the lengthwise direction thereof is defined as a Y direction, and the height direction thereof is defined as a Z direction. As shown in Fig. 1, the light emitting section 1 includes a wiring board 2 made of alumina ceramic which is excellent in electrical insulation and has a favorable heat dissipation ability. On a chip mounting surface 2a of the wiring board 2, a total of 20 light emitting diode (LED: Light Emitting Diode) chips 3 are equidistantly arranged in a matrix of four in the widthwise direction (that is, X direction) and five in the lengthwise direction (that is, Y direction) of the wiring board 2. Although not shown in Fig. 1, wiring patterns for respectively supplying the LED chips 3 with electric powers are formed on wiring board 2, and constitute an electric circuit to be described later.
In addition, the material of the wiring board 2 is not limited to the alumina ceramic, and the main body of the wiring board 2 may be formed of a material selected from, for example, resin, glass epoxy, and composite resin containing a filler as materials with excellent electrical insulation. Alternatively, in order to improve a light emitting efficiency of the light emitting section 1 by enhancing reflectivity of light on the chip mounting surface 2a of the wiring board 2, it is preferable to use silicon resin including a white pigment such as alumina powder, silica powder, magnesium oxide, or titanium oxide. On the other hand, in order to obtain a further excellent heat dissipation ability, the main body of the wiring board 2 may be made of metal. In this case, it is necessary to electrically insulate the wiring patterns and the like of the wiring board 2 from the main body made of metal.
As shown in Fig. 1, a transparent board 4, which is made of glass and has a plate shape, is disposed to be opposed to the chip mounting surface 2a of the wiring board 2 on which the LED chips 3 are mounted. Note that, for convenience, Fig. 1 shows a situation in which the wiring board 2 and the transparent board 4 are separated, but as described later, in practice the wiring board 2 and the transparent board 4 are disposed to be close to each other. In addition, the material of the transparent board 4 is not limited to glass, and the transparent board 4 may be formed of resin, which is transparent to the light emitted by the LED chips 3, or the like.
A fluorescent member 5 is divided and grouped into two wavelength conversion regions of a first wavelength conversion region P1 and a second wavelength conversion region P2. In accordance with the division of the fluorescent member 5, the LED chips 3 mounted on the wiring board 2 are grouped into respective LED groups corresponding to respective positions of the first wavelength conversion region P1 and the second wavelength conversion region P2 as shown in Figs. 1 and 2. That is, as shown in Fig. 2, in plan view of the light emitting section 1 (that is, in the XY top plan view of the light emitting section 1), 10 LED chips 3 are disposed to correspond to each of two wavelength conversion regions of the first wavelength conversion region P1 and the second wavelength conversion region P2. Here, the term "correspond" means a situation in which the first wavelength conversion region P1 is provided to be opposed to (that is, superimposed on or overlapped with) a first LED group D1 and the second wavelength conversion region P2 is provided to be opposed to a second LED group D2. In the description below, in order to distinguish the LED chips 3 for each wavelength conversion region, signs a and b are respectively attached to the tail end of the reference sign thereof so as to correspond to the first wavelength conversion region P1 and the second wavelength conversion region P2. Therefore, the 10 LED chips 3a positioned to correspond to the first wavelength conversion region P1 constitute the first LED group D1, and the 10 LED chips 3b positioned to correspond to the second wavelength conversion region P2 constitute the second LED group D2.
Accordingly, in the present example, respective combinations of the first wavelength conversion region P1 and the second wavelength conversion region P2 and the first LED group D1 and the second LED group D2 corresponding thereto correspond to respective light emitting units of the present invention. That is, the first LED group D1 and the first wavelength conversion region P1 constitute a first light emitting unit U1, and the second LED group D2 and the second wavelength conversion region P2 constitute a second light emitting unit U2. A light emitting section 1, in which the two light emitting units are integrated, corresponds to a light emitting unit group of the present invention. In the present example, the first light emitting unit U1 and the second light emitting unit U2 are integrally provided, and constitute the light emitting section 1 which is the light emitting unit group. Note that, in the description below, light, which is emitted by each of the first light emitting unit U1 and the second light emitting unit U2, is referred to as first-order light, and light, which is formed by synthesizing the first-order light emitted by each of the first light emitting unit U1 and the second light emitting unit U2 and is emitted from the light emitting section 1, is referred to as synthetic white light.

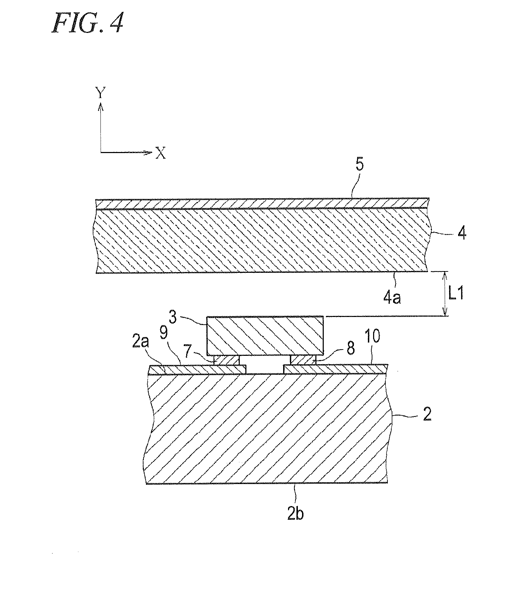

Fig. 3 is a cross-sectional view of the light emitting section 1 taken along the line III-III of Fig. 2. Fig. 4 is an enlarged cross-sectional view of a principal section shown in Fig. 3. As shown in Fig. 3, the transparent board 4 is bonded to the wiring board 2 with a plurality of spacers 6 interposed therebetween, by interposing the spacers 6, as shown in Fig. 4, a clearance is provided between the transparent board 4 and the LED chips 3.

The clearance provided herein is formed with a distance L1 calculated in advance such that the light emitted from the LED chips 3 reliably reaches the fluorescent member 5 positioned to correspond to the LED chips 3. When the LED chips 3 is as close to the fluorescent member 5 as possible, the light emitted by the LED chips 3 reliably reaches the fluorescent member 5. However, when the LED chips 3 is excessively close to the fluorescent member 5, the fluorescent member 5 is heated by heat emitted by the LED chips 3, and thus there is a concern that this may cause deterioration in the wavelength conversion function and the light emitting efficiency. Hence, in order to prevent the temperature from being excessively increased, it is preferable that the distance between the LED chips 3 and the fluorescent member 5 be equal to or greater than 0.01 mm.

Further, when the light emitting section 1 has thermal room, the first surface 4a of the transparent board 4 may be in close contact with the LED chips 3 without providing such a clearance. Furthermore, even when the LED chips 3 and the transparent board 4 are separated, the clearance may be sealed by silicon resin, epoxy resin, glass, or the like which is transparent. In such a manner, it is possible to efficiently guide the light emitted from the LED chips 3 to the fluorescent member 5.

In addition, in the present example, the fluorescent member 5 is provided on the second surface 4b of the transparent board 4, but the fluorescent member 5 may be provided on the first surface 4a of the transparent board 4, that is, a surface thereof close to the wiring board 2. Even in this case, in a similar manner to the present example, it is possible to provide an appropriate clearance between the fluorescent member 5 and the LED chips 3. However, when there is thermal room, it is possible to cause the fluorescent member 5 to be in close contact with the LED chips 3 or to be close thereto just before the contact.

(LED Chip)

As the LED chip 3, in the present example, an LED chip emitting blue light with a peak wavelength of 460 nm is used. Specifically, as such an LED chip, there is a GaN LED chip in which for example an InGaN semiconductor is used in a light emitting layer. Note that, the emission wavelength characteristic and the type of the LED chip 3 is not limited to this, and it may be possible to employ the semiconductor light emitting elements such as various LED chips without departing from the technical scope of the present invention. In the present example, it is preferable that the peak wavelength of the light emitted by the LED chips 3 be in the wavelength range of 420 nm to 500 nm.

A p electrode 7 and an n electrode 8 are formed on a surface of each LED chip 3 facing the wiring board 2. In a case of the LED chip 3 shown in Fig. 4, the p electrode 7 is bonded to the wiring pattern 9 formed on the chip mounting surface 2a of the wiring board 2, and the n electrode 8 is bonded to the wiring pattern 10 formed on the same chip mounting surface 2a. The p electrode 7 and the n electrode 8 are connected to the wiring pattern 9 and the wiring pattern 10 through a metal bump, which is not shown, by soldering. In cases of other LED chips 3, the p electrode 7 and the n electrode 8 are similarly bonded to the wiring patterns formed on the chip mounting surface 2a of the wiring board 2 corresponding to each LED chip 3.

Note that, a method of mounting the LED chips 3 on the wiring board 2 is not limited to this, and it may be possible to select a method appropriate for the type, the structure, and the like of the LED chip 3. For example, after the LED chips 3 are fixedly attached to predetermined positions on the wiring board 2, the two electrodes of each LED chip 3 may be connected to the corresponding wiring patterns through wire bonding. In addition, one electrode may be bonded to the corresponding wiring pattern as described above, and the other electrode may be connected to the corresponding wiring pattern through wire bonding.

(Fluorescent Member)

As described above, the fluorescent member 5 is divided into two of the first wavelength conversion region P1 and the second wavelength conversion region P2 corresponding to the first LED group D 1 and the second LED group D2. In the first wavelength conversion region P1 and the second wavelength conversion region P2, the wavelengths of the light emitted from the LED chips 3 are converted, and various phosphors for emitting light with various wavelengths are held in a distributed manner. The used various phosphors include: a red phosphor (first phosphor) which is for emitting red light by converting the wavelength of the blue light emitted by the LED chips 3; a green phosphor (second phosphor) which is for emitting green light by converting the wavelength of the blue light emitted by the LED chips 3; and a yellow phosphor (third phosphor) which is for emitting yellow light by converting the wavelength of the blue light emitted by the LED chips 3. In addition, it may be possible to use an orange phosphor (fourth phosphor) which is for emitting orange light by converting the wavelength of the blue light emitted by the LED chips 3. Further, it is not necessary for the fluorescent member 5 to hold all the above-mentioned red phosphor, green phosphor, and yellow phosphor in a distributed manner, and if the desired first-order light can be emitted from the fluorescent member 5, one type or two or more types of phosphors may be selected from the above-mentioned phosphors. For example, the fluorescent member 5 may hold the red phosphor and the green phosphor in a distributed manner, and may not hold the yellow phosphor in a distributed manner.

Here, specific examples of the above-mentioned phosphors will be described below. Note that, the phosphors exemplify phosphors quite appropriate for the present example. However, available phosphors are not limited thereto, and it may be possible to apply various types of phosphors insofar as they are within the technical scope of the present invention.

(Red Phosphor)

An appropriate wavelength range of the emission peak wavelength of the red phosphor is normally 570 nm or more and 780 nm or less, preferably 580 nm or more and 700 nm or less, or more preferably 585 nm or more and 680 nm or less. From this point of view, as the red phosphor, for example, the following are preferable: $(Ca,Sr,Ba)_2Si_5(N,O9)_8$:Eu; $(Ca,Sr,Ba)Si(N,O)_2$:Eu; $(Ca,Sr,Ba)AlSi(N,O)_3$:Eu; $(Sr,Ba)_3SiO_5$:Eu; $(Ca,Sr)S$:Eu; $SrAlSi_4N_7$:Eu; $(La,Y)_2O_2S$:Eu; $\beta$-diketone Eu complexes such as $Eu(dibenzoylmethane)_3$ ·1,10-phenanthroline complex; carboxylic acid Eu complex; and $K_2SiF_6$:Mn. In addition, the following are more preferable: $(Ca,Sr,Ba)_2Si_5(N,O9)_8$:Eu; $(Sr,Ca)AlSi(N,O)_3$:Eu; $SrAlSi_4N_7$:Eu; $(La,Y)_2O_2S$:Eu; and $K_2SiFe$:Mn (here, some Si may be replaced with Al or Na).

(Green Phosphor)

An appropriate wavelength range of the emission peak wavelength of the green phosphor is normally 500 nm or more and 550 nm or less, preferably 510 nm or more and 542 nm or less, or more preferably 515 nm or more and 535 nm or less. From this point of view, as the green phosphor, for example, the following are preferable: $Y_3(Al,Ga)_5O_{12}$:Ce; $CaSc_2O_4$:Ce; $Ca_3(Sc,Mg)_2Si_3O_{12}$:Ce; $(Sr,Ba)_2SiO_4$:Eu; $(Si,Al)_6(O,N)_8$:Eu($\beta$-sialon); $(Ba,Sr)_3Si_6O_{12}$:$N_2$:Eu; $SrGa_2S_4$·Eu, $BaMgAl_{10}O_{17}$:Eu; and Mn.

(Yellow Phosphor)

An appropriate wavelength range of the emission peak wavelength of the yellow phosphor is normally 530 nm or more and 620 nm or less, preferably 540 nm or more and 600 nm or less, or more preferably 550 nm or more and 580 nm or less. From this point of view, as the yellow phosphor, for example, the following are preferable: $Y_3Al_5O_{12}$:Ce; $(Y,Gd)_3Al_6Oi_2$:Ce; $(Sr,Ca,Ba,Mg)_2SiO_4$:Eu; $(Ca,Sr)Si_2N_2O_2$:Eu; $\alpha$-sialon; and $La_3Si_6N_{11}$:Ce (here, a part thereof may be replaced with Ca or O).

(Orange Phosphor)

The orange phosphor, of which the emission peak wavelength is in the range of 580 nm or more and 620 nm or less or preferably in the range of 590 nm or more and 610 nm or less, can be appropriately used instead of the red phosphor. Examples of such an orange phosphor include: $(Sr,Ba)_3SiO_5$:Eu; $(Sr,Ba)_2SiO_4$:Eu; $(Ca,Sr,Ba)_2Si_5(N,O9)_8$:Eu; $(Ca,Sr,Ba)AlSi(N,O)_3$:Ce; and the like.

Further, the first wavelength conversion region P1 and the second wavelength conversion region P2 are different in the mass and the mixture ratio of the red phosphor, the green phosphor, and the yellow phosphor. Accordingly, the ratios of the red light, the green light, and the yellow light, which are emitted from the first wavelength conversion region P1 through the wavelength conversion, to the blue light, which is emitted without the wavelength conversion, and the ratios of the red light, the green light, and the yellow light, which are emitted from the second wavelength conversion region P2 through the wavelength conversion, to the blue light, are different from each other. Hence, there are differences among color temperatures of: the white light, which is the first-order light formed by synthesizing the red light, green light, yellow light, and blue light emitted from the first wavelength conversion region P1; and the white light, which is the first-order light formed by synthesizing the red light, green light, yellow light, and blue light emitted from the second wavelength conversion region P2.

Note that, the numbers of phosphors, which are held in a distributed manner in the first wavelength conversion region P1 and the second wavelength conversion region P2, may be different from each other. For example, the red phosphor is held in a distributed manner only in the first wavelength conversion region P1, whereby the color temperatures of the first-order light respectively emitted from the first wavelength conversion region P1 and the second wavelength conversion region P2 are made to be different from each other.

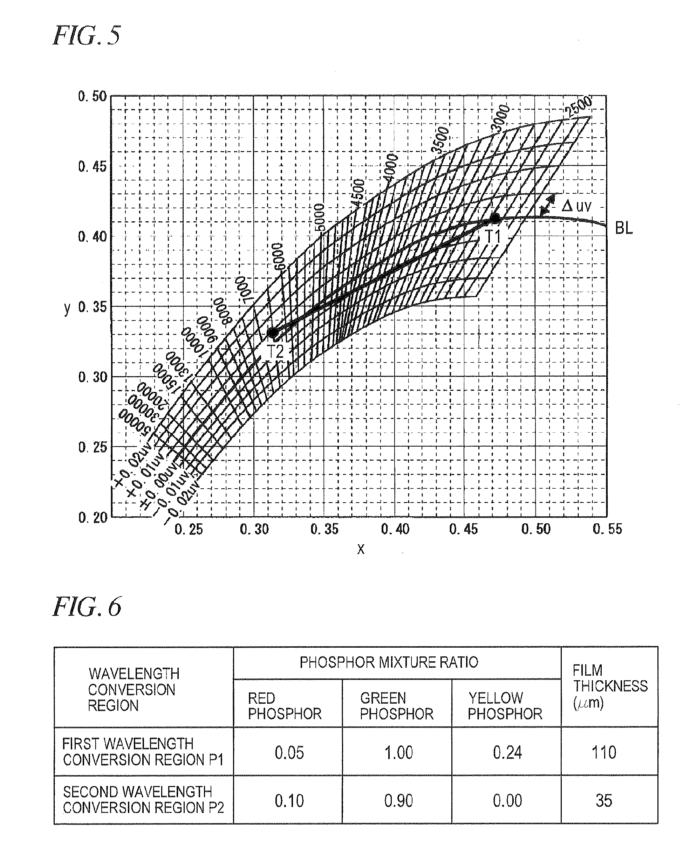

Next, referring to Fig. 5, a description will be given of a method of defining the mixture ratio of the phosphors in the first wavelength conversion region P1 and the second wavelength conversion region P2. Fig. 5 is an enlarged diagram of a principal section around the black-body radiation locus BL in the xy chromaticity diagram of the CIE (1931) XYZ color coordinate system. In the present example, the mixture ratio of the red phosphor, the green phosphor, and the yellow phosphor in the first wavelength conversion region P1 is determined such that the first-order light, which is emitted from the first light emitting unit U1 formed of the first LED group D1 and the first wavelength conversion region P1, has the chromaticity of the chromaticity point T1 (about 2700 K) of Fig. 5. Further, the mixture ratio of the red phosphor, the green phosphor, and the yellow phosphor in the second wavelength conversion region P2 is determined such that the first-order light, which is emitted from the second light emitting unit U2 formed of the second LED group D2 and the second wavelength conversion region P2, has the chromaticity of the chromaticity point T2 (about 6500 K) of Fig. 5.

Note that, the y value of the CIE (1931) XYZ color coordinate system at any chromaticity point of the first-order light, which is emitted from each of the first light emitting unit U1 and the second light emitting unit U2, is preferably equal to or less than 0.65. When the y value is greater than 0.65, the takeoff efficiency of the visible light of each light emitting unit deteriorates, and it is difficult for the overall light emission apparatus to efficiently emit light. On the other hand, when LED chips emitting near-ultraviolet light to be described later are used instead of the LED chips 3 emitting the blue light, there is no trouble even if the y value is greater than 0.65.

By determining the mixture ratio of the phosphors in each wavelength conversion region in the above-mentioned method, it is possible to make the color temperature of the first-order light emitted from the second light emitting unit U2 higher than the color temperature of the first-order light emitted from the first light emitting unit U1.

In the present example, as the red phosphor, $(Sr, Ca)_1AlSiN_3:Eu$ is used, as the green phosphor, $Ca_3(Sc, Mg)_2Si_3O_{12}:Ce$ is used, and as the yellow phosphor, $Y_3Al_5O_{12}:Ce$ is used. Further, as shown in Fig. 6, the mixture ratio of the phosphors in the first wavelength conversion region P1 is set such that red phosphor: green phosphor: yellow phosphor = 0.24: 1: 0.05, and the mixture ratio of the phosphors in the second wavelength conversion region P2 is set such that red phosphor: green phosphor: yellow phosphor = 0: 0.9: 0.1.

Furthermore, the first wavelength conversion region P1 and the second wavelength conversion region P2 have different film thicknesses. Specifically, as shown in Fig. 6, the film thickness of the first wavelength conversion region P1 is 110 $\mu$m, and the film thickness of the second wavelength conversion region P2 is 35 $\mu$m.

(Electric Circuit Configuration of Light Emission apparatus)

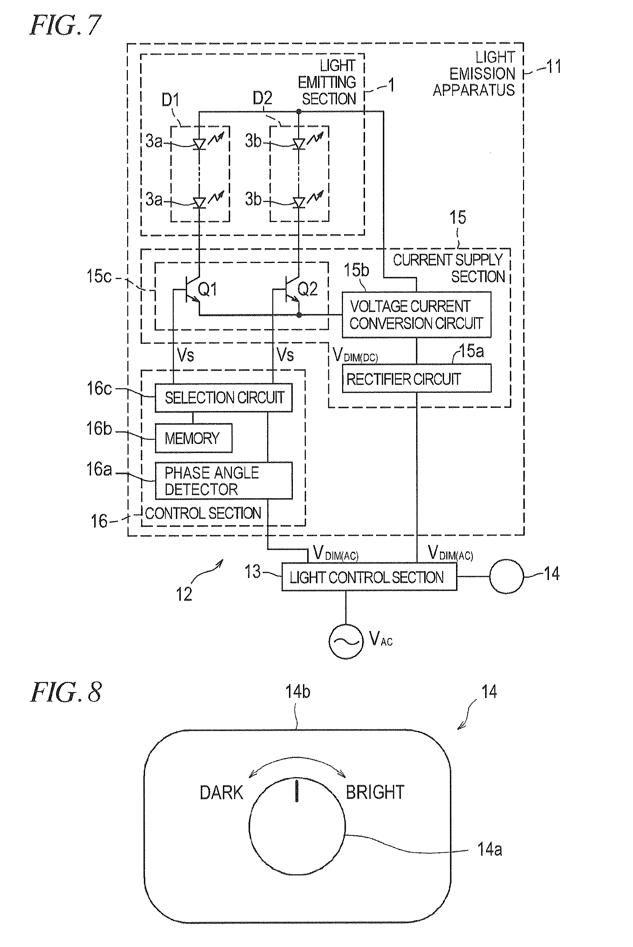

As described above, in the light emission apparatus of the present example, the color temperatures of the first-order light, which are respectively emitted from the first light emitting unit U1 and the second light emitting unit U2, are set to be different from each other, and the synthetic white light, which is generated by synthesizing the first-order light emitted from the light emitting units, is emitted from the light emission apparatus. Accordingly, in the light emission apparatus of the present example, by changing the total luminous flux (that is, emission intensity or luminance) of the first-order light emitted from each of the first light emitting unit U1 and the second light emitting unit U2, the total luminous flux of the synthetic white light emitted from the light emission apparatus is adjusted, and the color temperature of the synthetic white light is changed in accordance with the corresponding total luminous flux of the synthetic white light so as to emit the synthetic white light with the color temperature appropriate for the desired total luminous flux and the corresponding total luminous flux mentioned above. Description will be given below of the electric circuit of the light emission apparatus configured to emit the synthetic white light with the color temperature appropriate for the above-mentioned desired intensity and corresponding total luminous flux, with reference to Fig. 7.

Fig. 7 is an electric circuit diagram illustrating an overview of an electric circuit configuration of a light emission apparatus 11 and an illumination system 12 according to the present example. As shown in Fig. 7, the illumination system 12 has the light emission apparatus 11 that is one of various kinds of illumination mechanisms such as an electric bulb and a halogen lamp, a light control section 13 that is connected to the light emission apparatus 11, and an instruction section 14 that is connected to the light control section 13. Further, the light emission apparatus 11 includes the light emitting section 1, a current supply section 15, and a control section 16.

The light emitting section 1 has the LED chips 3a of the first LED group D1 and the LED chips 3b of the second LED group D2. In specific configurations of the first LED group D1 and the second LED group D2, the 10 LED chips 3a of the first LED group D1 are connected to one another in series such that the polarities thereof are the same. Likewise, the 10 LED chips 3b of the second LED group D2 are also connected to one another in series such that the polarities thereof are the same. Further, the first LED group D1 and the second LED group D2 are connected in parallel through a switch circuit 15c to be described later. Note that, the connection form of the LED chips 3 in the same LED group is not limited to serial connection, and may be, for example, parallel connection in which the LED chips 3 are connected to one another in parallel such that the polarities thereof are the same.

The light control section 13 is connected to the instruction section 14, the current supply section 15, the control section 16, and an alternating current voltage source $V_{AC}$. The light control section 13 controls the conduction phase angle of the waveform of the alternating current voltage supplied from the alternating current voltage source $V_{AC}$ in response to an instruction signal (signal representing the light control level) supplied from the instruction section 14, thereby generating the alternating-current light control voltage $V_{DIM(AC)}$. Further, the light control section 13 supplies the generated light control voltage $V_{DIM(AC)}$ to the current supply section 15 and the control section 16. For example, the light control section 13 is a light control circuit formed by a triac (bidirectional thyristor) used as a phase control element.

Here, the light control level can be represented by the following expression.

$$[\text{Numerical Expression 1}]$$
$$\text{Light Control Level} = (1 - \text{Actual Supply Current} / \text{Maximum Supply Current}) \times 100$$

The maximum supply current is a maximum current which is supplied to the light emission apparatus 11 (more specifically, the light emitting section 1), and the actual supply current is a current which is practically supplied to the light emission apparatus 11 (more specifically, the light emitting section 1). That is, when the light control level is 0%, the maximum current is supplied to the light emitting section 1, and as the light control level increases, the amount of current supplied to the light emitting section 1 decreases.

The instruction section 14 includes, as shown in Fig. 8: an operation dial 14a by which a user operates the light emission apparatus 11 according to the present example; and a main body 14b in which an electric circuit (not shown in the drawing) for generating the instruction signal by detecting the operation position of the operation dial 14a and transmitting the corresponding instruction signal to the light control section 13 is built. The operation dial 14a can be rotated by user's operation. As shown in Fig. 8, on the main body 14b, there is an indication to the effect that the total luminous flux (emission intensity or luminance) of the synthetic white light emitted from the light emission apparatus 11 can be increased as the operation dial 14a is rotated clockwise. The operation dial 14a may be formed to be rotated stepwise in accordance with the indications on the main body 14b, and may be formed to be continuously rotated.

The current supply section 15 is formed of a rectifier circuit 15a, a voltage current conversion circuit 15b, and the switch circuit 15c. The rectifier circuit 15a is a full-wave rectifier circuit formed of four diodes, or a half-wave rectifier circuit formed of a single diode. The rectifier circuit 15a is connected to the light control section 13, and converts the alternating-current light control voltage $V_{DIM(AC)}$, which is supplied from the light control section 13, into the direct-current light control voltage $V_{DIM(DC)}$. The voltage current conversion circuit 15b converts the direct-current light control voltage $V_{DIM(DC)}$, which is supplied from the rectifier circuit 15a, into the driving currents which are supplied to the LED chips 3. Accordingly, the driving current increases or decreases in accordance with the conduction phase angle. The switch circuit 15c includes transistors Q1 and Q2. Each collector of the transistors Q1 and Q2 is connected to a terminal closest to a cathode of each of the first LED group D1 and the second LED group D2, each emitter of the transistors Q1 and Q2 is connected to the voltage current conversion circuit 15b, and each base of the transistors Q1 and Q2 is connected to the control section 16. Note that, the current supply section 15 may provide AC driving currents to the LED chips 3 without the rectifier circuit 15a. In this case, the LED chips 3 periodically emit light.

Due to the configuration and the connection relationship of the light control section 13, the instruction section 14, and the current supply section 15 mentioned above, it is possible to adjust the amount of driving current (the amount of supply current), which is supplied to the LED chips 3, only by rotating the operation dial 14a. In addition, by adjusting the amount of supply current supplied to the light emitting section 1, it is possible to emit (that is, control) the synthetic white light with the desired total luminous flux from the light emission apparatus 11.

The control section 16 includes a phase angle detector 16a, a memory 16b, and a selection circuit 16c. The phase angle detector 16a is connected to the light control section 13, and detects the conduction phase angle controlled by the light control section 13. The memory 16b stores voltage value data on the value of the voltage to be supplied to the bases of the transistors Q1 and Q2 in accordance with the conduction phase angle. Here, the voltage value data is not data for only turning on or off the transistors Q1 and Q2, but data for changing the magnitude of the driving currents, which are respectively supplied to the first LED group D1 and the second LED group D2 from the voltage current conversion circuit 15b, by changing the voltage values of the base voltages $V_S$ applied to the bases of the transistors Q1 and Q2. The selection circuit 16c cross-checks the conduction phase angle, which is detected by the phase angle detector 16a, with the voltage value data stored in the memory, and determines the voltage values of the base voltages Vs applied to the transistors Q1 and Z2. Then, the selection circuit 16c applies the base voltages Vs with the determined voltage values to the bases of the transistors Q1 and Q2.

As described above, the control section 16 independently turns on the transistors Q1 and Q2 in accordance with the alternating-current light control voltage $V_{DIM(AC)}$. Thus, it is possible to emit the first-order light from both of the light emitting unit U1 and the light emitting unit U2 or either one of the light emitting unit U1 and the light emitting unit U2, in accordance with the total luminous flux of the synthetic white light emitted from the light emitting section 1. Further, the control section 16 changes the voltage values of the base voltages Vs applied to the bases of the transistors Q1 and Q2 in response to the light control level so as to change the magnitudes of the driving currents respectively supplied to the first LED group D 1 and the second LED group D2 from the voltage current conversion circuit 15b. Hence, it is possible to adjust the total luminous flux of the first-order light emitted from the light emitting unit U1 and the light emitting unit U2. In addition, as described above, the first wavelength conversion region P1 and the second wavelength conversion region P2 are different from each other in the weights, the mixture ratios, and the film thicknesses of the phosphors. Hence, the color temperatures of the first-order light emitted from the first wavelength conversion region P1 and the second wavelength conversion region P2 are different. Therefore, in the light emission apparatus 11 according to the present example, when the light control level is changed in order to obtain the desired total luminous flux, it is also possible to change the color temperature of the synthetic white light emitted from the light emission apparatus 11 in accordance with the corresponding light control level.

(Control of Light Emitting Section)

When a user of the light emission apparatus 11 operates the operation dial 14a, the main body 14b of the instruction section 14 detects the position of the operation dial 14a, and supplies the instruction signal (signal representing the light control level) based on the detected position of the operation dial 14a to the light control section 13. The light control section 13 controls the conduction phase angle of the waveform of the alternating current voltage, which is supplied from the alternating current voltage source $V_{AC}$, on the basis of the instruction signal supplied from the instruction section 14, thereby generating the alternating-current light control voltage $V_{DIM(AC)}$. In a specific control method, the light control section 13 inputs a trigger pulse with an arbitrary phase difference relative to the zero cross point of the sinusoidal waveform of the alternating current supplied from the alternating current voltage source so as to control the conduction phase angle. Accordingly, when the supplied instruction signal is changed, the light control section 13 controls the conduction phase angle by changing the phase difference of the trigger pulse in accordance with the change.

The rectifier circuit 15a of the current supply section 15 converts the alternating-current light control voltage $V_{DIM(AC)}$, which is supplied from the light control section 13, into the direct-current light control voltage $V_{DIM(DC)}$, and supplies the corresponding direct-current light control voltage $V_{DIM(DC)}$ to the voltage current conversion circuit 15b. The voltage current conversion circuit 15b converts the direct-current light control voltage $V_{DIM(DC)}$, which is supplied from the rectifier circuit 15a, into the driving currents to be supplied to the LED chips 3, and supplies the corresponding driving currents to the first LED group D1 and the second LED group D2. Accordingly, in accordance with the conduction phase angle of the alternating-current light control voltage $V_{DIM(AC)}$, the driving current increases or decreases.

The control section 16 controls the voltage values of the base voltages Vs applied to the bases of the transistors Q1 and Q2 while selectively turning on the transistors Q1 and Q2 in response to the alternating-current light control voltage $V_{DIM(AC)}$ which is supplied from the light control section 13, thereby controlling the magnitude of the driving current flowing for each LED group. Here, when the same voltages are applied to the bases of the transistors Q1 and Q2, the amounts of the driving currents flowing in the first LED group D1 and the second LED group D2 are equal. Further, when the base voltages Vs are not applied to the bases of the transistors Q1 and Q2, the transistors Q1 and Q2 are not turned on. Hence, even when the driving currents are supplied from the voltage current conversion circuit 15b to the first LED group D1 and the second LED group D2, the driving currents do not flow in the first LED group D1 and the second LED group D2, and the LED chips 3 do not emit light. In the present example, when the base voltages Vs are gradually increased from the state where the base voltages Vs are not applied, the transistor Q1 is turned on.

A specific control method of the control section 16 of the present example is as follows. The phase angle detector 16a of the control section 16 detects the conduction phase angle, which is controlled by the light control section 13, from the light control voltage $V_{DIM(AC)}$ supplied from the light control section 13. Specifically, the phase angle detector 16a detects the conduction phase angle from the voltage waveform (control signal) of the light control voltage $V_{DIM(AC)}$. The phase angle detector 16a supplies the data signal, which represents the detected conduction phase angle, to the selection circuit 16c. The selection circuit 16c cross-checks the voltage value data, which is stored in the memory 16b, with the data signal, which represents the supplied conduction phase angle, in order to determine the voltage values of the base voltages Vs applied to the bases of the transistors Q1 and Q2 in accordance with the supplied conduction phase angle. Then, the selection circuit 16c applies the base voltages Vs, which have the voltage values determined through the cross-checking, to the bases of the transistors Q1 and Q2. Thereby, either one or both of the transistors Q1 and Q2 are turned on, and the magnitudes of the driving currents, which are supplied to the first LED group D1 and the second LED group D2, are controlled in accordance with the voltage values of the base voltages Vs which are applied to the bases of the transistors Q1 and Q2, and the first-order light with the total luminous flux corresponding to the light control level and the color temperature corresponding to each wavelength conversion region is emitted from either one or both of the first light emitting unit U1 and the second light emitting unit U2.

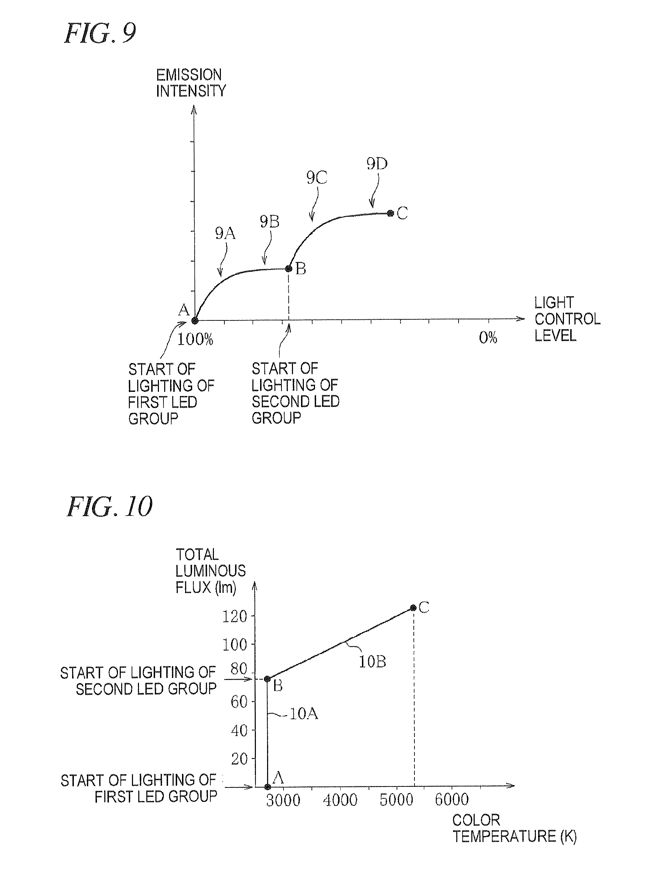

Next, referring to Figs. 9 and 10, a description will be given of how to apply the base voltages Vs to the bases of the transistors Q1 and Q2 and control the magnitudes of the driving currents, which are supplied to the first LED group D1 and the second LED group D2, in order to emit the synthetic white light with the color temperature appropriate for the desired total luminous flux and the corresponding total luminous flux from the light emission apparatus 11. Fig. 9 is a graph illustrating a relationship between the light control level of the light control section 13 and the emission intensity of the synthetic white light emitted from the light emission apparatus 11. Fig. 10 is a graph illustrating a relationship between the color temperature (unit: Kelvin (K)) and the total luminous flux of the synthetic white light (unit: Lumen (lm)) emitted from the light emission apparatus 11.

First, when lighting of the LED groups is started such that the darkest synthetic white light is emitted from the light emission apparatus 11 by operating the operation dial 14a, only the transistor Q1 is turned on, and the first-order light is emitted from the first light emitting unit U1. That is, at this time, the synthetic white light, which is emitted from the light emission apparatus 11, is formed of only the first-order light emitted from the first light emitting unit U1. In Figs. 9 and 10, the start of the lighting of the corresponding first LED group D1 is indicated by the point A.

When the light is controlled (that is, the light control level is lowered) such that the further bright synthetic white light is emitted by further operating the operation dial 14a, the driving current supplied to the first LED group D1 increases, and the total luminous flux of the first-order light, which is emitted from the first light emitting unit U1, increases. The increase of the total luminous flux corresponds to the curve portion 9A on the graph of Fig. 9. Further, since the ratio of synthesis of the phosphors is adjusted such that the color temperature of the first-order light emitted from the first light emitting unit U1 is set to about 2700 K, when the first-order light is emitted from only the first light emitting unit U1, the color temperature of the synthetic white light emitted from the light emission apparatus 11 is maintained at about 2700 K. The solid line 10A of Fig. 10 indicates that the total luminous flux increases while the color temperature is maintained.

When the light control level is further lowered by further operating the operation dial 14a, the voltage value of the base voltage Vs, which is applied to the base of the transistor Q1, is controlled by the control section 16 such that the driving current flowing in the first LED group D 1 is not increased, and thus the total luminous flux of the first-order light, which is emitted from the first light emitting unit U1, is not increased. The state where the total luminous flux is not increased is defined as a full lighting state of the first light emitting unit U1. The state where the total luminous flux is not increased corresponds to the straight line portion 9B on the graph of Fig. 9. As described above, the reason why the total luminous flux is not increased is to prevent the LED chips 3 from being heated by the excessive driving current.

In the state where the increase in the total luminous flux of the synthetic white light mentioned above is suppressed, when the light control level is further lowered by further operating the operation dial 14a, the transistor Q2 is also turned on so as to start lighting of the second LED group, and thereby the first-order light is also emitted from the second light emitting unit U2. At this time, the control section 16 applies the base voltage $V_S$ to the base of the transistor Q1 so as to maintain the full lighting state of the first light emitting unit U1 In Figs. 9 and 10, the corresponding state is indicated by the point B.

When the light control level is further lowered by further operating the operation dial 14a from the start of lighting of the second LED group, the base voltages Vs are applied to the bases of the transistors Q1 and Q2 such that the total luminous flux of the first-order light emitted from the second light emitting unit U2 is increased while the full lighting state of the first light emitting unit U1 is maintained. The increase of the total luminous flux corresponds to the curve portion 9C on the graph of Fig. 9. Further, since the ratio of synthesis of the phosphors is adjusted such that the color temperature of the first-order light emitted from the second light emitting unit U2 is set to about 6500 K, when the total luminous flux of the first-order light emitted from the second light emitting unit U2 is increased, the color temperature of the synthetic white light emitted from the light emission apparatus 11 is increased to be close to 6500 K. The solid line 10B of Fig. 10 indicates that the color temperature is increased.

When the light control level is further lowered by further operating the operation dial 14a, the voltage value of the base voltage Vs, which is applied to the base of the transistor Q2, is controlled by the control section 16 such that not only the driving current flowing in the first LED group D1 but also the driving current flowing in the second LED group D2 is not increased, and thus the total luminous flux of the first-order light, which is emitted from the second light emitting unit U2, is not increased. That is, the second light emitting unit U2 also reaches the full lighting state. The full lighting state of the first light emitting unit U1 and the second light emitting unit U2 corresponds to the straight line portion 9D on the graph of Fig. 9. In addition, in the full lighting state of the first light emitting unit U1 and the second light emitting unit U2, the color temperature of the synthetic white light emitted from the light emission apparatus 11 does not reach 6500 K, but reaches about 5300 K (the point C of Figs. 9 and 10).

In the above-mentioned control, the transistors Q1 and Q2 are independently turned on in accordance with the light control level. Hence, it is possible to control the timing of the start of the light emission of the LED chips 3a constituting the first LED group D1 and the timing of the start of the light emission of the LED chips 3b constituting the second LED group D2, in accordance with the light control level. That is, in the light emission apparatus 11 of the present example, it is possible to independently control the timing (light start timing) of lighting the first LED group D1 and the second LED group D2 in accordance with the light control level. In other words, in the light emission apparatus 11 of the present example, the timing of starting to supply the driving current is different for each LED group. Thus, the corresponding timing of starting to supply the current is set as a current supply start light control level for each LED group in accordance with the light control level, and the LED group to be lighted on is selected on the basis of the relationship between the instruction signal (signal representing the light control level) supplied from the instruction section 14 and the corresponding current supply start light control level.

Further, when the first light emitting unit U1 reaches the full lighting state by starting to light the first LED group D1, lighting of the second LED group D2 is started. That is, as the amount of current supplied to the first LED group D1 is increased, the lighting of the second LED group D2 is started. Then, while the total luminous flux of the first-order light emitted from the second light emitting unit U2 increases, the full lighting state of the first light emitting unit U1 is maintained. Hence, after the start of the lighting of the second LED group D2, in accordance with the increase in the total luminous flux of the synthetic white light emitted from the light emission apparatus 11, the color temperature of the synthetic white light is made to be close to the color temperature of the first-order light emitted from the second light emitting unit U2 (that is, the color temperature is increased). Generally, when the total luminous flux is low, the white light (that is, the light emitted from the filament electric bulb) with a low color temperature is preferred, and when the total luminous flux is high, the white light (that is, the light emitted from the fluorescent lamp) with a high color temperature is preferred. Accordingly, in the light emission apparatus 11 and the illumination system 12 according to the present example, in accordance with the increase in the total luminous flux of the synthetic white light, the color temperature is simultaneously controlled. Thereby, it is possible to emit the synthetic white light with the color temperature appropriate for the desired total luminous flux and the corresponding total luminous flux.

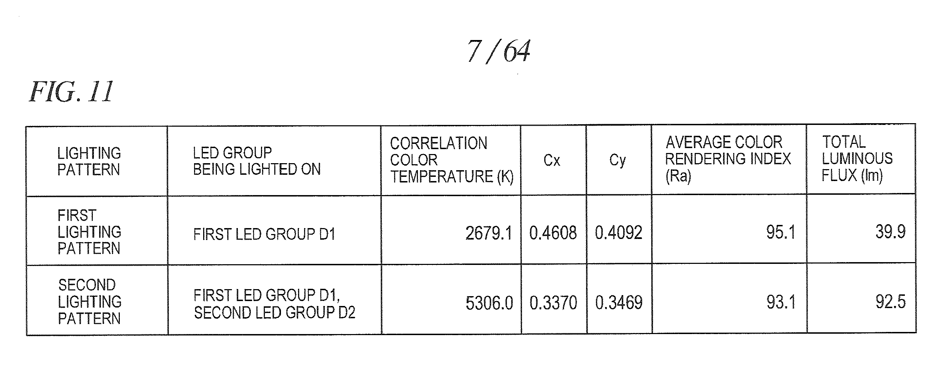

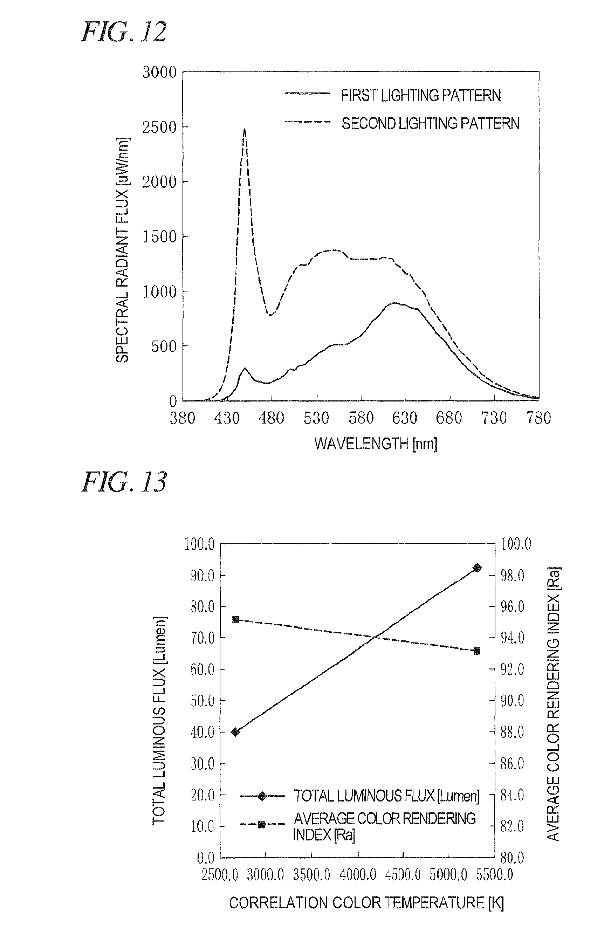

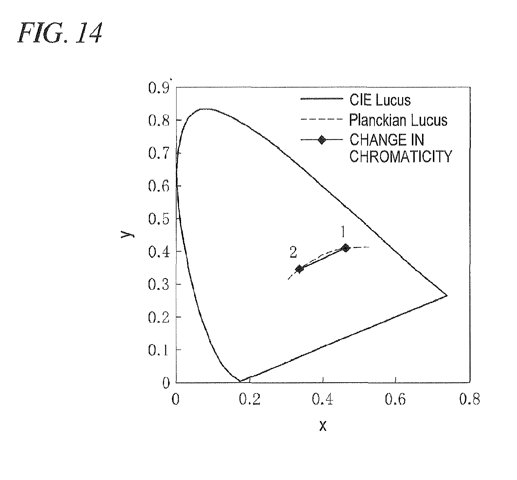

Figs. 11 to 14 show results of ray-tracing simulations of the light emission apparatus of the present example. Fig. 11 shows the correlation color temperatures of the synthetic white light which is emitted from the light emission apparatus 11, the Cx and Cy values based on the CIE1931, average color rendering indices, and simulation results of the total luminous fluxes in the pattern (first lighting pattern), in which only the first LED group D 1 is lighted on, and the pattern (second lighting pattern) in which the first LED group D1 and the second LED group D2 are lighted on. Fig. 12 is a graph illustrating spectral radiant flux spectra of the synthetic white light, which is emitted from the light emission apparatus 11, in the first lighting pattern and the second lighting pattern. Fig. 13 is a graph illustrating change of the total luminous flux relative to the correlation color temperature and change of the average color rendering index relative to the correlation color temperature, where the simulation result of the correlation color temperature shown in Fig. 11 is indicated by the horizontal axis, the simulation result of the total luminous flux is indicated by the first vertical axis, and the average color rendering index is indicated by the second vertical axis, in the first lighting pattern and the second lighting pattern. Fig. 14 is a graph illustrating the simulation results of the Cx and Cy values of the synthetic white light, which is emitted from the light emission apparatus 11 according to the present example, on the color temperature coordinates of the CIE 1931, in the first lighting pattern and the second lighting pattern.

(Modified Examples of Pattern Shapes of LED Groups and Wavelength Conversion Regions)

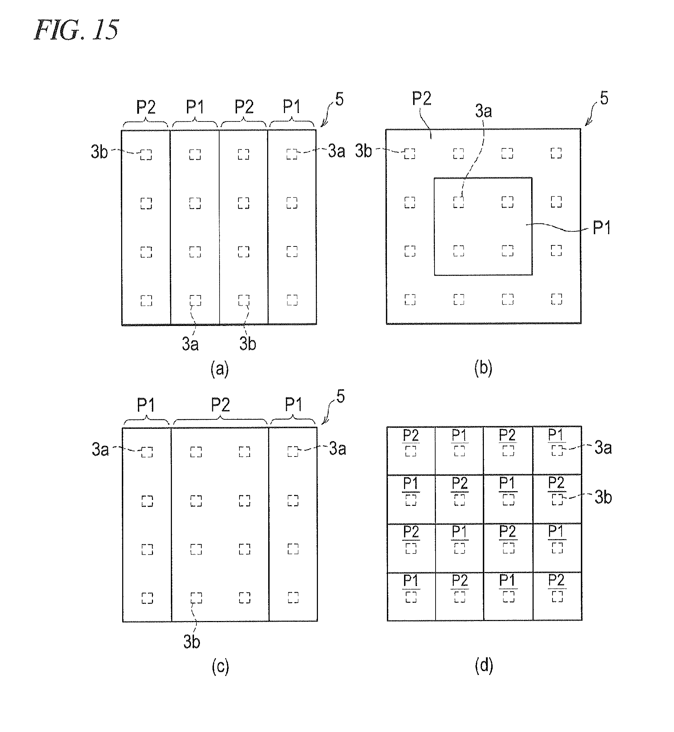

In the above-mentioned example, the fluorescent member 5 is divided into one first wavelength conversion region P1 having a rectangular shape, and one second wavelength conversion region P2 having a rectangular shape, but the invention is not limited to this. For example, as shown in Figs. 15(a) to 15(b), the fluorescent member 5 may be divided into the first wavelength conversion region P1 and the second wavelength conversion region P2. In addition, Figs. 15(a) to 15(d) show the case where 16 LED chips 3 are arranged in a matrix with 4 rows and 4 columns.

As shown in Fig. 15(a), the fluorescent member 5 is divided into two first wavelength conversion regions P1 having rectangular shapes and two second wavelength conversion regions P2 having rectangular shapes. The first wavelength conversion regions P1 and the second wavelength conversion regions P2 may be arranged alternately (that is, to have stripe shapes). Further, each of the alternately arranged first wavelength conversion regions P1 and second wavelength conversion regions P2 having rectangular shapes has the same area in plan view of Fig. 15(a), and has the same planar shape. Furthermore, although not represented by reference signs and numerals, the first LED groups D1 formed of the LED chips 3a and the second LED groups D2 formed of the LED chips 3b are also alternately divided, and the first LED groups D1 are opposed to the first wavelength conversion regions P1 and the second LED groups D2 are opposed to the second wavelength conversion regions P2. Accordingly, the four LED chips 3a are provided to be opposed to one first wavelength conversion region P1, and four LED chips 3b are provided to be opposed to one second wavelength conversion region P2.

The four LED chips 3a arranged in one first LED group D1 may be connected in series, or may be connected in parallel. Further, the two first LED groups D1 opposed to the two first wavelength conversion regions P1 separately divided may be connected in series, or may be connected in parallel. Likewise, the four LED chips 3b arranged in one second LED group D2 may be connected in series, or may be connected in parallel. Furthermore, the two second LED groups D2 opposed to the two second wavelength conversion regions P2 separately divided may be connected in series, or may be connected in parallel.

As shown in Fig. 15(b), the fluorescent member 5 is divided into one first wavelength conversion region P1 having a square shape and one second wavelength conversion region P2 having an annular shape. The first wavelength conversion region P1 and the second wavelength conversion region P2 may be disposed such that outer periphery portion of the first wavelength conversion region P1 is surrounded by the second wavelength conversion region P2. Further, although not represented by reference signs and numerals, a plurality of LED chips 3 are also grouped into the first LED group D1 having a square shape and the second LED group having an annular shape. The second LED group D2 is disposed to surround the first LED group D1. The first LED group D1 is opposed to the first wavelength conversion region P1, and the second LED group D2 is opposed to the second wavelength conversion region P2. Accordingly, the four LED chips 3a are provided so as to be opposed to the first wavelength conversion region P1, and the twelve LED chips 3b are provided so as to be opposed to the second wavelength conversion region P2.

The four LED chips 3a arranged in the first LED group D1 may be connected in series, or may be connected in parallel. Likewise, the twelve LED chips 3b arranged in the second LED group D2 may be connected in series, or may be connected in parallel.

As shown in Fig. 15(c), the fluorescent member 5 is divided into two first wavelength conversion regions P1 having rectangular shapes and one second wavelength conversion region P2 having a rectangular shape. The first wavelength conversion regions P1 and the second wavelength conversion region P2 may be disposed such that the second wavelength conversion region P2 is interposed between the two first wavelength conversion regions P1. Each of the two first wavelength conversion regions P1 has the same area, and has the same planar shape. Further, the area of the second wavelength conversion region P2 in plan view of Fig. 15(c) is two times the area of the first wavelength conversion region P1 in plan view. Furthermore, although not represented by reference signs and numerals, the first LED groups D1 formed of LED chips 3a are disposed such that the second LED group D2 formed of the LED chips 3b is interposed therebetween. The first LED groups D1 are opposed to the first wavelength conversion regions P1, and the second LED group D2 is opposed to the second wavelength conversion region P2. Accordingly, the four LED chips 3a are provided to be opposed to one first wavelength conversion region P1, and the eight LED chips 3b are provided to be opposed to the second wavelength conversion region P2.

The four LED chips 3a arranged in one first LED group D1 may be connected in series, or may be connected in parallel. Further, the two first LED groups D1 opposed to the two first wavelength conversion regions P1 separately divided may be connected in series, or may be connected in parallel. Likewise, the eight LED chips 3b arranged in the second LED group D2 may be connected in series, or may be connected in parallel.

A shown in Fig. 15(d), the fluorescent member 5 is divided in a lattice shape. Eight first wavelength conversion regions P1 having square shapes and eight second wavelength conversion regions P2 having square shapes may be alternately arranged. Further, each of the alternately arranged first wavelength conversion regions P1 and second wavelength conversion regions P2 having rectangular shapes has the same area in plan view of Fig. 15(a), and has the same planar shape. That is, the first wavelength conversion region P1 and the second wavelength conversion region P2 are arranged in a checkered pattern. Furthermore, although not represented by reference signs and numerals, the first LED groups D1 formed of the LED chips 3a and the second LED groups D2 formed of the LED chips 3b are also alternately divided, and the first LED groups D1 are opposed to the first wavelength conversion regions P1 and the second LED groups D2 are opposed to the second wavelength conversion regions P2. That is, the first LED groups D1 and the second LED groups D2 are also arranged in a checkered pattern in a similar manner to the first wavelength conversion region P1 and the second wavelength conversion region P2. Accordingly, each one LED chip 3a is provided to be opposed to each one first wavelength conversion region P1, and each one LED chip 3b is provided to be opposed to each one second wavelength conversion region P2.

The LED chips 3a disposed in the first LED groups D1 may be connected in series, or may be connected in parallel. Likewise, the LED chips 3b disposed in the second LED groups D2 may be connected in series, or may be connected in parallel.

(Modified Example of Light Emitting Section)

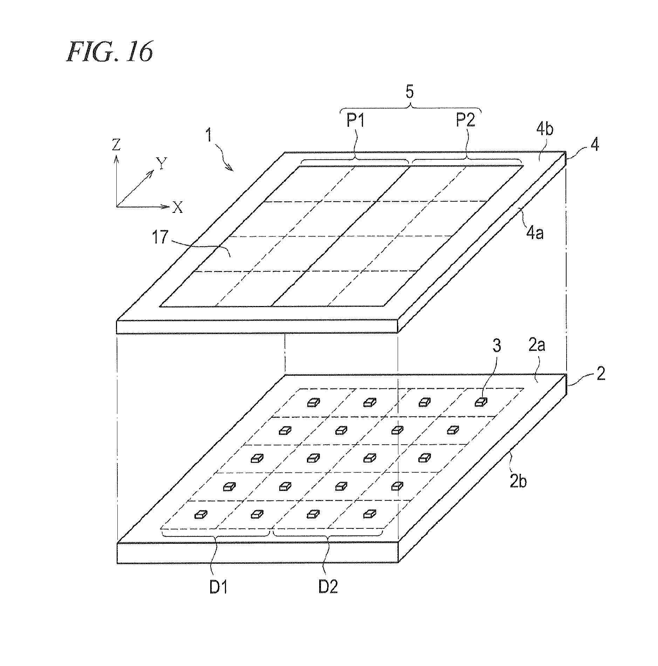

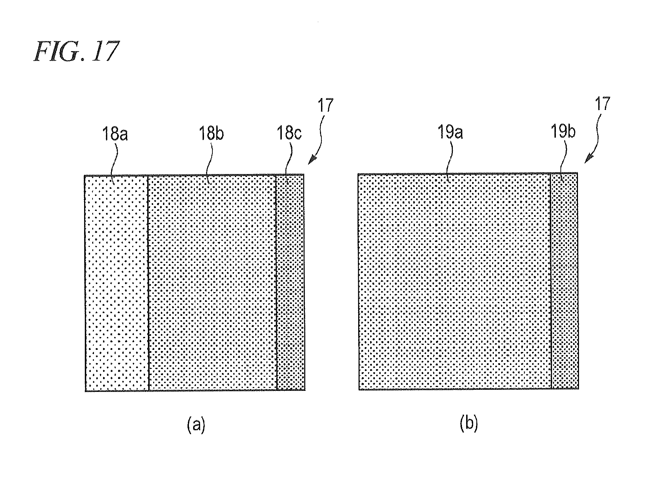

Regarding the fluorescent member 5, in the present example, in either one of the first wavelength conversion region P1 and the second wavelength conversion region P2 of the fluorescent member 5, three type phosphors of the red phosphor, green phosphor, and blue phosphor are mixed, and are held in a distributed manner. However, instead of distributive holding, as shown in Figs. 16, 17(a), and 17(b), each of the first wavelength conversion region P1 and the second wavelength conversion region P2 may be divided into a plurality of cell regions 17 each corresponding to one LED chip 3, and the red phosphor, the green phosphor, and the yellow phosphor may be separately disposed for each cell region 17.

Fig. 16 is a perspective view illustrating an overview of an overall configuration of the light emitting section 1 in the case where the first wavelength conversion region P1 and the second wavelength conversion region P2 are divided into the plurality of cell regions 17. Fig. 17(a) shows a phosphor portion of the cell region 17 in the first wavelength conversion region P1. Fig. 17(b) shows a phosphor portion of the cell region 17 in the second wavelength conversion region P2. In Fig. 17(a), in order from the left side of the drawing, the red phosphor 18a, the green phosphor 18b, and the yellow phosphor 18c are separately provided. Note that, in Fig. 17(a), in order to distinguish emission colors of the respective phosphors, the respective phosphors are represented by dot hatch patterns. In the cell regions 17 in the first wavelength conversion region P1, by adjusting the area ratio of three type phosphors, the first-order light with the color temperature of 2700°K is emitted from each cell region 17. In Fig. 17(b), in order from the left side of the drawing, the green phosphor 19a and the yellow phosphor 19b are separately provided. Note that, in Fig. 17(b), in order to distinguish emission colors of the respective phosphors, the respective phosphors are represented by dot hatch patterns. In the cell regions 17 in the second wavelength conversion region P2, by adjusting the area ratio of two type phosphors, the first-order light with the color temperature of 6500°K is emitted from each cell region 17. In such a manner, even when the cell regions 17 are formed by dividing the first wavelength conversion region P1 and the second wavelength conversion region P2, it is possible to obtain the same effects as the above-mentioned light emission apparatus. Note that, combination of phosphors in the cell region 17 is not limited to the above description, and may be appropriately changed in accordance with the emitted first-order light.

Further, when the red phosphor, the green phosphor, and the yellow phosphor are mixed, distributed, and held, there is an effect that light can be satisfactorily synthesized and emitted in the respective fluorescent regions. However, there is a possibility that cascade excitation is caused by mixing of the red phosphor, the green phosphor, and the yellow phosphor in one fluorescent region. Therefore, as described above, by separately arranging the red phosphor, the green phosphor, and the yellow phosphor, it is possible to satisfactorily prevent cascade excitation. On the other hand, in terms of synthesis of the radiant light from each phosphor, in each cell region 17, although inferior to the case where the red phosphor, the green phosphor, and the yellow phosphor are mixed, distributed, and held, even in the case where the red phosphor, the green phosphor, and the yellow phosphor are separately disposed, it is possible to satisfactorily synthesize the radiant light.

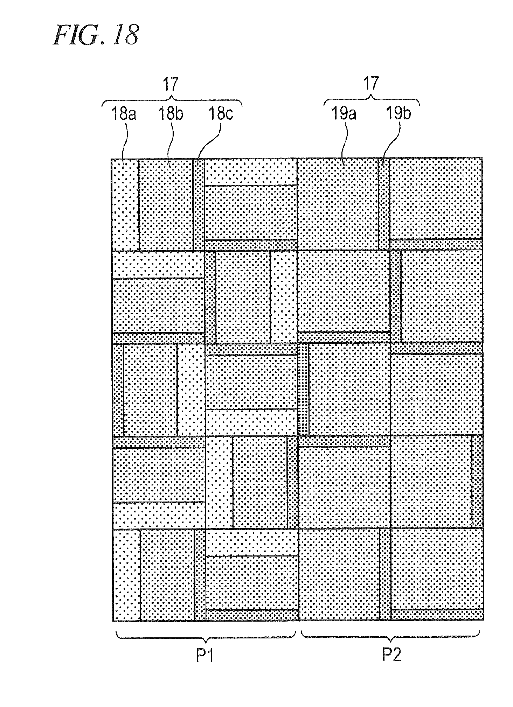

That is, the directions of the plurality of cell regions 17 in the first wavelength conversion region P1 are changed into various directions and are distributed, while the directions of the plurality of cell regions 17 in the second wavelength conversion region P2 are changed into various directions and are distributed. Thereby, it is possible to satisfactorily synthesize the radiant light from each wavelength conversion region as a whole. An example of arrangement of the cell regions 17 is shown in Fig. 18. Fig. 18 is a schematic top plan view of the fluorescent member 5. Note that, in Fig. 18, in order to distinguish emission colors of the respective phosphors, the respective phosphors are represented by dot hatch patterns. As shown in Fig. 18, the respective directions of the plurality of cell regions 17 in the first wavelength conversion region P1 are changed into four types, and the cell regions 17 are provided to be distributed. Likewise, the plurality of cell regions 17 in the second wavelength conversion region P2 are distributed with the directions changed.

Note that, in the modified example, the arrangement order of the red phosphor, the green phosphor, and the yellow phosphor is made to be the same in each of the first wavelength conversion region P1 and the second wavelength conversion region P2, the direction of the first wavelength conversion region P1 and the direction of the second wavelength conversion region P2 are changed into various directions, so that the regions are distributed. However, additionally, the arrangement order of the red phosphor, the green phosphor, and the yellow phosphor of the cell region 17 may be changed.

Further, in the example and the modified example, the three types of the red phosphor, the green phosphor, and the yellow phosphor are used in each of the first wavelength conversion region P1 and the second wavelength conversion region P2. However, when using the quality (color rendering property) of the blue color, it is possible to use the LED chips emitting the near-ultraviolet light instead of the LED chips emitting blue light. In such a case, in addition to the above-mentioned phosphors, a blue phosphor, which converts the wavelength of the near-ultraviolet light into that of the blue light, is used. In this case, an appropriate wavelength range of the emission peak wavelength of the blue phosphor is normally 420 nm or more, preferably 430 nm or more, or more preferably 440 nm or more, and normally 500 nm or less, preferably 490 nm or less, more preferably 480 nm or less, further preferably 470 nm or less, or particularly preferably 460 nm or less. From this point of view, as the blue phosphor, for example, the following are preferable: $(Ca, Sr, Ba)MgAl_{10}O_{17}$:Eu; $(Sr, Ca, Ba, Mg)_{10}(PO_4)_6(Cl, F)_2$:Eu; $(Ba, Ca, Mg, Sr)_2SiO_4$:Eu; and $(Ba, Ca, Sr)_3MgSi_2O_8$:Eu. In addition, $(Ba, Sr)MgAl_{10}O_{17}$:Eu, $(Ca, Sr, Ba)_{10}(PO_4)_6(Cl, F)_2$:Eu, and $Ba_3MgSi_2O_8$:Eu are more preferable, and $Sr_{10}(PO_4)_6C_{12}$:Eu and $BaMgAl_{10}O_{17}$:Eu are particularly preferable.

Note that, when the LED chips emitting the near-ultraviolet light are used, adjustment of the ratio of the red phosphor, the green phosphor, and the yellow phosphor is different from adjustment thereof in the case of using the LED chips emitting the blue light.

As described above, even when the LED chips emitting the near-ultraviolet light are used, when the type, the quantitative ratio, and the quantity of the light emitting member are changed in the above-mentioned manner, it is possible to obtain target light color in the same manner as the example. Therefore, it is possible to emit the synthetic white light which is the same as that of the light emission apparatus of the example. In addition, by adjusting the number of light emitting units in a stepwise fashion, it is possible to obtain the same effects as the light emission apparatus of the example.

(Modified Example of Electric Circuit Configuration of Light Emission apparatus)

In the above-mentioned example, the light control section 13 performs the light control by controlling the conduction phase angle of the waveform of the alternating current voltage supplied from the alternating current voltage source $V_{AC}$ in accordance with the instruction signal supplied from the instruction section 14. However, the light control section 13 may perform the light control by changing the own voltage value of the alternating current voltage supplied from the alternating current voltage source $V_{AC}$. For example, the light control may be performed by changing the amplitude voltage value of the voltage waveform (control signal) of the alternating current voltage.

Further, when the light control is performed by changing the amplitude voltage value of the voltage waveform of the alternating current voltage, the control section 16 has a voltage detector detecting the amplitude voltage value in place of the phase angle detector 16a, and in the memory constituting the control section 16, voltage value data of the base voltage corresponding to the amplitude voltage value is recorded. In addition, in the case of the light control based on the amplitude voltage value, it is possible to obtain the same effects as the above-mentioned example.

Furthermore, the on/off control of the transistors Q1 and Q2 is not limited to the adjustment based on the voltage values of the base voltages $V_S$ mentioned above, and may be applied to adjustment based on supply times (that is, duties of the pulse widths) of the base voltages Vs applied to the bases of the transistors Q1 and Q2.

In the above-mentioned example, the light control section 13 is connected to the alternating current voltage source $V_{AC}$, but may be connected to the direct current voltage source $V_{DC}$. In this case, the rectifier circuit 15a is not necessary.

(Effects of Present Example)

The light emission apparatus 11 of the present example includes: the wiring board 2; the plurality of LED chips 3 that are disposed on the LED chip mounting surface of the wiring board 2 so as to emit light with a predetermined wavelength range of the wavelength region ranging from the visible light region to the near-ultraviolet region, and are grouped into the plurality of LED groups; the fluorescent member 5 that is disposed at a position on the wiring board 2 corresponding to the LED chip mounting surface, and is partitioned into the plurality of wavelength conversion regions corresponding to the plurality of LED chips 3, in which the plurality of wavelength conversion regions are grouped into the plurality of wavelength conversion regions corresponding to the LED groups, and each wavelength conversion region has a different wavelength conversion characteristic, converts the wavelength of light emitted by the corresponding LED chips 3, and emits the first-order light with a different color temperature; the current supply section 15 that supplies the driving current to the LED chips 3 independently for each LED group through the wiring board 2; and the control section 16 that controls the current supplied for each LED group in response to the control signal which is input from outside. In addition, the control section 16 independently controls timing of starting to light the LED groups in accordance with the light control level. Hence, it is possible to generate the light with the color temperature appropriate for the desired emission intensity by controlling the emission intensity and the color temperature, and to suppress the manufacturing costs thereof.

The light emission apparatus 11 of the present example includes: the wiring board 2; the plurality of LED chips 3 that are disposed on the LED chip mounting surface of the wiring board 2 so as to emit light with a predetermined wavelength range of the wavelength region ranging from the visible light region to the near-ultraviolet region, and are grouped into the plurality of LED groups; the fluorescent member 5 that is disposed at a position on the wiring board 2 corresponding to the LED chip mounting surface, and is partitioned into the plurality of wavelength conversion regions corresponding to the plurality of LED chips 3, in which the plurality of wavelength conversion regions are grouped into the plurality of wavelength conversion regions corresponding to the LED groups, and each wavelength conversion region has a different wavelength conversion characteristic, converts the wavelength of light emitted by the corresponding LED chips 3, and emits the first-order light with a different color temperature; the current supply section 15 that supplies the driving current to the LED chips 3 independently for each LED group through the wiring board 2; and the control section 16 that controls the current supplied for each LED group in response to the control signal which is input from outside. In addition, the control section 16 sequentially lights on the LED groups, in accordance with the increase in the luminance of synthetic white light which is formed by synthesizing first-order light emitted from the plurality of wavelength conversion regions. Hence, it is possible to generate the light with the color temperature appropriate for the desired emission intensity by controlling the emission intensity and the color temperature, and to suppress the manufacturing costs thereof.

Furthermore, in the above-mentioned light emission apparatus 11, in accordance with the increase in the luminance of the synthetic white light, the control section sequentially lights on the LED groups in an order from an LED group which corresponds to the wavelength conversion region emitting the first-order light with the lower color temperature, to an LED group which corresponds to the wavelength conversion region emitting the first-order light with the higher color temperature. Hence, it is possible to increase the luminance of the synthetic white light emitted from the light emission apparatus 11, and change the color temperature of the corresponding synthetic white light appropriate for the increase in the corresponding luminance.

A further specific configuration of the light emission apparatus 11 is as follows. The plurality of LED chips and the wavelength conversion member are provided to be separated, the plurality of light emitting units are formed of the respective LED groups and the respective wavelength conversion regions corresponding to the LED groups, each of the plurality of light emitting units is integrally provided, and the light emitting units form a light emitting unit group. In this case, it is easy to treat the light emitting unit group, and thus it is possible to reduce the number of manufacturing processes and the manufacturing costs of the light emission apparatus 11.

Further, the illumination system 12 of the present example includes: the wiring board 2; the plurality of LED chips 3 that are disposed on the LED chip mounting surface of the wiring board 2 so as to emit light with the predetermined wavelength range of the wavelength region ranging from the visible light region to the near-ultraviolet region, and are grouped into the plurality of LED groups; the fluorescent member 5 that is disposed at the position on the wiring board 2 corresponding to the LED chip mounting surface, and is partitioned into the plurality of wavelength conversion regions corresponding to the plurality of LED chips 3, where the plurality of wavelength conversion regions are grouped into the plurality of wavelength conversion regions corresponding to the LED groups, and each wavelength conversion region has the different wavelength conversion characteristic, converts the wavelength of light emitted by the corresponding LED chips 3, and emits first-order light with the different color temperature; the current supply section 15 that supplies the driving current to the LED chips 3 independently for each LED group through the wiring board 2; the instruction section 14 that gives the instruction to generate synthetic white light with the desired luminance by synthesizing the first-order light; the light control section 13 that outputs the control signal to change the luminance of the synthetic white light in response to the instruction from the instruction section 14; and the control section 16 that controls the amount of the current supplied for each LED group in response to the control signal which is output from the light control section 13. In addition, the control section 16 sequentially lights on the LED groups, in accordance with the increase in the luminance of the synthetic white light. Hence, it is possible to generate the light with the color temperature appropriate for the desired emission intensity by controlling the emission intensity and the color temperature, and to suppress the manufacturing costs thereof.

Further, in the above-mentioned illumination system 12, in accordance with the increase in the luminance of the synthetic white light, the control section sequentially lights on the LED groups in an order from an LED group which corresponds to the wavelength conversion region emitting the first-order light with the lower color temperature, to an LED group which corresponds to the wavelength conversion region emitting the first-order light with the higher color temperature. Hence, when increasing the luminance of the synthetic white light supplied from the corresponding illumination system 12, it is possible to change the color temperature of the corresponding synthetic white light appropriate for the increase in the corresponding luminance.

Furthermore, the illumination method of the present example includes the steps of: supplying the current independently to each LED group of the plurality of LED chips 3 grouped into the plurality of LED groups so as to cause each LED group to emit light; supplying the light emitted by the LED chips 3 to the fluorescent member 5 that is partitioned into the plurality of wavelength conversion regions corresponding to the plurality of LED chips 3, in which the plurality of wavelength conversion regions are grouped into the plurality of wavelength conversion regions corresponding to the LED groups, and each wavelength conversion region has the different wavelength conversion characteristic, and emits first-order light with the different color temperature; and forming synthetic white light by synthesizing the first-order light. In addition, in the illumination method, the LED groups are sequentially lighted on by controlling the amount of the current supplied for each LED group in accordance with the increase in the luminance of the synthetic white light. Hence, it is possible to emit the light with the color temperature appropriate for the desired emission intensity by controlling the emission intensity and the color temperature while suppressing manufacturing costs of the light emission apparatus 11.

In addition, in the above-mentioned illumination method, in accordance with the increase in the luminance of the synthetic white light, the LED groups, which range from the LED group corresponding to the wavelength conversion region emitting the first-order light with the low color temperature to the LED group corresponding to the wavelength conversion region emitting the first-order light with the high color temperature, are sequentially lighted on. In this case, the synthetic white light generated by the illumination method has a color temperature appropriate for the desired luminance obtained by the light control.

Note that, in the above-mentioned example, the light emission apparatus 11 is configured to have one light emitting section 1, but the invention is not limited to this, and the light emission apparatus 11 may be configured to have a plurality of light emitting sections 1 so as to cause each light emitting section 1 to emit the synthetic white light with different color temperature. That is, by packaging each light emitting section 1, the light emission apparatus 11 may be constituted of a plurality of packages. Further, the present example described the single configuration of the light emission apparatus (illumination apparatus), but the invention may be applied to an illumination mechanism in which different light emission apparatuses (illumination step) such as an electric bulb and downlight, a heat dissipation system, and an optical lens system are added to the light emission apparatus of the present example. In such a case, it is also possible to obtain the above-mentioned effects.

<Second Example>

In the above-mentioned first example, the first wavelength conversion region P1 and the second wavelength conversion region P2, which emit first-order light with color temperatures different from each other, constitute the fluorescent member 5. That is, from the fluorescent member 5, the two types of the first-order light with different color temperatures are emitted. However, various modifications and variations may be made without departing from the technical scope of the invention. Therefore, examples of a light emitting section 1', a light emission apparatus 11' and an illumination system 12', which are configured by using a fluorescent member 5' having a different configuration from the configuration of the fluorescent member 5 of the first example, will be described below as a second example of the present invention. Note that, the members and components the same as the first example are represented by the same reference numerals and signs, and the description thereof will be omitted.

(Configuration of Light Emitting Section)

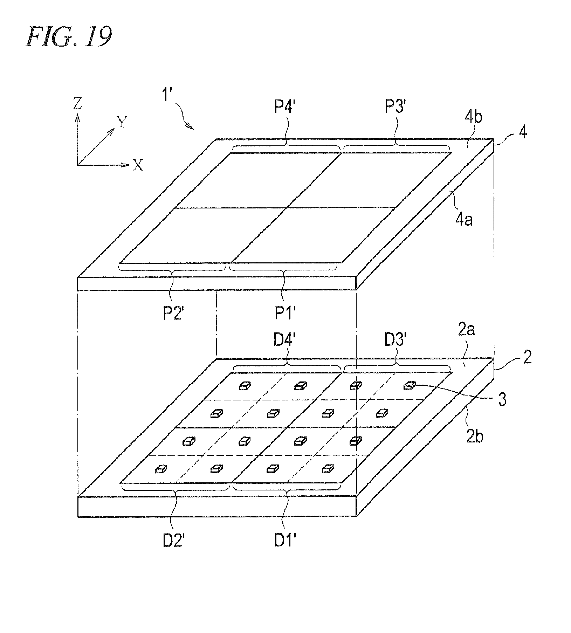

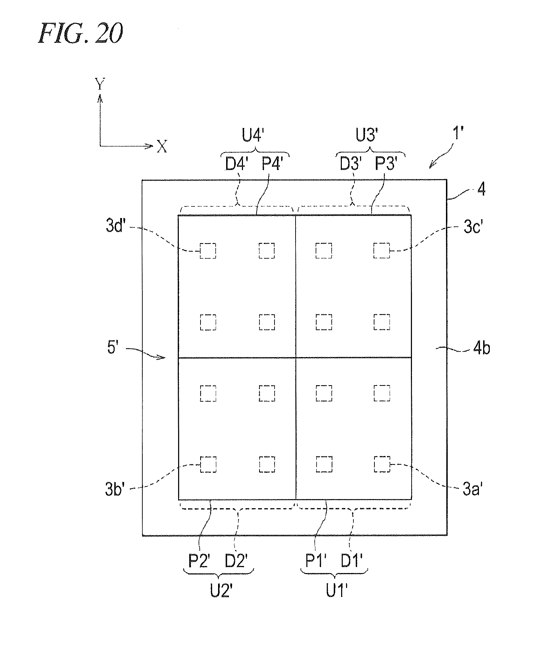

Fig. 19 is a perspective view illustrating an overview of an overall configuration of a light emitting section 1' in the light emission apparatus 11' according to the present example. Fig. 20 is a top plan view of the light emitting section 1' of Fig. 19. Note that, in Figs. 19 and 20, one direction of the light emitting section 1' is defined as an X direction, a direction perpendicular to the X direction is defined as a Y direction, and the height direction of the light emitting section 1' is defined as a Z direction. As shown in Fig. 19, the light emitting section 1' includes the wiring board 2 which has a square shape in XY plane. On a chip mounting surface 2a of the wiring board 2, a total of 16 LED chips 3 are equidistantly arranged in a matrix of four in the X direction and four in the Y direction of the wiring board 2. Note that, basic structures of the light emitting section 1', the wiring board 2, and the LED chips 3 are the same as the LED chips 3 of the first example, and thus the description thereof will be omitted. Further, as shown in Fig. 19, the transparent board 4, which is made of glass and has a square shape in the XY plane, is disposed to be opposed to the chip mounting surface 2a of the wiring board 2 on which the LED chips 3 are mounted.

A fluorescent member 5' is divided into four wavelength conversion regions of a first wavelength conversion region P1' a second wavelength conversion region P2', a third wavelength conversion region P3', and a fourth wavelength conversion region P4'. In the XY plane, the first wavelength conversion region P1', the second wavelength conversion region P2', the third wavelength conversion region P3', and the fourth wavelength conversion region P4' have the same planar shape and area. In accordance with the division of the fluorescent member 5', the LED chips 3 mounted on the wiring board 2 are grouped into respective LED groups corresponding to respective positions of the first wavelength conversion region P1', the second wavelength conversion region P2', the third wavelength conversion region P3', and the fourth wavelength conversion region P4' as shown in Figs. 19 and 20. That is, as shown in Fig. 20, in plan view of the light emitting section 1', four LED chips 3 are disposed to correspond to each of four wavelength conversion regions of the first wavelength conversion region P1', the second wavelength conversion region P2', the third wavelength conversion region P3', and the fourth wavelength conversion region P4'. Here, the term "correspond" has the same meaning as that of the first example. In the description below, in order to distinguish the LED chips 3 for each wavelength conversion region, a', b', c', and d' are respectively attached to the tail end of the reference sign thereof so as to correspond to the first wavelength conversion region P1', the second wavelength conversion region P2', the third wavelength conversion region P3', and the fourth wavelength conversion region P4'. Therefore, the four LED chips 3a' positioned to correspond to the first wavelength conversion region P1' constitute a first LED group D1', the four LED chips 3b' positioned to correspond to a second wavelength conversion region P2' constitute a second LED group D2', the four LED chips 3c' positioned to correspond to the third wavelength conversion region P3' constitute a third LED group D3', and the four LED chips 3d' positioned to correspond to the fourth wavelength conversion region P4' constitute a fourth LED group D4'.

Accordingly, in the present example, respective combinations of the first wavelength conversion region P1', the second wavelength conversion region P2', the third wavelength conversion region P3', and the fourth wavelength conversion region P4' and the first LED group D1', the second LED group D2', the third LED group D3', and the fourth LED group D4' corresponding thereto correspond to respective light emitting units of the present invention. That is, the first LED group D1' and the first wavelength conversion region P1' constitute a first light emitting unit U1', the second LED group D2' and the second wavelength conversion region P2' constitute a second light emitting unit U2', the third LED group D3' and the third wavelength conversion region P3' constitute a third light emitting unit U3', and the fourth LED group D4' and the fourth wavelength conversion region P4' constitute a fourth light emitting unit U4'. A light emitting section 1', in which the four light emitting units are integrated, corresponds to a light emitting unit group of the present invention. In the present example, the first light emitting unit U1', the second light emitting unit U2', the third light emitting unit U3', and the fourth light emitting unit U4' are integrally provided, and constitute the light emitting section 1' which is the light emitting unit group. Note that, in the description below, light, which is emitted by each of the first light emitting unit U1', the second light emitting unit U2', the third light emitting unit U3', and the fourth light emitting unit U4', is referred to as first-order light, and light, which is formed by synthesizing the first-order light emitted by each of the first light emitting unit U1', the second light emitting unit U2', the third light emitting unit U3', and the fourth light emitting unit U4' and is emitted from the light emitting section 1', is referred to as synthetic white light.

(Fluorescent Member)

As described above, the fluorescent member 5' is divided into two of the first wavelength conversion region P1', the second wavelength conversion region P2', the third wavelength conversion region P3', and the fourth wavelength conversion region P4' corresponding to the first LED group D1', the second LED group D2', the third LED group D3', and the fourth LED group D4'. In the first wavelength conversion region P1', the second wavelength conversion region P2', the third wavelength conversion region P3', and the fourth wavelength conversion region P4', the wavelengths of the light emitted from the LED chips 3 are converted, and various phosphors for emitting light with various wavelengths are held in a distributed manner. The used various phosphors include, in the same manner as the first example: a red phosphor which is for emitting red light by converting the wavelength of the blue light emitted by the LED chips 3; a green phosphor which is for emitting green light by converting the wavelength of the blue light emitted by the LED chips 3; and a yellow phosphor which is for emitting yellow light by converting the wavelength of the blue light emitted by the LED chips 3. Furthermore, it may be possible to use an orange phosphor which is for emitting orange light by converting the wavelength of the blue light emitted by the LED chips 3. In addition, in a similar manner to the first example, it is not necessary for the fluorescent member 5' to hold all the above-mentioned red phosphor, green phosphor, and yellow phosphor in a distributed manner, and if the desired first-order light can be emitted from the fluorescent member 5', one type or two or more types of phosphors may be selected from the above-mentioned phosphors. For example, the fluorescent member 5' may hold the red phosphor and the green phosphor in a distributed manner, and may not hold the yellow phosphor in a distributed manner. The other specific composition, structure, and the like of the phosphors are the same as those of the first example.

Further, the first wavelength conversion region P1', the second wavelength conversion region P2', the third wavelength conversion region P3', and the fourth wavelength conversion region P4' are different in the mass and the mixture ratio of the red phosphor, the green phosphor, and the yellow phosphor. Accordingly, the ratios of the red light, the green light, and the yellow light, which are emitted from each wavelength conversion region, to the blue light, which is emitted without the wavelength conversion, are different from each other. Hence, there are differences among color temperatures of: the white light, which is the first-order light formed by synthesizing the red light, green light, yellow light, and blue light emitted from the first wavelength conversion region P1'; the white light, which is the first-order light formed by synthesizing the red light, green light, yellow light, and blue light emitted from the second wavelength conversion region P2'; the white light, which is the first-order light formed by synthesizing the red light, green light, yellow light, and blue light emitted from the third wavelength conversion region P3'; and the white light, which is the first-order light formed by synthesizing the red light, green light, yellow light, and blue light emitted from the fourth wavelength conversion region P4'.

In a similar manner to the first example, the numbers of phosphors, which are held in a distributed manner in the first wavelength conversion region P1', the second wavelength conversion region P2', the third wavelength conversion region P3', and the fourth wavelength conversion region P4', may be different from each other. In such a case, the color temperatures of the first-order light respectively emitted from the first wavelength conversion region P1', the second wavelength conversion region P2', the third wavelength conversion region P3', and the fourth wavelength conversion region P4' are made to be different from each other.

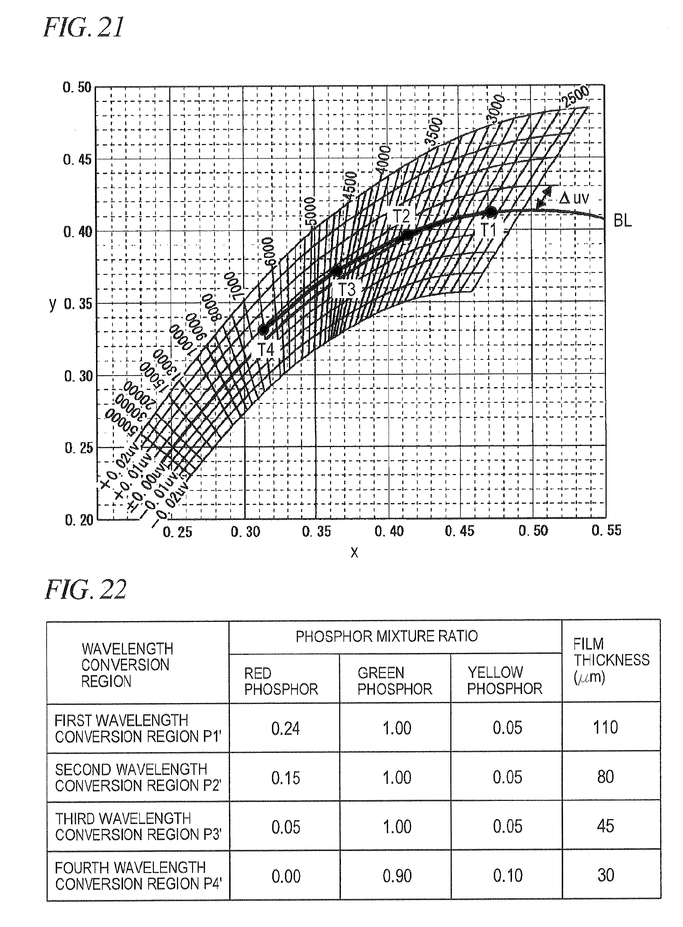

Next, referring to Fig. 21, a description will be given of a method of defining the mixture ratio of the phosphors in the first wavelength conversion region P1', the second wavelength conversion region P2', the third wavelength conversion region P3', and the fourth wavelength conversion region P4'. Fig. 21 is an enlarged diagram of a principal section around the black-body radiation locus BL in the xy chromaticity diagram of the CIE (1931) XYZ color coordinate system. In the present example, the mixture ratio of the red phosphor, the green phosphor, and the yellow phosphor in the first wavelength conversion region P1' is determined such that the first-order light, which is emitted from the first light emitting unit U1' formed of the first LED group D1' and the first wavelength conversion region P1', has the chromaticity of the chromaticity point T1 (about 2700 K) of Fig. 21. Further, the mixture ratio of the red phosphor, the green phosphor, and the yellow phosphor in the second wavelength conversion region P2' is determined such that the first-order light, which is emitted from the second light emitting unit U2' formed of the second LED group D2' and the second wavelength conversion region P2', has the chromaticity of the chromaticity point T2 (about 3400 K) of Fig. 21. Furthermore, the mixture ratio of the red phosphor, the green phosphor, and the yellow phosphor in the third wavelength conversion region P3' is determined such that the first-order light, which is emitted from the third light emitting unit U3' formed of the third LED group D3' and the third wavelength conversion region P3', has the chromaticity of the chromaticity point T3 (about 4500 K) of Fig. 21. In addition, the mixture ratio of the red phosphor, the green phosphor, and the yellow phosphor in the fourth wavelength conversion region P4' is determined such that the first-order light, which is emitted from the fourth light emitting unit U4' formed of the fourth LED group D4' and the fourth wavelength conversion region P4', has the chromaticity of the chromaticity point T4 (about 6500 K) of Fig. 21.

Note that, the y value of the CIE (1931) XYZ color coordinate system at any chromaticity point of the first-order light, which is emitted from each of the first light emitting unit U1', the second light emitting unit U2', the third light emitting unit U3', and the fourth light emitting unit U4', is preferably equal to or less than 0.65. When the y value is greater than 0.65, the takeoff efficiency of the visible light of each light emitting unit deteriorates, and it is difficult for the overall light emission apparatus to efficiently emit light. On the other hand, when LED chips emitting near-ultraviolet light are used instead of the LED chips 3 emitting the blue light, there is no trouble even if the y value is greater than 0.65.

By determining the mixture ratio of the phosphors in each wavelength conversion region in the above-mentioned method, it is possible to set the magnitudes of the color temperatures of the first-order light emitted from the first light emitting unit U1', the second light emitting unit U2', the third light emitting unit U3', and the fourth light emitting unit U4' in order of the first light emitting unit U1', the second light emitting unit U2', the third light emitting unit U3' and the fourth light emitting unit U4.

In the present example, as the red phosphor, $(Sr, Ca)_1AlSiN_3:Eu$ is used, as the green phosphor, $Ca_3(Sc, Mg)_2Si_3O_{12}:Ce$ is used, and as the yellow phosphor, $Y_3Al_5O_{12}:Ce$ is used. Further, as shown in Fig. 22, the mixture ratio of the phosphors in the first wavelength conversion region P1' is set such that red phosphor: green phosphor: yellow phosphor = 0.24: 1: 0.05, and the mixture ratio of the phosphors in the second wavelength conversion region P2' is set such that red phosphor: green phosphor: yellow phosphor = 0.15: 1: 0.05. In addition, the mixture ratio of the phosphors in the third wavelength conversion region P3' is set such that red phosphor: green phosphor: yellow phosphor = 0.05: 1: 0.05, and the mixture ratio of the phosphors in the fourth wavelength conversion region P4' is set such that red phosphor: green phosphor: yellow phosphor = 0: 0.9: 0.1.

Furthermore, the first wavelength conversion region P1', the second wavelength conversion region P2', the third wavelength conversion region P3', and the fourth wavelength conversion region P4' have different film thicknesses. Specifically, as shown in Fig. 22, the film thickness of the first wavelength conversion region P1' is 110 $\mu$m, the film thickness of the second wavelength conversion region P2' is 80 $\mu$m, the film thickness of the third wavelength conversion region P3' is 45 $\mu$m, and the film thickness of the fourth wavelength conversion region P4' is 30 $\mu$m.

(Electric Circuit Configuration of Light Emission apparatus)

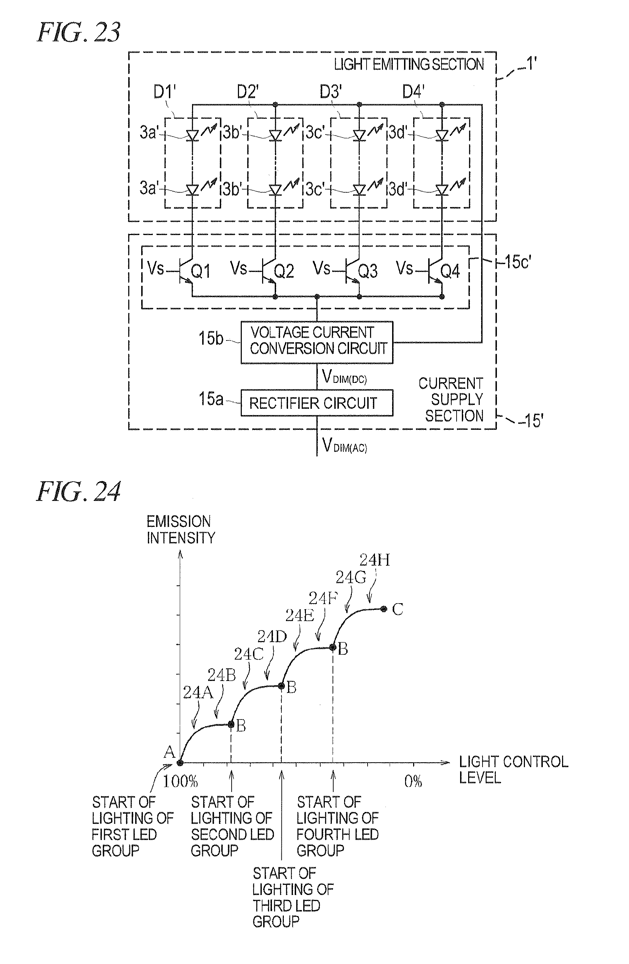

As described above, in the light emission apparatus of the present example, the color temperatures of the first-order light, which are respectively emitted from the first light emitting unit U1', the second light emitting unit U2', the third light emitting unit U3', and the fourth light emitting unit U4', are set to be different from each other, and the synthetic white light, which is generated by synthesizing the first-order light emitted from the light emitting units, is emitted from the light emission apparatus. Accordingly, in the light emission apparatus of the present example, by changing the total luminous flux (that is, emission intensity or luminance) of the first-order light emitted from each of the first light emitting unit U1', the second light emitting unit U2', the third light emitting unit U3', and the fourth light emitting unit U4', the total luminous flux of the synthetic white light emitted from the light emission apparatus is adjusted, and the color temperature of the synthetic white light is changed in accordance with the corresponding total luminous flux of the synthetic white light so as to emit the synthetic white light with the color temperature appropriate for the desired total luminous flux and the corresponding total luminous flux mentioned above. The configurations of the light emitting section 1' and the current supply section 15', which are circuit configuration portions different from those of the first example, will be described below with reference to Fig. 23. Here, Fig. 23 is an electric circuit diagram illustrating an overview of an electric circuit configuration of the light emitting section 1' and current supply section 15' in the light emission apparatus 11' according to the present example, where the light control section 13, the instruction section (operation section) 14, and the control section 16, which are the same components as the first example, are omitted. The light control section 13, the instruction section (operation section) 14, and the control section 16 will be described below on the basis of the drawings related to the first example 1.

The light emitting section 1' has the LED chips 3a' of the first LED group D1', the LED chips 3b' of the second LED group D2', the LED chips 3c' of the third LED group D3', and the LED chips 3d' of the fourth LED group D4'. In specific configurations of the first LED group D1' and the second LED group D2', the four LED chips 3a' of the first LED group D1' are connected to one another in series such that the polarities thereof are the same, and the four LED chips 3b' of the second LED group D2' are also connected to one another in series such that the polarities thereof are the same. Likewise, in specific configurations of the third LED group D3' and the fourth LED group D4', the four LED chips 3c' of the third LED group D3' are connected to one another in series such that the polarities thereof are the same, and the four LED chips 3d' of the fourth LED group D4' are also connected to one another in series such that the polarities thereof are the same. Further, the first LED group D1', the second LED group D2', the third LED group D3', and the fourth LED group D4' are connected in parallel through a switch circuit 15c' to be described later. Note that, the connection form of the LED chips 3 in the same LED group is not limited to serial connection, and may be, for example, parallel connection in which the LED chips 3 are connected to one another in parallel such that the polarities thereof are the same.

The current supply section 15' is formed of the rectifier circuit 15a, the voltage current conversion circuit 15b, and the switch circuit 15c'. The rectifier circuit 15a and the voltage current conversion circuit 15b have the same configuration as the first example, and thus the description thereof will be omitted. The switch circuit 15c' includes transistors Q1, Q2, Q3, and Q4. Each collector of the transistors Q1, Q2, Q3, and Q4 is connected to a terminal closest to a cathode of each of the first LED group D1', the second LED group D2', the third LED group D3', and the fourth LED group D4', each emitter of the transistors Q1, Q2, Q3, and Q4 is connected to the voltage current conversion circuit 15b, and each base of the transistors Q1, Q2, Q3, and Q4 is connected to the control section 16.

In the illumination system 12' of the present example, due to the configuration and the connection relationship of the light control section 13, the instruction section 14, and the current supply section 15' mentioned above, it is possible to adjust the amount of driving current (the amount of supply current), which is supplied to the LED chips 3, only by rotating the operation dial 14a. In addition, by adjusting the amount of supply current supplied to the light emitting section 1', it is possible to emit (that is, control) the synthetic white light with the desired total luminous flux from the light emission apparatus 11'.

(Control of Light Emitting Section)

When a user of the light emission apparatus 11' operates the operation dial 14a, the main body 14b of the instruction section 14 detects the position of the operation dial 14a, and supplies the instruction signal (signal representing the light control level) based on the detected position of the operation dial 14a to the light control section 13. The light control section 13 controls the conduction phase angle of the waveform of the alternating current voltage, which is supplied from the alternating current voltage source $V_{AC}$, on the basis of the instruction signal supplied from the instruction section 14, thereby generating the alternating-current light control voltage $V_{DIM(AC)}$. In a specific control method, the light control section 13 inputs a trigger pulse with an arbitrary phase difference relative to the zero cross point of the sinusoidal waveform of the alternating current supplied from the alternating current voltage source so as to control the conduction phase angle. Accordingly, when the supplied instruction signal is changed, the light control section 13 controls the conduction phase angle by changing the phase difference of the trigger pulse in accordance with the change.

The rectifier circuit 15a of the current supply section 15' converts the alternating-current light control voltage $V_{DIM(AC)}$, which is supplied from the light control section 13, into the direct-current light control voltage $V_{DIM(DC)}$, and supplies the corresponding direct-current light control voltage $V_{DIM(DC)}$ to the voltage current conversion circuit 15b. The voltage current conversion circuit 15b converts the direct-current light control voltage $V_{DIM(DC)}$, which is supplied from the rectifier circuit 15a, into the driving currents to be supplied to the LED chips 3, and supplies the corresponding driving currents to the first LED group D1', the second LED group D2', the third LED group D3', and the fourth LED group D4'.

The control section 16 controls the voltage values of the base voltages Vs applied to the bases of the transistors Q1, Q2, Q3, and Q4 while selectively turning on the transistors Q1, Q2, Q3, and Q4 in response to the alternating-current light control voltage $V_{DIM(AC)}$ which is supplied from the light control section 13, thereby controlling the magnitude of the driving current flowing for each LED group. Here, when the base voltages Vs with the same voltage values are applied to the bases of the transistors Q1, Q2, Q3, and Q4, the amounts of the driving currents flowing in the first LED group D1', the second LED group D2', the third LED group D3', and the fourth LED group D4' are equal. Further, when the base voltages Vs are not applied to the bases of the transistors Q1, Q2, Q3, and Q4, the transistors Q1, Q2, Q3, and Q4 are not turned on. Hence, even when the driving currents are supplied from the voltage current conversion circuit 15b to the first LED group D1', the second LED group D2', the third LED group D3', and the fourth LED group D4', the driving currents do not flow in the first LED group D1', the second LED group D2', the third LED group D3', and the fourth LED group D4', and the LED chips 3 do not emit light. In the present example, when the base voltages Vs are gradually increased from the state where the base voltages Vs are not applied, the transistors are turned on in order of the transistors Q1, Q2, Q3, and Q4.

A specific control method of the control section 16 of the present example is as follows. Note that, in the memory 16b of the control section 16, the voltage value data of the base voltages applied to the bases of the transistors Q1, Q2, Q3, and Q4 is recorded to correspond to the conduction phase angles controlled by the light control section 13. The phase angle detector 16a of the control section 16 detects the conduction phase angle, which is controlled by the light control section 13, from the alternating-current light control voltage $V_{DIM(AC)}$ supplied from the light control section 13.

Specifically, the phase angle detector 16a detects the conduction phase angle from the voltage waveform (control signal) of the light control voltage $V_{DIM(AC)}$. The phase angle detector 16a supplies the data signal, which represents the detected conduction phase angle, to the selection circuit 16c. The selection circuit 16c cross-checks the voltage value data, which is stored in the memory 16b and relates to the transistors Q1, Q2, Q3, and Q4, with the data signal, which represents the supplied conduction phase angle, in order to determine the voltage values of the base voltages Vs applied to the bases of the transistors Q1, Q2, Q3, and Q4 in accordance with the supplied conduction phase angle. Then, the selection circuit 16c applies the base voltages Vs, which have the voltage values determined through the cross-checking, to the bases of the transistors Q1, Q2, Q3, and Q4. Thereby, at least one of the transistors Q1, Q2, Q3, and Q4 are turned on, and the magnitudes of the driving currents, which are supplied to the first LED group D1', the second LED group D2', the third LED group D3', and the fourth LED group D4', are controlled in accordance with the voltage values of the base voltages Vs which are applied to the bases of the transistors Q1, Q2, Q3, and Q4, and the synthetic white light with the total luminous flux corresponding to the light control level and the color temperature corresponding to each wavelength conversion region is emitted from at least one of the first light emitting unit U1', the second light emitting unit U2', the third light emitting unit U3', and the fourth light emitting unit U4'.

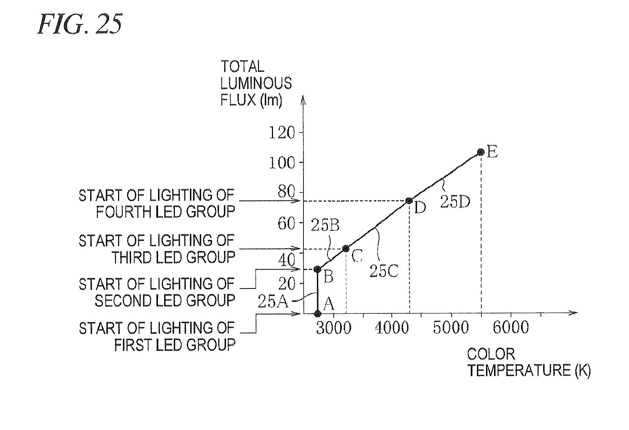

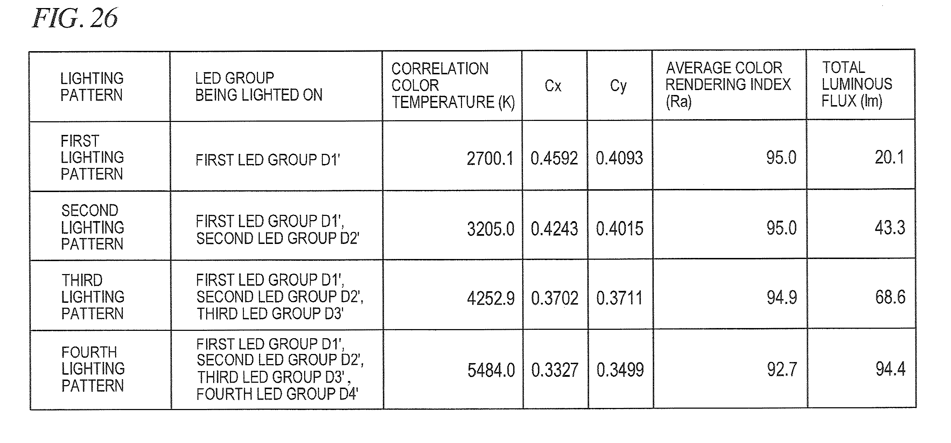

Next, referring to Figs. 25 and 26, a description will be given of how to apply the base voltages Vs to the bases of the transistors Q1, Q2, Q3, and Q4 and control the magnitudes of the driving currents, which are supplied to the first LED group D1', the second LED group D2', the third LED group D3', and the fourth LED group D4', in order to emit the synthetic white light with the color temperature appropriate for the desired total luminous flux and the corresponding total luminous flux from the light emission apparatus 11'. Fig. 24 is a graph illustrating a relationship between the light control level of the light control section 13 and the emission intensity of the synthetic white light emitted from the light emission apparatus 11'. Fig. 25 is a graph illustrating a relationship between the color temperature (unit: Kelvin (K)) and the total luminous flux of the synthetic white light (unit: Lumen (lm)) emitted from the light emission apparatus 11'.

First, when lighting of the LED groups is started such that the darkest synthetic white light is emitted from the light emission apparatus 11' by operating the operation dial 14a, only the transistor Q1 is turned on, and the first-order light is emitted from the first light emitting unit U1'. That is, at this time, the synthetic white light, which is emitted from the light emission apparatus 11', is formed of only the first-order light emitted from the first light emitting unit U1'. In Figs. 24 and 25, the start of the lighting of the corresponding first LED group D1' is indicated by the point A.

When the light is controlled (that is, the light control level is lowered) such that the further bright synthetic white light is emitted by further operating the operation dial 14a, the driving current supplied to the first LED group D1' increases, and the total luminous flux of the first-order light, which is emitted from the first light emitting unit U1', increases. The increase of the total luminous flux corresponds to the curve portion 24A on the graph of Fig. 24. Further, since the ratio of synthesis of the phosphors is adjusted such that the color temperature of the first-order light emitted from the first light emitting unit U1' is set to about 2700 K, when the first-order light is emitted from only the first light emitting unit U1', the color temperature of the synthetic white light emitted from the light emission apparatus 11' is maintained at about 2700 K. The solid line 25A of Fig. 25 indicates that the total luminous flux increases while the color temperature is maintained.

When the light control level is further lowered by further operating the operation dial 14a, the voltage value of the base voltage Vs, which is applied to the base of the transistor Q1, is controlled by the control section 16 such that the driving current flowing in the first LED group D1' is not increased, and thus the total luminous flux of the first-order light, which is emitted from the first light emitting unit U1', is not increased. The state where the total luminous flux is not increased is defined as a full lighting state of the first light emitting unit U1'. The state where the total luminous flux is not increased corresponds to the straight line portion 24B on the graph of Fig. 24. As described above, the reason why the total luminous flux is not increased is to prevent the LED chips 3 from being heated by the excessive driving current.

In the state where the increase in the total luminous flux of the synthetic white light mentioned above is suppressed, when the light control level is further lowered by further operating the operation dial 14a, the transistor Q2 is also turned on so as to start lighting of the second LED group D2', and thereby the first-order light is also emitted from the second light emitting unit U2'. At this time, the control section 16 applies the base voltage Vs to the base of the transistor Q1 so as to maintain the full lighting state of the first light emitting unit U1'. In Figs. 24 and 25, the corresponding state is indicated by the point B.

When the light control level is further lowered by further operating the operation dial 14a from the start of lighting of the second. LED group D2', the base voltages $V_S$ are applied to the bases of the transistors Q1 and Q2 such that the total luminous flux of the first-order light emitted from the second light emitting unit U2' is increased while the full lighting state of the first light emitting unit U1' is maintained. The increase of the total luminous flux corresponds to the curve portion 24C on the graph of Fig. 24. Further, since the ratio of synthesis of the phosphors is adjusted such that the color temperature of the first-order light emitted from the second light emitting unit U2' is set to about 3400 K, when the total luminous flux of the first-order light emitted from the second light emitting unit U2' is increased, the color temperature of the synthetic white light emitted from the light emission apparatus 11' is increased to be close to 3400 K. The solid line 25B of Fig. 25 indicates that the color temperature is increased.

When the light control level is further lowered by further operating the operation dial 14a, the voltage value of the base voltage Vs, which is applied to the base of the transistor Q2, is controlled by the control section 16 such that not only the driving current flowing in the first LED group D1' but also the driving current flowing in the second LED group D2' is not increased, and thus the total luminous flux of the first-order light, which is emitted from the second light emitting unit U2', is not increased. That is, the second light emitting unit U2' also reaches the full lighting state. The full lighting states of the first light emitting unit U1' and the second light emitting unit U2' correspond to the straight line portion 24D on the graph of Fig. 24. In addition, when the second light emitting unit U2' reaches the full lighting state, the color temperature of the synthetic white light emitted from the light emission apparatus 11' reaches about 3200 K.

In the state where the second light emitting unit U2' reaches the full lighting state and thereby the increase in the total luminous flux of the synthetic white light mentioned above is suppressed, when the light control level is further lowered by further operating the operation dial 14a, the transistor Q3 is also turned on so as to start lighting of the third LED group D3', and thereby the first-order light is also emitted from the third light emitting unit U3'. At this time, the control section 16 applies the base voltages Vs to the bases of the transistors Q1 and Q2 so as to maintain the full lighting states of the first light emitting unit U1' and the second light emitting unit U2'. In Figs. 24 and 25, the corresponding state is indicated by the point C.

When the light control level is further lowered by further operating the operation dial 14a from the start of Lighting of the third LED group D3', the base voltages Vs are applied to the bases of the transistors Q1, Q2, and Q3 such that the total luminous flux of the first-order light emitted from the third light emitting unit U3' is increased while the full lighting states of the first light emitting unit U1' and the second light emitting unit U2' are maintained. The increase of the total luminous flux corresponds to the curve portion 24E on the graph of Fig. 24. Further, since the ratio of synthesis of the phosphors is adjusted such that the color temperature of the first-order light emitted from the third light emitting unit U3' is set to about 4500 K, when the total luminous flux of the first-order light emitted from the third light emitting unit U3' is increased, the color temperature of the synthetic white light emitted from the light emission apparatus 11' is increased to be close to 4500 K. The solid line 25C of Fig. 25 indicates that the color temperature is increased.

When the light control level is further lowered by further operating the operation dial 14a, the voltage value of the base voltage $V_S$, which is applied to the base of the transistor Q3, is controlled by the control section 16 such that not only the driving currents flowing in the first LED group D1' and the second LED group D2' but also the driving current flowing in the third LED group D3' is not increased, and thus the total luminous flux of the first-order light, which is emitted from the third light emitting unit U3', is not increased. That is, the third light emitting unit U3' also reaches the full lighting state. The full lighting states of the first light emitting unit U1', the second light emitting unit U2', and the third light emitting unit U3' correspond to the straight line portion 24F on the graph of Fig. 24. In addition, when the third light emitting unit U3' reaches the full lighting state, the color temperature of the synthetic white light emitted from the light emission apparatus 11' reaches about 4300 K.

In the state where the third light emitting unit U3' reaches the full lighting state and thereby the increase in the total luminous flux of the synthetic white light mentioned above is suppressed, when the light control level is further lowered by further operating the operation dial 14a, the transistor Q4 is also turned on so as to start lighting of the fourth LED group D4', and thereby the first-order light is also emitted from the fourth light emitting unit U4'. At this time, the control section 16 applies the base voltages Vs to the bases of the transistors Q1, Q2, and Q3 so as to maintain the full lighting states of the first light emitting unit U1', the second light emitting unit U2', and the third light emitting unit U3'. In Figs. 24 and 25, the corresponding state is indicated by the point D.

When the light control level is further lowered by further operating the operation dial 14a from the start of lighting of the fourth LED group D4', the base voltages Vs are applied to the bases of the transistors Q1, Q2, Q3, and Q4 such that the total luminous flux of the first-order light emitted from the fourth light emitting unit U4' is increased while the full lighting states of the first light emitting unit U1', the second light emitting unit U2', and the third light emitting unit U3' are maintained. The increase of the total luminous flux corresponds to the curve portion 24G on the graph of Fig. 24. Further, since the ratio of synthesis of the phosphors is adjusted such that the color temperature of the first-order light emitted from the fourth light emitting unit U4' is set to about 6500 K, when the total luminous flux of the first-order light emitted from the fourth light emitting unit U4' is increased, the color temperature of the synthetic white light emitted from the light emission apparatus 11' is increased to be close to 6500 K. The solid line 25D of Fig. 25 indicates that the color temperature is increased.

When the light control level is further lowered by further operating the operation dial 14a, the voltage value of the base voltage Vs, which is applied to the base of the transistor Q4, is controlled by the control section 16 such that not only the driving currents flowing in the first LED group D1', the second LED group D2', and the third LED group D3' but also the driving current flowing in the fourth LED group D4' is not increased, and thus the total luminous flux of the first-order light, which is emitted from the fourth light emitting unit U4', is not increased. That is, the fourth light emitting unit U4' also reaches the full lighting state. The full lighting states of the first light emitting unit U1', the second light emitting unit U2', the third light emitting unit U3', and the fourth light emitting unit U4' correspond to the straight line portion 24H on the graph of Fig. 24. In addition, in the full lighting states of the first light emitting unit U1', the second light emitting unit U2', the third light emitting unit U3', and the fourth light emitting unit U4', the color temperature of the synthetic white light emitted from the light emission apparatus 11' does not reach 6500 K, but may reach about 5500 K (the point E in Figs. 24 and 25).

In the above-mentioned control, the transistors Q1, Q2, Q3, and Q4 are independently turned on in accordance with the light control level. Hence, it is possible to control the timing of the start of the light emission of the LED chips 3a', the timing of the start of the light emission of the LED chips 3b', the timing of the start of the light emission of the LED chips 3c', and the timing of the start of the light emission of the LED chips 3d', in accordance with the light control level. That is, in the light emission apparatus 11' of the present example, it is possible to independently control the timing (light start timing) of lighting the first LED group D1', the second LED group D2', the third LED group D3', and the fourth LED group D4' in accordance with the light control level. In other words, in the light emission apparatus 11' of the present example, the timing of starting to supply the driving current is different for each LED group. Thus, the corresponding timing of starting to supply the current is set as a current supply start light control level for each LED group in accordance with the light control level, and the LED group to be lighted on is selected on the basis of the relationship between the instruction signal (signal representing the light control level) supplied from the instruction section 14 and the corresponding current supply start light control level.

Further, when the first light emitting unit U1' reaches the full lighting state by starting to light the first LED group D1', lighting of the second LED group D2' is started. Then, while the total luminous flux of the first-order light emitted from the second light emitting unit U2' increases, the full liglzting state of the first light emitting unit U1' is maintained. Hence, after the start of the lighting of the second LED group D2', in accordance with the increase in the total luminous flux of the synthetic white light emitted from the light emission apparatus 11', the color temperature of the synthetic white light also increases. Likewise, while lighting of the third LED group D3' is started and then the total luminous flux of the first-order light emitted from the third light emitting unit U3' increases, the full lighting states of the first light emitting unit U1' and the second light emitting unit U2' are maintained. In addition, while lighting of the fourth LED group D4' is started and then the total luminous flux of the first-order light emitted from the fourth light emitting unit U4' increases, the full lighting states of the first light emitting unit U1', the second light emitting unit U2', the third light emitting unit U3' are maintained. That is, as the total amount of currents supplied to the plurality of LED groups increases, the respective LED groups are sequentially lighted on. Hence, after the start of the lighting of the third LED group D3' and after the start of the lighting of the fourth LED group D4', in accordance with the increase in the total luminous flux of the synthetic white light emitted from the light emission apparatus 11', the color temperature of the synthetic white light also increases. Generally, when the total luminous flux is low, the white light (that is, the light emitted from the filament electric bulb) with a low color temperature is preferred, and when the total luminous flux is high, the white light (that is, the light emitted from the fluorescent lamp) with a high color temperature is preferred. Accordingly, in the light emission apparatus 11' and the illumination system 12' according to the present example, in accordance with the increase in the total luminous flux of the synthetic white light, the color temperature is simultaneously controlled. Thereby, it is possible to emit the synthetic white light with the color temperature appropriate for the desired total luminous flux and the corresponding total luminous flux.

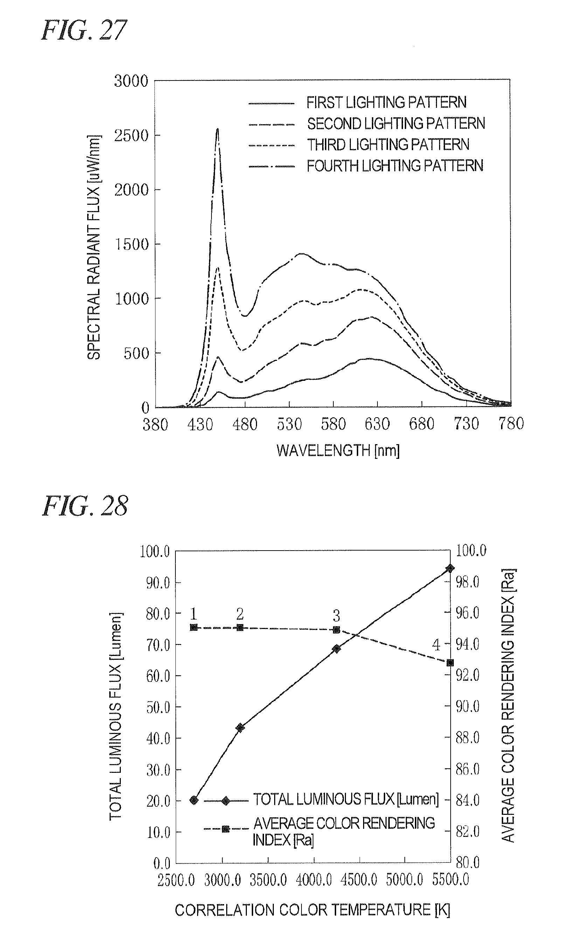

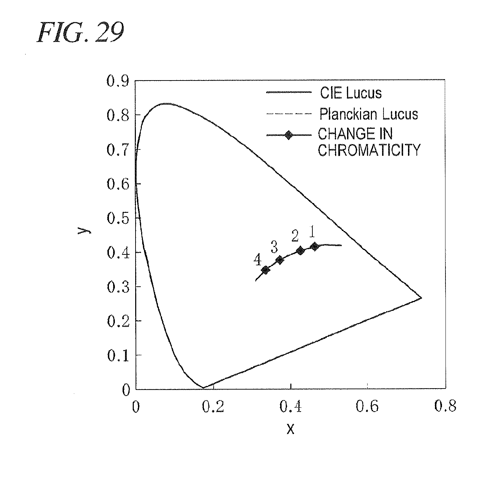

Figs. 26 to 29 show results of ray-tracing simulations of the light emission apparatus of the present example. Fig. 26 shows the correlation color temperatures of the synthetic white light which is emitted from the light emission apparatus 11', the Cx and Cy values based on the CIE1931, average color rendering indices, and simulation results of the total luminous fluxes in the pattern (first lighting pattern) in which only the first LED group D1' is lighted on, the pattern (second lighting pattern) in which the first LED group D1' and the second LED group D2' are lighted on, the pattern (second lighting pattern) in which the first LED group D1' and the second LED group D2' are lighted on, the pattern (third Lighting pattern) in which the first LED group D1', the second LED group D2', and the third LED group D3' are lighted on, and the pattern (fourth lighting pattern) in which the first LED group D1', the second LED group D2', the third LED group D3', and the fourth LED group D4' are lighted on. Fig. 27 is a graph illustrating spectral radiant flux spectra of the synthetic white light, which is emitted from the light emission apparatus 11', in the first lighting pattern, the second lighting pattern, the third lighting pattern, and the fourth lighting pattern. Fig. 28 is a graph illustrating change of the total luminous flux relative to the correlation color temperature and change of the average color rendering index relative to the correlation color temperature, where the simulation result of the correlation color temperature shown in Fig. 26 is indicated by the horizontal axis, the simulation result of the total luminous flux is indicated by the first vertical axis, and the average color rendering index is indicated by the second vertical axis, in the first lighting pattern, the second lighting pattern, the third lighting pattern, and the fourth lighting pattern. Fig. 29 is a graph illustrating the simulation results of the Cx and Cy values of the synthetic white light, which is emitted from the light emission apparatus 11' according to the present example, on the color temperature coordinates of the CIE1931, in the first lighting pattern, the second lighting pattern, the third lighting pattern, and the fourth lighting p attern.

(Modified Examples of Pattern Shapes of LED Groups and Wavelength Conversion Regions)

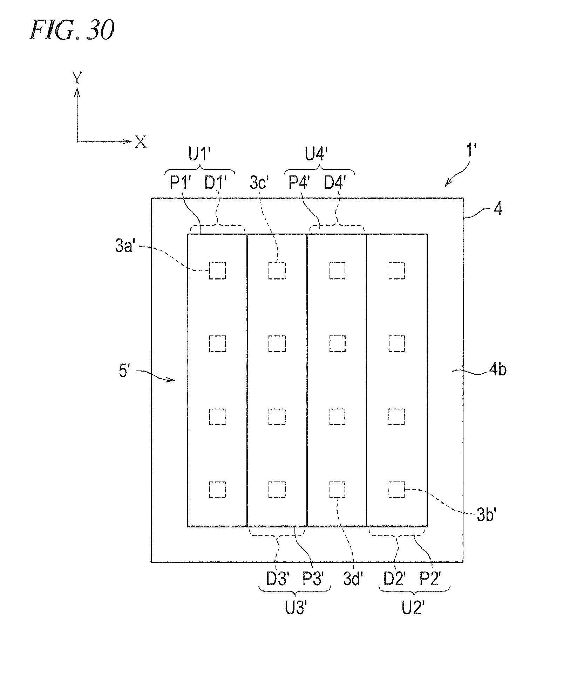

In the above-mentioned example, the fluorescent member 5' is divided into four regions of the first wavelength conversion region P1', the second wavelength conversion region P2', the third wavelength conversion region P3', and the fourth wavelength conversion region P4' which have square shapes, but the invention is not limited to this. For example, as shown in Fig. 30, the fluorescent member 5' may be divided into the first wavelength conversion region P1', the second wavelength conversion region P2', the third wavelength conversion region P3', and the fourth wavelength conversion region P4'.

As shown in Fig. 30, the fluorescent member 5' is divided into the first wavelength conversion region P1', the second wavelength conversion region P2', the third wavelength conversion region P3', and the fourth wavelength conversion region P4' having rectangular shapes. In addition, the first wavelength conversion region P1', the second wavelength conversion region P2', the third wavelength conversion region P3', and the fourth wavelength conversion region P4' may be arranged in parallel. Further, each of the first wavelength conversion region P1', the second wavelength conversion region P2', the third wavelength conversion region P3', and the fourth wavelength conversion region P4' has the same area in plan view of Fig. 30, and has the same planar shape. Furthermore, although not represented by reference signs and numerals, the first LED group D 1', the second LED group D2', the third LED group D3', and the fourth LED group D4' are also arranged in parallel, and the first LED group D1' is opposed to the first wavelength conversion region P 1' the second LED group D2' is opposed to the second wavelength conversion region P2', the third LED group D3' is opposed to the third wavelength conversion region P3' and the fourth LED group D4' is opposed to the fourth wavelength conversion region P4'.

The four LED chips 3a' arranged in the first LED group D1' and the four LED chips 3b' arranged in the second LED group D2' may be connected in series, or may be connected in parallel. Likewise, four LED chips 3c' arranged in one third LED group D3' and the four LED chips 3d' arranged in the fourth LED group D4' may be connected in series, or may be connected in parallel.

(Effects of The Present Example)

Compared with the light emission apparatus 11 and the illumination system 12 of the first example, the light emission apparatus 11' and the illumination system 12' according to the present example is different in the number of LED groups and the number of wavelength conversion regions, but has the same basic structure. Hence, even in the light emission apparatus 11', the illumination system 12', and the illumination method according to the present example, it is possible to obtain the same effect as the first example. Further, compared with the light emission apparatus 11 and the illumination system 12 of the first example, in the light emission apparatus 11' and the illumination system 12' according to the present example, the number of LED groups and the number of wavelength conversion regions are large. Hence, it is possible to more accurately control the color temperature relative to the change in the luminance of the synthetic white light.

<Third Example>

In the above-mentioned first example, the first wavelength conversion region P1 and the second wavelength conversion region P2, which emit first-order light with color temperatures different from each other, constitute the fluorescent member 5. That is, from the fluorescent member 5, the two types of the first-order light with different color temperatures are emitted. However, various modifications and variations may be made without departing from the technical scope of the invention. Therefore, examples of a light emitting section 1", a light emission apparatus 11" and an illumination system 12", which are configured by using a fluorescent member 5" having a different configuration from the configuration of the fluorescent member 5 of the first example, will be described below as a third example of the present invention. Note that, the members and components the same as the first example are represented by the same reference numerals and signs, and the description thereof will be omitted.

(Configuration of Light Emitting Section)

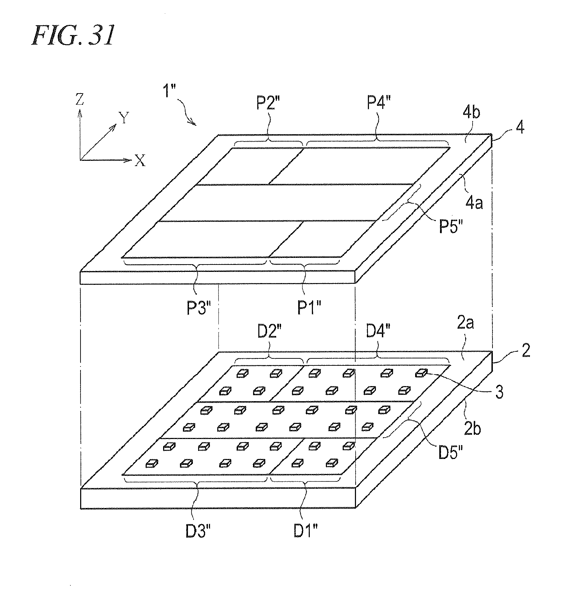

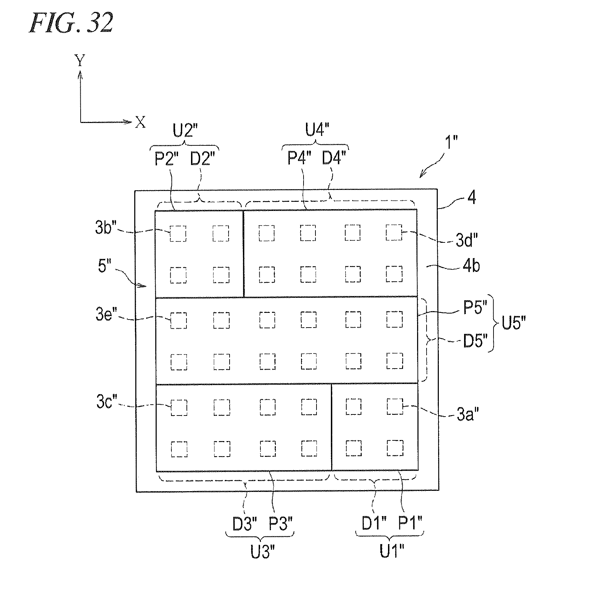

Fig. 31 is a perspective view illustrating an overview of an overall configuration of a light emitting section 1" in the light emission apparatus 11" according to the present example. Fig. 32 is a top plan view of the light emitting section 1" of Fig. 31. Note that, in Figs. 31 and 32, one direction of the light emitting section 1" is defined as an X direction, a direction perpendicular to the X direction is defined as a Y direction, and the height direction of the light emitting section 1" is defined as a Z direction. As shown in Fig. 31, the light emitting section 1" includes the wiring board 2 which has a square shape in XY plane. On a chip mounting surface 2a of the wiring board 2, a total of 36 LED chips 3 are equidistantly arranged in a matrix of six in the X direction and six in the Y direction of the wiring board 2. Note that, basic structures of the light emitting section 1", the wiring board 2, and the LED chips 3 are the same as the LED chips 3 of the first example, and thus the description thereof will be omitted. Further, as shown in Fig. 31, the transparent board 4, which is made of glass and has a square shape in the XY plane, is disposed to be opposed to the chip mounting surface 2a of the wiring board 2 on which the LED chips 3 are mounted.

A fluorescent member 5" is divided into five wavelength conversion regions of a first wavelength conversion region P1" a second wavelength conversion region P2", a third wavelength conversion region P3", a fourth wavelength conversion region P4", and a fifth wavelength conversion region P5". Specifically, the first wavelength conversion region P1" and the second wavelength conversion region P2" having square shapes are disposed two corner portions of the fluorescent member 5". The third wavelength conversion region P3" and the fourth wavelength conversion region P4" having rectangular shapes are disposed to extend in the X directions from the terminal of the fluorescent member 5" toward the first wavelength conversion region P1" and the second wavelength conversion region P2". The fifth wavelength conversion region P5" having a rectangular shape is disposed to be interposed in the first wavelength conversion region P1", the second wavelength conversion region P2", the third wavelength conversion region P3" and the fourth wavelength conversion region P4" and to extend in the X direction. Further, in the XY plane, the first wavelength conversion region P1" and the second wavelength conversion region P2" have the same planar shape and area. In addition, the third wavelength conversion region P3" and the fourth wavelength conversion region P4" have the same planar shape and area.

In accordance with the division of the fluorescent member 5", the LED chips 3 mounted on the wiring board 2 are grouped into respective LED groups corresponding to respective positions of the first wavelength conversion region P1", the second wavelength conversion region P2", the third wavelength conversion region P3", the fourth wavelength conversion region P4", and the fifth wavelength conversion region P5" as shown in Figs. 31 and 32. That is, as shown in Fig. 32, in plan view of the light emitting section 1", four LED chips 3 are disposed to correspond to each of the first wavelength conversion region P1" and the second wavelength conversion region P2", eight LED chips 3 are disposed to correspond to each of the third wavelength conversion region P3" and the fourth wavelength conversion region P4", and 16 LED chips 3 are disposed to correspond to the fifth wavelength conversion region P5". Here, the term "correspond" has the same meaning as that of the first example.

In the description below, in order to distinguish the LED chips 3 for each wavelength conversion region, a", b", c", d" and e" are respectively attached to the tail end of the reference sign thereof so as to correspond to the first wavelength conversion region P1", the second wavelength conversion region P2", the third wavelength conversion region P3", the fourth wavelength conversion region P4", and the fifth wavelength conversion region P5". Therefore, the four LED chips 3a" positioned to correspond to the first wavelength conversion region P1" constitute a first LED group D1", the four LED chips 3b" positioned to correspond to a second wavelength conversion region P2" constitute a second LED group D2", the eight LED chips 3c" positioned to correspond to the third wavelength conversion region P3" constitute a third LED group D3", the eight LED chips 3d" positioned to correspond to the fourth wavelength conversion region P4" constitute a fourth LED group D4", and the 16 LED chips 3e" positioned to correspond to the fifth wavelength conversion region P5" constitute a fifth LED group D5".

Accordingly, in the present example, respective combinations of the first wavelength conversion region P1", the second wavelength conversion region P2", the third wavelength conversion region P3", the fourth wavelength conversion region P4", and the fifth wavelength conversion region P5" and the first LED group D1", the second LED group D2", the third LED group D3", the fourth LED group D4", and the fifth LED group D5" corresponding thereto correspond to respective light emitting units of the present invention. That is, the first LED group D1" and the first wavelength conversion region P1" constitute a first light emitting unit U 1", the second LED group D2" and the second wavelength conversion region P2" constitute a second light emitting unit U2", the third LED group D3" and the third wavelength conversion region P3" constitute a third light emitting unit U3", the fourth LED group D4" and the fourth wavelength conversion region P4" constitute a fourth light emitting unit U4", and the fifth LED group D5" and the fifth wavelength conversion region P5" constitute a fifth light emitting unit U5". Alight emitting section 1", in which the five light emitting units are integrated, corresponds to a light emitting unit group of the present invention. In the present example, the first light emitting unit U1", the second light emitting unit U2", the third light emitting unit U3", the fourth light emitting unit U4", and the fifth light emitting unit U5" are integrally provided, and constitute the light emitting section 1" which is the light emitting unit group. Note that, in the description below, light, which is emitted by each of the first light emitting unit U1", the second light emitting unit U2", the third light emitting unit U3", the fourth light emitting unit U4", and the fifth light emitting unit U5", is referred to as first-order light, and light, which is formed by synthesizing the first-order light emitted by each of the first light emitting unit U1", the second light emitting unit U2", the third light emitting unit U3", the fourth light emitting unit U4", and the fifth light emitting unit U5" and is emitted from the light emitting section 1", is referred to as synthetic white light.

(Fluorescent Member)

As described above, the fluorescent member 5" is divided into four regions of the first wavelength conversion region P1", the second wavelength conversion region P2", the third wavelength conversion region P3", the fourth wavelength conversion region P4", and the fifth wavelength conversion region P5" corresponding to the first LED group D1", the second LED group D2", the third LED group D3", the fourth LED group D4", and the fifth LED group D5". In the first wavelength conversion region P1", the second wavelength conversion region P2", the third wavelength conversion region P3", the fourth wavelength conversion region P4", and the fifth wavelength conversion region P5", the wavelengths of the light emitted from the LED chips 3 are converted, and various phosphors for emitting light with various wavelengths are held in a distributed manner. The used various phosphors include, in the same manner as the first example: a red phosphor which is for emitting red light by converting the wavelength of the blue light emitted by the LED chips 3; a green phosphor which is for emitting green light by converting the wavelength of the blue light emitted by the LED chips 3; and a yellow phosphor which is for emitting yellow light by converting the wavelength of the blue light emitted by the LED chips 3. Furthermore, it may be possible to use an orange phosphor which is for emitting orange light by converting the wavelength of the blue light emitted by the LED chips 3. In addition, in a similar manner to the first example, it is not necessary for the fluorescent member 5" all the above-mentioned red phosphor, green phosphor, and yellow phosphor in a distributed manner, and if the desired first-order light can be emitted from the fluorescent member 5", one type or two or more types of phosphors may be selected from the above-mentioned phosphors. For example, the fluorescent member 5" may hold the red phosphor and the green phosphor in a distributed manner, and may not hold the yellow phosphor in a distributed manner. The other specific composition, structure, and the like of the phosphors are the same as those of the first example.

Further, the first wavelength conversion region P1", the second wavelength conversion region P2", the third wavelength conversion region P3", the fourth wavelength conversion region P4", and the fifth wavelength conversion region P5" are different in the mass and the mixture ratio of the red phosphor, the green phosphor, and the yellow phosphor. Accordingly, the ratios of the red light, the green light, and the yellow light, which are emitted from each wavelength conversion region, to the blue light, which is emitted without the wavelength conversion, are different from each other. Hence, there are differences among color temperatures of: the white light, which is the first-order light formed by synthesizing the red light, green light, yellow light, and blue light emitted from the first wavelength conversion region P1"; the white light, which is the first-order light formed by synthesizing the red light, green light, yellow light, and blue light emitted from the second wavelength conversion region P2"; the white light, which is the first-order light formed by synthesizing the red light, green light, yellow light, and blue light emitted from the third wavelength conversion region P3"; the white light, which is the first-order light formed by synthesizing the red light, green light, yellow light, and blue light emitted from the fourth wavelength conversion region P4"; and the white light, which is the first-order light formed by synthesizing the red light, green light, yellow light, and blue light emitted from the fifth wavelength conversion region P5".

In a similar manner to the first example, the numbers of phosphors, which are held in a distributed manner in the first wavelength conversion region P1", the second wavelength conversion region P2", the third wavelength conversion region P3", the fourth wavelength conversion region P4", and the fifth wavelength conversion region P5", may be different from each other. In such a case, the color temperatures of the first-order light respectively emitted from the first wavelength conversion region P1", the second wavelength conversion region P2", the third wavelength conversion region P3", the fourth wavelength conversion region P4", and the fifth wavelength conversion region P5" are made to be different from each other.

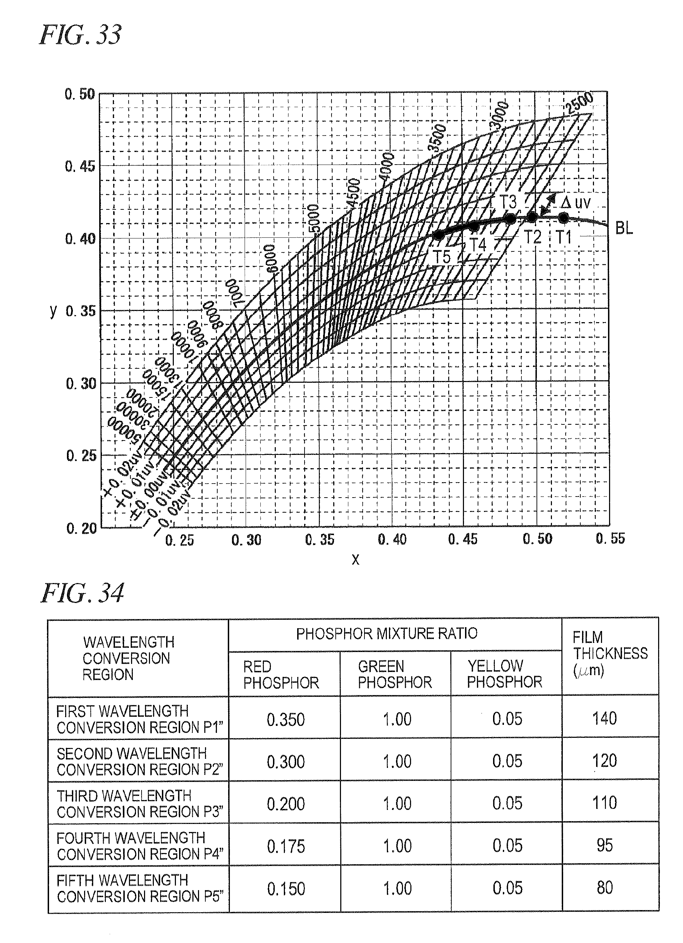

Next, referring to Fig. 33, a description will be given of a method of defining the mixture ratio of the phosphors in the first wavelength conversion region P1", the second wavelength conversion region P2", the third wavelength conversion region P3", the fourth wavelength conversion region P4", and the fifth wavelength conversion region P5". Fig. 33 is an enlarged diagram of a principal section around the black-body radiation locus BL in the xy chromaticity diagram of the CIE (1931) XYZ color coordinate system. In the present example, the mixture ratio of the red phosphor, the green phosphor, and the yellow phosphor in the first wavelength conversion region P1" is determined such that the first-order light, which is emitted from the first light emitting unit U1" formed of the first LED group D1" and the first wavelength conversion region P1", has the chromaticity of the chromaticity point T1 (about 2050 K) of Fig. 33. Further, the mixture ratio of the red phosphor, the green phosphor, and the yellow phosphor in the second wavelength conversion region P2" is determined such that the first-order light, which is emitted from the second light emitting unit U2" formed of the second LED group D2" and the second wavelength conversion region P2", has the chromaticity of the chromaticity point T2 (about 2300 K) of Fig. 33. Furthermore, the mixture ratio of the red phosphor, the green phosphor, and the yellow phosphor in the third wavelength conversion region P3" is determined such that the first-order light, which is emitted from the third light emitting unit U3" formed of the third LED group D3" and the third wavelength conversion region P3", has the chromaticity of the chromaticity point T3 (about 2550 K) of Fig. 33. In addition, the mixture ratio of the red phosphor, the green phosphor, and the yellow phosphor in the fourth wavelength conversion region P4" is determined such that the first-order light, which is emitted from the fourth light emitting unit U4" formed of the fourth LED group D4" and the fourth wavelength conversion region P4", has the chromaticity of the chromaticity point T4 (about 2800 K) of Fig. 33. Moreover, the mixture ratio of the red phosphor, the green phosphor, and the yellow phosphor in the fifth wavelength conversion region P5" is determined such that the first-order light, which is emitted from the fifth light emitting unit U5" formed of the fifth LED group D5" and the fifth wavelength conversion region P5", has the chromaticity of the chromaticity point T5 (about 3100 K) of Fig. 33.

Note that, the y value of the CIE (1931) XYZ color coordinate system at any chromaticity point of the first-order light, which is emitted from each of the first light emitting unit U1", the second light emitting unit U2", the third light emitting unit U3", the fourth light emitting unit U4", and the fifth light emitting unit U5", is preferably equal to or less than 0.65. When the y value is greater than 0.65, the takeoff efficiency of the visible light of each light emitting unit deteriorates, and it is difficult for the overall light emission apparatus to efficiently emit light. On the other hand, when LED chips emitting near-ultraviolet light are used instead of the LED chips 3 emitting the blue light, there is no trouble even if the y value is greater than 0.65.

By determining the mixture ratio of the phosphors in each wavelength conversion region in the above-mentioned method, it is possible to set the magnitudes of the color temperatures of the first-order light emitted from the first light emitting unit U1", the second light emitting unit U2", the third light emitting unit U3", the fourth light emitting unit U4", and the fifth light emitting unit U5" in order of the first light emitting unit U1", the second light emitting unit U2", the third light emitting unit U3", the fourth light emitting unit U4", and the fifth light emitting unit U5".

In the present example, as the red phosphor, $(Sr, Ca)_1AlSiN_3$:Eu is used, as the green phosphor, $Ca_3(Sc, Mg)_2Si_3O_{12}$:Ce is used, and as the yellow phosphor, $Y_3Al_5O_{12}$:Ce is used. Further, as shown in Fig. 34, the mixture ratio of the phosphors in the first wavelength conversion region P1" is set such that red phosphor: green phosphor: yellow phosphor = 0.35: 1: 0.05, and the mixture ratio of the phosphors in the second wavelength conversion region P2" is set such that red phosphor: green phosphor: yellow phosphor = 0.30: 1: 0.05. In addition, the mixture ratio of the phosphors in the third wavelength conversion region P3" is set such that red phosphor: green phosphor: yellow phosphor = 0.20: 1: 0.05, the mixture ratio of the phosphors in the fourth wavelength conversion region P4" is set such that red phosphor: green phosphor: yellow phosphor = 0.175: 1.0: 0.05, and the mixture ratio of the phosphors in the fifth wavelength conversion region P5" is set such that red phosphor: green phosphor: yellow phosphor = 0.150: 1.0: 0.05.

Furthermore, the first wavelength conversion region P1", the second wavelength conversion region P2", the third wavelength conversion region P3", the fourth wavelength conversion region P4", and the fifth wavelength conversion region P5" have different film thicknesses. Specifically, as shown in Fig. 34, the film thickness of the first wavelength conversion region P 1" is 140 $\mu$m, the film thickness of the second wavelength conversion region P2" is 120 $\mu$m, the film thickness of the third wavelength conversion region P3" is 110 $\mu$m, the film thickness of the fourth wavelength conversion region P4" is 95 $\mu$m, and the film thickness of the fifth wavelength conversion region P5" is 80 $\mu$m.

(Electric Circuit Configuration of Light Emission apparatus)

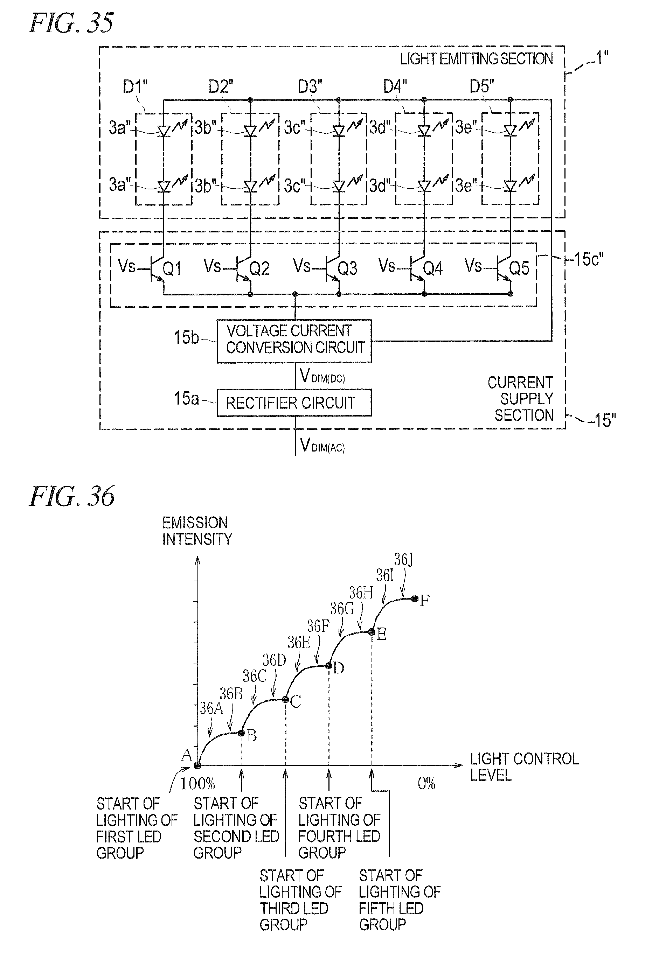

As described above, in the light emission apparatus of the present example, the color temperatures of the first-order light, which are respectively emitted from the first light emitting unit U1", the second light emitting unit U2", the third light emitting unit U3", the fourth light emitting unit U4", and the fifth light emitting unit U5", are set to be different from each other, and the synthetic white light, which is generated by synthesizing the first-order light emitted from the light emitting units, is emitted from the light emission apparatus. Accordingly, in the light emission apparatus of the present example, by changing the total luminous flux (that is, emission intensity or luminance) of the first-order light emitted from each of the first light emitting unit U1", the second light emitting unit U2", the third light emitting unit U3", the fourth light emitting unit U4", and the fifth light emitting unit U5", the total luminous flux of the synthetic white light emitted from the light emission apparatus is adjusted, and the color temperature of the synthetic white light is changed in accordance with the corresponding total luminous flux of the synthetic white light so as to emit the synthetic white light with the color temperature appropriate for the desired total luminous flux and the corresponding total luminous flux mentioned above. The configurations of the light emitting section 1" and the current supply section 15", which are circuit configuration portions different from those of the first example, will be described below with reference to Fig. 35. Here, Fig. 35 is an electric circuit diagram illustrating an overview of an electric circuit configuration of the light emitting section 1" and current supply section 15" in the light emission apparatus 11" according to the present example, where the light control section 13, the instruction section (operation section) 14, and the control section 16, which are the same components as the first example, are omitted. The light control section 13, the instruction section (operation section) 14, and the control section 16 will be described below on the basis of the drawings related to the first example 1.

The light emitting section 1" has the LED chips 3a" of the first LED group D 1", the LED chips 3b" of the second LED group D2", the LED chips 3c" of the third LED group D3", the LED chips 3d" of the fourth LED group D4", and the LED chips 3e" of the fifth LED group D5". In specific configurations of the first LED group D1" and the second LED group D2", the four LED chips 3a" of the first LED group D1" are connected to one another in series such that the polarities thereof are the same, and the four LED chips 3b" of the second LED group D2" are also connected to one another in series such that the polarities thereof are the same. Likewise, in specific configurations of the third LED group D3" and the fourth LED group D4", the eight LED chips 3c" of the third LED group D3" are connected to one another in series such that the polarities thereof are the same, and the eight LED chips 3d" of the fourth LED group D4" are also connected to one another in series such that the polarities thereof are the same. Furthermore, in specific configurations of the fifth LED group D5", the 16 LED chips 3e" of the fifth LED group D5" are also connected to one another in series such that the polarities thereof are the same. Further, the first LED group D1", the second LED group D2", the third LED group D3", the fourth LED group D4", and the fifth LED group D5" are connected in parallel through a switch circuit 15c" to be described later. Note that, the connection form of the LED chips 3 in the same LED group is not limited to serial connection, and may be, for example, parallel connection in which the LED chips 3 are connected to one another in parallel such that the polarities thereof are the same.

The current supply section 15" is formed of the rectifier circuit 15a, the voltage current conversion circuit 15b, and the switch circuit 15c". The rectifier circuit 15a and the voltage current conversion circuit 15b have the same configuration as the first example, and thus the description thereof will be omitted. The switch circuit 15c" includes transistors Q1, Q2, Q3, Q4, and Q5. Each collector of the transistors Q1, Q2, Q3, Q4, and Q5 is connected to a terminal closest to a cathode of each of the first LED group D1", the second LED group D2", the third LED group D3", the fourth LED group D4", and the fifth LED group D5", each emitter of the transistors Q1, Q2, Q3, Q4, and Q5 is connected to the voltage current conversion circuit 15b, and each base of the transistors Q1, Q2, Q3, Q4, and Q5 is connected to the control section 16.

In the illumination system 12" of the present example, due to the configuration and the connection relationship of the light control section 13, the instruction section 14, and the current supply section 15" mentioned above, it is possible to adjust the amount of driving current (the amount of supply current), which is supplied to the LED chips 3, only by rotating the operation dial 14a. In addition, by adjusting the amount of supply current supplied to the light emitting section 1", it is possible to emit (that is, control) the synthetic white light with the desired total luminous flux from the light emission apparatus 11".

(Control of Light Emitting Section)

When a user of the light emission apparatus 11" operates the operation dial 14a, the main body 14b of the instruction section 14 detects the position of the operation dial 14a, and supplies the instruction signal (signal representing the light control level) based on the detected position of the operation dial 14a to the light control section 13. The light control section 13 controls the conduction phase angle of the waveform of the alternating current voltage, which is supplied from the alternating current voltage source $V_{AC}$, on the basis of the instruction signal supplied from the instruction section 14, thereby generating the alternating-current light control voltage $V_{DIM(AC)}$. In a specific control method, the light control section 13 inputs a trigger pulse with an arbitrary phase difference relative to the zero cross point of the sinusoidal waveform of the alternating current supplied from the alternating current voltage source so as to control the conduction phase angle. Accordingly, when the supplied instruction signal is changed, the light control section 13 controls the conduction phase angle by changing the phase difference of the trigger pulse in accordance with the change.

The rectifier circuit 15a of the current supply section 15" converts the alternating-current light control voltage $V_{DIM(AC)}$, which is supplied from the light control section 13, into the direct-current light control voltage $V_{DIM(DC)}$, and supplies the corresponding direct-current light control voltage $V_{DIM(DC)}$ to the voltage current conversion circuit 15b. The voltage current conversion circuit 15b converts the direct-current light control voltage $V_{DIM(DC)}$, which is supplied from the rectifier circuit 15a, into the driving currents to be supplied to the LED chips 3, and supplies the corresponding driving currents to the first LED group D1", the second LED group D2", the third LED group D3", the fourth LED group D4", and the fifth LED group D5".

The control section 16 controls the voltage values of the base voltages Vs applied to the bases of the transistors Q1, Q2, Q3, Q4, and Q5 while selectively turning on the transistors Q1, Q2, Q3, Q4, and Q5 in response to the alternating-current light control voltage $V_{DIM(AC)}$ which is supplied from the light control section 13, thereby controlling the magnitude of the driving current flowing for each LED group. Here, when the same voltages are applied to the bases of the transistors Q1, Q2, Q3, Q4, and Q5, the amounts of the driving currents flowing in the first LED group D1", the second LED group D2", the third LED group D3", the fourth LED group D4", and the fifth LED group D5" are equal. Further, when the base voltages $V_S$ are not applied to the bases of the transistors Q1, Q2, Q3, Q4, and Q5, the transistors Q1, Q2, Q3, Q4, and Q5 are not turned on. Hence, even when the driving currents are supplied from the voltage current conversion circuit 15b to the first LED group D1", the second LED group D2", the third LED group D3", the fourth LED group D4", and the fifth LED group D5", the driving currents do not flow in the first LED group D1", the second LED group D2", the third LED group D3", the fourth LED group D4", and the fifth LED group D5", and the LED chips 3 do not emit light.

A specific control method of the control section 16 of the present example is as follows. Note that, in the memory 16b of the control section 16, the voltage value data of the base voltages applied to the bases of the transistors Q1, Q2, Q3, Q4, and Q5 is recorded to correspond to the conduction phase angles controlled by the light control section 13. The phase angle detector 16a of the control section 16 detects the conduction phase angle, which is controlled by the light control section 13, from the alternating-current light control voltage $V_{DIM(AC)}$ supplied from the light control section 13. Specifically, the phase angle detector 16a detects the conduction phase angle from the voltage waveform (control signal) of the light control voltage $V_{DIM(AC)}$. The phase angle detector 16a supplies the data signal, which represents the detected conduction phase angle, to the selection circuit 16c. The selection circuit 16c cross-checks the voltage value data, which is stored in the memory 16b and relates to the transistors Q1, Q2, Q3, Q4, and Q5, with the data signal, which represents the supplied conduction phase angle, in order to determine the voltage values of the base voltages Vs applied to the bases of the transistors Q 1, Q2, Q3, Q4, and Q5 in accordance with the supplied conduction phase angle. Then, the selection circuit 16c applies the base voltages Vs, which have the voltage values determined through the cross-checking, to the bases of the transistors Q1, Q2, Q3, Q4, and Q5. Thereby, at least one of the transistors Q1, Q2, Q3, Q4, and Q5 are turned on, and the magnitudes of the driving currents, which are supplied to the first LED group D1", the second LED group D2", the third LED group D3", the fourth LED group D4", and the fifth LED group D5", are controlled in accordance with the voltage values of the base voltages Vs which are applied to the bases of the transistors Q1, Q2, Q3, Q4, and Q5, and the synthetic white light with the total luminous flux corresponding to the light control level and the color temperature corresponding to each wavelength conversion region is emitted from at least one of the first light emitting unit U1", the second light emitting unit U2", the third light emitting unit U3", the fourth light emitting unit U4", and the fifth light emitting unit U5". In the present example, when the base voltages Vs are gradually increased from the state where the base voltages Vs are not applied, the transistors are turned on in order of the transistors Q1, Q2, Q3, Q4, and Q5.

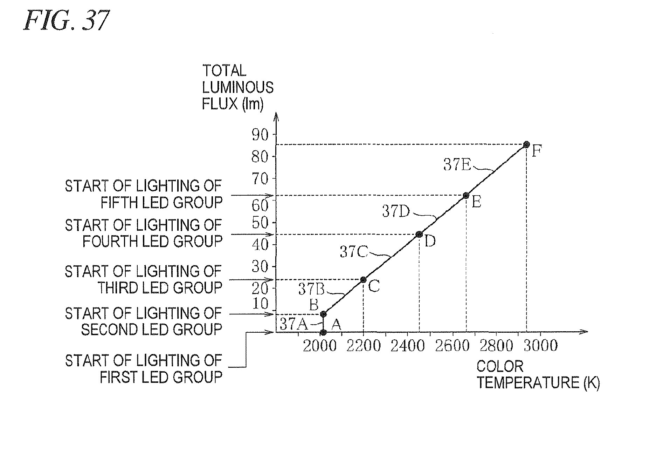

Next, referring to Figs. 36 and 37, a description will be given of how to apply the base voltages Vs to the bases of the transistors Q1, Q2, Q3, Q4, and Q5 and control the magnitudes of the driving currents, which are supplied to the first LED group D1", the second LED group D2", the third LED group D3", the fourth LED group D4", and the fifth LED group D5", in order to emit the synthetic white light with the color temperature appropriate for the desired total luminous flux and the corresponding total luminous flux from the light emission apparatus 11". Fig. 36 is a graph illustrating a relationship between the light control level of the light control section 13 and the emission intensity of the synthetic white light emitted from the light emission apparatus 11". Fig. 37 is a graph illustrating a relationship between the color temperature (unit: Kelvin (K)) and the total luminous flux of the synthetic white light (unit: Lumen (lm)) emitted from the light emission apparatus 11".

First, when lighting of the LED groups is started such that the darkest synthetic white light is emitted from the light emission apparatus 11" by operating the operation dial 14a, only the transistor Q1 is turned on, and the first-order light is emitted from the first light emitting unit U1". That is, at this time, the synthetic white light, which is emitted from the light emission apparatus 11", is formed of only the first-order light emitted from the first light emitting unit U1". In Figs. 36 and 37, the start of the lighting of the corresponding first LED group D 1" is indicated by the point A.

When the light is controlled (that is, the light control level is lowered) such that the further bright synthetic white light is emitted by further operating the operation dial 14a, the driving current supplied to the first LED group D1" increases, and the total luminous flux of the first-order light, which is emitted from the first light emitting unit U1", increases. The increase of the total luminous flux corresponds to the curve portion 36A on the graph of Fig. 36. Further, since the ratio of synthesis of the phosphors is adjusted such that the color temperature of the first-order light emitted from the first light emitting unit U1" is set to about 2050 K, when the first-order light is emitted from only the first light emitting unit U1", the color temperature of the synthetic white light emitted from the light emission apparatus 11" is maintained at about 2050 K. The solid line 37A of Fig. 37 indicates that the total luminous flux increases while the color temperature is maintained.

When the light control level is further lowered by further operating the operation dial 14a, the voltage value of the base voltage Vs, which is applied to the base of the transistor Q1, is controlled by the control section 16 such that the driving current flowing in the first LED group D 1" is not increased, and thus the total luminous flux of the first-order light, which is emitted from the first light emitting unit U1", is not increased. The state where the total luminous flux is not increased is defined as a full lighting state of the first light emitting unit U1". The state where the total luminous flux is not increased corresponds to the straight line portion 36B on the graph of Fig. 36. As described above, the reason why the total luminous flux is not increased is to prevent the LED chips 3 from being heated by the excessive driving current.

In the state where the increase in the total luminous flux of the synthetic white light mentioned above is suppressed, when the light control level is further lowered by further operating the operation dial 14a, the transistor Q2 is also turned on so as to start lighting of the second LED group D2", and thereby the first-order light is also emitted from the second light emitting unit U2". At this time, the control section 16 applies the base voltage $V_S$ to the base of the transistor Q1 so as to maintain the full lighting state of the first light emitting unit U1". In Figs. 36 and 37, the corresponding state is indicated by the point B.

When the light control level is further lowered by further operating the operation dial 14a from the start of lighting of the second LED group D2", the base voltages $V_S$ are applied to the bases of the transistors Q1 and Q2 such that the total luminous flux of the first-order light emitted from the second light emitting unit U2" is increased while the full lighting state of the first light emitting unit U 1" is maintained. The increase of the total luminous flux corresponds to the curve portion 36C on the graph of Fig. 36. Further, since the ratio of synthesis of the phosphors is adjusted such that the color temperature of the first-order light emitted from the second light emitting unit U2" is set to about 2300 K, when the total luminous flux of the first-order light emitted from the second light emitting unit U2" is increased, the color temperature of the synthetic white light emitted from the light emission apparatus 11" is increased to be close to 2300 K. The solid line 37B of Fig. 27 indicates that the color temperature is increased.

When the light control level is further lowered by further operating the operation dial 14a, the voltage value of the base voltage Vs, which is applied to the base of the transistor Q2, is controlled by the control section 16 such that not only the driving current flowing in the first LED group D1" but also the driving current flowing in the second LED group D2" is not increased, and thus the total luminous flux of the first-order light, which is emitted from the second light emitting unit U2", is not increased. That is, the second light emitting unit U2" also reaches the full lighting state. The full lighting states of the first light emitting unit U1" and the second light emitting unit U2" correspond to the straight line portion 36D on the graph of Fig. 36. In addition, when the second light emitting unit U2" reaches the full lighting state, the color temperature of the synthetic white light emitted from the light emission apparatus 11" reaches about 2200 K.

In the state where the second light emitting unit U2" reaches the full lighting state and thereby the increase in the total luminous flux of the synthetic white light mentioned above is suppressed, when the light control level is further lowered by further operating the operation dial 14a, the transistor Q3 is also turned on so as to start lighting of the third LED group D3", and thereby the first-order light is also emitted from the third light emitting unit U3". At this time, the control section 16 applies the base voltages $V_S$ to the bases of the transistors Q1 and Q2 so as to maintain the full lighting states of the first light emitting unit U1" and the second light emitting unit U2". In Figs. 36 and 37, the corresponding state is indicated by the point C.

When the light control level is further lowered by further operating the operation dial 14a from the start of lighting of the third LED group D3", the base voltages Vs are applied to the bases of the transistors Q1, Q2, and Q3 such that the total luminous flux of the first-order light emitted from the third light emitting unit U3" is increased while the full lighting states of the first light emitting unit U1" and the second light emitting unit U2" are maintained. The increase of the total luminous flux corresponds to the curve portion 36E on the graph of Fig. 36. Further, since the ratio of synthesis of the phosphors is adjusted such that the color temperature of the first-order light emitted from the third light emitting unit U3" is set to about 2550 K, when the total luminous flux of the first-order light emitted from the third light emitting unit U3" is increased, the color temperature of the synthetic white light emitted from the light emission apparatus 11" is increased to be close to 2550 K. The solid line 37C of Fig. 37 indicates that the color temperature is increased.

When the light control level is further lowered by further operating the operation dial 14a, the voltage value of the base voltage Vs, which is applied to the base of the transistor Q3, is controlled by the control section 16 such that not only the driving currents flowing in the first LED group D1" and the second LED group D2" but also the driving current flowing in the third LED group D3" is not increased, and thus the total luminous flux of the first-order light, which is emitted from the third light emitting unit U3", is not increased. That is, the third light emitting unit U3" also reaches the full lighting state. The full lighting states of the first light emitting unit U1", the second light emitting unit U2", and the third light emitting unit U3" correspond to the straight line portion 36F on the graph of Fig. 36. In addition, when the third light emitting unit U3" reaches the full lighting state, the color temperature of the synthetic white light emitted from the light emission apparatus 11" reaches about 2470 K.

In the state where the third light emitting unit U3" reaches the full lighting state and thereby the increase in the total luminous flux of the synthetic white light mentioned above is suppressed, when the light control level is further lowered by further operating the operation dial 14a, the transistor Q4 is also turned on so as to start lighting of the fourth LED group D4", and thereby the first-order light is also emitted from the fourth light emitting unit U4". At this time, the control section 16 applies the base voltages $V_S$ to the bases of the transistors Q1, Q2, and Q3 so as to maintain the full lighting states of the first light emitting unit U1", the second light emitting unit U2", and the third light emitting unit U3". In Figs. 36 and 37, the corresponding state is indicated by the point D.

When the light control level is further lowered by further operating the operation dial 14a from the start of lighting of the fourth LED group D4", the base voltages Vs are applied to the bases of the transistors Q1, Q2, Q3, and Q4 such that the total luminous flux of the first-order light emitted from the fourth light emitting unit U4" is increased while the full lighting states of the first light emitting unit U1", the second light emitting unit U2", and the third light emitting unit U3" are maintained. The increase of the total luminous flux corresponds to the curve portion 36G on the graph of Fig. 36. Further, since the ratio of synthesis of the phosphors is adjusted such that the color temperature of the first-order light emitted from the fourth light emitting unit U4" is set to about 2800 K, when the total luminous flux of the first-order light emitted from the fourth light emitting unit U4" is increased, the color temperature of the synthetic white light emitted from the light emission apparatus 11" is increased to be close to 2800 K. The solid line 37D of Fig. 37 indicates that the color temperature is increased.

When the light control level is further lowered by further operating the operation dial 14a, the voltage value of the base voltage $V_S$, which is applied to the base of the transistor Q4, is controlled by the control section 16 such that not only the driving currents flowing in the first LED group D1", the second LED group D2", and the third LED group D3" but also the driving current flowing in the fourth LED group D4" is not increased, and thus the total luminous flux of the first-order light, which is emitted from the fourth light emitting unit U4", is not increased. That is, the fourth light emitting unit U4" also reaches the full lighting state. The full lighting states of the first light emitting unit U1", the second light emitting unit U2", the third light emitting unit U3", and the fourth light emitting unit U4" correspond to the straight line portion 36H on the graph of Fig. 36. In addition, when the fourth light emitting unit U4" reaches the full lighting state, the color temperature of the synthetic white light emitted from the light emission apparatus 11" reaches about 2670 K.

In the state where the fourth light emitting unit U4" reaches the full lighting state and thereby the increase in the total luminous flux of the synthetic white light mentioned above is suppressed, when the light control level is further lowered by further operating the operation dial 14a, the transistor Q5 is also turned on so as to start lighting of the fifth LED group D5", and thereby the first-order light is also emitted from the fifth light emitting unit U5". At this time, the control section 16 applies the base voltages Vs to the bases of the transistors Q1, Q2, Q3, and Q4 so as to maintain the full lighting states of the first light emitting unit U1", the second light emitting unit U2", the third light emitting unit U3", and the fourth light emitting unit U4". In Figs. 36 and 37, the corresponding state is indicated by the point E.

When the light control level is further lowered by further operating the operation dial 14a from the start of lighting of the fifth LED group D5", the base voltages Vs are applied to the bases of the transistors Q1, Q2, Q3, Q4, and Q5 such that the total luminous flux of the first-order light emitted from the fifth light emitting unit U5" is increased while the full lighting states of the first light emitting unit U1", the second light emitting unit U2", the third light emitting unit U3", and the fourth light emitting unit U4" are maintained. The increase of the total luminous flux corresponds to the curve portion 36I on the graph of Fig. 36. Further, since the ratio of synthesis of the phosphors is adjusted such that the color temperature of the first-order light emitted from the fifth light emitting unit U5" is set to about 3100 K, when the total luminous flux of the first-order light emitted from the fifth light emitting unit U5" is increased, the color temperature of the synthetic white light emitted from the light emission apparatus 11" is increased to be close to 3100 K. The solid line 37E of Fig. 37 indicates that the color temperature is increased.

When the light control level is further lowered by further operating the operation dial 14a, the voltage value of the base voltage Vs, which is applied to the base of the transistor Q5, is controlled by the control section 16 such that not only the driving currents flowing in the first LED group D1", the second LED group D2", the third LED group D3", and the fourth LED group D4" but also the driving current flowing in the fifth LED group D5" is not increased, and thus the total luminous flux of the first-order light, which is emitted from the fifth light emitting unit U5", is not increased. That is, the fifth light emitting unit U5" also reaches the full lighting state. The full lighting states of the first light emitting unit U1", the second light emitting unit U2", the third light emitting unit U3", the fourth light emitting unit U4", and the fifth light emitting unit U5" correspond to the straight line portion 36J on the graph of Fig. 36. In addition, in the full lighting states of the first light emitting unit U1", the second light emitting unit U2", the third light emitting unit U3", the fourth light emitting unit U4", and the fifth light emitting unit U5", the color temperature of the synthetic white light emitted from the light emission apparatus 11" does not reach 3100 K, but may reach about 2930 K (the point E in Figs. 36 and 37).

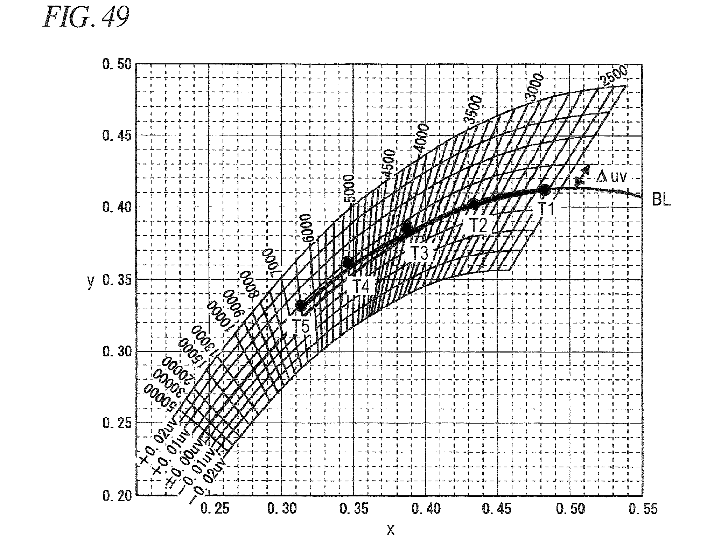

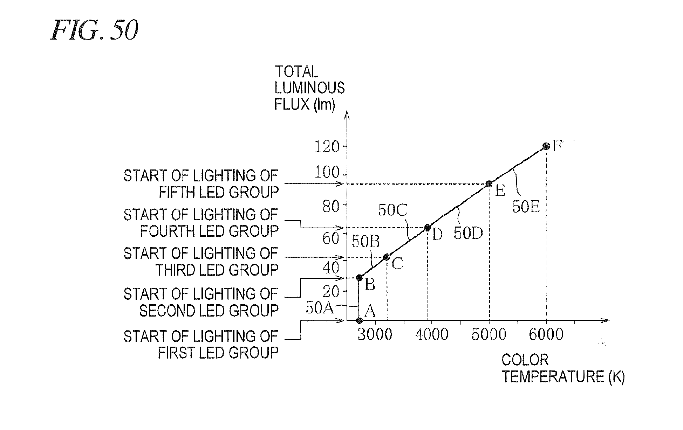

Further, Fig. 49 is an enlarged diagram of a principal section illustrating a relationship between the control curve and the chromaticity point of each light emitting unit of the light emitting section in the xy chromaticity diagram of the CIE (1931) XYZ color coordinate system, when the first wavelength conversion region is set to 2400 K, the second wavelength conversion region is set to 3100 K, the third wavelength conversion region is set to 3900 K, the fourth wavelength conversion region is set to 5000 K, and the fifth wavelength conversion region is set to 6500 K in the third example. Further, Fig. 50 is a graph illustrating a relationship between the total luminous flux of the synthetic white light and the color temperature of the synthetic white light obtained by the illumination system of Fig. 49.

In the above-mentioned control, the transistors Q1, Q2, Q3, Q4, and Q5 are independently turned on in accordance with the light control level. Hence, it is possible to control the timing of the start of the light emission of the LED chips 3a", the timing of the start of the light emission of the LED chips 3b", the timing of the start of the light emission of the LED chips 3c", the timing of the start of the light emission of the LED chips 3d", and the timing of the start of the light emission of the LED chips 3e", in accordance with the light control level. That is, in the light emission apparatus 11" of the present example, it is possible to independently control the timing (light start timing) of lighting the first LED group D1", the second LED group D2", the third LED group D3", the fourth LED group D4", and the fifth LED group D5" in accordance with the light control level. In other words, in the light emission apparatus 11" of the present example, the timing of starting to supply the driving current is different for each LED group. Thus, the corresponding timing of starting to supply the current is set as a current supply start light control level for each LED group in accordance with the light control level, and the LED group to be lighted on is selected on the basis of the relationship between the instruction signal (signal representing the light control level) supplied from the instruction section 14 and the corresponding current supply start light control level.

Further, when the first light emitting unit U1" reaches the full lighting state by starting to light the first LED group D1", lighting of the second LED group D2" is started. Then, while the total luminous flux of the first-order light emitted from the second light emitting unit U2" increases, the full lighting state of the first light emitting unit U1" is maintained.

Hence, after the start of the lighting of the second LED group D2", in accordance with the increase in the total luminous flux of the synthetic white light emitted from the light emission apparatus 11", the color temperature of the synthetic white light also increases. Likewise, while lighting of the third LED group D3" is started and then the total luminous flux of the first-order light emitted from the third light emitting unit U3" increases, the full lighting states of the first light emitting unit U1" and the second light emitting unit U2" are maintained. In addition, while lighting of the fourth LED group D4' is started and then the total luminous flux of the first-order light emitted from the fourth light emitting unit U4" increases, the full lighting states of the first light emitting unit U1", the second light emitting unit U2", the third light emitting unit U3" are maintained. Hence, after the start of the lighting of the third LED group D3" and after the start of the lighting of the fourth LED group D4", in accordance with the increase in the total luminous flux of the synthetic white light emitted from the light emission apparatus 11", the color temperature of the synthetic white light also increases. Furthermore, while lighting of the fifth LED group D5" is started and then the total luminous flux of the first-order light emitted from the fifth light emitting unit U5" increases, the full lighting states of the first light emitting unit U1", the second light emitting unit U2", the third light emitting unit U3", and the fourth light emitting unit U4" are maintained. That is, as the total amount of currents supplied to the plurality of LED groups increases, the respective LED groups are sequentially lighted on. Hence, after the start of the lighting of the fifth LED group D5", in accordance with the increase in the total luminous flux of the synthetic white light emitted from the light emission apparatus 11", the color temperature of the synthetic white light also increases. Generally, when the total luminous flux is low, the white light (that is, the light emitted from the filament electric bulb) with a low color temperature is preferred, and when the total luminous flux is high, the white light (that is, the light emitted from the fluorescent lamp) with a high color temperature is preferred. Accordingly, in the light emission apparatus 11" and the illumination system 12" according to the present example, in accordance with the increase in the total luminous flux of the synthetic white light, the color temperature is simultaneously controlled. Thereby, it is possible to emit the synthetic white light with the color temperature appropriate for the desired total luminous flux and the corresponding total luminous flux.

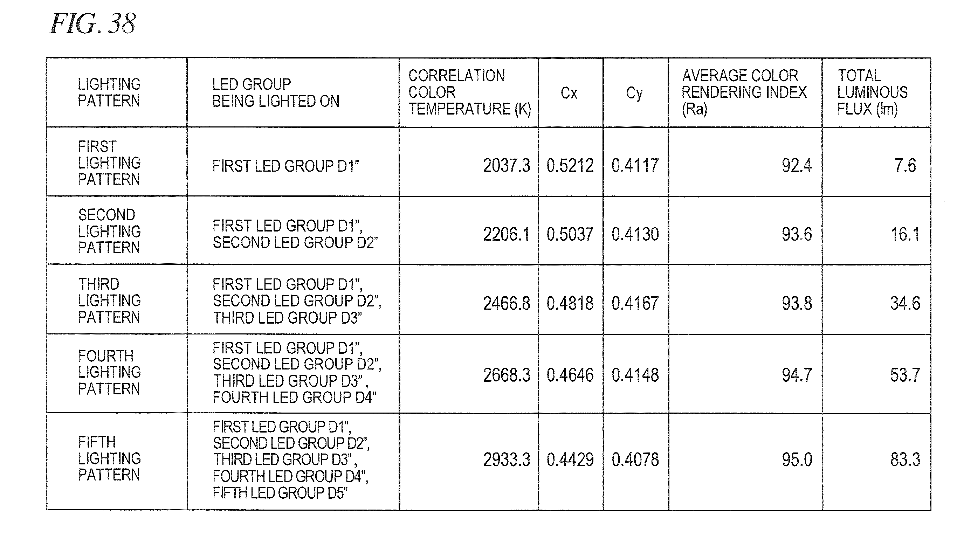

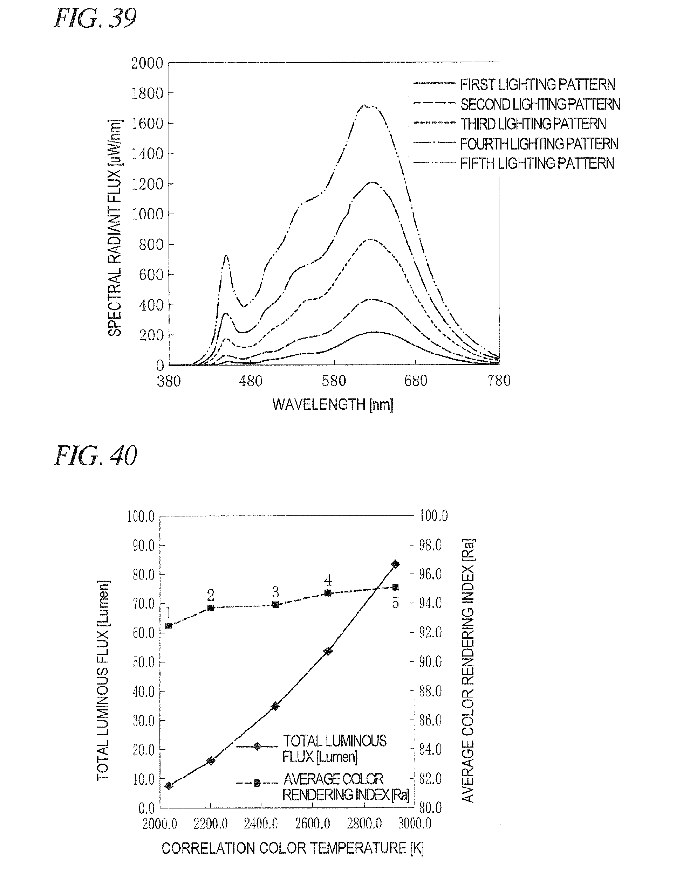

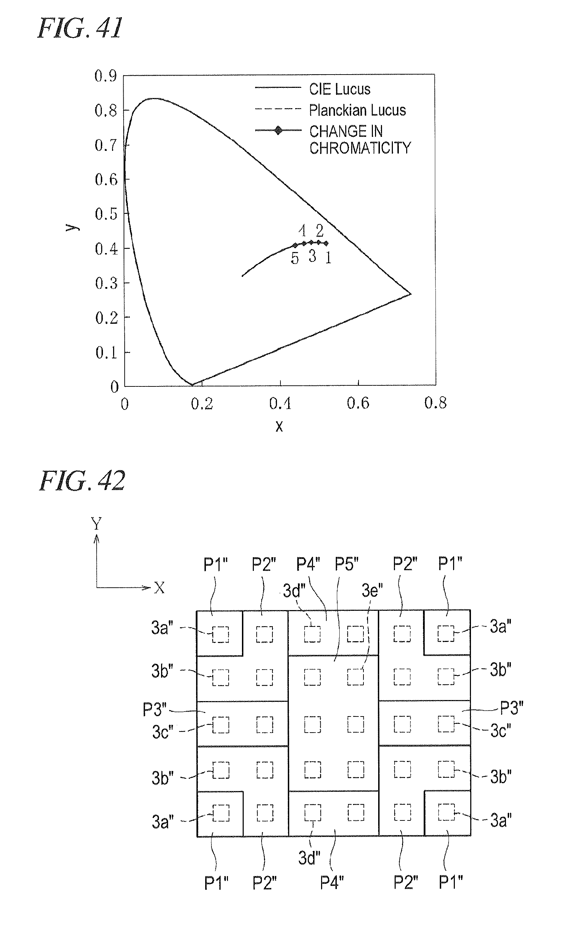

Figs. 38 to 41 show results of ray-tracing simulations of the light emission apparatus of the present example. Fig. 38 shows the correlation color temperatures of the synthetic white light which is emitted from the light emission apparatus 11", the Cx and Cy values based on the CIE1931, average color rendering indices, and simulation results of the total luminous fluxes in the pattern (first lighting pattern) in which only the first LED group D1" is lighted on, the pattern (second lighting pattern) in which the first LED group D1" and the second LED group D2" are lighted on, the pattern (second lighting pattern) in which the first LED group D1" and the second LED group D2" are lighted on, the pattern (third lighting pattern) in which the first LED group D1", the second LED group D2", and the third LED group D3" are lighted on, the pattern (fourth lighting pattern) in which the first LED group D1", the second LED group D2", the third LED group D3", and the fourth LED group D4" are lighted on, and the pattern (fifth lighting pattern) in which the first LED group D1", the second LED group D2", the third LED group D3", the fourth LED group D4", and the fifth LED group D5" are lighted on. Fig. 39 is a graph illustrating spectral radiant flux spectra of the synthetic white light, which is emitted from the light emission apparatus 11", in the first lighting pattern, the second lighting pattern, the third lighting pattern, the fourth lighting pattern, and the fifth lighting pattern. Fig. 40 is a graph illustrating change of the total luminous flux relative to the correlation color temperature and change of the average color rendering index relative to the correlation color temperature, where the simulation result of the correlation color temperature shown in Fig. 38 is indicated by the horizontal axis, the simulation result of the total luminous flux is indicated by the first vertical axis, and the average color rendering index is indicated by the second vertical axis, in the first lighting pattern, the second lighting pattern, the third lighting pattern, the fourth lighting pattern, and the fifth lighting pattern. Fig. 41 is a graph illustrating the simulation results of the Cx and Cy values of the synthetic white light, which is emitted from the light emission apparatus 11" according to the present example, on the color temperature coordinates of the CIE 1931, in the first lighting pattern, the second lighting pattern, the third lighting pattern, the fourth lighting pattern, and the fifth lighting pattern.

(Modified Examples of Pattern Shapes of LED Groups and Wavelength Conversion Regions)

In the above-mentioned example, the fluorescent member 5" is configured such that a single wavelength conversion region is provided for each division, but the invention is not limited to this. For example, as shown in Fig. 42, the fluorescent member 5" may be divided into the first wavelength conversion regions P1", the second wavelength conversion regions P2", the third wavelength conversion regions P3", the fourth wavelength conversion regions P4", and the fifth wavelength conversion region P5".

As shown in Fig. 42, the fluorescent member 5" may be divided into four first wavelength conversion regions P1" having a square shape, four second wavelength conversion regions P2" having L-shapes, two third wavelength conversion regions P3' having rectangular shapes, two fourth wavelength conversion regions P4' having rectangular shapes, and one fifth wavelength conversion region P5" having a rectangular shape. Further, the first wavelength conversion regions P1" are positioned at four corners of the fluorescent member 5", and the second wavelength conversion regions P2" are positioned around the first wavelength conversion regions P1". Furthermore, the third wavelength conversion regions P3" are positioned at the spaces between the second wavelength conversion regions P2" in the Y direction, and the fourth wavelength conversion regions P4" are positioned at the spaces between the second wavelength conversion regions P2" in the X direction. In addition, the fifth wavelength conversion region P5" is positioned at the center of the fluorescent member 5", and is surrounded by the second wavelength conversion region P2", the third wavelength conversion region P3", and the fourth wavelength conversion region P4'. By arranging the first wavelength conversion regions P1", the second wavelength conversion regions P2", the third wavelength conversion regions P3", the fourth wavelength conversion regions P4', and the fifth wavelength conversion region P5" in the above-mentioned manner, the fluorescent member 5" is made to be symmetric with respect to the center axis in the X direction and the center axis in the Y direction.

Further, although not represented by reference signs and numerals, in a similar manner to the above-mentioned example, each LED group corresponding to each wavelength conversion region is provided to be opposed to each wavelength conversion region. In addition, each first LED group D1" opposed to each first wavelength conversion region P1" has one LED chip 3a", each second LED group D2" opposed to each second wavelength conversion region P2" has three LED chips 3b", each third LED group D3" opposed to each third wavelength conversion region P3" has two LED chips 3c", each fourth LED group D4" opposed to each fourth wavelength conversion region P4" has two LED chips 3d", and each fifth LED group D5" opposed to each fifth wavelength conversion region P5" has six LED chips 3e".

In a similar manner to the above-mentioned example, the LED chips 3 in each LED group may be connected in series, or may be connected in parallel.

Further, Literature Kruithof AA: Tubular Luminescence Lamps for General Illumination, Philips Technical Review, 6, pp. 65-96 (1941) describes the illuminance at which a human feels comfortable when the color temperature of the synthetic white light is changed. On the basis of this Literature (hereinafter referred to as Kruithof Literature), if the color temperature of the synthetic white light is intended to be changed while comfort is maintained, it is preferable to control light emission of the light emitting unit at the time of changing the target luminous flux $\phi$ in accordance with the target correlation color temperature T such that such that the constant A0, at which the following inequality expression (1) is established, is present.

$$-80743 \cdot (1000/T)^5 + 164973 \cdot (1000/T)^4 - 135260 \cdot (1000/T)^3 + 57994 \cdot (1000/T)^2 - 13995 \cdot (1000/T) + 1632.9 < \phi/A0 <$$
$$\exp\{-342.11 \cdot (1000/T)^3 + 450.43 \cdot (1000/T)^2 - 212.19 \times (1000/T) + 39.47\} \quad \cdots (1)$$

In the above-mentioned first to third examples, the illuminance of the irradiated surface, which faces the fronts of the light emitting section 1, the light emitting section 1', and the light emitting section 1" and is positioned at the distance R, is $\phi/(\pi \cdot R^2)$. Here, it is assumed that the light distribution of the light emission apparatus is Lambertian. When N light emission apparatuses are provided, by substituting $A0 = \pi \cdot R^2/N$ into the inequality expression (1), it is possible to calculate the target luminous flux appropriate for the target correlation color temperature T. Accordingly, when there is a constant A0 at which the relationship between the color temperature and the total luminous flux of the illumination light emitted by the light emission apparatus satisfies the inequality expression (1) in any case, by appropriately setting R and N, it is possible to realize the color temperature, at which a human feels comfortable, even at any illuminance.

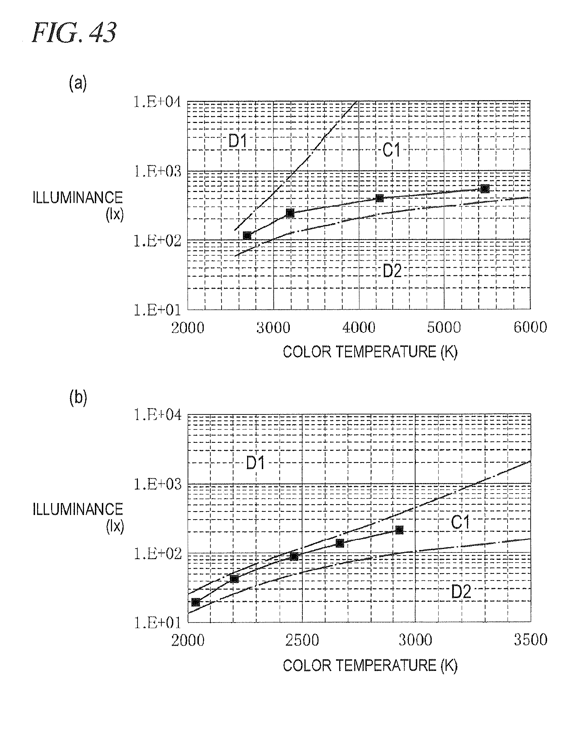

When performing the emission control of the above-mentioned first to third examples, by setting R and N corresponding to A0 at which the relationship between the color temperature and the total luminous flux of the illumination light emitted from the light emission apparatus satisfies the above-mentioned Expression (1), on the basis of the description of Kruithof Literature, it is possible to realize illumination for providing the color temperature, at which a human feels comfortable, in accordance with the illuminance even at any light control level. For example, in the light emission apparatus of the second example, by setting R to 2m and N to 70, it is possible to change the illuminance (total luminous flux) and the color temperature in accordance with the relationship indicated by the solid line in Fig. 43(a). Note that, on the basis of the description of Kruithof Literature, the region C1, which is interposed between the two chain lines in Fig. 43(a), represents a range in which a human feels comfortable, and the other regions D1 and D2 represent ranges in which a human feels uncomfortable. As shown in Fig. 43(a), it was discovered that the illumination light generated from the light emission apparatus is made to provide comfort all the time when the illuminance and the color temperature are changed. Likewise, in the light emission apparatus of the third example, by setting R to 2m and N to 33, it is possible to change the illuminance (total luminous flux) and the color temperature in accordance with the relationship indicated by the solid line in Fig. 43(b). In addition, on the basis of the description of Kruithof Literature, the region C1, which is interposed between the two chain lines in Fig. 43(b), represents a range in which a human feels comfortable, and the other regions D1 and D2 represent ranges in which a human feels uncomfortable. As shown in Fig. 43(b), it was discovered that the illumination light generated from the light emission apparatus is made to provide comfort all the time when the illuminance and the color temperature are changed.

(Effects of The Present Example)

Compared with the light emission apparatus 11 and the illumination system 12 of the first example, the light emission apparatus 11" and the illumination system 12" according to the present example is different in the number of LED groups and the number of wavelength conversion regions, but has the same basic structure. Hence, even in the light emission apparatus 11", the illumination system 12", and the illumination method according to the present example, it is possible to obtain the same effect as the first example. Further, compared with the light emission apparatuses and the illumination systems of the first example and the second example, in the light emission apparatus 11" and the illumination system 12" according to the present example, the number of LED groups and the number of wavelength conversion regions are large. Hence, it is possible to more accurately control the color temperature relative to the change in the luminance of the synthetic white light.

<Fourth Example>

In the above-mentioned first to third examples, the light emission apparatus is configured by using the light emitting unit groups each including the plurality of LED chips 3 mounted on the wiring board 2 and the fluorescent member 5 provided on the transparent board 4. However, the light emission apparatus according to the present invention is not limited to such a form, and may be modified into or replaced with various forms without departing from the technical scope of the present invention. Accordingly, an example of the light emission apparatus, which is configured by using light emitting unit groups different from the light emitting unit groups of the first to third examples, will be described below as a fourth example of the present invention.

(Configuration of Light Emitting Section)

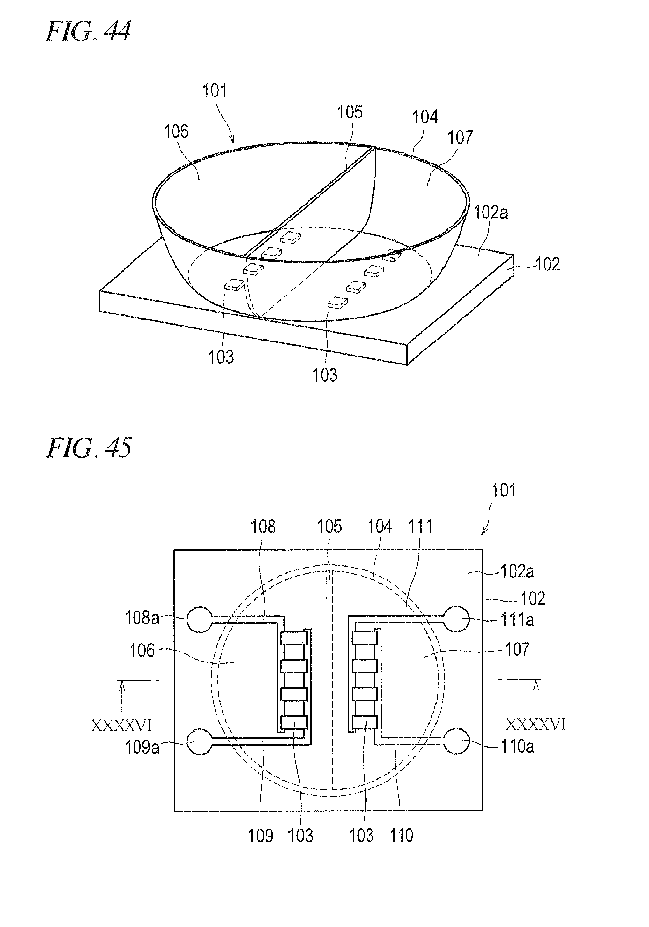

Fig. 44 is a perspective view illustrating a basic configuration of a light emitting section 101 in the light emission apparatus according to the present example. Fig. 45 is a top plan view of the light emitting section 101. The light emitting section 101 includes four LED chips 103 that are mounted in each of two arrays on a chip mounting surface 102a of a wiring board 102 made of alumina ceramic which is excellent in electrical insulation and has a favorable heat dissipation ability. Furthermore, a reflector (wall member) 104 having an annular and truncated cone shape is provided on the chip mounting surface 102a of the wiring board 102 so as to surround the LED chips 103.

The inside of the reflector 104 is partitioned by the partition member 105 into a first region 106 and a second region 107. In the first region 106, the LED chips 103, which belong to one of the two arrays of the LED chips 103, are disposed. In the second region 107, the LED chips 103, which belong to the other array, are disposed. In addition, the reflector 104 and the partition member 105 can be formed of resin, metal, ceramic, or the like, and is fixed onto the wiring board 102 through an adhesive or the like. Further, when a conductive material is used in the reflector 104 and the partition member 105, a process for providing electrical insulation to a wiring pattern to be described later is necessary.

Note that, in the present example, the number of LED chips 103 is just an example, may be increased or decreased as necessary, may be one for each of the first region 106 and the second region 107, and may be different for each region. Further, the material of the wiring board 102 is not limited to the alumina ceramic, and may use various kinds of materials. For example, it may be possible to use a material selected from ceramic, resin, glass epoxy, and composite resin containing a filler as materials with excellent electrical insulation. Furthermore, in order to improve a light emitting efficiency of the light emitting section 101 by enhancing reflectivity of light on the chip mounting surface 102a of the wiring board 102, it is preferable to use silicon resin including a white pigment such as alumina powder, silica powder, magnesium oxide, or titanium oxide. On the other hand, by using a substrate made of metal such as copper or aluminum, it is possible to improve a heat dissipation ability. However, in this case, it is necessary to form the wiring patterns on the wiring board with electrical insulation performed thereon.

Further, the shapes of the above-mentioned reflector 104 and partition member 105 are also just exemplary shapes, may be modified into various shapes as necessary. For example, instead of the reflector 104 and the partition member 105 formed in advance, an annular wall portion (wall member) corresponding to the reflector 104 may be formed on the chip mounting surface 102a of the wiring board 102 by using a dispenser or the like, and thereafter a partition wall (partition member) corresponding to the partition member 105 may be formed. In this case, the material used in the annular wall portion and the partition wall portion is, for example, a UV curable resin material or a thermosetting resin material having a paste form, and thus silicon resin containing an inorganic filter is appropriate therefor.

As shown in Figs. 44 and 45, in the first region 106 inside the reflector 104, the four LED chips 103 are arranged in series so as to be parallel with the extension direction of the partition member 105. In addition, the second region 107 inside the reflector 104, the four LED chips 103 are arranged in series so as to be parallel with the extension direction of the partition member 105. Note that, in Fig. 45, for convenience of description, the reflector 104 and the partition member 105 are indicated by the dashed line.

The wiring patterns 108, 109, 110, and 111 for respectively supplying driving currents to the LED chips 103 are formed on the chip mounting surface 102a of the wiring board 102, as shown in Fig. 45. A connection terminal 108a for external connection is formed at one end of the wiring pattern 108 outside the reflector 104, and the other end side of the pattern inside the first region 106 is provided to extend in parallel with the partition member 105 as shown in Fig. 45. Further, a connection terminal 109a for external connection is formed at one end of the wiring pattern 109 outside the reflector 104, and the other end side of the pattern inside the first region 106 is provided to extend in parallel with the partition member 105 as shown in Fig. 45.

The four LED chips 103 inside the first region 106 are connected in parallel between the wiring pattern 108 and the wiring pattern 109, which are formed as described above, such that the directions of polarities thereof are the same. More specifically, the LED chip 103 has two electrodes (not shown in the drawing) for supplying driving currents on the surface of the wiring board 102 side. In addition, one electrode (p electrode) of the LED chip 103 is connected to the wiring pattern 108, and the other electrode (n electrode) thereof is connected to the wiring pattern 109. Note that, the LED chips 103 are not limited to be connected in parallel, and may be connected to each other in series.

On the other hand, a connection terminal 110a for external connection is formed at one end of the wiring pattern 110 outside the reflector 104, and the other end side of the pattern inside the second region 107 is provided to extend in parallel with the partition member 105 as shown in Fig. 45. Further, a connection terminal 111a for external connection is formed at one end of the wiring pattern 111 outside the reflector 104, and the other end side of the pattern inside the second region 107 is provided to extend in parallel with the partition member 105 as shown in Fig. 45.

The four LED chips 103 inside the second region 107 are connected in parallel between the wiring pattern 110 and the wiring pattern 111, which are formed as described above, such that the directions of polarities thereof are the same. More specifically, one electrode (p electrode) of the LED chip 103 is connected to the wiring pattern 110, and the other electrode (n electrode) thereof is connected to the wiring pattern 111.

By using flip chip mounting, the LED chips 103 are mounted and both electrodes are connected to the respective wiring patterns with an unillustrated metal bump interposed therebetween through the eutectic solder. Note that, the method of mounting the LED chips 103 on the wiring board 102 is not limited to this, and it may be possible to select a method appropriate for the type, the structure, or the like of the LED chips 103. For example, it may be possible to employ double wire bonding which connects the electrodes of the LED chips 103 to the corresponding wiring patterns through wire bonding after the LED chips 103 are fixedly attached to predetermined positions of the wiring board 102 mentioned above. In addition, it may be possible to employ single wire bonding which bonds one electrode to the wiring pattern as described above and connects the other electrode to the wiring pattern through the wire bonding.

The first region 106 and the second region 107 inside the reflector 104 house fluorescent members (wavelength conversion members) respectively having different wavelength conversion characteristics such that the fluorescent members cover the LED chips 103. In the present example, two types of the fluorescent members are employed. Further, the two types of the fluorescent members are formed of three types of phosphors, and the two types of the fluorescent members are different in the mixture ratio of the phosphors. Accordingly, in the description below, the light emitting section in the first region 106 is referred to as a first light emitting section 101A, and the light emitting section in the second region 107 is referred to as a second light emitting section 101B.

The first light emitting section 101A and the second light emitting section 101B have the same structure mentioned above except the fluorescent members, and all the LED chips 103 also have the same type. Here, for convenience of description, the reference sign 103a is assigned to each LED chip positioned in the first region 106, and the reference sign 103b is assigned to each LED chip positioned in the second region 107. The respective members other than the fluorescent members and the LED chips are represented by common reference signs and numerals in the first light emitting section 101A and the second light emitting section 101B.

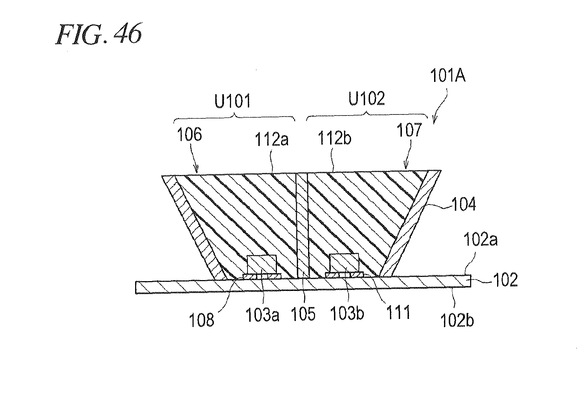

Fig. 46 is a cross-sectional view of the light emitting section 101 taken along the line YXXXVI-XXXXVI of Fig. 45. As shown in Fig. 46, in the light emitting section 101, the first region 106 inside the reflector 104 houses the first fluorescent member (wavelength conversion member) 112a such that the member covers the four LED chips 103a. In addition, the second region 107 inside the reflector 104 houses the second fluorescent member (wavelength conversion member) 112b such that the member covers the four LED chips 103b.

The first fluorescent member 112a is excited by the light emitted by the LED chips 103a, and is formed of a plurality of phosphors, which emits light with wavelengths different from that of the light emitted by the LED chips 103a, and a filler for holding the plurality of phosphors in a distributed manner. Further, the second fluorescent member 112b is excited by the light emitted by the LED chips 103b, and is formed of a plurality of phosphors, which emits light with wavelengths different from that of the light emitted by the LED chips 103b, and a filler for holding the plurality of phosphors in a distributed manner. In addition, as the filler, it may be possible to use thermoplastic resin, thermosetting resin, photo curable resin, glass, or the like.

Accordingly, in the present example, the respective combinations of the first and second fluorescent member 112a and 112b and the LED chips 103a and 103b, which are used to correspond thereto, correspond to the respective light emitting units of the present invention. Here, the term "used to correspond" means a situation in which the first fluorescent member 112a is provided to cover the LED chips 103a, the second fluorescent member 112b is provided to cover the LED chips 103b, the wavelength of the light emitted from the LED chips 103a is converted by the first fluorescent member 112a, and the wavelength of the light emitted from the LED chips 103b is converted by the second fluorescent member 112b. Therefore, the LED chips 103a and the first fluorescent member 112a constitute a first light emitting unit U101, and the LED chips 103b and the second fluorescent member 112b constitute a second light emitting unit U102. Further, integrated one of the two types of the light emitting units corresponds to the light emitting unit group of the present invention. Note that, in the description below, light, which is emitted by each of the first light emitting unit U101 and the second light emitting unit U102, is referred to as first-order light, and light, which is formed by synthesizing the first-order light emitted by each of the first light emitting unit U101 and the second light emitting unit U102 and is emitted from the light emitting section 101, is referred to as synthetic white light.

(LED Chip)

As the LED chips 103a and 103b, in the present example, the LED chips emitting the blue light with a peak wavelength of 460 nm are used. Specifically, as such an LED chip, there is a GaN LED chip in which for example an InGaN semiconductor is used in a light emitting layer. Note that, the emission wavelength characteristic and the type of the LED chip 103 is not limited to this, and it may be possible to employ the semiconductor light emitting elements such as various LED chips without departing from the technical scope of the present invention. In the present example, it is preferable that the peak wavelengths of the light emitted by the LED chips 103a and 103b be in the wavelength range of 420 nm to 500 nm.

(Fluorescent Member)

In a similar manner to the first wavelength conversion region P1 of the fluorescent member 5 of the first example, the first fluorescent member 112a is configured to emit the first-order light with the chromaticity of the chromaticity point T1 (about 2700 K) in the xy chromaticity diagram of the CIE (1931) XYZ color coordinate system of Fig. 5. That is, the mixture ratio of the phosphors of the first fluorescent member 112a is the same as that of the first wavelength conversion region P1 of the fluorescent member 5 in the first example. Further, in a similar manner to the second wavelength conversion region P2 of the fluorescent member 5 of the first example, the second fluorescent member 112b is configured to emit the first-order light with the chromaticity of the chromaticity point T2 (about 6500 K) in the xy chromaticity diagram of the CIE (1931) XYZ color coordinate system of Fig. 5. That is, the mixture ratio of the phosphors of the second fluorescent member 112b is the same as that of the second wavelength conversion region P2 of the fluorescent member 5 in the first example. Accordingly, in the present example, as the red phosphor, $(Sr, Ca)_1AlSiN_3$:Eu is used, as the green phosphor, $Ca_3(Sc, Mg)_2Si_3O_{12}$:Ce is used, and as the yellow phosphor, $Y_3Al_5O_{12}$:Ce is used. Further, as shown in Fig. 6, the mixture ratio of the phosphors in the first wavelength conversion region P1 is set such that red phosphor: green phosphor: yellow phosphor = 0.24: 1: 0.05, the mixture ratio of the phosphors in the second wavelength conversion region P2 is set such that red phosphor: green phosphor: yellow phosphor = 0: 0.9: 0.1.

By determining the mixture ratio of the phosphors as described above, it is possible to make the color temperature of the first-order light emitted from the second light emitting unit U102 higher than the color temperature of the first-order light emitted from the first light emitting unit U101.

In addition, in a similar manner to the first example, it is not necessary for the first fluorescent member 112a and the second fluorescent member 112b to hold all the above-mentioned red phosphor, green phosphor, and yellow phosphor in a distributed manner, and if the desired first-order light can be emitted from the first fluorescent member 112a and the second fluorescent member 112b, one type or two or more types of phosphors may be selected from the above-mentioned phosphors. For example, the first fluorescent member 112a and the second fluorescent member 112b may hold the red phosphor and the green phosphor in a distributed manner, and may not hold the yellow phosphor in a distributed manner. The other specific composition, structure, and the like of the phosphors are the same as those of the first example.

(Electric Circuit Configuration of Light Emission apparatus and Control of Light Emitting Section)

As described above, in the light emission apparatus of the present example, the color temperatures of the first-order light, which are respectively emitted from the first light emitting unit U101 and the second light emitting unit U102, are set to be different from each other, and the synthetic white light, which is generated by synthesizing the first-order light emitted from the light emitting units, is emitted from the light emission apparatus. Therefore, in the light emission apparatus of the present example, by changing the total luminous flux (that is, emission intensity or luminance) of the first-order light emitted from each of the first light emitting unit U101 and the second light emitting unit U102, the total luminous flux of the synthetic white light emitted from the light emission apparatus is adjusted, and the color temperature of the synthetic white light is changed in accordance with the corresponding total luminous flux of the synthetic white light so as to emit the synthetic white light with the color temperature appropriate for the desired total luminous flux and the corresponding total luminous flux mentioned above. Accordingly, compared with the light emission apparatus 11 of the first example, the light emission apparatus of the present example has a different exterior configuration, and the first fluorescent member 112a and the second fluorescent member 112b have the same mixture ratios as the first wavelength conversion region P1 and the second wavelength conversion region P2 of the light emitting section 1 of the first example. Hence, the circuit configuration of the inside is the same as the circuit configuration of the light emission apparatus 11. That is, the present example uses a structure in which the first wavelength conversion region P1 and the second wavelength conversion region P2 of the first example are provided to be separated. Therefore, description of the control of the light emitting section and the electric circuit configuration of the light emission apparatus of the present example will be omitted.

(Modified Example of Light Emitting Section)

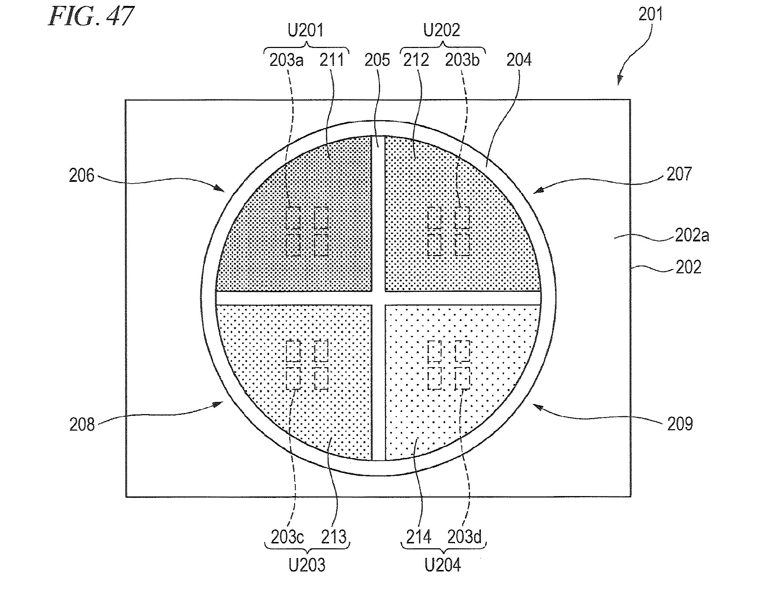

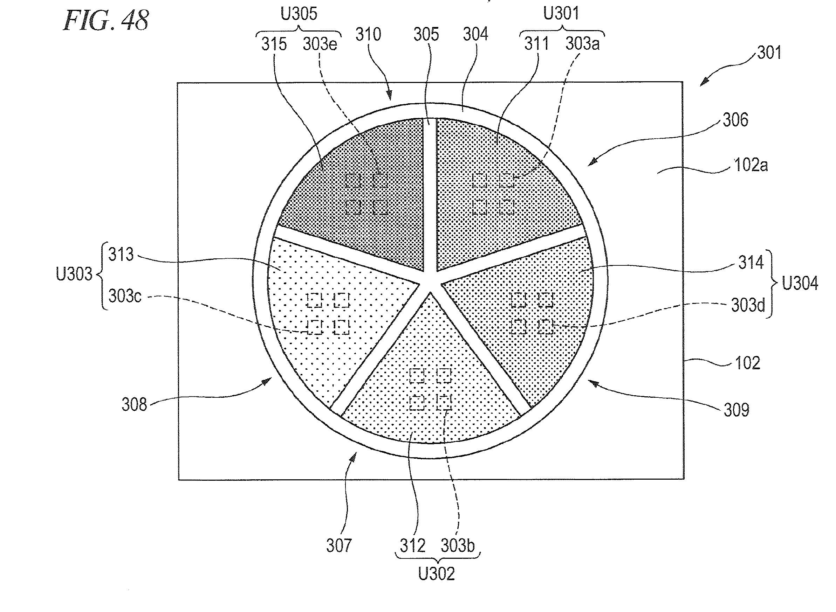

In the above-mentioned example, by dividing the reflector 104 through the partition member 105, the first region 106 and the second region 107 are formed, the LED chips 103a and the first fluorescent member 112a are provided in the first region 106, and the LED chips 103b and the second fluorescent member 112b are provided in the second region 107, but the invention is not limited to such a structure. However, the invention is not limited to the structure, and the light emitting section 201 or the light emitting section 301 having the structure shown in Fig. 47 or 48 may be used in the light emission apparatus. Note that, Figs. 47 and 48 are top plan views of the light emitting section 201 and the light emitting section 301.

In the light emitting section 201 shown in Fig. 47, the partition member 205 having a cross-shape partitions the inner region of the reflector 104 into four regions of a first region 206, a second region 207, a third region 208, and a fourth region 209. Specifically, in plan view of the light emitting section 201, the first region 206, the second region 207, the third region 208, and the fourth region 209 have the same shapes and the same areas. That is, the first region 206, the second region 207, the third region 208, and the fourth region 209 are disposed to be symmetric with respect to the intersection point of the partition member 205 as the center thereof.

In the first region 206, the four LED chips 203a and the first fluorescent member 211, which covers the four LED chips 203a, are provided. Accordingly, the four LED chips 203a and the first fluorescent member 211 constitute the first light emitting unit U201. Further, in the second region 207, the four LED chips 203b and the second fluorescent member 212, which covers the four LED chips 203b, are provided. Accordingly, the four LED chips 203b and the second fluorescent member 212 constitute the second light emitting unit U202. Furthermore, in the third region 208, the four LED chips 203c and the third fluorescent member 213, which covers the four LED chips 203c, are provided. Accordingly, the four LED chips 203c and the third fluorescent member 213 constitute the third light emitting unit U203. In addition, in the fourth region 209, the four LED chips 203d and the fourth fluorescent member 214, which covers the four LED chips 203d, are provided. Accordingly, the four LED chips 203d and the fourth fluorescent member 214 constitute the fourth light emitting unit U204. Note that, in Fig. 47, in order to distinguish emission colors of the respective phosphors, the respective phosphors are represented by dot hatch patterns.

In a similar manner to the first wavelength conversion region P1' of the fluorescent member 5' of the second example, the first fluorescent member 211 is configured to emit the first-order light with the chromaticity of the chromaticity point T1 (about 2700 K) in the xy chromaticity diagram of the CIE (1931) XYZ color coordinate system of Fig. 21. That is, the mixture ratio of the phosphors of the first fluorescent member 211 is the same as that of the first wavelength conversion region P1' of the fluorescent member 5' in the second example. Further, in a similar manner to the second wavelength conversion region P2' of the fluorescent member 5' af the second example, the second fluorescent member 212 is configured to emit the first-order light with the chromaticity of the chromaticity point T2 (about 3400 K) in the xy chromaticity diagram of the CIE (1931) XYZ color coordinate system of Fig. 21. That is, the mixture ratio of the phosphors of the second fluorescent member 212 is the same as that of the second wavelength conversion region P2' of the fluorescent member 5' in the second example. Furthermore, in a similar manner to the third wavelength conversion region P3' of the fluorescent member 5' of the second example, the third fluorescent member 213 is configured to emit the first-order light with the chromaticity of the chromaticity point T3 (about 4500 K) in the xy chromaticity diagram of the CIE (1931) XYZ color coordinate system of Fig. 21. That is, the mixture ratio of the phosphors of the third fluorescent member 213 is the same as that of the third wavelength conversion region P3' of the fluorescent member 5' in the second example. In addition, in a similar manner to the fourth wavelength conversion region P4' of the fluorescent member 5' of the second example, the fourth fluorescent member 214 is configured to emit the first-order light with the chromaticity of the chromaticity point T4 (about 6500 K) in the xy chromaticity diagram of the CIE (1931) XYZ color coordinate system of Fig. 21. That is, the mixture ratio of the phosphors of the fourth fluorescent member 214 is the same as that of the fourth wavelength conversion region P4' of the fluorescent member 5' in the second example.

Accordingly, in the light emitting section 201 shown in Fig. 47, as the red phosphor, $(Sr, Ca)_1AlSiN_3$:Eu is used,

as the green phosphor, $Ca_3(Sc, Mg)_2Si_3O_{12}$:Ce is used, and as the yellow phosphor, $Y_3Al_5O_{12}$:Ce is used. Further, as shown in Fig. 22, the mixture ratio of the phosphors in the first wavelength conversion region P1' is set such that red phosphor: green phosphor: yellow phosphor = 0.24: 1: 0.05, and the mixture ratio of the phosphors in the second wavelength conversion region P2' is set such that red phosphor: green phosphor: yellow phosphor = 0.15: 1: 0.05. In addition, the mixture ratio of the phosphors in the third wavelength conversion region P3' is set such that red phosphor: green phosphor: yellow phosphor = 0.05: 1: 0.05, and the mixture ratio of the phosphors in the fourth wavelength conversion region P4' is set such that red phosphor: green phosphor: yellow phosphor = 0: 0.9: 0.1.

By determining the mixture ratio of the phosphors as described later, it is possible to set the magnitudes of the color temperatures of the first-order light emitted from the first light emitting unit U201, the second light emitting unit U202, the third light emitting unit U203, and the fourth light emitting unit U204 in order of the first light emitting unit U201, the second light emitting unit U202, the third light emitting unit U203, and the fourth light emitting unit U204.

In addition, in a similar manner to the second example, it is not necessary for the first fluorescent member 211, the second fluorescent member 212, the third fluorescent member 213, and the fourth fluorescent member 214 to hold all the above-mentioned red phosphor, green phosphor, and yellow phosphor in a distributed manner, and if the desired first-order light can be emitted from the first fluorescent member 211, the second fluorescent member 212, the third fluorescent member 213, and the fourth fluorescent member 214, one type or two or more types of phosphors may be selected from the above-mentioned phosphors. For example, the first fluorescent member 211, the second fluorescent member 212, the third fluorescent member 213, and the fourth fluorescent member 214 may hold the red phosphor and the green phosphor in a distributed manner, and may not hold the yellow phosphor in a distributed manner. The other specific composition, structure, and the like of the phosphors are the same as those of the first example.

In addition, compared with the light emitting section 1' of the second example, the light emission apparatus 201 shown in Fig. 47 has a different exterior configuration, and the first fluorescent member 211, the second fluorescent member 212, the third fluorescent member 213, and the fourth fluorescent member 214 have the same mixture ratios as the first wavelength conversion region P1', the second wavelength conversion region P2', the third wavelength conversion region P3', and the fourth wavelength conversion region P4' of the light emitting section 1' of the second example. Hence, the circuit configuration of the inside is the same as the circuit configuration of the light emission apparatus 11' of the second example. That is, the light emission apparatus 201 shown in Fig. 47 uses a structure in which the first wavelength conversion region P1', the second wavelength conversion region P2', the third wavelength conversion region P3', and the fourth wavelength conversion region P4' of the second example are provided to be separated. Therefore, description of the control of the light emitting section and the electric circuit configuration of the light emission apparatus of the present example will be omitted.

In the light emitting section 301 shown in Fig. 48, the partition member 305 partitions the inner region of the reflector 104 into five regions of a first region 306, a second region 307, a third region 308, a fourth region 309, and a fifth region 310. Specifically, in plan view of the light emitting section 301, the partition member 305 is provided to radiate out from the center of the reflector 104, and the first region 306, the second region 307, the third region 308, the fourth region 309, and the fifth region 310 have the same shapes and the same areas.

In the first region 306, the four LED chips 303a and the first fluorescent member 311, which covers the four LED chips 303a, are provided. Accordingly, the four LED chips 303a and the first fluorescent member 311 constitute the first light emitting unit U301. Further, in the second region 307, the four LED chips 303b and the second fluorescent member 312, which covers the four LED chips 303b, are provided. Accordingly, the four LED chips 303b and the second fluorescent member 312 constitute the second light emitting unit U302. Furthermore, in the third region 308, the four LED chips 303c and the third fluorescent member 313, which covers the four LED chips 303c, are provided. Accordingly, the four LED chips 303c and the third fluorescent member 313 constitute the third light emitting unit U303. In addition, in the fourth region 309, the four LED chips 303d and the fourth fluorescent member 314, which covers the four LED chips 303d, are provided. Accordingly, the four LED chips 303d and the fourth fluorescent member 314 constitute the fourth light emitting unit U304. Likewise, in the fifth region 310, the four LED chips 303e and the fifth fluorescent member 315, which covers the four LED chips 303e, are provided. Accordingly, the four LED chips 303e and the fifth fluorescent member 315 constitute the fifth light emitting unit U305. Note that, in Fig. 48, in order to distinguish emission colors of the respective phosphors, the respective phosphors are represented by dot hatch patterns.

In a similar manner to the first wavelength conversion region P1" of the fluorescent member 5" of the third example, the first fluorescent member 311 is configured to emit the first-order light with the chromaticity of the chromaticity point T1 (about 2050 K) in the xy chromaticity diagram of the CIE (1931) XYZ color coordinate system of Fig. 33. That is, the mixture ratio of the phosphors of the first fluorescent member 311 is the same as that of the first wavelength conversion region P1" of the fluorescent member 5" in the third example. Further, in a similar manner to the second wavelength conversion region P2" of the fluorescent member 5" of the third example, the second fluorescent member 312 is configured to emit the first-order light with the chromaticity of the chromaticity point T2 (about 2300 K) in the xy chromaticity diagram of the CIE (1931) XYZ color coordinate system of Fig. 33. That is, the mixture ratio of the phosphors of the second fluorescent member 312 is the same as that of the second wavelength conversion region P2" of the fluorescent member 5" in the third example. Furthermore, in a similar manner to the third wavelength conversion region P3" of the fluorescent member 5" of the third example, the third fluorescent member 313 is configured to emit the first-order light with the chromaticity of the chromaticity point T3 (about 2550 K) in the xy chromaticity diagram of the CIE (1931) XYZ color coordinate system of Fig. 33. That is, the mixture ratio of the phosphors of the third fluorescent member 313 is the same as that of the third wavelength conversion region P3" of the fluorescent member 5" in the third example. In addition, in a similar manner to the fourth wavelength conversion region P4" of the fluorescent member 5" of the third example, the fourth fluorescent member 314 is configured to emit the first-order light with the chromaticity of the chromaticity point T4 (about 2800 K) in the xy chromaticity diagram of the CIE (1931) XYZ color coordinate system of Fig. 33. That is, the mixture ratio of the phosphors of the fourth fluorescent member 314 is the same as that of the fourth wavelength conversion region P4" of the fluorescent member 5" in the third example. Likewise, in a similar manner to the fifth wavelength conversion region P5" of the fluorescent member 5" of the third example, the fifth fluorescent member 315 is configured to emit the first-order light with the chromaticity of the chromaticity point T5 (about 3100 K) in the xy chromaticity diagram of the CIE (1931) XYZ color coordinate system of Fig. 33. That is, the mixture ratio of the phosphors of the fifth fluorescent member 315 is the same as that of the fifth wavelength conversion region P5" of the fluorescent member 5" in the third example.

Accordingly, in the light emitting section 301 shown in Fig. 48, as the red phosphor, $(Sr, Ca)_1AlSiN_3:Eu$ is used, as the green phosphor, $Ca_3(Sc, Mg)_2Si_3O_{12}:Ce$ is used, and as the yellow phosphor, $Y_3Al_5O_{12}:Ce$ is used. Further, as shown in Fig. 34, the mixture ratio of the phosphors in the first wavelength conversion region P1" is set such that red phosphor: green phosphor: yellow phosphor = 0.35: 1: 0.05, and the mixture ratio of the phosphors in the second wavelength conversion region P2" is set such that red phosphor: green phosphor: yellow phosphor = 0.30: 1: 0.05. In addition, the mixture ratio of the phosphors in the third wavelength conversion region P3" is set such that red phosphor: green phosphor: yellow phosphor = 0.20: 1: 0.05, the mixture ratio of the phosphors in the fourth wavelength conversion region P4" is set such that red phosphor: green phosphor: yellow phosphor = 0.175: 1.0: 0.05, and the mixture ratio of the phosphors in the fifth wavelength conversion region P5" is set such that red phosphor: green phosphor: yellow phosphor = 0.150: 1.0: 0.05.

By determining the mixture ratio of the phosphors as described later, it is possible to set the magnitudes of the color temperatures of the first-order light emitted from the first light emitting unit U301, the second light emitting unit U302, the third light emitting unit U303, the fourth light emitting unit U304, and the fifth light emitting unit U305 in order of the first light emitting unit U301, the second light emitting unit U302, the third light emitting unit U303, the fourth light emitting unit U304, and the fifth light emitting unit U305.

In addition, in a similar manner to the third example, it is not necessary for the first fluorescent member 311, the second fluorescent member 312, the third fluorescent member 313, the fourth fluorescent member 314, and the fifth fluorescent member 315 to hold all the above-mentioned red phosphor, green phosphor, and yellow phosphor in a distributed manner. If the desired first-order light can be emitted from the first fluorescent member 311, the second fluorescent member 312, the third fluorescent member 313, the fourth fluorescent member 314, and the fifth fluorescent member 315, one type or two or more types of phosphors may be selected from the above-mentioned phosphors. For example, the first fluorescent member 311, the second fluorescent member 312, the third fluorescent member 313, the fourth fluorescent member 314, and the fifth fluorescent member 315 may hold the red phosphor and the green phosphor in a distributed manner, and may not hold the yellow phosphor in a distributed manner. The other specific composition, structure, and the like of the phosphors are the same as those of the first example.

In addition, compared with the light emitting section 1" of the third example, the light emission apparatus 301 shown in Fig. 48 has a different exterior configuration, and the first fluorescent member 311, the second fluorescent member 312, the third fluorescent member 313, the fourth fluorescent member 314, and the fifth fluorescent member 315 have the same mixture ratios as the first wavelength conversion region P1", the second wavelength conversion region P2", the third wavelength conversion region P3", the fourth wavelength conversion region P4", and the fifth wavelength conversion region P5" of the light emitting section 11" of the third example. Hence, the circuit configuration of the inside is the same as the circuit configuration of the light emission apparatus 11" of the third example. That is, the light emission apparatus 301 shown in Fig. 48 uses a structure in which the first wavelength conversion region P1", the second wavelength conversion region P2", the third wavelength conversion region P3", the fourth wavelength conversion region P4", and the fifth wavelength conversion region P5" of the third example are provided to be separated. Therefore, description of the control of the light emitting section and the electric circuit configuration of the light emission apparatus of the present example will be omitted.

(Effects of The Present Example)

Compared with the light emission apparatus 11 and the illumination system 12 of the first example, the light emission apparatus and the illumination system according to the present example is different in the number of LED groups and the number of wavelength conversion regions, but has the same basic structure. Hence, even in the light emission apparatus, the illumination system, and the illumination method according to the present example, it is possible to obtain the same effect as the first example.

<Fifth Example>

(Configuration of Light Emitting Section)

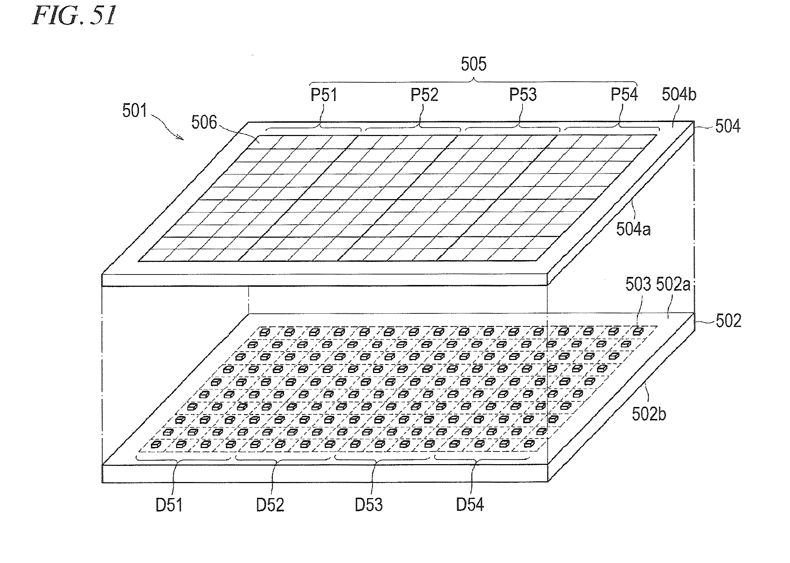

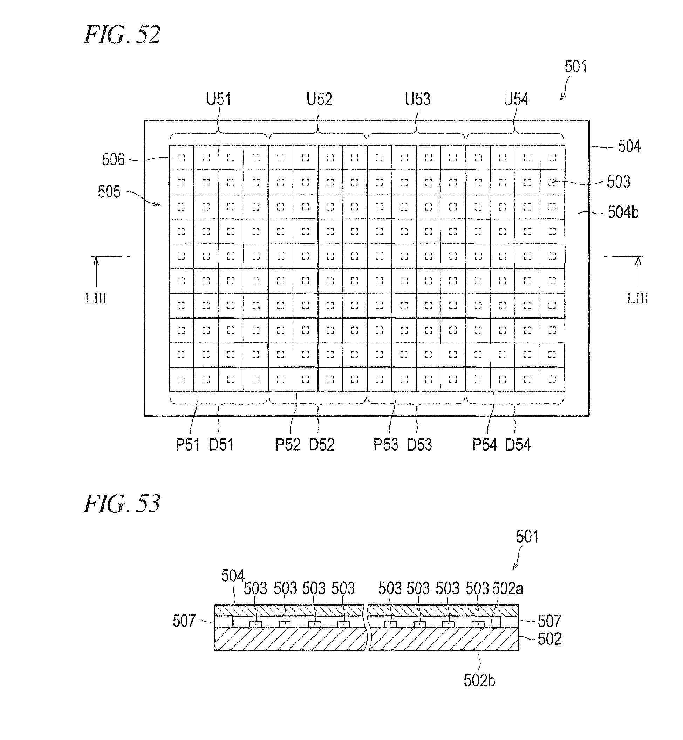

Fig. 51 is a perspective view illustrating an overview of an overall configuration of a light emitting section 501 in the illumination apparatus (light emission apparatus) according to the present example. Fig. 52 is a top plan view of the light emitting section 501 of Fig. 51. As shown in Fig. 51, the light emitting section 501 includes a wiring board 502 made of alumina ceramic which is excellent in electrical insulation and has a favorable heat dissipation ability. On a chip mounting surface 502a of the wiring board 502, a total of 160 LED chips 503 are equidistantly arranged in a matrix of 10 in the widthwise direction and 16 in the lengthwise direction of the wiring board 502. Although not shown in Fig. 51, wiring patterns for respectively supplying the LED chips 503 with electric powers are formed on wiring board 502, and constitute an electric circuit to be described later.

In addition, the material of the wiring board 502 is not limited to the alumina ceramic, and the main body of the wiring board 502 may be formed of a material selected from, for example, resin, glass epoxy, and composite resin containing a filler as materials with excellent electrical insulation. Alternatively, in order to improve a light emitting efficiency of the light emitting section 501 by enhancing reflectivity of light on the chip mounting surface 502a of the wiring board 502, it is preferable to use silicon resin including a white pigment such as alumina powder, silica powder, magnesium oxide, or titanium oxide. On the other hand, in order to obtain a further excellent heat dissipation ability, the main body of the wiring board 502 may be made of metal. In this case, it is necessary to electrically insulate the wiring patterns and the like of the wiring board 502 from the main body made of metal.

As shown in Fig. 51, a transparent board 504, which is made of glass and has a plate shape, is disposed to be opposed to the chip mounting surface 502a of the wiring board 502 on which the LED chips 503 are mounted. Note that, for convenience, Fig. 51 shows a situation in which the wiring board 502 and the transparent board 504 are separated, but as described later, the wiring board 502 and the transparent board 504 are practically disposed to be close to each other. In addition, the material of the transparent board 504 is not limited to glass, and the transparent board 504 may be formed of resin, which is transparent to the light emitted by the LED chips 503, or the like.

A fluorescent member (wavelength conversion member) 505 is provided on the second surface 504b of the transparent board 504, which is opposite to the first surface 504a facing the wiring board 502, so as to cover the LED chips 503 mounted on the wiring board 502. Accordingly, the fluorescent member 505 is disposed at a position where it is opposed to the chip mounting surface 502a of the wiring board 502 with the transparent board 504 interposed therebetween. The fluorescent member 505 is divided into a plurality of cell regions 506 corresponding to the respective LED chips 503 which are positioned to be opposed thereto. As shown in Fig. 52 in plan view of the light emitting section 501, each corresponding LED chip 503 is positioned at the center of each cell region 506. Accordingly, the fluorescent member 505 is divided into 160 cell regions 506 of which the number is equal to the number of the LED chips 503.

As described later in detail, the fluorescent member 505 has a function of converting the wavelength of the light emitted by the LED chips 503 and emitting light with a peak wavelength different from the light emitted by the LED chips 503. As described above, since the fluorescent member 505 is divided into 160 cell regions 506, each cell region 506 is provided to correspond to each LED chip 503. Therefore, light emitted for the respective cell regions 506 corresponding to the LED chips 503, which are emitting light, are synthesized and emitted from the fluorescent member 505. Then, the light emitted from the fluorescent member 505 becomes illumination light of the illumination apparatus of the present example.

Such cell regions 506 are grouped, as shown in Figs. 51 and 52, into a first wavelength conversion region P51, a second wavelength conversion region P52, a third wavelength conversion region P53, and a fourth wavelength conversion region P54 each having 40 cell regions. Accordingly, in other words, the fluorescent member 505 is divided into four wavelength conversion regions of the first wavelength conversion region P51, the second wavelength conversion region P52, the third wavelength conversion region P53, and the fourth wavelength conversion region P54, where each wavelength conversion region is divided into 40 cell regions 506.

In accordance with the division of the fluorescent member 505, the LED chips 503 mounted on the wiring board 502 are grouped into respective LED groups corresponding to respective positions of the first wavelength conversion region P51, the second wavelength conversion region P52, the third wavelength conversion region P53, and the fourth wavelength conversion region P54 as shown in Fig. 51. In the description below, in order to distinguish the LED chips 503 for each wavelength conversion region, a, b, c, and d are respectively attached to the tail end of the reference sign thereof so as to correspond to the first wavelength conversion region P51, the second wavelength conversion region P52, the third wavelength conversion region P53, and the fourth wavelength conversion region P54.

That is, the 40 LED chips 503a positioned to correspond to the first wavelength conversion region P51 constitute a first LED group D51, and the 40 LED chips 503b positioned to correspond to a second wavelength conversion region P52 constitute a second LED group D52. In addition, the 40 LED chips 503c positioned to correspond to the third wavelength conversion region P53 constitute a third LED group D53, and the 40 LED chips 503d positioned to correspond to the fourth wavelength conversion region P54 constitute a fourth LED group D54.

Accordingly, in the present example, respective combinations of the first to fourth wavelength conversion regions P51 to P54 and first to fourth LED groups D51 to D54 corresponding thereto correspond to respective light emitting units of the present invention. That is, the first LED group D51 and the first wavelength conversion region P51 constitute a first light emitting unit U51, and the second LED group D52 and the second wavelength conversion region P52 constitute a second light emitting unit U52. Further, the third LED group D53 and the third wavelength conversion region P53 constitute a third light emitting unit U53, and the fourth LED group D54 and the fourth wavelength conversion region P54 constitute a fourth light emitting unit U54. A light emitting section 501, in which the four light emitting units are integrated, corresponds to a light emitting unit group of the present invention. Note that, in the description below, light, which is emitted by each of the first to fourth light emitting units U51 to U54, is referred to as first-order light, and light, which is formed by synthesizing the first-order light emitted by each of the first to fourth light emitting units U51 to U54 and is emitted from the light emitting section 501, is referred to as synthetic light.

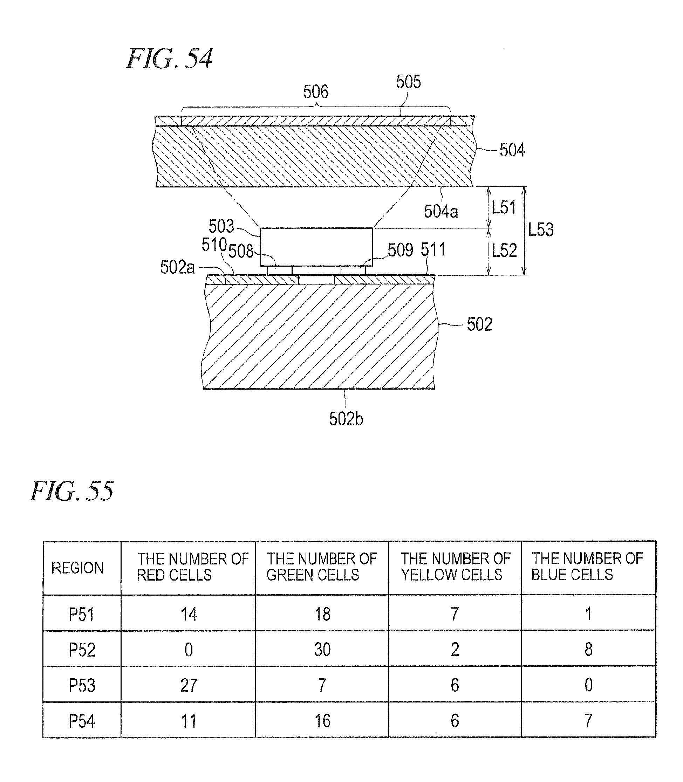

Fig. 53 is a cross-sectional view of the light emitting section 501 taken along the line LIII-LIII of Fig. 52. Fig. 54 is an enlarged cross-sectional view of a principal section. As shown in Fig. 53, the transparent board 504 is bonded to the wiring board 502 with a plurality of spacers 507 interposed therebetween, by interposing the spacers 507, as shown in Fig. 54, a clearance is provided between the transparent board 504 and the LED chips 503.

The clearance provided herein is formed with a distance L51 calculated in advance such that the light emitted from the LED chip 503 reliably reaches the cell region 506 of the fluorescent member 505 positioned to correspond to the LED chip 503 and an amount of light, which leaks to the different cell regions 506 adjacent to the corresponding cell region 506 is reduced. That is, for example, as shown in Fig. 54, the light emitted from the LED chip 503 reaches the transparent board 504 in the range indicated by the chain line of Fig. 54, thereafter passes through the transparent board 504, and reaches the fluorescent member 505. At this time, the clearance distance L51 is determined such that the extent of reaching of the light of the fluorescent member 505 is in the range of the cell region 506 provided to correspond to the LED chip 503.

In order to achieve this, in the present example, the space between the LED chip 503 and the fluorescent member 505 should be less than or equal to 5 mm, and thus the clearance distance L51 is determined such that a total thickness of the clearance and the transparent board 504 is less than or equal to 5 mm. It is the same for all the LED chips 503 in the present example. By providing the clearance with the distance L51, it is possible to reliably prevent light from leaking to other adjacent cell regions. As a result, by adopting the configuration in which the fluorescent member 505 is positioned to be opposed to the LED chip 503 together with the above configuration, it is possible to accurately perform the wavelength conversion in the fluorescent member 505, and it is possible to ensure high light emitting efficiency.

In addition, when the LED chips 503 are made to be as close to the corresponding cell regions 506 as possible, the light emitted by the LED chips 503 reliably reach the cell regions 506. However, when the LED chips 503 are excessively close to the cell regions 506, the cell regions 506 are heated by heat emitted by the LED chips 503, and thus there is a concern that this causes deterioration in the wavelength conversion function and the light emitting efficiency. For this reason, in order to prevent the temperature thereof from being excessively increased, it is preferable that the distance between the LED chips 503 and the fluorescent member 505 be greater than and equal to 0.01 mm. Accordingly, considering the thickness of the transparent board 504, the clearance distance L51 is determined such that the distance between the LED chips 503 and the fluorescent member 505 be in the range of 0.01 mm to 5 mm.

In the present example, the clearance distance L51 is set to 0.1 mm, and on the basis of L53 which is obtained by adding the height L52 of each LED chip 503 to the clearance distance, the distance between the first surface 504a of the transparent board 504 and the chip mounting surface 502a of the wiring board 502 is defined. In addition, when the light emitting section 501 has thermal room, the thickness of the transparent board 504 is determined such that the distance between the LED chips 503 and cell regions 506 is set to an appropriate distance as described above in the state where the first surface 504a of the transparent board 504 may be in close contact with the LED chips 503 without providing such a clearance. Furthermore, even when the LED chips 503 and the transparent board 504 are separated, the clearance may be sealed by silicon resin, epoxy resin, glass, or the like which is transparent. In such a manner, it is possible to efficiently guide the light emitted from the LED chips 503 to the fluorescent member 505.

In addition, in the present example, the fluorescent member 505 is provided on the second surface 504b of the transparent board 504, but the fluorescent member 505 may be provided on the first surface 504a of the transparent board 504, that is, a surface thereof close to the wiring board 502. Even in this case, in a similar manner to the present example, it is possible to provide an appropriate clearance between the fluorescent member 505 and the LED chips 503. However, when there is thermal room, it is possible to cause the fluorescent member 505 to be in close contact with the LED chips 503 or to be close thereto just before the contact.

(LED Chip)

As the LED chip 503, in the present example, an LED chip emitting blue light with a peak wavelength of 460 nm is used. Specifically, as such an LED chip, there is a GaN LED chip in which for example an InGaN semiconductor is used in a light emitting layer. Note that, the emission wavelength characteristic and the type of the LED chip 503 is not limited to this, and it may be possible to employ the semiconductor light emitting elements such as various LED chips without departing from the technical scope of the present invention. In the present example, it is preferable that the peak wavelength of the light emitted by the LED chips 503 be in the wavelength range of 420 nm to 500 nm.

A p electrode 508 and an n electrode 509 are formed on a surface of each LED chip 503 facing the wiring board 502. In a case of the LED chip 503 shown in Fig. 54, the p electrode 508 is bonded to the wiring pattern 510 formed on the chip mounting surface 502a of the wiring board 502, and the n electrode 509 is bonded to the wiring pattern 511 formed on the same chip mounting surface 502a. The p electrode 508 and the n electrode 509 are connected to the wiring pattern 510 and the wiring pattern 511 through a metal bump, which is not shown, by soldering. In cases of other LED chips 503, the p electrode 508 and the n electrode 509 are similarly bonded to the wiring patterns formed on the chip mounting surface 502a of the wiring board 502 corresponding to each LED chip 503.

Note that, a method of mounting the LED chips 503 on the wiring board 502 is not limited to this, and it may be possible to select a method appropriate for the type, the structure, and the like of the LED chip 503. For example, after the LED chips 503 are fixedly attached to predetermined positions on the wiring board 502, the two electrodes of each LED chip 503 may be connected to the corresponding wiring patterns through wire bonding. In addition, one electrode may be bonded to the corresponding wiring pattern as described above, and the other electrode may be connected to the corresponding wiring pattern through wire bonding.

(Fluorescent Member)

As described above, the fluorescent member 505 is divided into 160 cell regions 506 corresponding to positions of the respective LED chips 503 mounted on the wiring board 502. The cell regions 506 are divided into four types of red cells (first cell regions) 506r, green cells (second cell regions) 506g, yellow cells (third cell regions) 506y, and blue cells (fourth cell regions) 506b. In the red cells 506r, red phosphors (first phosphors), which are for emitting red light by converting the wavelength of the blue light emitted by the LED chips 503, are held in a distributed manner. Accordingly, the red cells 506r emit red light, which is subjected to the wavelength conversion and is emitted from the red phosphors, and blue light of the LED chips 503 which is transmitted through the red cells 506r without the wavelength conversion performed through the red phosphors.

Further, in the green cells 506g, green phosphors (second phosphors), which are for emitting green light by converting the wavelength of the blue light emitted by the LED chips 503, are held in a distributed manner. Accordingly, the green cells 506g emit green light, which is subjected to the wavelength conversion and is emitted from the green phosphors, and blue light of the LED chips 503 which is transmitted through the green cells 506g without the wavelength conversion performed through the green phosphors.

In addition, in the yellow cells 506y, yellow phosphors (third phosphors), which are for emitting yellow light by converting the wavelength of the blue light emitted by the LED chips 503, are held in a distributed manner. Accordingly, the yellow cells 506y emit yellow light, which is subjected to the wavelength conversion and is emitted from the yellow phosphors, and blue light of the LED chips 503 which is transmitted through the yellow cells 506y without the wavelength conversion performed through the yellow phosphors.

On the other hand, in each blue cell 506b, diffusing particles for satisfactorily diffusing and emitting blue light are held in a distributed manner in the cell region which transmits the blue light emitted by the LED chip 503 without wavelength conversion. As the diffusing particles, specifically, it is preferable to use alumina, titania, zirconia, silica, or the like. Accordingly, the blue cells 506b emit blue light of the LED chips 503 which is transmitted through the blue cells 506b without the wavelength conversion.

A fluorescent member 505 is divided into four wavelength conversion regions of the first wavelength conversion region P51, the second wavelength conversion region P52, the third wavelength conversion region P53, and the fourth wavelength conversion region P54. However, there are differences in the numbers of cell regions of four types of the red cells 506r, the green cells 506g, the yellow cells 506y, and the blue cells 506b included in each of the four wavelength conversion regions. Fig. 55 is a table showing an example of the numbers of the cell regions of the wavelength conversion regions.

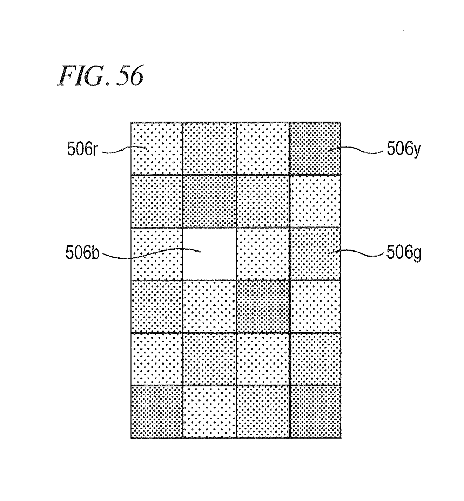

In each wavelength conversion region of the first wavelength conversion region P51, the second wavelength conversion region P52, the third wavelength conversion region P53, and the fourth wavelength conversion region P54, when the LED chips 503 emit light, in order to satisfactorily synthesize light emitted from the cell regions, the cell regions are distributed such that the cell regions having the same type are prevented from being adjacent to one another as far as possible. Fig. 56 is a schematic diagram partially illustrating an example of distribution arrangement of the four type cell regions of the red cells 506r, the green cells 506g, the yellow cells 506y, and the blue cells 506b in the first wavelength conversion region P51, in view of a part of the first wavelength conversion region P51. Note that, in Fig. 56, in order to distinguish emission colors of the respective cells, the respective phosphors are represented by dot hatch patterns. In the second wavelength conversion region P52, the third wavelength conversion region P53, and the fourth wavelength conversion region P54, regarding a plurality of types of the cell regions belonging to each region, in a similar manner to the case of the first wavelength conversion region P51, the cell regions having the different types are distributed so as not to be as adjacent to one another as possible.

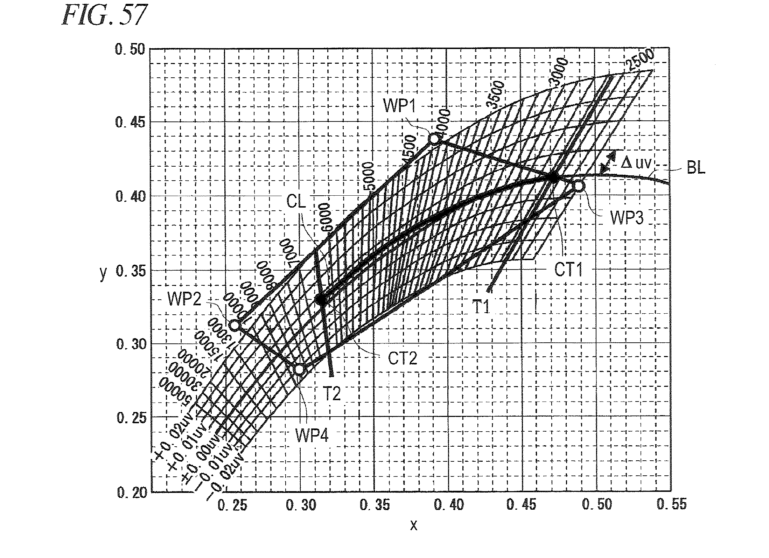

By arranging the cell regions 506 having the plurality of types in each wavelength conversion region in a distributed manner as shown in Fig. 56, when each LED chip 503a of the first LED group D51 corresponding to the first wavelength conversion region P51 emits light, the first wavelength conversion region P51, that is, the first light emitting unit U51 emits the first-order light in which the red light, the green light, the yellow light, and the blue light emitted from the red cells 506r, the green cells 506g, the yellow cells 506y, and the blue cells 506b are synthesized. Fig. 57 is an enlarged diagram of a principal section around the black-body radiation locus BL in the xy chromaticity diagram of the CIE (1931) XYZ color coordinate system. In the present example, as described above, the number of red cells 506r, the number of green cells 506g, the number of yellow cells 506y, and the number of blue cells 506b in the first wavelength conversion region P51 are determined such that the first-order light, which is emitted from the first light emitting unit U51, has the chromaticity of the chromaticity point WP1 of Fig. 57.

In the second wavelength conversion region P52, as shown in Fig. 55, the number of red cells 506r is 0, and thus the second wavelength conversion region P52 does not include the red cell 506r. Accordingly, when each LED chip 503b of the second LED group D52 corresponding to the second wavelength conversion region P52 emits light, the second wavelength conversion region P52, that is, the second light emitting unit U52 emits the first-order light in which the green light, the yellow light, and the blue light emitted from the green cells 506g, the yellow cells 506y, and the blue cells 506b are synthesized. In the present example, as described above, the number of green cells 506g, the number of yellow cells 506y, and the number of blue cells 506b in the second wavelength conversion region P52 are determined such that the first-order light, which is emitted from the second light emitting unit U52, has the chromaticity of the chromaticity point WP2 of Fig. 57.

Further, in the third wavelength conversion region P53, as shown in Fig. 56, the number of blue cells 506b is 0, and thus the third wavelength conversion region P53 does not include the blue cell 506b. Accordingly, when each LED chip 503c of the third LED group D53 corresponding to the third wavelength conversion region P53 emits light, the third wavelength conversion region P53, that is, the third light emitting unit U53 emits the first-order light in which the red light, the green light, and the yellow light emitted from the red cells 506r, the green cells 506g, and the yellow cells 506y are synthesized. In the present example, as described above, the number of red cells 506r, the number of green cells 506g, and the number of yellow cells 506y in the third wavelength conversion region P53 are determined such that the first-order light, which is emitted from the third light emitting unit U53, has the chromaticity of the chromaticity point WP3 of Fig. 57.

In addition, when each LED chip 503d of the fourth LED group D54 corresponding to the fourth wavelength conversion region P54 emits light, the fourth wavelength conversion region P54, that is, the fourth light emitting unit U54 emits the first-order light in which the red light, the green light, the yellow light, and the blue light emitted from the red cells 506r, the green cells 506g, the yellow cells 506y, and the blue cells 506b are synthesized. In the present example, as described above, the number of red cells 506r, the number of green cells 506g, the number of yellow cells 506y, and the number of blue cells 506b in the fourth wavelength conversion region P54 are determined such that the first-order light, which is emitted from the fourth light emitting unit U54, has the chromaticity of the chromaticity point WP4 of Fig. 57.

As shown in Fig. 57, at the chromaticity point WP1 of the first-order light emitted by the first light emitting unit U51 and the chromaticity point WP2 of the first-order light emitted by the second light emitting unit U52, the deviation $\Delta uv$ from the black-body radiation locus BL is positive. In contrast, at the chromaticity point WP3 of the first-order light emitted by the third light emitting unit U53 and the chromaticity point WP4 of the first-order light emitted by the fourth light emitting unit U54, the deviation $\Delta uv$ from the black-body radiation locus BL is negative. That is, as shown in Fig. 57, the chromaticity points WP1 and WP2 are positioned to be opposite to the chromaticity points WP3 and WP4 with respect to the black-body radiation locus BL, and thus a rectangle of which the vertexes are the four chromaticity points is formed.

Note that, the chromaticity points of the first-order light respectively emitted by the first to fourth light emitting units U51 to U54 are not limited to the chromaticity points WP1 to WP4 shown in Fig. 57, but may be changed into different points. However, in a similar manner to the present example, in the case of using the LED chips 503 emitting the blue light and the fluorescent member 505 in combination, the y value of the CIE (1931) XYZ color coordinate system at any chromaticity point of the first-order light, which is emitted from each of the first to fourth light emitting units U51 to U54, is preferably equal to or less than 0.65. When the y value is greater than 0.65, the takeoff efficiency of the visible light of each light emitting unit deteriorates, and it is difficult for the overall light emission apparatus to efficiently emit light. On the other hand, when LED chips emitting near-ultraviolet light are used instead of the LED chips 503 emitting the blue light, there is no trouble even if the y value is greater than 0.65.

Further, in a similar manner to the present example, in the case of using the four light emitting units, in a similar manner to the chromaticity points WP1 to WP4 shown in Fig. 57, it is preferable that two of chromaticity points of the first-order light emitted by the light emitting units be set for each of the high color temperature side and the low color temperature side. Specifically, two chromaticity points of the four chromaticity points and the center thereof are preferably in the range of $0.22 < x < 0.36$ and $0.23 < y < 0.40$, and the remaining two chromaticity points and the center thereof are preferably in the range of $0.37 < x < 0.55$ and $0.30 < y < 0.50$. When the four chromaticity points are not in such ranges, it is possible to perform toning based on the control curve CL, but the efficiency of use of each light emitting unit is lowered, and thus it becomes difficult for the overall illumination apparatus to efficiently emit light.

Here, specific examples of various phosphors respectively applicable to the red cell 506r, the green cell 506g, and the yellow cell 506y will be described below. Note that, the phosphors exemplify phosphors quite appropriate for the present example. However, available phosphors are not limited thereto, and it may be possible to apply various types of phosphors insofar as they are within the technical scope of the present invention.

(Red Phosphor)

An appropriate wavelength range of the emission peak wavelength of the red phosphor is normally 570 nm or more and 780 nm or less, preferably 580 nm or more and 700 nm or less, or more preferably 585 nm or more and 680 nm or less. From this point of view, as the red phosphor, for example, the following are preferable: $(Ca, Sr, Ba)_2Si_5(N, O)_8$:Eu; $(Ca, Sr, Ba)Si(N, O)_2$:Eu; $(Ca, Sr, Ba)AlSi(N, O)_3$:Eu; $(Sr, Ba)_3SiO_5$:Eu; $(Ca, Sr)S$:Eu; $SrAlSi_4N_7$:Eu; $(La, Y)_2O_2S$:Eu; Eu(dibenzoylmethane)$_3$ ·1; β-diketone Eu complexes such as 10-phenanthroline complex; carboxylic acid Eu complex; and $K_2SiF_6$:Mn. In addition, the following are more preferable: $(Ca, Sr, Ba)_2Si_5(N, O)_8$:Eu; $(Sr, Ca)AlSi(N, O)_3$:Eu; $SrAlSi_4N_7$:Eu; $(La, Y)_2O_2S$:Eu; and $K_2SiF_6$:Mn.

(Orange Phosphor)

The orange phosphor, of which the emission peak wavelength is in the range of 580 nm or more and 620 nm or less or preferably in the range of 590 nm or more and 610 nm or less, can be appropriately used instead of the red phosphor. Examples of such an orange phosphor include: $(Sr, Ba)_3SiO_5$:Eu; $(Sr, Ba)_2SiO_4$:Eu; $(Ca, Sr, Ba)_2Si_5(N, O)_8$:Eu; $(Ca, Sr, Ba)AlSi(N, O)_3$:Ce; and the like.

(Green Phosphor)

An appropriate wavelength range of the emission peak wavelength of the green phosphor is normally 500 nm or more and 550 nm or less, preferably 510 nm or more and 542 nm or less, or more preferably 515 nm or more and 535 nm or less. From this point of view, as the green phosphor, for example, the following are preferable: $Y_3(Al, Ga)_5O_{12}$:Ce; $CaSc_2O_4$:Ce; $Ca_3(Sc, Mg)_2Si_3O_{12}$:Ce; $(Sr, Ba)_2SiO_4$:Eu; $(Si, Al)_6(O, N)_8$:Eu(β-sialon); $(Ba, Sr)_3Si_6O_{12}$:N$_2$:Eu; $SrGa_2S_4$:Eu; $BaMgAl_{10}O_{17}$:Eu; and Mn.

(Yellow Phosphor)

An appropriate wavelength range of the emission peak wavelength of the yellow phosphor is normally 530 nm or more and 620 nm or less, preferably 540 nm or more and 600 nm or less, or more preferably 550 nm or more and 580 nm or less. From this point of view, as the yellow phosphor, for example, the following are preferable: $Y_3Al_5O_{12}$:Ce; $(Y, Gd)_3Al_5O_{12}$:Ce; $(Sr, Ca, Ba, Mg)_2SiO_4$:Eu; $(Ca, Sr)Si_2N_2O_2$:Eu; α-sialon; and $La_3Si_6N_{11}$:Ce (here, a part thereof may be replaced with Ca or O).

(Electric Circuit Configuration of Illumination Apparatus)

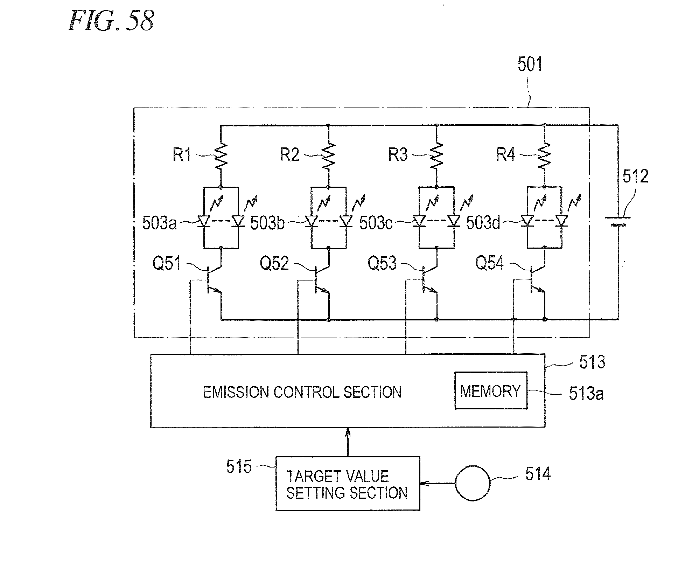

As described above, in the illumination apparatus of the present example, the color temperatures of the first-order light, which are respectively emitted from the first to fourth light emitting units U51 to U54, are set to be different from each other, and the synthetic light, which is generated by synthesizing the first-order light emitted from the light emitting units, is emitted as illumination light of the illumination apparatus. Therefore, the illumination apparatus of the present example emits white light with various color temperatures as illumination light by adjusting the intensity of the first-order light which is emitted from each of the first to fourth light emitting units U51 to U54. Here, an electric circuit configuration of the illumination apparatus configured to change the intensity of the first-order light emitted from each light emitting unit will be described with reference to Fig. 58.

Fig. 58 is an electric circuit diagram illustrating an overview of the electric circuit configuration of the illumination apparatus according to the present example. As shown in Fig. 58, the light emitting section 501 is provided with the LED chips 503a of the first LED group D51, the LED chips 503b of the second LED group D52, the LED chips 503c of the third LED group D53, and the LED chips 503d of the fourth LED group D54, and additionally current-limiting resistor R1, R2, R3 and R4 and transistors Q51, Q52, Q53, and Q54 for supplying the driving currents to the LED chips 503 of the respective LED groups. Note that, the resistors R1 to R4 are provided to limit the currents, which flow in the LED chips 503 respectively corresponding thereto, to an appropriate magnitude (for example, 60 mA per one LED chip 503).

Specifically, the LED chips 503a of the first LED group D51 are connected to one another in parallel such that the polarities thereof are the same, and the anode of each LED chip 503a is connected to the positive terminal of the power supply 512 through the resistor R1. Further, the cathode of each LED chip 503a is connected to the collector of the transistor Q51, and the emitter of the transistor Q51 is connected to the negative terminal of the power supply 512. In a similar manner to the LED chips 503a, the LED chips 503b of the second LED group D52 are connected to one another in parallel such that the polarities thereof are the same, and each anode is connected to the positive terminal of the power supply 512 through the resistor R2, and each cathode is connected to the negative terminal of the power supply 512 through the transistor Q52. Further, in a similar manner to the LED chips 503a, the LED chips 503c of the third LED group D53 are connected to one another in parallel such that the polarities thereof are the same, and each anode is connected to the positive terminal of the power supply 512 through the resistor R3, and each cathode is connected to the negative terminal of the power supply 512 through the transistor Q53. Furthermore, in a similar manner to the LED chips 503a, the LED chips 503d of the fourth LED group D54 are connected to one another in parallel such that the polarities thereof are the same, and each anode is connected to the positive terminal of the power supply 512 through the resistor R4, and each cathode is connected to the negative terminal of the power supply 512 through the transistor Q54.

In such an electric circuit configuration, by turning on the transistor Q51, forward currents supplied from the power supply 512 flow in the respective LED chips 503a of the first LED group D51, and thereby the LED chips 503a respectively emit light. Accordingly, by turning on the transistor Q51, the first light emitting unit U51, which is formed of the first LED group D51 and the first wavelength conversion region P51 corresponding thereto, emits the first-order light with the chromaticity of the chromaticity point WP1 in Fig. 57.

Likewise, by turning on the transistor Q52, forward currents supplied from the power supply 512 flow in the respective LED chips 503b of the second LED group D52, and thereby the LED chips 503b respectively emit light. Accordingly, by turning on the transistor Q52, the second light emitting unit U52, which is formed of the second LED group D52 and the second wavelength conversion region P52 corresponding thereto, emits the first-order light with the chromaticity of the chromaticity point WP2 in Fig. 57.

Further, by turning on the transistor Q53, forward currents supplied from the power supply 512 flow in the respective LED chips 503c of the third LED group D53, and thereby the LED chips 503c respectively emit light. Accordingly, by turning on the transistor Q53, the third light emitting unit U53, which is formed of the third LED group D53 and the third wavelength conversion region P53 corresponding thereto, emits the first-order light with the chromaticity of the chromaticity point WP3 in Fig. 57.

Furthermore, by turning on the transistor Q54, forward currents supplied from the power supply 512 flow in the respective LED chips 503d of the fourth LED group D54, and thereby the LED chips 503d respectively emit light. Accordingly, by turning on the transistor Q54, the fourth light emitting unit U54, which is formed of the fourth LED group D54 and the fourth wavelength conversion region P54 corresponding thereto, emits the first-order light with the chromaticity of the chromaticity point WP4 in Fig. 57.

In order to control on/off states of the transistors Q51 to Q54, the illumination apparatus of the present example is provided with an emission control section 513. All the transistors Q51 to Q54 are able to switch the on/off states in response to the respective base signals, and the emission control section 513 is configured to individually transmit the base signals to the respective bases.

The intensities of the first-order light which is respectively emitted from the first to fourth light emitting units U51 to U54 are maximized in a state where the corresponding transistors Q51 to Q54 are consecutively turned on. Accordingly, in the present example, the emission control section 513 consecutively turns on any of the transistors Q51 to Q54 in such a manner, whereby it is possible to maximize the intensity of the first-order light which is emitted from the light emitting unit corresponding to the transistor. Meanwhile, when the intensity of the first-order light emitted from any of the first to fourth light emitting units U51 to U54 is lowered from the maximum thereof, the transistor corresponding to the light emitting unit is intermittently turned on and off with a predetermined cycle, and the duty ratio of the current supply pulses at this time is adjusted, thereby adjusting the electric power supplied to the LED group of the light emitting unit. Furthermore, by reducing the duty ratio of the current supply pulses at this time, the electric power for causing the LED chips 503 to emit light is not supplied, and then the light emitting unit having the LED chips 503 does not emit the first-order light.

As shown in Fig. 58, the transistors Q51 to Q54 are able to independently control the on/off states. Therefore, it is possible to independently adjust the electric power supplied to each LED group of the first to fourth light emitting units U51 to U54. Accordingly, it is possible to individually adjust the first-order light, which is emitted from each of the first to fourth light emitting units U51 to U54, to an arbitrary state in the range from the light-off state to a state where the first-order light with the maximum intensity in each light emitting unit is emitted.

In the illumination apparatus of the present example, the synthetic light, which is generated by synthesizing the first-order light emitted by the first to fourth light emitting units U51 to U54, is the illumination light of the illumination apparatus. Therefore, in such a manner, by adjusting the intensity of the first-order light with a different chromaticity emitted from each of the first to fourth light emitting units U51 to U54, it is possible to adjust the chromaticity of the illumination light of the illumination apparatus to various values. Accordingly, in order to generate the desired illumination light, the illumination apparatus of the present example is provided with an operation unit (operation member) 514 by which a user performs operation, and a target value setting section 515 that sets a target value for appropriately adjusting the chromaticity of the illumination light in accordance with the operation performed on the operation unit 514. In the present example, the emission control section 513, the operation unit 514, and the target value setting section 515 constitute the control means of the present invention.

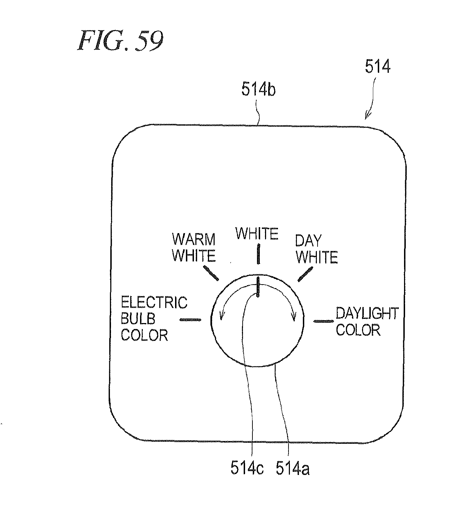

Fig. 59 is a schematic diagram illustrating an example of the operation unit 514 used in the present example. As shown in Fig. 59, the operation unit 514 includes: an operation dial 514a by which a user performs operation; and a main body 514b in which an electric circuit (not shown in the drawing) for detecting the operation position of the operation dial 514a and transmitting the position information of the operation dial 514a to the light control section 513 is built. The operation dial 514a can be rotated by user's operation. As shown in Fig. 59, on the operation side of the main body 514b, there are provided indications such as "electric bulb color", "warm white", "white", "day white", and "daylight color" in a clockwise order in a movable range of a mark 514c which is provided on the operation dial 514a.

This indications correspond to the color temperatures of the white light emitted as the illumination light by the illumination apparatus, and thus assist a user to grasp the level of the color temperature more intuitively than a case where the own numerical values of the color temperatures are inscribed on the main body 514b. Specifically, for example, the "electric bulb color" indicates about 2550°K, the "warm white" indicates about 3500°K, the "white" indicates about 4200°K, the "day white" indicates about 5000°K, and the "daylight color" indicates about 6400°K. The operation dial 514a may be formed to be rotated stepwise in accordance with the indications, and may be formed to be continuously rotated.

(Control of Light Emitting Section)

The main body 514b of the operation unit 514 detects the position of the operation dial 514a, and notifies the detected position of the operation dial 514a to the target value setting section 515. The target value setting section 515 determines the target correlation color temperature corresponding to the detected position of the operation dial 514a, on the basis of the relationship between the target correlation color temperature and the position of the operation dial 514a which is set in advance to match with the indication on the main body 514b of the operation unit 514. The target correlation color temperature determined in such a manner is sent from the target value setting section 515 to the emission control section 513. Then, the emission control section 513 performs emission control for controlling light emission of the light emitting section 501 in response to the target correlation color temperature sent from the target value setting section 515.

At this time, the emission control, which is performed by the emission control section 513, is to control the intensity of the first-order light, which is emitted from each of the first to fourth light emitting units U51 to U54, such that the illumination light emitted from the illumination apparatus is made to be the white light with the target correlation color temperature which is set through the operation unit 514. Specifically, the emission control is performed such that the chromaticity of the illumination light is positioned on the control curve CL in the XY chromaticity diagram of Fig. 57. As shown in Fig. 57, the control curve CL in the present example is a convex curve approximate to the black-body radiation locus BL since the deviation $\Delta$uv from the black-body radiation locus BL is within +0.005.

Further, as shown in Fig. 57, the control curve CL is set to be included in the rectangle which is formed such that the vertexes thereof are the chromaticity points WP1 to WP4 of the first-order light respectively emitted from the first to fourth light emitting units U51 to U54. That is, in other words, the chromaticity of the first-order light, which is emitted from each of the first to fourth light emitting units U51 to U54, is determined such that the rectangle, of which the vertexes are the chromaticity points WP1 to WP4, includes the control curve CL. In addition, the chromaticity point CT1, which is the lower limit color temperature (first color temperature) T1 in the control curve CL, is in the line connecting the chromaticity point WP1 and the chromaticity point WP3. The chromaticity point CT2, which is the upper limit color temperature (second color temperature) T2 in the control curve CL, is on the low color temperature side of the line connecting the chromaticity point WP2 and the chromaticity point WP4.

In addition, in the present example, the lower limit color temperature T1 is set to 2550 K, and the upper limit color temperature T2 is set to 6400 K such that they match with the range of color temperature which is set by the above-mentioned operation unit 514. By setting the lower limit color temperature T1 and the upper limit color temperature T2 as described above, it is possible to emit the illumination light in the color temperature range of the illumination light, which is obtained in a general illumination apparatus, from the illumination apparatus. The lower limit color temperature T1 and the upper limit color temperature T2 are not limited to the above-mentioned values, and may be increased or decreased as necessary. However, when the illumination light in the color temperature range of the illumination light obtained in the general illumination apparatus is intended to be emitted from the illumination apparatus, the lower limit color temperature T1 is preferably less than and equal to 2800 K, and the upper limit color temperature T2 is preferably greater than or equal to 6000 K.

The illumination light, which is emitted from the illumination apparatus, is generated by synthesizing the first-order light which is respectively emitted from the first to fourth light emitting units U51 to U54. Therefore, it is necessary for at least one of the four chromaticity points WP1 to WP4 to be on the low color temperature side of the lower limit color temperature T1 of the control curve CL, and to be on the high color temperature side of the upper limit color temperature T2 of the control curve CL. Accordingly, in the case of the present example, the chromaticity point WP3, which is the minimum color temperature of the four chromaticity points WP1 to WP4, is set on the low color temperature side of the lower limit color temperature T1 of the control curve CL. In addition, the chromaticity point WP2, which is the maximum color temperature, and the chromaticity point WP4, which is the second-highest color temperature, are set on the high color temperature side of the upper limit color temperature T2 of the control curve CL.

Further, as described above, the control curve CL is set to be included in the rectangle which is formed such that the vertexes thereof are the chromaticity points WP1 to WP4, and each of the chromaticity points WP1 to WP4 is positioned outside the triangle which is formed such that the vertexes thereof are the other three chromaticity points. If the chromaticity point of the first-order light emitted by any one light emitting unit of the first to fourth light emitting units U51 to U54 is inside the triangle which is formed such that the vertexes thereof are the other three chromaticity points, at a certain color temperature of the adjusted illumination light, instead of the two light emitting units corresponding to both chromaticity points adjacent to the chromaticity point inside the triangle, it may suffice to use the light emitting unit corresponding to the chromaticity point inside the triangle. In this case, the total luminous flux of the illumination light is lowered, and thus there is a concern that it is difficult to obtain the necessary total luminous flux. Accordingly, in the present example, when each of the chromaticity points WP1 to WP4 is positioned outside the triangle which is formed such that the vertexes thereof are the other three chromaticity points, it is possible to cause each of the first to fourth light emitting units U51 to U54 to emit light as uniformly as possible. As a result, it is possible to ensure the total luminous flux necessary for the illumination light.

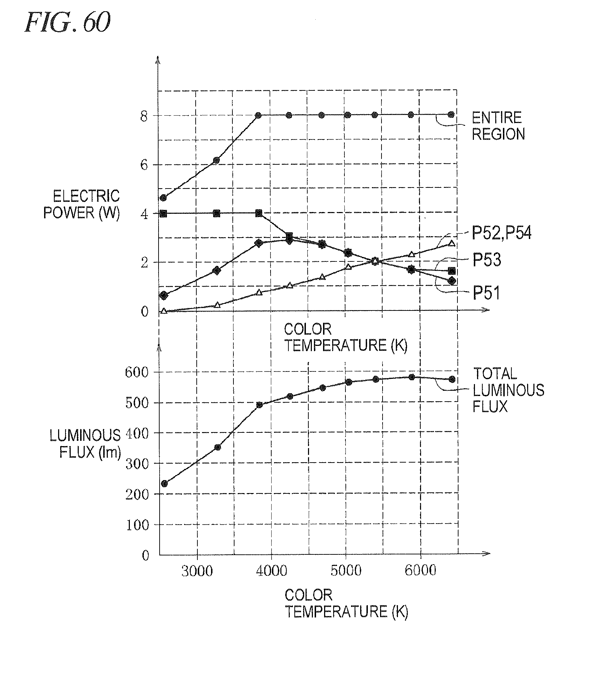

Fig. 60 is a graph illustrating relationships of the color temperatures of the illumination light emitted from the illumination apparatus when the emission control section 513 controls light emission, the electric powers respectively supplied to the first to fourth light emitting units U51 to U54, the total supply power which is the sum of the supply powers, and the total luminous flux of the illumination light, in the illumination apparatus of the present example. Note that, in the present example, the electric power supplied to the second light emitting unit U52 has the same magnitude as the electric power supplied to the fourth light emitting unit U54, but the magnitude of the total supply power and the magnitudes of the electric powers supplied to the light emitting units shown in Fig. 60 are examples, and thus the invention is not limited to them. Accordingly, in some cases, the electric powers respectively supplied to the second light emitting unit U52 and fourth light emitting unit U54 may be different from each other in accordance with the light emission characteristics of the light emitting units, the characteristics of the illumination light, and the like.

In addition, in the present example, the upper limit of the electric power which can be supplied to the light emitting section 501 is set to 8W (watt) on the basis of the thermal capacity of the heat dissipation member provided in the light emitting section 501. Accordingly, it is necessary to set the sum of the electric powers, which are respectively supplied to the first to fourth light emitting units U51 to U54, to a magnitude not more than 8W. In contrast, the upper limit of the electric power which can be supplied to each of the first to fourth light emitting units U51 to U54 is determined by the rated maximum power of the LED chips 503 provided in each light emitting unit, and is set to 4W in the present example. Accordingly, the sum of the upper limits of the electric powers, which can be respectively supplied to the light emitting units, is 16W, and is thus greater than 8W as the upper limit of the sum power which can be supplied to the light emitting section 501.

As described above, the sum of the upper limits of the electric powers, which can be supplied to the light emitting units, is set to be greater than the upper limit of the sum power which can be supplied to the light emitting section 501. Therefore, it is possible to set the sum of the electric powers, which are respectively supplied to the first to fourth light emitting units U51 to U54, to not more than 8W as the upper limit of the sum power which can be supplied to the light emitting section 501 while setting the electric power, which is supplied to any light emitting unit of the first to fourth light emitting units U51 to U54, to 4W as the upper limit. As a result, compared with the case where the sum of the upper limits of the electric powers which can be supplied to the light emitting units is limited to be less than or equal to the upper limit of the sum power which can be supplied to the light emitting section 501, it is possible to increase the total luminous flux of the illumination light emitted from the illumination apparatus.

Note that, the upper limit of the electric power, which can be supplied to the light emitting section 501, indicated herein and the upper limits of the electric powers, which can be supplied to the light emitting units, are just examples, and the invention is not limited to them, and may be appropriately changed in accordance with specification of each light emitting unit or the illumination apparatus. In any case, in view of the advantage that it is possible to increase the total luminous flux of the illumination light emitted from the illumination apparatus, it is preferable that the sum of the upper limits of the electric powers, which can be supplied to the light emitting units, be set to be greater than the upper limit of the sum power which can be supplied to the light emitting section 501.

In such a manner, the control curve CL is determined, and the upper limit of the electric powers, which can be respectively supplied to the first to fourth light emitting units U51 to U54, is determined. Thereby, as shown in Fig. 60, in the region in which the color temperature is greater than or equal to about 4000 K, while the electric power is supplied to each light emitting unit so as to be biased as little as possible, the electric power greater than 2W, which is obtained by subtracting 8W as the upper limit of the sum power that can be supplied to the light emitting section 501 by the number of light emitting units, is supplied to some light emitting units, and thus it is possible to ensure the total luminous flux greater than or equal to 500 Lumen in the illumination light of the illumination apparatus.

In addition, in the region in which the color temperature is less than or equal to 4000 K, in order to eliminate sense of discomfort caused by change in the color temperature and the total luminous flux of a general incandescent bulb, the total luminous flux is decreased in accordance with the decrease in the color temperature of the illumination light of the illumination apparatus. However, in the present example, even in such a case, until the color temperature is decreased up to the lower limit color temperature T1, the total luminous flux, which is greater than and equal to 1/3 of the maximum luminous flux, is ensured. In such a manner, by suppressing the decrease in the total luminous flux of the illumination light in the case of decreasing the color temperature, it is possible to generate bright illumination light even at the low color temperature.

The relationships between the supply power and the color temperature of the illumination light mentioned above are figured out in advance by performing simulations, experiments, or the like. Thus, on the basis of the relationships obtained from the results thereof as shown in Fig. 60, it is possible to calculate the supply power which is necessary to generate the illumination light with the desired color temperature and is to be supplied to each light emitting unit. In addition, the supply power supplied to each light emitting unit depends on the duty ratio of the current supply pulses supplied to each light emitting unit.

Accordingly, in the present example, on the basis of the relationship between the color temperature and the supply power supplied to each light emitting unit in Fig. 60, the relationship between the color temperature of the illumination light and the amount of on/off control (the amount of emission control) for each of the transistors Q51 to Q54 of the light emitting section 501 is acquired in advance. In addition, by setting the color temperature of the illumination light of Fig. 60 to the target correlation color temperature, the amounts of control of the transistors Q51 to Q54 corresponding to the target correlation color temperature, which can be set by the target value setting section 515, are stored as a control map in advance in the memory (storage device) 513a provided in the emission control section 513. Note that, when the on/off control of the transistors Q51 to Q54 is performed on the basis of the relationship shown in Fig. 60, as shown in Fig. 60, the total luminous flux of the illumination light is determined to correspond to the target correlation color temperature at that time. Therefore, the target total luminous flux is also determined by determining the target correlation color temperature. Accordingly, the on/off control of the transistors Q51 to Q54 based on the target correlation color temperature is control practically based on the target correlation color temperature and the target total luminous flux.

When receiving the target correlation color temperature corresponding to the operation position of the operation dial 514a of the operation unit 514 from the target value setting section 515, the emission control section 513 acquires the amount of on/off control of each of the transistors Q51 to Q54 corresponding to the target correlation color temperature from the control map stored in the memory 513a, and controls on and off states of the transistors Q51 to Q54 of the light emitting section 501 on the basis of the acquired amount of control. As a result, the illumination light with the color temperature, of which the chromaticity is in the control curve CL in the XY chromaticity diagram of Fig. 57, is emitted from the illumination apparatus. At this time, the color temperature of the illumination light is the color temperature which is set by the operation unit 514.

As described above, in the control curve CL in the XY chromaticity diagram of Fig. 57, the deviation Δuv from the black-body radiation locus BL is within +0.005, and thus it is possible to generate the white light of which the average color rendering index Ra is greater than or equal to 90 and which is extremely excellent in the color rendering property. Note that, as the deviation Δuv from the black-body radiation locus BL of the control curve CL decreases, it is possible to generate white light which is natural without sense of discomfort, and it is possible to achieve the high total luminous flux without decreasing the color rendering property. However, in the present example, it is not always necessary for the deviation Δuv to be within +0.005, and the magnitude of the deviation Δuv may be set in accordance with the purpose of use or the characteristics required for the illumination apparatus. Here, generally when the deviation Δuv is set to a positive value, compared with the case where the deviation is set to a negative value which is the same absolute value, it is possible to increase the light emitting efficiency. Therefore, in order to generate the illumination light with high luminance, it is preferable to set the deviation Δuv to a positive value. In addition, in view of the above-mentioned effects, it is preferable that the control curve CL be set such that the deviation Δuv is +0.01±0.01.

As described above, in the illumination apparatus of the present example, it is possible to change the color temperature of the illumination light emitted from the illumination apparatus in the range from the lower limit color temperature T1 to the upper limit color temperature T2 in accordance with the operation amount of the operation dial 514a of the operation unit 514. At this time, the chromaticity of the illumination light is approximate to the black-body radiation locus BL, and the deviation Δuv is within +0.005, and thus it is possible to make the illumination light be white light which is natural without sense of discomfort. In addition, both the color temperature of the illumination light and the total luminous flux are appropriately adjusted by the operation performed on the operation dial 514a.

Further, in the XY chromaticity diagram of Fig. 57, the control curve CL is set such that it is included in the rectangle of which vertexes are the chromaticity points WP1 to WP4 of the first-order light respectively emitted from the first to fourth light emitting units U51 to U54. Therefore, the first-order light emitted from two light emitting units is used in order to generate the illumination light, and thus it is possible to suppress the decrease in the total luminous flux inappropriate for the illumination light.

Furthermore, in the present example, the LED chips 503 and the cell regions 506 containing the phosphors are used in combination. Therefore, by using the emission spectrum characteristics of the phosphors, it is possible to generate illumination light excellent in the color rendering property without the missing parts which occur in the emission spectrum of each light emitting unit when the light emitted by the LED chips is used as it is.

Moreover, in each cell region 506, the plurality kinds of phosphors with different wavelength conversion characteristics are not used in a mixed manner. Hence, it is possible to suppress occurrence of cascade excitation that the light of which the wavelength is converted by one phosphor is subjected to the wavelength conversion again by the other phosphor. Thus, it is possible to prevent the light emitting efficiency from being decreased in each wavelength conversion region by such cascade excitation.

In addition, in the present example, the transparent board 504, on which the fluorescent member 505 is provided, is provided to be opposed to the wiring board 502 on which the LED chips 503 are mounted, thereby forming the light emitting section 501 having the light emitting unit group. Therefore, since the first to fourth light emitting units U51 to U54 are integrally formed, it becomes easy to treat the light emitting section 501, and it is possible to reduce the manufacturing costs and the number of manufacturing processes of the illumination apparatus.

(Modified Example of Electric Circuit Configuration of Illumination apparatus)

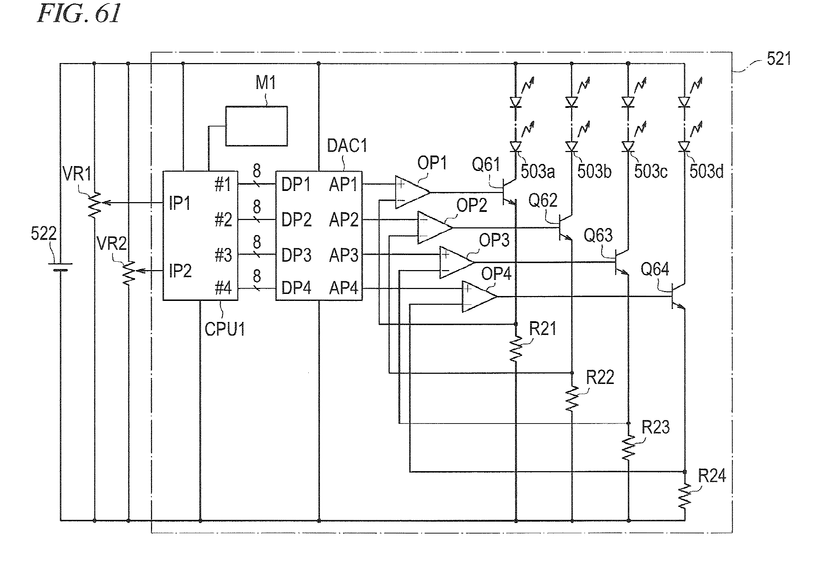

The above-mentioned configuration shown in Fig. 58 does not limit the electric circuit of the illumination apparatus which changes the intensity of the first-order light which is emitted from each of the first to fourth light emitting units U51 to U54 so as to emit the white light with various color temperatures as the illumination light. Accordingly, referring to Fig. 61, a description will be given below of a modified example of an electric circuit configuration of the illumination apparatus which is for changing the intensity of the first-order light which is emitted from each of the first to fourth light emitting units U51 to U54. In addition, in the light emitting section 521 of the present modified example, in a similar manner to the light emitting section 501 of the fifth example mentioned above, 160 LED chips 503 are arranged on the substrate, and the transparent board 504, on which the fluorescent member 505 is provided in a similar manner to the fifth example, is used to correspond to the LED chips 503. That is, the present modified example is different from the above-mentioned fifth example only in the electric circuit configuration in the substrate and the emission control thereof, and the other configuration thereof is the same as that of the fifth example.

In the present modified example, in a similar manner to the fifth example, the 40 LED chips 503a constitute the first LED group D51, and the 40 LED chips 503b constitute the second LED group D52. Likewise, the 40 LED chips 503c constitute the third LED group D53, and the 40 LED chips 503d constitute the fourth LED group D54. Here, as shown in Fig. 61, in the present modified example, in each LED group, the LED chips are connected in series.

As shown in Fig. 61, a transistor Q61, which adjusts the driving current and supplies it to each LED chip 503a, and a current detection resistor R21 are connected to the above-mentioned LED chips 503a of the first LED group D51 in series, and they are connected between the positive terminal and the negative terminal of the power supply 522. Likewise, a transistor Q62 and a current detection resistor R22 are connected to the LED chips 503b of the second LED group D52 in series. A transistor Q63 and a current detection resistor R23 are connected to the LED chips 503c of the third LED group D53 in series. A transistor Q64 and a current detection resistor R24 are connected to the LED chips 503d of the fourth LED group D54 in series.

The bases of the bases of the transistors Q61 to Q64 are connected to the output of operational amplifiers OP1 to OP4. In addition, the inverting inputs of the respective operational amplifiers OP1 to OP4 are connected, as shown in Fig. 61, to the respective corresponding current detection resistors R21 to R24. Accordingly, for example, in response to the output signal level of the operational amplifier OP1, the corresponding transistor Q61 becomes conductive. Then, as the current flows in the LED chips 503a and resistor R21, the electric potential of the resistor R21 increases. At this time, until the electric potential of the inverting input of the operational amplifier OP1 is equal to the electric potential of the non-inverting input, the transistor Q61 is allowed to be conductive. Then, as the electric potential of the inverting input is greater than the electric potential of the non-inverting input, the output signal of the operational amplifier OP 1 is inverted, and the transistor Q61 becomes non-conductive. As a result, the current flowing in the LED chips 503a is maintained at a constant value corresponding to the electric potential of the non-inverting input of the operational amplifier OP1. That is, the operational amplifier OP1, the resistor R21, and the transistor Q61 constitute a constant current circuit for the driving current supplied to the LED chips 503a, and the current value is determined depending on the electric potential of the non-inverting input of the operational amplifier OP1.

Likewise, the operational amplifier OP2, the resistor R22, and the transistor Q62 constitute a constant current circuit for the driving current supplied to the LED chips 503b. The operational amplifier OP3, the resistor R23, and the transistor Q63 constitute a constant current circuit for the driving current supplied to the LED chips 503c. The operational amplifier OP4, the resistor R24, and the transistor Q64 constitute a constant current circuit for the driving current supplied to the LED chips 503d. In addition, the magnitudes of the driving currents of the LED chips 503b to 503d are determined depending on the electric potentials of the non-inverting inputs of the operational amplifiers respectively corresponding thereto like the case of the LED chips 503a.

In the present modified example, when the driving current is supplied to only any one of the first to fourth LED groups D51 to D54, the first-order light, which is emitted from the light emitting unit corresponding to the LED group of the first to fourth light emitting units U51 to U54, is also the same as that of the above-mentioned fifth example. That is, when each LED chip 503a of the first LED group D51 emits light, the first-order light with the chromaticity of the chromaticity point WP1 of Fig. 57 is emitted from the first light emitting unit U51 formed of the first LED group D51 and the first wavelength conversion region P51 corresponding thereto. Likewise, when each LED chip 503b of the second LED group D52 emits light, the first-order light with the chromaticity of the chromaticity point WP2 of Fig. 57 is emitted from the second light emitting unit U52 formed of the second LED group D52 and the second wavelength conversion region P52 corresponding thereto. Further, when each LED chip 503c of the third LED group D53 emits light, the first-order light with the chromaticity of the chromaticity point WP3 of Fig. 57 is emitted from the third light emitting unit U53 formed of the third LED group D53 and the third wavelength conversion region P53 corresponding thereto. Furthermore, when each LED chip 503d of the fourth LED group D54 emits light, the first-order light with the chromaticity of the chromaticity point WP4 of Fig. 57 is emitted from the fourth light emitting unit U54 formed of the fourth LED group D54 and the fourth wavelength conversion region P54 corresponding thereto.

By controlling light emission of the first to fourth light emitting units U51 to U54, in a similar manner to the illumination apparatus of the fifth example, the chromaticity of the illumination light, which is emitted from the illumination apparatus by synthesizing the first-order light which is emitted from each of the first to fourth light emitting units U51 to U54, is changed in the control curve CL shown in Fig. 57. For this operation, in the present modified example, the light emitting section 521 is provided with a micro computer CPU1, a memory (storage device) M1, and a D/A converter DAC1. In addition, the micro computer CPU1, the memory M1, and the D/A converter DAC1 are mounted on the substrate of the light emitting section 521, together with the LED chips 503a to 503d, the transistors Q61 to Q64, the resistors R21 to R24, and the operational amplifiers OP1 to OP4 mentioned above.

The micro computer CPU1 includes two analog input ports IP1 and IP2, and includes four digital output ports #1, #2, #3, and #4 that output 8-bit digital signals. Further, the memory M1 is connected to the micro computer CPU1 through a signal line so as to interchange data with the micro computer CPU1. In addition, the D/A converter DAC1 includes four digital input ports DP1, DP2, DP3, and DP4, and includes analog output ports AP1, AP2, AP3, and AP4 that convert the digital signals, which are input to the digital input ports DP1, DP2, DP3, and DP4, into analog signals and output them. In addition, the digital input ports DP1, DP2, DP3, and DP4 correspond one-to-one with the analog output ports AP1, AP2, AP3, and AP4 in this order.

The variable resistor VR1 is provided, in the same form as the operation unit 514 of the fifth example, in the illumination apparatus so as to be operated by the color temperature adjustment dial (not shown in the drawing) which assists a user to perform an operation to adjust the color temperature of the illumination light. One of two fixed terminals of the variable resistor VR1 are connected to the positive terminal of the power supply 522, and the other is connected to the negative terminal of the power supply 522. On the other hand, the variable terminal is connected to the analog input port IP1 of the micro computer CPU1, and the electric potential, which is applied to the analog input port IP1, is changed by the operation of a user performed on the color temperature adjustment dial.

In the present modified example, the emission control is performed such that, when the electric potential of the variable terminal of the variable resistor VR1 is minimized, the color temperature of the illumination light reaches the lower limit color temperature (first color temperature) T1 in the control curve CL of Fig. 57, and when the corresponding electric potential is maximized, the color temperature of the illumination light reaches the upper limit color temperature (second color temperature) T2 in the control curve CL of Fig. 57. In addition, the emission control is performed such that, when the electric potential of the variable terminal of the variable resistor VR1 is changed between the minimum and the maximum, in response to the electric potential, the color temperature of the illumination light is continuously changed between the lower limit color temperature T1' and the upper limit color temperature T2' in the control curve CL of Fig. 57. In addition, in the present modified example, compared with the case of the fifth example, the control curve CL is slightly extended, where the lower limit color temperature T1' is set to 2500 K and the upper limit color temperature T2' is set to 6500 K. In this case, in the extension portion of the control curve CL, distribution of electric powers supplied to the first to fourth light emitting units U51 to U54 is determined by the same method as the fifth example.

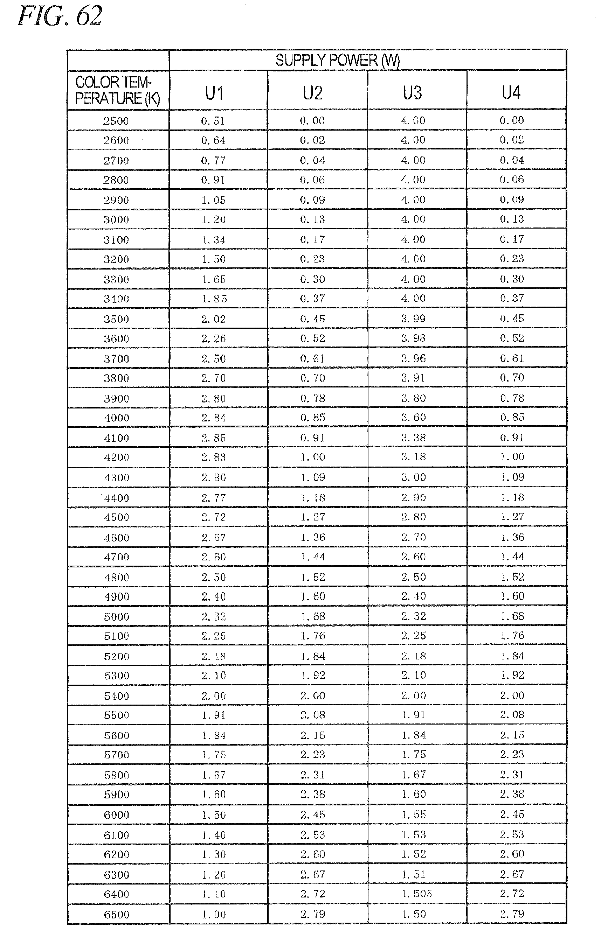

As described above, the electric potential of the variable terminal of the variable resistor VR1 corresponds one-to-one with the color temperature of the illumination light designated by the operation of the color temperature adjustment dial, and the target correlation color temperature of the illumination light is determined on the basis of the electric potential of the variable terminal of the variable resistor VR1. On the other hand, the distribution of the electric powers, which are supplied to the first to fourth light emitting units U51 to U54, for achieving the set target correlation color temperature in the control curve CL is the same as that of the above-mentioned fifth example, and in the same method, the amount of the electric power supplied to each light emitting unit is calculated in advance on the basis of the target correlation color temperature which can be set. Further, when the electric powers supplied to the first to fourth light emitting units U51 to U54 are determined, the magnitudes of the driving currents respectively supplied to the LED chips 503a to 503d are also determined. Accordingly, in the present modified example, the electric potential of the variable terminal of the variable resistor VR1 representing the target correlation color temperature is set as a parameter, and 8-bit data, which corresponds to the driving current values supplied to the first to fourth light emitting units U51 to U54 corresponding to various color temperatures in the range from the lower limit color temperature T1' to the upper limit color temperature T2', is stored as a control map in the memory M1. Fig. 62 is a table showing an example of the electric power supplied to each light emitting unit corresponding to the target correlation color temperature. The driving current value, which is calculated on the basis of the target correlation color temperature for each light emitting unit from the relation between the target temperature and the supply power shown in Fig. 62, is stored as a control map in the memory M1.

When the electric potential of the variable terminal corresponding to the operation position of the color temperature adjustment dial is applied to the analog input port IP1 of the micro computer CPU1, the micro computer CPU1 acquires four pieces of 8-bit data, which represent the driving current values supplied to the first to fourth light emitting units U51 to U54 corresponding to the electric potential applied to the analog input port IP1, that is, the target correlation color temperature, from the memory M1. The micro computer CPU1 respectively associates the acquired four pieces of 8-bit data with the first to fourth light emitting units U51 to U54 and outputs them to the output ports #1 to #4. In addition, at this time, when each of the four pieces of 8-bit data is multiplied by the same reduction coefficient, it is possible to reduce the total luminous flux of the illumination light without changing the color temperature. Accordingly, in the present modified example, the acquired four pieces of 8-bit data are multiplied by the reduction coefficient of 0 to 1 for adjusting the total luminous flux, and are thereafter output to the output ports #1 to #4. Although the reduction coefficient for adjusting the total luminous flux will be described later, a description will be given below of a case where the total luminous flux is not reduced at the reduction coefficient of 1.

The output port #1 of the micro computer CPU1 is connected to the digital input port DP1 of the D/A converter DAC1. Thus, the digital signal, which is input to the digital input port DP1, is output from the analog output port AP1 after converted into the analog signal. The analog output port AP1 is connected to the non-inverting input of the operational amplifier OP1, and the output of the operational amplifier OP1 is connected to the base of the transistor Q61 corresponding to the first light emitting unit U51 as described above. Accordingly, the micro computer CPU1 outputs the 8-bit data, which represents the driving current supplied to the first light emitting unit U51, among the four pieces of 8-bit data, which are acquired from the memory M1 as described above, from the output port #1.

Likewise, the digital input port DP2 of the D/A converter DAC1, to which the output port #2 of the micro computer CPU1 is connected, corresponds to the analog output port AP2, and the analog output port AP2 is connected to the non-inverting input of the operational amplifier OP2. In addition, the output of the operational amplifier OP2 is connected to the base of the transistor Q62 corresponding to the second light emitting unit U52. Accordingly, the micro computer CPU1 outputs the 8-bit data, which represents the driving current supplied to the second light emitting unit U52, among the four pieces of 8-bit data, which are acquired from the memory M1 as described above, from the output port #2.

Further, the digital input port DP3 of the D/A converter DAC1, to which the output port #3 of the micro computer CPU1 is connected, corresponds to the analog output port AP3, and the analog output port AP3 is connected to the non-inverting input of the operational amplifier OP3. In addition, the output of the operational amplifier OP3 is connected to the base of the transistor Q63 corresponding to the third light emitting unit U53. Accordingly, the micro computer CPU1 outputs the 8-bit data, which represents the driving current supplied to the third light emitting unit U53, among the four pieces of 8-bit data, which are acquired from the memory M1 as described above, from the output port #3.

Furthermore, the digital input port DP4 of the D/A converter DAC1, to which the output port #4 of the micro computer CPU1 is connected, corresponds to the analog output port AP4, and the analog output port AP4 is connected to the non-inverting input of the operational amplifier OP4. In addition, the output of the operational amplifier OP4 is connected to the base of the transistor Q64 corresponding to the fourth light emitting unit U54. Accordingly, the micro computer CPU1 outputs the 8-bit data, which represents the driving current supplied to the fourth light emitting unit U54, among the four pieces of 8-bit data, which are acquired from the memory M1 as described above, from the output port #4.

Accordingly, from the respective four analog output ports AP1 to AP4 of the D/A converter DAC1, in order to generate the illumination light with the target correlation color temperature which is determined by the variable resistor VR1, the analog signals with the voltage values corresponding to the driving currents to be supplied to the first to fourth light emitting units U51 to U54 are output. Then, the analog signals are respectively transmitted to the non-inverting inputs of the corresponding operational amplifiers OP1 to OP4. As described above, the output signals of the operational amplifiers OP1 to OP4 are respectively transmitted to the bases of the corresponding transistors Q61 to Q64, and currents, which correspond to the voltage values of the analog signals transmitted to the non-inverting inputs of the operational amplifiers OP1 to OP4, flow in the corresponding LED chips 503a to 503d, respectively. As a result, by synthesizing the first-order light which is emitted from each of the first to fourth light emitting units U51 to U54, it is possible to generate the illumination light with the color temperature which is set by the operation of the color temperature adjustment dial.

As described above, in the present modified example, in addition to the color temperature adjustment, it is possible to adjust the total luminous flux of the illumination light. The variable resistor VR2 in the electric circuit of Fig. 61 is provided to adjust the total luminous flux of the illumination light in the range from the light-off state to the upper limit of the total luminous flux which can be obtained in the illumination apparatus, and is provided in the illumination apparatus so as to be operated by the total luminous flux adjustment dial (not shown in the drawing) which assists a user to perform an operation. One of two fixed terminals of the variable resistor VR2 are connected to the positive terminal of the power supply 522, and the other is connected to the negative terminal of the power supply 522. On the other hand, the variable terminal is connected to the analog input port IP2 of the micro computer CPU1, and the electric potential, which is applied to the analog input port IP2, is changed by the operation of a user performed on the total luminous flux adjustment dial.

In present modified example, the target value of the total luminous flux of the illumination light is determined on the basis of the ratio of the total luminous flux to the upper limit thereof which can be obtained by the illumination apparatus. Thus, the target value is 0 in the light-off state, and the target value is 1 in the state in which the upper limit total luminous flux is obtained. In addition, when the electric potential of the variable terminal of the variable resistor VR2 is minimized, the target value is 0, and when the corresponding electric potential is maximized, the target value is 1. Further, when the electric potential of the variable terminal of the variable resistor VR2 is changed between the minimum and the maximum, in response to the electric potential, the target value of the total luminous flux is continuously changed in the range from 0 to 1.

As described above, the micro computer CPU1 multiplies the four pieces of 8-bit data by the reduction coefficient for reducing the total luminous flux of the illumination light when acquiring the four pieces of 8-bit data, which represent the driving current values supplied to the first to fourth light emitting units U51 to U54 corresponding to the target correlation color temperature, from the memory M1 and outputting them to the output ports #1 to #4. The micro computer CPU1 applies the target value of 0 to 1 determined by the electric potential of the variable terminal of the variable resistor VR2 to the reduction coefficient used herein. Accordingly, by operating the total luminous flux adjustment dial of the variable resistor VR2, it is possible to continuously adjust the total luminous flux of the illumination light in the range from the light-off state of the illumination light to the state in which the total luminous flux reaches the upper limit.

As described above, in the present modified example, in a similar manner to the above-mentioned fifth example, it is also possible to adjust the color temperature of the illumination light, and thus it is possible to obtain the same effects as the fifth example. Further, in the present modified example, in addition to the color temperature adjustment, it is possible to adjust the total luminous flux of the illumination light, whereby it is possible to generate illumination light with various color temperatures and luminances desired by a user together with the color temperature adjustment. Note that, as clearly seen from the above description of the present modified example, not only the micro computer CPU1, but also the memory M1, the D/A converter DAC1, the variable resistor VR1, and the variable resistor VR2 correspond to the control means of the present invention.

(Another Example of The Number of Light Emitting Units)

In the present example, in the XY chromaticity diagram of Fig. 57, the control curve CL is set such that it is included in the rectangle of which vertexes are the chromaticity points WP1 to WP4 of the first-order light respectively emitted from the first to fourth light emitting units U51 to U54. However, the number of light emitting units used in the illumination apparatus is not limited to four, and may be the number by which a polygon can be formed in the XY chromaticity diagram.

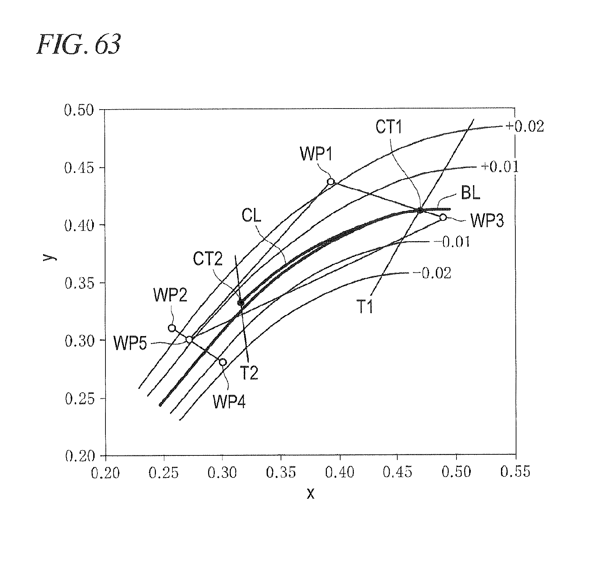

For example, Fig. 63 shows a case where the number of light emitting units is set to three, that is, an example in which the number of chromaticity points of the first-order light is three. Fig. 63 is a partially simplified diagram of the XY chromaticity diagram of Fig. 57. In the example of Fig. 63, instead of the second light emitting unit U52 and the fourth light emitting unit U54, the fifth light emitting unit U55 is used in combination with the first light emitting unit U51 and the third light emitting unit U53, and the chromaticity point of the first-order light, which is emitted from the fifth light emitting unit U55, is WP5. Further, the control curve CL used herein is the same as that of the above-mentioned fifth example.

As shown in Fig. 63, the chromaticity point WP5 is set such that the triangle of which the vertexes are the three chromaticity points WP1, WP3, and WP5 includes the control curve CL. Accordingly, the chromaticity point WP5 is on the high color temperature side of the upper limit color temperature T2 of the control curve CL. Specifically, for example, the chromaticity point WP5 may be set in the line connecting the chromaticity point WP2 and the chromaticity point WP4 used in the above-mentioned fifth example. It is apparent that the chromaticity point WP5 may be set at a position different from the above-mentioned position. The chromaticity point WP5 is set by setting the numbers of red cells 506r, green cells 506g, yellow cells 506y, and blue cells 506b provided in the fifth light emitting unit U55.

In the example of Fig. 63, the triangle, which is formed such that the vertexes thereof are the three chromaticity points WP1, WP3, and WP5, includes the control curve CL. Therefore, the intensities of the first-order light respectively emitted from the first light emitting unit U51, the third light emitting unit U53, and the fifth light emitting unit U55 are adjusted in the same manner as the above-mentioned fifth example. Thereby, while positioning the chromaticity of the illumination light emitted from the illumination apparatus in the control curve CL, it is possible to adjust the color temperature of the illumination light in the range from the lower limit color temperature T1 to the upper limit color temperature T2. Accordingly, in the example shown in Fig. 63, it is also possible to obtain the same effects as the above-mentioned illumination apparatus of the fifth example.

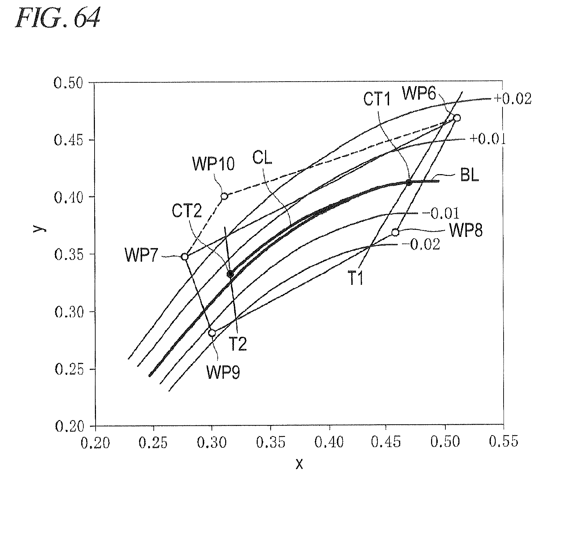

In the case where the number of light emitting units is set to four, the chromaticity points of the light emitted by the respective light emitting units are not limited to those of the above-mentioned fifth example, and various changes may be made as necessary. Fig. 64 is, in a similar manner to Fig. 63, a partially simplified diagram of the XY chromaticity diagram of Fig. 57, and shows an example in which four chromaticity points different from those of the fifth example are employed. In the example of Fig. 64, the control curve CL used in the fifth example is used, but sixth to ninth light emitting units U56 to U59 are used in place of the first to fourth light emitting units U51 to U54. In addition, the chromaticity points of the first-order light emitted from the sixth to ninth light emitting units U56 to U59 are respectively represented by WP6 to WP9.

As shown in Fig. 64, both the chromaticity point WP6 of the first-order light emitted from the sixth light emitting unit U56 and the chromaticity point WP8 of the first-order light emitted from the eighth light emitting unit U58 are on the low color temperature side of the lower limit color temperature T1 of the control curve CL. In contrast, both the chromaticity point WP7 of the first-order light emitted from the seventh light emitting unit U57 and the chromaticity point WP9 of the first-order light emitted from the ninth light emitting unit U59 are on the high color temperature side of the upper limit color temperature T2 of the control curve CL. The four chromaticity points WP6 to WP9 are set such that the rectangle, of which the vertexes are the chromaticity points WP6 to WP9, includes the control curve CL. Further, the respective chromaticity points WP6 to WP9 are positioned outside the triangle which is formed such that the vertexes thereof are the remaining chromaticity points. Such setting is performed by setting the numbers of red cells 506r, green cells 506g, yellow cells 506y, and blue cells 506b provided in each of the sixth to ninth light emitting units U56 to U59.

In the example of Fig. 64, the rectangle, which is formed such that the vertexes thereof are the four chromaticity points WP6 to WP9, includes the control curve CL. Therefore, the intensities of the first-order light respectively emitted from the sixth to ninth light emitting units U56 to U59 are adjusted in the same manner as the above-mentioned fifth example. Thereby, while positioning the chromaticity of the illumination light emitted from the illumination apparatus in the control curve CL, it is possible to adjust the color temperature of the illumination light in the range from the lower limit color temperature T1 to the upper limit color temperature T2. Accordingly, in the example shown in Fig. 64, it is also possible to obtain the same effects as the above-mentioned illumination apparatus of the fifth example.

The number of light emitting units can also be increased to become greater than four. For example, in an example in a case where the number of light emitting units is set to five, in addition to the sixth to ninth light emitting units U56 to U59, a tenth light emitting unit U60 may further be used. In this case, in order to prevent a bias toward a specific light emitting unit from occurring due to the above-mentioned reason, for example, the chromaticity point WP 10 shown in Fig. 64 may be set to be positioned outside the rectangle which is formed such that the vertexes thereof are the chromaticity points WP6 to WP9.

In such a manner, by setting the chromaticity point WP10, the control curve CL is included in a pentagon which is formed such that the vertexes thereof are the chromaticity points WP6 to WP10. Further, the respective chromaticity points WP6 to WP 10 are positioned outside the rectangle which is formed such that the vertexes thereof are the remaining chromaticity points. The chromaticity point WP10 is set by setting the numbers of red cells 506r, green cells 506g, yellow cells 506y, and blue cells 506b provided in the tenth light emitting unit U60.

In this case, the pentagon, which is formed such that the vertexes thereof are the five chromaticity points WP6 to WP10, also includes the control curve CL. Therefore, the intensities of the light respectively emitted from the sixth to tenth light emitting units U56 to U60 are adjusted in the same manner as the above-mentioned fifth example. Thereby, while positioning the chromaticity of the illumination light emitted from the illumination apparatus in the control curve CL, it is possible to adjust the color temperature of the illumination light in the range from the lower limit color temperature T1 to the upper limit color temperature T2. Accordingly, it is also possible to obtain the same effects as the above-mentioned illumination apparatus of the fifth example.

(Modified Example of LED Chip)

In the above-mentioned fifth example, the LED chips 503 emits the blue light with the peak wavelength of 460 nm. However, as described above, the emission wavelength characteristic and the type of the LED chip 503 is not limited to this, and it may be possible to employ the semiconductor light emitting elements such as various LED chips without departing from the technical scope of the present invention. Accordingly, for example, a description will be given below of a case of using the LED chips emitting the near-ultraviolet light with the peak wavelength of 405 nm as a modified example of the LED chip. Note that, in the case of the present modified example, in accordance with the change of the LED chip, as described later, the types of the phosphors used in the fluorescent member 505 are different from only some of the types of the fifth example, and thus the structure thereof is the same as that of the fifth example. Accordingly, the description below will be given with reference to the drawings used in the description of the fifth example.

The LED chip used in the present modified example emits the near-ultraviolet light with the peak wavelength of 405 nm, but as the LED chip, it is preferable to use a GaN LED chip in which an InGaN semiconductor is used in a light emitting layer and which emits light in the near-ultraviolet region. Further, it is preferable that the peak wavelength of the light emitted by the LED chips in the present modified example be in the wavelength range of 360 nm to 420 nm.

The cell regions 506 of the fluorescent member are divided, in a similar manner to the fifth example, into four types of the red cells 506r, the green cells 506g, the yellow cells 506y, and the blue cells 506b. Each red cell 506r, each green cell 506g, and each yellow cell 506y employ the red phosphor, the green phosphor, and the yellow phosphor which respectively wavelength-convert, instead of the blue light, the near-ultraviolet light into red light, green light, and yellow light. However, as the phosphors, it may be possible to apply various phosphors exemplified in the fifth example. On the other hand, each blue cell 506b does not transmit blue light like the blue cell 506b of the fifth example, but holds the blue phosphor (fourth phosphor), which wavelength-converts the near-ultraviolet light emitted by the LED chip 503 into blue light, in a distributed manner.

An appropriate wavelength range of the emission peak wavelength of the blue phosphor is normally 420 nm or more, preferably 430 nm or more, or more preferably 440 nm or more, and normally 500 nm or less, preferably 490 nm or less, more preferably 480 nm or less, further preferably 470 nm or less, or particularly preferably 460 nm or less. From this point of view, as the blue phosphor, for example, the following are preferable: $(Ca, Sr, Ba)MgAl_{10}O_{17}:Eu$; $(Sr, Ca, Ba, Mg)_{10}(PO_4)_6(Cl, F)_2:Eu$; $(Ba, Ca, Mg, Sr)_2SiO_4:Eu$; and $(Ba, Ca, Sr)_3MgSi_2O_8:Eu$. In addition, $(Ba, Sr)MgAl_{10}O_{17}:Eu$, $(Ca, Sr, Ba)_{10}(PO_4)_6(Cl, F)_2:Eu$, and $Ba_3MgSi_2O_8:Eu$ are more preferable, and $Sr_{10}(PO_4)_6C_{12}:Eu$ and $BaMgAl_{10}O_{17}:Eu$ are particularly preferable.

In addition, when the LED chips emitting the near-ultraviolet light are used, blue light transmitted through the red cells 506r, the green cells 506g, and the yellow cells 506y is reduced. Therefore, in order to compensate the reduction in blue light, the number of red cells 506r, the number of green cells 506g, the number of yellow cells 506y, and the number of blue cells 506b in the first to fourth wavelength conversion regions P51 to P54 are adjusted.

As described above, even when the LED chips emitting the near-ultraviolet light are used, if the blue cells 506b are changed in the above-mentioned manner, it is possible to generate blue light from the blue cells 506b in a similar manner to the case of the fifth example. Therefore, it is possible to emit the illumination light in the same manner as the illumination apparatus of the fifth example. In addition, by adjusting the intensity of the first-order light emitted from each light emitting unit, it is possible to obtain the same effects as the illumination apparatus of the fifth example.

(First Modified Example of Fluorescent Member)

In the above-mentioned fifth example, the fluorescent member 505 is divided into the first to fourth wavelength conversion regions P51 to P54 so as to correspond to the first to fourth light emitting units U51 to U54, and each of the wavelength conversion regions is divided into the cell regions 506 so as to correspond the respective LED chips 503. Further, the cell regions 506 are divided into four types of the red cells 506r, the green cells 506g, the yellow cells 506y, and the blue cells 506b in which mutually different types of phosphors are held in a distributed manner. In addition, in each of the first to fourth wavelength conversion regions P51 to P54, the number of red cells 506r, the number of green cells 506g, the number of yellow cells 506y, and the number of blue cells 506b are set to be different. Thereby, the chromaticities of the first-order light which is respectively emitted from the first to fourth light emitting units U51 to U54 are set to be different.

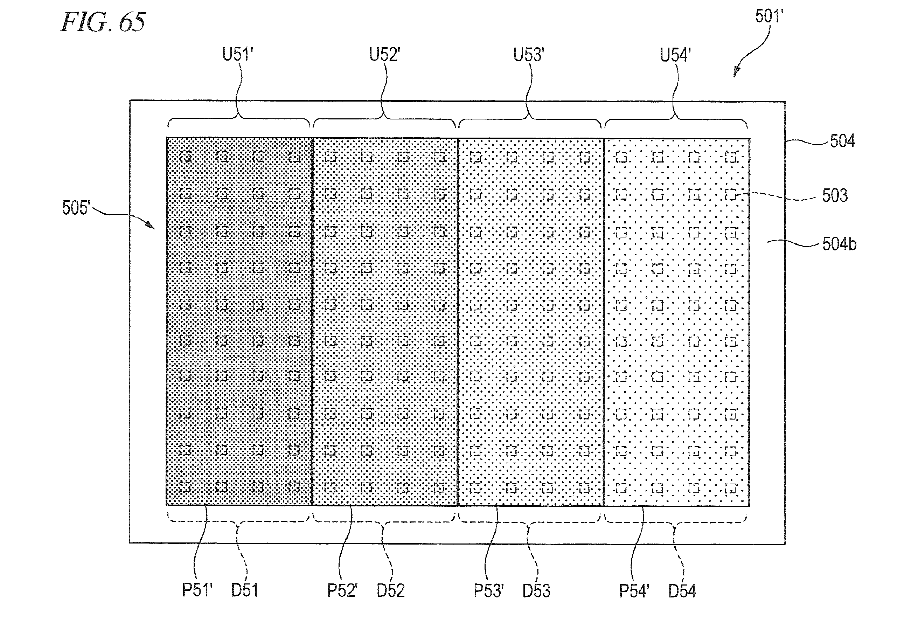

However, the configuration of the fluorescent member of the fifth example is not limited to this, and may be modified into various forms. Accordingly, one thereof will be described below as a first modified example of the fluorescent member with reference to Fig. 65. Note that, in the present modified example, the same members as the above-mentioned fifth example are represented by the same reference numerals and signs, and detailed description thereof will be omitted.

Fig. 65 is a top plan view of the light emitting section 501' according to the present modified example. In a similar manner to the fifth example, a fluorescent member (wavelength conversion member) 505' is provided on the second surface 504b of the transparent board 504, and 160 LED chips 503 are arranged on the chip mounting surface 502a of the wiring board 502, which is not shown in Fig. 65, in the same manner as the fifth example. In addition, in a similar manner to the fifth example, the transparent board 504 is disposed to be opposed to the chip mounting surface 502a of the wiring board 502, and the fluorescent member 505' is disposed to be opposed to the chip mounting surface 502a of the wiring board 502 with the transparent board 504 interposed therebetween.

The fluorescent member 505' is divided, in a similar manner to the fifth example, into four wavelength conversion regions of the first wavelength conversion region P51', the second wavelength conversion region P52', the third wavelength conversion region P53', and the fourth wavelength conversion region P54'. Note that, in Fig. 65, in order to distinguish emission colors of the respective wavelength conversion regions, the respective phosphors are represented by dot hatch patterns. Accordingly, as shown in Fig. 65, in plan view of the light emitting section 50 1', 40 LED chips 503 are disposed to correspond to each of four wavelength conversion regions of the first wavelength conversion region P51', the second wavelength conversion region P52', the third wavelength conversion region P53', and the fourth wavelength conversion region P54'. That is, in a similar manner to the fifth example, the LED chips 503 are grouped, as shown in Fig. 65, into the first LED group D51, the second LED group D52, the third LED group D53, and the fourth LED group D54 respectively corresponding to the positions of the first wavelength conversion region P51', the second wavelength conversion region P52', the third wavelength conversion region P53', and the fourth wavelength conversion region P54'.

Accordingly, in the present modified example, the first LED group D51 and the first wavelength conversion region P51' constitute a first light emitting unit U51', and the second LED group D52 and the second wavelength conversion region P52' constitute a second light emitting unit U52'. Further, the third LED group D53 and the third wavelength conversion region P53' constitute a third light emitting unit U53', and the fourth LED group D54 and the fourth wavelength conversion region P54' constitute a fourth light emitting unit U54'. The light emitting section 501', in which the four light emitting units are integrated, corresponds to the light emitting unit group of the present invention. Note that, in the description below, light, which is emitted by each of the first to fourth light emitting units U51' to U54', is referred to as first-order light, and light, which is formed by synthesizing the first-order light emitted by each of the first to fourth light emitting units U51' to U54' and is emitted from the light emitting section 501', is referred to as synthetic light.

The fluorescent member 505' has, in a similar manner to the fluorescent member 505 of the fifth example, a function of converting the wavelength of the light emitted by the LED chips 503 for each wavelength conversion region and emitting light with a peak wavelength different from the light emitted by the LED chips 503. However, the fluorescent member 505' is not divided into cell regions, where the phosphors are uniformly distributed and held in each wavelength conversion region. Specifically, in the fluorescent member 505' of the present modified example, the red phosphor, the green phosphor, and the yellow phosphor are used in a mixed manner. Therefore, instead of adjusting the number of red cells 506r, the number of green cells 506g, the number of yellow cells 506y, and the number of blue cells 506b through each wavelength conversion region in the same manner as the fifth example, the mixture ratio of the red phosphor, the green phosphor, and the yellow phosphor is changed for each wavelength conversion region.

More specifically, as shown in Fig. 55, on the basis of the number of red cells 506r, the number of green cells 506g, the number of yellow cells 506y, and the number of blue cells 506b of each wavelength conversion region in the fifth example, the mixture ratio of the red phosphor, the green phosphor, and the yellow phosphor is determined for each wavelength conversion region. In such a manner, in a similar manner to the case of the fifth example, the first-order light emitted from each of the first to fourth light emitting units U51' to U54' has each chromaticity of the chromaticity point WP1, the chromaticity point WP2, the chromaticity point WP3, and the chromaticity point WP4 in the XY chromaticity diagram of Fig. 57.

Note that, as shown in Fig. 55, in the fifth example, the second wavelength conversion region P52 does not include the red cells 506r, and thus in the present modified example, the mixture ratio of the red phosphor in the second wavelength conversion region P52' is 0%. Further, in the fifth example, as the blue light emitted from the blue cells 506b, blue light, which is emitted through each wavelength conversion region without wavelength conversion, is used. Accordingly, in the present modified example, the densities of the red phosphor, the green phosphor, and the yellow phosphor are determined for each wavelength conversion region such that the blue light with the same level as the case of the fifth example is emitted from each wavelength conversion region.

As described above, with such a configuration of the first to fourth wavelength conversion regions P51' to P54' of the fluorescent member 505', the first-order light emitted from each of the first to fourth light emitting units U51' to U54' has each chromaticity of the chromaticity points WP1 to WP4 in the XY chromaticity diagram of Fig. 57 in a similar manner to the case of the fifth example. Accordingly, by adjusting the intensity of the first-order light emitted from each of the light emitting units U51' to U54' in a similar manner to the case of the fifth example, the illumination light of the illumination apparatus of the present modified example can be adjusted in the color temperature range from the lower limit color temperature T1 to the upper limit color temperature T2 at the chromaticity in the control curve CL shown in Fig. 57. As a result, in the present modified example, it is also possible to obtain the same effects as the case of the fifth example.

Note that, in the present modified example, instead of the LED chips emitting the blue light, it may be possible to use the LED chips emitting the near-ultraviolet light. In this case, in addition to the red phosphor, the green phosphor, and the yellow phosphor used in the fluorescent member 505', the blue phosphor, which converts the wavelength of the near-ultraviolet light emitted by the LED chips so as to emit blue light, may be used in a mixed manner.

(Second Modified Example of Fluorescent Member)

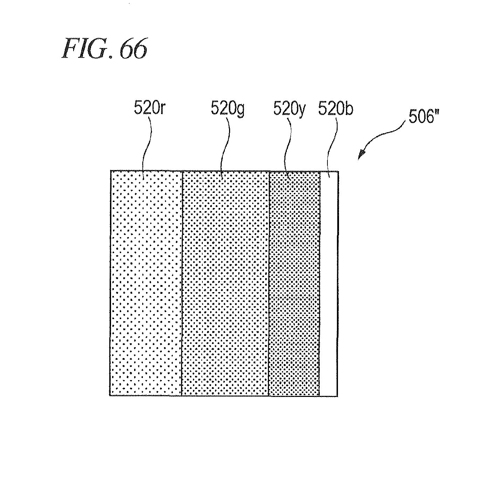

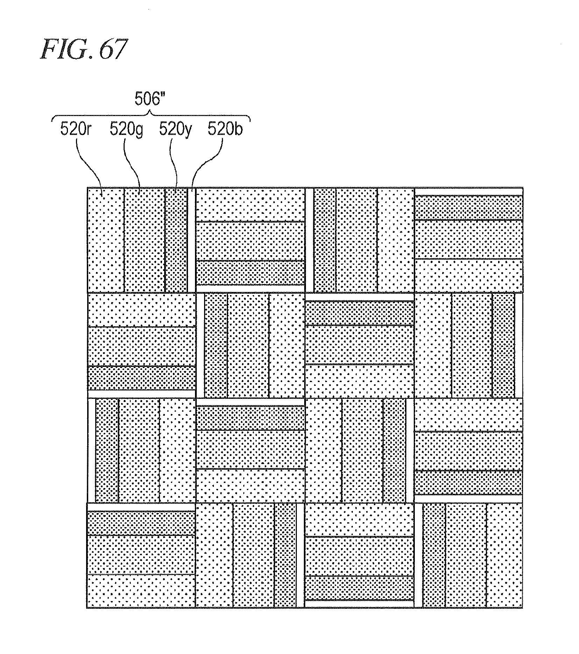

A further modified example of the fluorescent member will be described as a second modified example with reference to Figs. 66 and 67. Note that, in the present modified example, the same members as the above-mentioned fifth example are represented by the same reference numerals and signs, and detailed description thereof will be omitted. Further, in Figs. 66 and 67, in order to distinguish emission colors of the respective cells, the respective phosphors are represented by dot hatch patterns.

In the present modified example, the basic configuration of the light emitting section is also the same as that of the fifth example, and only the division of the fluorescent member provided in the transparent board 504 is different from the fifth example or the first modified example. Specifically, in a similar manner to the fifth example, also in the present modified example, the fluorescent member is divided into 160 cell regions 506" respectively corresponding to the LED chips 503. However, the configuration of each cell region 506" is different from the cell region 506 of the fifth example.

That is, also in the present modified example, in a similar manner to the fifth example, the fluorescent member is divided into four wavelength conversion regions of the first wavelength conversion region, the second wavelength conversion region, the third wavelength conversion region, and the fourth wavelength conversion region, and each wavelength conversion region includes 40 cell regions 506". In the fifth example, the 160 cell regions 506 are divided into four type cell regions of the red cells 506r, the green cells 506g, the yellow cells 506y, and the blue cells 506b. In each wavelength conversion region, the number of red cells 506r, the number of green cells 506g, the number of yellow cells 506y, and the number of blue cells 506b are different.

In contrast, in the present modified example, each cell region 506" is further divided into four regions of a red region 520r, a green region 520g, a yellow region 520y, and a blue region 520b. In the red regions 520r, the red phosphors, which are for emitting red light by converting the wavelength of the blue light emitted by the LED chips 503, are held in a distributed manner. In the green regions 520g, the green phosphors, which are for emitting green light by converting the wavelength of the blue light emitted by the LED chips 503, are held in a distributed manner. In the yellow regions 520y, the yellow phosphors, which are for emitting yellow light by converting the wavelength of the blue light emitted by the LED chips 503, are held in a distributed manner. In addition, in each blue region 520b, in a similar manner to the blue cell 506b of the fifth example, the diffusing particles for satisfactorily diffusing and emitting blue light are held in a distributed manner in the cell region which transmits the blue light emitted by the LED chip 503 without wavelength conversion.

Fig. 66 is a top plan view exemplifying one of the cell region 506" in the present modified example. However, as shown in Fig. 66, in each cell region 506", areas of the red region 520r, the green region 520g, the yellow region 520y, and the blue region 520b are not exactly the same. That is, in the present modified example, instead of adjusting the number of red cells 506r, the number of green cells 506g, the number of yellow cells 506y, and the number of blue cells 506b through each wavelength conversion region in the same manner as the fifth example, the areas of the red region 520r, the green region 520g, the yellow region 520y, and the blue region 520b in each cell region 506" are changed for each wavelength conversion region.

Specifically, as shown in Fig. 55, on the basis of the number of red cells 506r, the number of green cells 506g, the number of yellow cells 506y, and the number of blue cells 506b in the fifth example, the areas of the red region 520r, the green region 520g, the yellow region 520y, and the blue region 520b in each cell region 506" are determined for each wavelength conversion region. In such a manner, in a similar manner to the case of the fifth example, the first-order light emitted from each light emitting unit has each chromaticity of the chromaticity point WP1, the chromaticity point WP2, the chromaticity point WP3, and the chromaticity point WP4 in the XY chromaticity diagram of Fig. 57.

Note that, as shown in Fig. 55, in the fifth example, the second wavelength conversion region P52 does not include the red cells 506r, and thus in the present modified example, the red region 520r is also not provided in each cell region 506" in the second wavelength conversion region. Further, in the fifth example, the third wavelength conversion region P53 does not include the blue cells 506b, and thus in the present modified example, the blue region 520b is also not provided in each cell region 506" in the third wavelength conversion region.

Fig. 67 is a schematic diagram partially illustrating an example of arrangement of the cell regions 506", which are formed in such a manner, in the first wavelength conversion region. In each wavelength conversion region, the areas of the red region 520r, the green region 520g, the yellow region 520y, and the blue region 520b of the cell region 506" are determined to have constant values. However, as shown in Fig. 67, the cell regions 506" are arranged in a state where the rotation angles of the cell regions 506" adjacent to one another are different by 90 degrees from one another such that the directions of the cell regions 506" are not the same. In the second to fourth wavelength conversion regions, in the same manner as described above, the cell regions 506" are arranged. In such a manner, the light emitted from each cell region 506" is further satisfactorily synthesized. Note that, the method of arranging the cell regions 506" are not limited to the form of Fig. 67, and may be modified into various forms.

As described above, with such a configuration of the cell regions 506" included in each wavelength conversion region, the first-order light emitted from each light emitting unit has each chromaticity of the chromaticity points WP1 to WP4 in the XY chromaticity diagram of Fig. 57 in a similar manner to the case of the fifth example. Accordingly, by adjusting the intensity of the first-order light emitted from each light emitting unit in a similar manner to the case of the fifth example, the illumination light of the illumination apparatus of the present modified example can be adjusted in the color temperature range from the lower limit color temperature T1 to the upper limit color temperature T2 at the chromaticity in the control curve CL shown in Fig. 57. As a result, in the present modified example, it is also possible to obtain the same effects as the case of the fifth example.

Note that, in the present modified example, instead of the LED chips emitting the blue light, it may be possible to use the LED chips emitting the near-ultraviolet light. In this case, in the blue region 520b of the cell region 506", it is preferable that the blue phosphor, which converts the wavelength of the near-ultraviolet light emitted by the LED chip so as to emit blue light, be held in a distributed manner. However, when the LED chips emitting the near-ultraviolet light are used, blue light transmitted through the red regions 520r, the green regions 520g, and the yellow regions 520y is reduced. Therefore, in order to compensate the reduction in blue light, the areas of the red region 520r, the green region 520g, the yellow region 520y, and the blue region 520b of each cell region 506" are adjusted for each wavelength conversion region.

(Third Modified Example of Fluorescent Member)

In the fifth example, the fluorescent member 505 is divided into four parts, that is, the first to fourth wavelength conversion regions P51 to P54, and together with the LED chips 503 grouped into the first to fourth LED groups D51 to D54 corresponding to the wavelength conversion regions, the first to fourth light emitting units U51 to U54 are formed one by one. However, at least one of the first to fourth wavelength conversion regions P51 to P54 may be further divided.

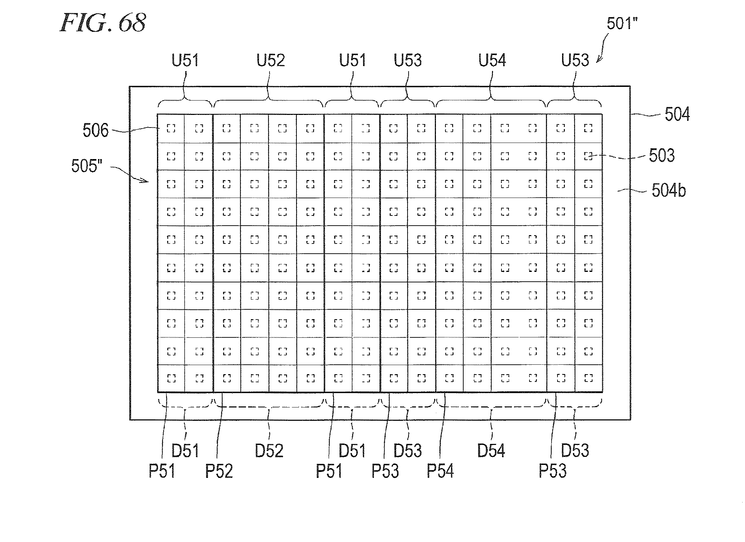

Fig. 68 shows an example of such a case as a third modified example, and is a top plan view illustrating a fluorescent member in which each of the first wavelength conversion region P51 and the third wavelength conversion region P53 is further divided into two parts. As shown in Fig. 68, the first wavelength conversion region P51 is divided into two parts, and they are disposed with the second wavelength conversion region P52 interposed therebetween. Likewise, the third wavelength conversion region P53 is divided into two parts, and they are disposed with the fourth wavelength conversion region P54 interposed therebetween.

In accordance with the division of the wavelength conversion regions, the first LED group D51 is also divided into two parts, and they are disposed with the second LED group D52 interposed therebetween. Likewise, the third LED group D53 is also divided into two parts, and they are disposed with the fourth LED group D54 interposed therebetween. As a result, the first light emitting unit U51 formed of the first LED group D51 and the first wavelength conversion region P51 is also divided into two parts, and they are disposed with the second light emitting unit U52 interposed therebetween. Further, the third light emitting unit U53 formed of the third LED group D53 and the third wavelength conversion region P53 is also divided into two parts, and they are disposed with the fourth light emitting unit U54 interposed therebetween. Note that, in this case, the light emitting section 501" formed of the first to fourth light emitting units U51 to U54 corresponds to the light emitting unit group of the present invention.

In the first wavelength conversion region P51 divided into two parts, the total number of the red cells 506r, the green cells 506g, the yellow cells 506y, and the blue cells 506b is the same as that of the first wavelength conversion region P51 of the fifth example. In the third wavelength conversion region P53 divided into two parts, the total number of the red cells 506r, the green cells 506g, the yellow cells 506y, and the blue cells 506b is the same as that of the third wavelength conversion region P53 of the fifth example. Accordingly, by adjusting the intensity of the first-order light emitted from each light emitting unit in a similar manner to the case of the fifth example, the illumination light of the illumination apparatus of the present modified example can be adjusted in the color temperature range from the lower limit color temperature T1 to the upper limit color temperature T2 at the chromaticity in the control curve CL shown in Fig. 57. As a result, in the present modified example, it is also possible to obtain the same effects as the case of the fifth example.

Furthermore, since each of the first wavelength conversion region P51 and the third wavelength conversion region P53 is divided into two parts so as to be disposed in a distributed manner, it is possible to more satisfactorily synthesize the first-order light emitted from each wavelength conversion region. Note that, in the present modified example, each of the first wavelength conversion region P51 and the third wavelength conversion region P53 is divided into two parts, but the divided wavelength conversion regions are not limited to them, and at least one of the first to fourth wavelength conversion regions P51 to P54 may be divided in the same manner. Further, the number of divided parts is also not limited to two, may be three or more. Furthermore, the arrangement of the wavelength conversion regions is also not limited to the form of Fig. 68, and may be modified into various forms.

In the present modified example, each wavelength conversion region is further divided into cell regions in a similar manner to the fifth example, but the present modified example can also be applied to the first modified example shown in Fig. 65. That is, as shown in Fig. 65, at least one of the first to fourth wavelength conversion regions P51' to P54', which are not divided into the cell regions, may be divided as described in the present modified example. Further, in a similar manner to the application to the fifth example, the present modified example can also be applied to the second modified example as a modified example in the case where each wavelength conversion region is further divided into the cell regions.

(First Modified Example of Emission control)

In the fifth example, by setting the target correlation color temperature in accordance with the operation position of the operation dial 514a of the operation unit 514, the emission control for controlling light emission of the first to fourth light emitting units U51 to U54 is performed such that the color temperature of the illumination light of the illumination apparatus (light emission apparatus 1) is the target correlation color temperature. At this time, particularly in the color temperature region less than or equal to 4000 K, as shown in Fig. 60, the total luminous flux of the illumination light is decreased in accordance with the decrease in the color temperature, thereby eliminating sense of discomfort caused by change in the color temperature and the total luminous flux of a general incandescent bulb. The degree of the decrease in the total luminous flux caused by the decrease in the color temperature can be adjusted to various magnitudes by changing the magnitudes of the electric powers respectively supplied to the first to fourth light emitting units U51 to U54 from the magnitudes thereof shown in Fig. 60.

Accordingly, instead of adjusting the color temperature in accordance with the operation performed on the operation unit 514 in the same manner as the fifth example, it is possible to adjust the total luminous flux of the illumination light of the illumination apparatus in the range from the light-off state to the maximum total luminous flux state. Further, in a similar manner to the description of the emission control of the fifth example, when the on/off control of the transistors Q51 to Q54 is performed on the basis of the relationship shown in Fig. 60, as shown in Fig. 60, the total luminous flux of the illumination light is determined to correspond to the target correlation color temperature at that time. Therefore, the target total luminous flux is also determined by determining the target correlation color temperature. Hereinafter, a description will be given of emission control in a case where the emission control section 513 of the fifth example is configured to adjust the total luminous flux of the illumination light as a modified example of the emission control.

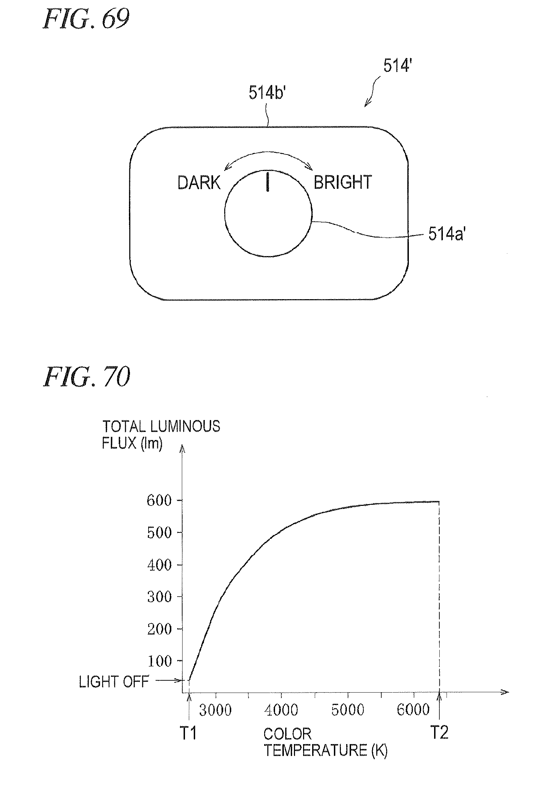

Fig. 69 is a schematic diagram of an operation unit 514' used instead of the operation unit 514 of the fifth example for emission control of the present modified example. In addition, in the present modified example, only contents of the emission control and the operation unit 514' are different from those of the fifth example, thus the other configuration is the same as that of the fifth example, the members with the same configurations as the fifth example are represented by the same reference numerals and signs, and the detailed description thereof will be omitted.

As shown in Fig. 69, the operation unit 514' includes: an operation dial 514a' by which a user performs operation; and a main body 514b' in which an electric circuit (not shown in the drawing) for detecting the operation position of the operation dial 514a' and transmitting the position to the light control section 513 is built. The operation dial 514a' can be rotated by user's operation. As shown in Fig. 69, on the main body 514b', there is an indication to the effect that, as the operation dial 514a' is rotated clockwise, the total luminous flux of the illumination light emitted from the illumination apparatus is increased. The operation dial 514a' may be formed to be rotated stepwise in accordance with the indication on the main body 514b', and may be formed to be continuously rotated.

Fig. 70 is a graph illustrating a relationship between the total luminous flux and the color temperature of the illumination light emitted from the illumination apparatus in accordance with the position of the operation dial 514a' of the operation unit 514' by performing the emission control of the present modified example. As shown in Fig. 70, in the present modified example, by operating the operation dial 514a' of the operation unit 514', it is possible to adjust the total luminous flux of the illumination light in the range from the light-off state to around 600 lm. In addition, in response to the change in the total luminous flux, the color temperature of the illumination light is changed in the range from the lower limit color temperature T1 to the upper limit color temperature T2.

The change in the color temperature and the total luminous flux of the illumination light can be achieved by changing the magnitudes of the electric powers respectively supplied to the first to fourth light emitting units U51 to U54 from the magnitudes thereof shown in Fig. 60 as described above. In the fifth example, on the basis of the relationship between the color temperature of the illumination light and the supply powers respectively supplied to the first to fourth light emitting units U51 to U54, the relationship between the target correlation color temper and the amount of control (the amount of emission control) of the transistors Q51 to Q54 of the light emitting section 501 are stored in advance as a control map in the memory 513a of the emission control section 513. At this time, the relationship between the supply power and the color temperature of the illumination light is figured out in advance by performing simulation, experiment, or the like. Thus, the relationship between the color temperature and the total luminous flux is additionally figured out. Accordingly, through the same simulation or experiment, it is possible to figure out the relationship of the color temperature, the total luminous flux, and the supply power as the relationship shown in Fig. 70. That is, when the target total luminous flux or the target color temperature is determined, in a similar manner to the case of the fifth example, on the basis of the set control map, it is possible to determine the supply powers supplied to the first to fourth light emitting units U51 to U54, that is, the amounts of control (the amount of emission control) of the transistors Q51 to Q54 of the light emitting section 501. Therefore, in the present modified example, instead of the target correlation color temperature used in the fifth example, by mainly using the target total luminous flux, the emission control is performed.

The main body 514b' of the operation unit 514' detects the position of the operation dial 514a', and notifies the detected position of the operation dial 514a' to the target value setting section 515 in a similar manner to the fifth example. The target value setting section 515 determines the target total luminous flux corresponding to the detected position of the operation dial 514a', on the basis of the relationship between the target total luminous flux and the position of the operation dial 514a' which is set in advance to match with the indication on the main body 514b' of the operation unit 514', and transmits the target total luminous flux to the emission control section 513. In addition, since the relationship shown in Fig. 70 is determined in advance between the color temperature of the illumination light and the total luminous flux, in response to the determination of the target total luminous flux, the target correlation color temperature is automatically determined.

The emission control section 513 acquires the amount of on/off control of each of the transistors Q51 to Q54 corresponding to the target total luminous flux, which is sent from the target value setting section 515, from the control map stored in the memory 513a, and controls on and off states of the transistors Q51 to Q54 on the basis of the acquired amount of control. As a result, the illumination light of the total luminous flux corresponding to the position of the operation dial 514a of the operation unit 514' is emitted from the illumination apparatus.

As shown in Fig. 70, the color temperature of the illumination light at this time gradually decreases in accordance with the decrease in the total luminous flux. Thus, immediately before the light-off state, the color temperature thereof reaches the lower limit color temperature T1. Since the lower limit color temperature T1 is set to about 2550 K, due to the change in the color temperature, it is possible to achieve the change of the emission color practically the same as the case of gradually changing a general incandescent bulb from the light-on state to the light-off state.

Further, Literature Kruithof AA: Tubular Luminescence Lamps for General Illumination, Philips Technical Review, 6, pp. 65-96 (1941) describes the illuminance at which a human feels comfortable when the color temperature of the synthetic white light is changed. On the basis of this Literature (hereinafter referred to as Kruithof Literature), if the color temperature of the synthetic white light is intended to be changed while comfort is maintained, it is preferable to control light emission of the light emitting unit at the time of changing the target luminous flux $\phi$ in accordance with the target correlation color temperature T such that such that the constant A0, at which the following inequality expression (1) is established, is present.

$$-80743 \cdot (1000/T)^5 + 164973 \cdot (1000/T)^4 - 135260 \cdot (1000/T)^3 + 57994 \cdot (1000/T)^2 - 13995 \cdot (1000/T) + 1632.9 < \phi/A0 < \exp\{-342.11 \cdot (1000/T)^3 + 450.43 \cdot (1000/T)^2 - 212.19 \times (1000/T) + 39.47\} \quad \cdots (1)$$

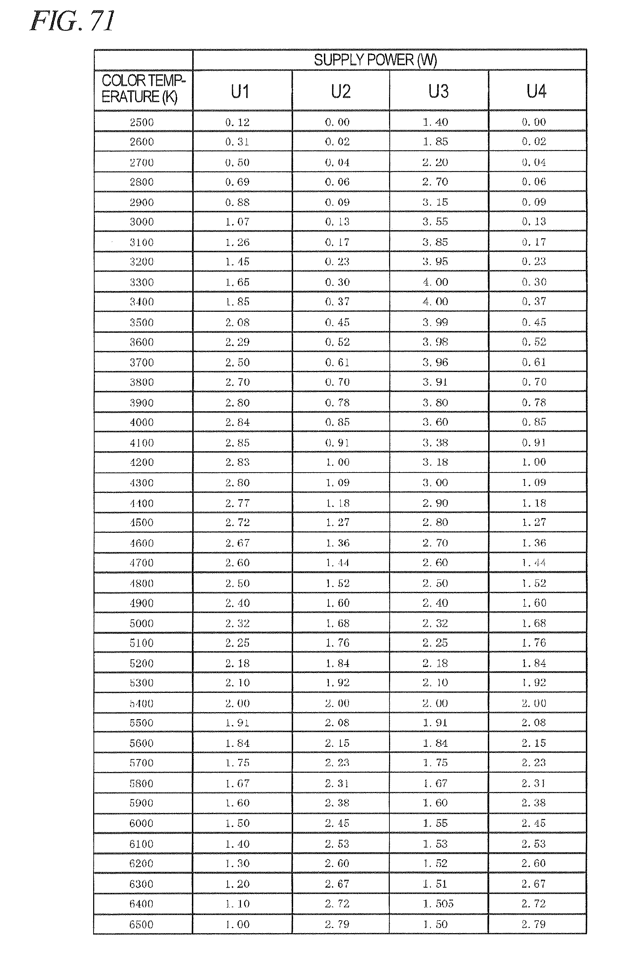

In the above-mentioned fifth example, the illuminance of the irradiated surface (that is, the irradiated object which is irradiated with light by the illumination apparatus), which faces the fronts of the light emitting section 501 and is positioned at the distance R, is $\phi/(\pi \cdot R^2)$. Here, it is assumed that the light distribution of the light emission apparatus is Lambertian. When N light emission apparatuses are provided (that is, when the illuminance of the above-mentioned irradiated object is $N \phi/(\pi \cdot R^2)$), by substituting $A0 = \pi \cdot R^2 \cdot N$ into the inequality expression (1), it is possible to calculate the target luminous flux appropriate for the target correlation color temperature T. For example, when R is set to 2m and N is set to 12, as shown in the table of Fig. 71, by performing the emission control so as to respectively supply the electric powers corresponding to the target correlation color temperature to the first to fourth light emitting units U51 to U54, it is possible to make the change in the total luminous flux and the color temperature of the illumination light of the illumination apparatus comfortable. The electric circuit used in such a case may have either one of the configurations of Figs. 58 and 61.

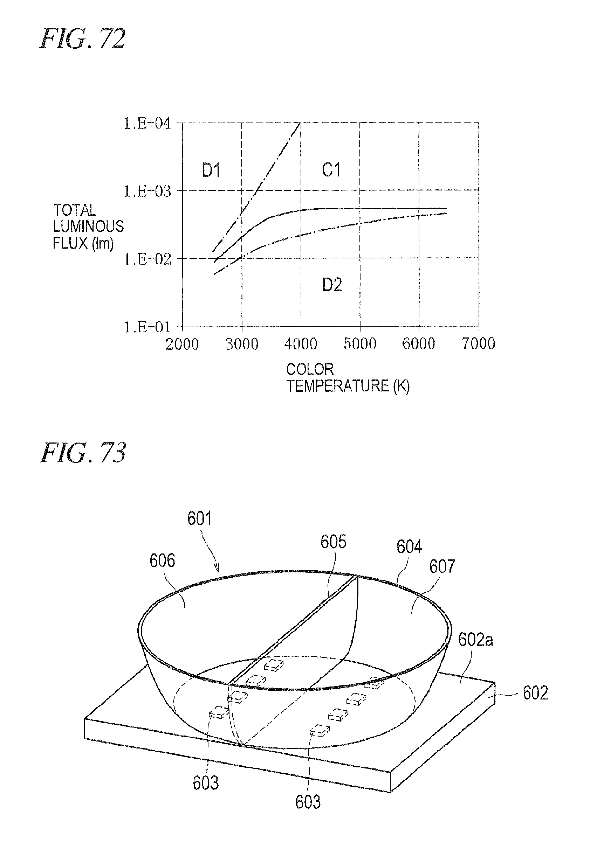

By performing such emission control, the color temperature and the total luminous flux of the illumination light emitted from the illumination apparatus are changed in accordance with the relationship indicated by the solid line of Fig. 72. Note that, on the basis of the description of Kruithof Literature, the region C1, which is interposed between the two chain lines in Fig. 72, represents a range in which a human feels comfortable, and the other regions D 1 and D2 represent ranges in which a human feels uncomfortable. As shown in Fig. 72, it was discovered that the illumination light generated from the light emission apparatus is made to provide comfort all the time when the illuminance and the color temperature are changed.

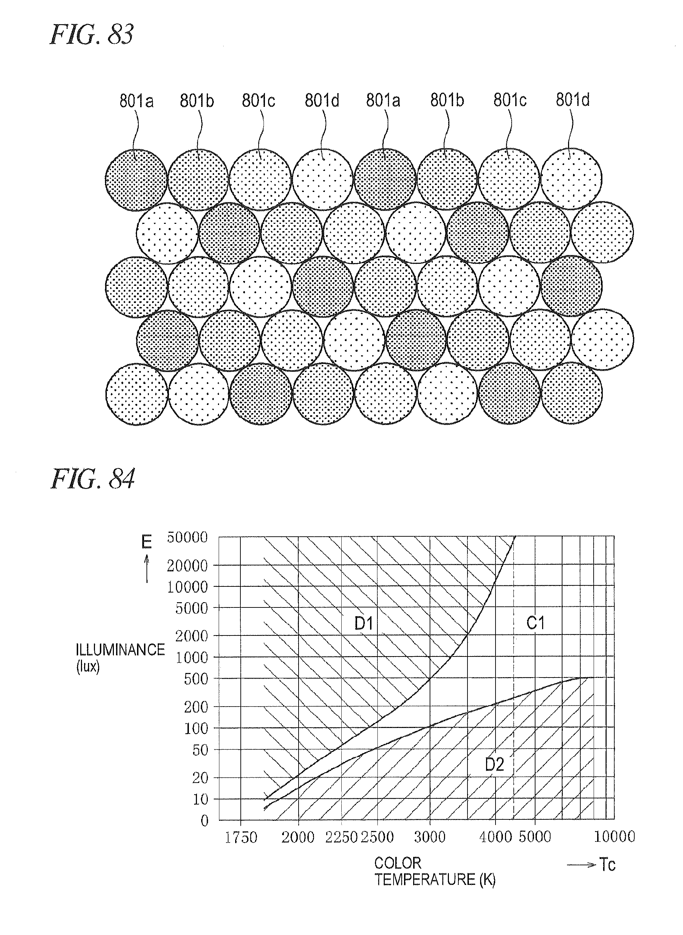

Further, Fig. 84 is a graph in which the vertical axis of Fig. 72 is changed to represent the illuminance of the irradiated object which is irradiated with light by the illumination apparatus. Likewise, in Fig. 84, on the basis of the description of Kruithof Literature, the region C1, which is interposed between the two chain lines, represents a range in which a human feels comfortable, and the other regions D1 and D2 represent ranges in which a human feels uncomfortable. In Fig. 84, when the color temperature (that is, the target correlation color temperature T) is sequentially changed in the range of 3500 K to 4500 K, in order to obtain the illuminance in the region C1 in the entire range of 3500 K to 4500 K, in terms of the expression (that is, $N \cdot \phi/(\pi \cdot R^2)$) representing the illuminance of the irradiated object and the relationships of Figs. 72 and 84, it is necessary for the total luminous flux (that is, the target total luminous flux $\phi$) at 4500 K to be greater than or equal to two times and less than or equal to 30 times the total luminous flux (that is, the target total luminous flux $\phi$) at 3500 K in correspondence with the appropriate illuminance (that is, the desired illuminance of the irradiated object with respect to each illumination apparatus) in the range of 3500 K to 4500 K. The total luminous flux is preferably greater than or equal to two times and less than or equal to 20 times, and is more preferably greater than or equal to two times and less than or equal to 10 times. Here, to correspond to the appropriate illuminance in the range of 3500 K to 4500 K means that, for example, the target total luminous flux $\phi$ is set such that the illuminance of the irradiated object at 3500 K is in the range of 100 Lux to 500 Lux and the illuminance of the irradiated object at 4500 K is in the range of 300 Lux to 40000 Lux.

In Fig. 84, when the color temperature (that is, the target correlation color temperature T) is sequentially changed in the range of 2000 K to 4500 K, in order to obtain the illuminance in the region C1 in the entire range of 2000 K to 4500 K, in terms of the expression (that is, $N \cdot \phi/(\pi \cdot R^2)$) representing the illuminance of the irradiated object and the relationships of Figs. 72 and 84, it is necessary for the total luminous flux (that is, the target total luminous flux $\phi$) at 4500 K to be greater than or equal to 10 times and less than or equal to 100 times the total luminous flux (that is, the target total luminous flux $\phi$) at 2000 K so as to correspond to the appropriate illuminance (that is, the desired illuminance of each illumination apparatus of the irradiated object) in the range of 2000 K to 4500 K. The total luminous flux is preferably greater than or equal to 15 times and less than or equal to 85 times, and is more preferably greater than or equal to 20 times and less than or equal to 70 times. Here, to correspond to the appropriate illuminance in the range of 2000 K to 4500 K means that, for example, the target total luminous flux $\phi$ is set such that the illuminance of the irradiated object at 2000 K is in the range of 15 Lux to 50 Lux and the illuminance of the irradiated object at 4500 K is in the range of 300 Lux to 40000 Lux.

As described above, in both of the case where the target correlation color temperature T is set and thereby the target total luminous flux $\phi$ is set (the case of the present example) and the case where the target total luminous flux $\phi$ is set and thereby the target correlation color temperature T is set (in the case of the modified example), in the entire set color temperature range, it is possible to obtain an appropriate illuminance. Thus, even in the case where the color temperature of the light emitted from the illumination apparatus is changed, it is possible to provide light which is comfortable all the time.

(Second Modified Example of Emission control)

In the fifth example, the target correlation color temperature is determined in accordance with the operation performed on the operation unit 514, the amount of control corresponding to the target correlation color temperature is acquired from the control map which is stored in advance, and the on/off control of the transistors Q51 to Q54 is performed. In such a manner, it is possible to reduce the computation load of the emission control section 513. However, in such a case where there is a room for computation capability of the emission control section 513, the amount of control corresponding to the set target correlation color temperature may be computed without using such a control map in each case. In this case, it is possible to reduce the amount of data occupying the memory 513a provided on the emission control section 513.

(Third Modified Example of Emission control)

In the fifth example, the color temperature of the illumination light can be changed in accordance with the operation performed on the operation unit 514, but instead of user's operation, the total luminous flux and the color temperature of the illumination light are changed in accordance with the pattern which is set in advance. In this case, the amount of control (the amount of emission control), which corresponds to the pattern of the change in the total luminous flux or the change in the color temperature of the illumination light with the passage of time, is stored in advance in the memory 513a of the emission control section 513, and the transistors Q51 to Q54 may be controlled on the basis of the amount of control acquired in accordance with the time count of the timer built in the emission control section 513. Further, instead of the pattern which is set in advance, by detecting environment using the illumination apparatus such as temperature, humidity, a season, or a place of use or a purpose of use of the illumination apparatus, the total luminous flux and the color temperature of the illumination light may be changed in accordance with the detected environment.

(Fourth Modified Example of Emission control)

In the fifth example, the target correlation color temperature is determined in accordance with the operation performed on the operation unit 514, the corresponding amount of control is determined on the basis of the target correlation color temperature, and the transistors Q51 to Q54 is controlled. However, in accordance with the operation performed on the operation unit 514, the amount of control (the amount of emission control) may be directly determined. In this case, in a similar manner to the fifth example, the amount of control is determined on the basis of the relation shown in Fig. 60, and thus the control is practically performed on the basis of the target correlation color temperature.

<Sixth Example>

In the fifth example mentioned above, the illumination apparatus is configured by using the light emitting unit groups each including the plurality of LED chips 503 mounted on the wiring board 502 and the fluorescent member 505 provided on the transparent board 504. However, the illumination apparatus according to the present invention is not limited to such a form, and may be modified into or replaced with various forms without departing from the technical scope of the present invention. Accordingly, an example of the illumination apparatus, which is configured by using light emitting unit groups different from the light emitting unit groups of the fifth example, will be described below as a sixth example of the present invention.

(Configuration of Light Emitting Section)

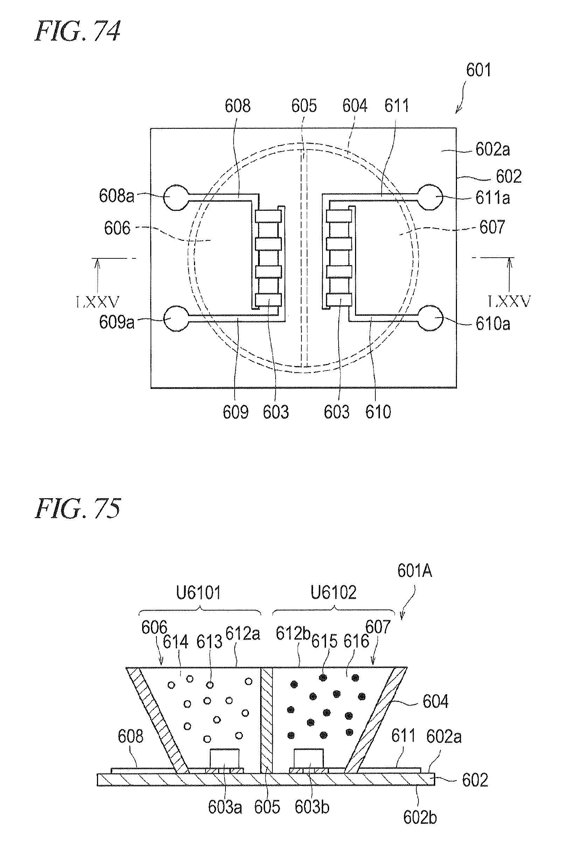

Fig. 73 is a perspective view illustrating a basic configuration of a light emitting section 601 in the illumination apparatus according to the present example. Fig. 74 is a top plan view of the light emitting section 601. The light emitting section 601 includes four LED chips 603 that are mounted in each of two arrays on a chip mounting surface 602a of a wiring board 602 made of alumina ceramic which is excellent in electrical insulation and has a favorable heat dissipation ability. Furthermore, a reflector (wall member) 604 having an annular and truncated cone shape is provided on the chip mounting surface 602a of the wiring board 602 so as to surround the LED chips 603.

The inside of the reflector 604 is partitioned by the partition member 605 into a first region 606 and a second region 607. In the first region 606, the LED chips 603, which belong to one of the two arrays of the LED chips 603, are disposed. In the second region 607, the LED chips 603, which belong to the other array, are disposed. In addition, the reflector 604 and the partition member 605 can be formed of resin, metal, ceramic, or the like, and is fixed onto the wiring board 602 through an adhesive or the like. Further, when a conductive material is used in the reflector 604 and the partition member 605, a process for providing electrical insulation to a wiring pattern to be described later is necessary.

Note that, in the present example, the number of LED chips 603 is just an example, may be increased or decreased as necessary, may be one for each of the first region 606 and the second region 607, and may be different for each region. Further, the material of the wiring board 602 is not limited to the alumina ceramic, and may use various kinds of materials. For example, it may be possible to use a material selected from ceramic, resin, glass epoxy, and composite resin containing a filler as materials with excellent electrical insulation. Furthermore, in order to improve a light emitting efficiency of the light emitting section 601 by enhancing reflectivity of light on the chip mounting surface 602a of the wiring board 602, it is preferable to use silicon resin including a white pigment such as alumina powder, silica powder, magnesium oxide, or titanium oxide. On the other hand, by using a substrate made of metal such as copper or aluminum, it is possible to improve a heat dissipation ability. However, in this case, it is necessary to form the wiring patterns on the wiring board with electrical insulation performed thereon.

Further, the shapes of the above-mentioned reflector 604 and partition member 605 are also just exemplary shapes, may be modified into various shapes as necessary. For example, instead of the reflector 604 and the partition member 605 formed in advance, an annular wall portion (wall member) corresponding to the reflector 604 may be formed on the chip mounting surface 602a of the wiring board 602 by using a dispenser or the like, and thereafter a partition wall (partition member) corresponding to the partition member 605 may be formed. In this case, the material used in the annular wall portion and the partition wall portion is, for example, a UV curable resin material or a thermosetting resin material having a paste form, and thus silicon resin containing an inorganic filler is appropriate therefor.

As shown in Figs. 73 and 74, in the first region 606 inside the reflector 604, the four LED chips 603 are arranged in series so as to be parallel with the extension direction of the partition member 605. In addition, the second region 607 inside the reflector 604, the four LED chips 603 are arranged in series so as to be parallel with the extension direction of the partition member 605. Note that, in Fig. 74, for convenience of description, the reflector 604 and the partition member 605 are indicated by the dashed line.

The wiring patterns 608, 609, 610, and 611 for respectively supplying driving currents to the LED chips 603 are formed on the chip mounting surface 602a of the wiring board 602, as shown in Fig. 74. A connection terminal 608a for external connection is formed at one end of the wiring pattern 608 outside the reflector 604, and the other end side of the pattern inside the first region 606 is provided to extend in parallel with the partition member 605 as shown in Fig. 74. Further, a connection terminal 609a for external connection is formed at one end of the wiring pattern 609 outside the reflector 604, and the other end side of the pattern inside the first region 606 is provided to extend in parallel with the partition member 605 as shown in Fig. 74.

The four LED chips 603 inside the first region 606 are connected in parallel between the wiring pattern 608 and the wiring pattern 609, which are formed as described above, such that the directions of polarities thereof are the same. More specifically, the LED chip 603 has two electrodes (not shown in the drawing) for supplying driving currents on the surface of the wiring board 602 side. In addition, one electrode (p electrode) of the LED chip 603 is connected to the wiring pattern 608, and the other electrode (n electrode) thereof is connected to the wiring pattern 609.

On the other hand, a connection terminal 610a for external connection is formed at one end of the wiring pattern 610 outside the reflector 604, and the other end side of the pattern inside the second region 607 is provided to extend in parallel with the partition member 605 as shown in Fig. 74. Further, a connection terminal 611a for external connection is formed at one end of the wiring pattern 611 outside the reflector 604, and the other end side of the pattern inside the second region 607 is provided to extend in parallel with the partition member 605 as shown in Fig. 74.

The four LED chips 603 inside the second region 607 are connected in parallel between the wiring pattern 610 and the wiring pattern 611, which are formed as described above, such that the directions of polarities thereof are the same. More specifically, one electrode (p electrode) of the LED chip 603 is connected to the wiring pattern 610, and the other electrode (n electrode) thereof is connected to the wiring pattern 611.

By using flip chip mounting, the LED chips 603 are mounted and both electrodes are connected to the respective wiring patterns with an unillustrated metal bump interposed therebetween through the eutectic solder. Note that, the method of mounting the LED chips 603 on the wiring board 602 is not limited to this, and it may be possible to select a method appropriate for the type, the structure, or the like of the LED chips 603. For example, it may be possible to employ double wire bonding which connects the electrodes of the LED chips 603 to the corresponding wiring patterns through wire bonding after the LED chips 603 are fixedly attached to predetermined positions of the wiring board 602 mentioned above. In addition, it may be possible to employ single wire bonding which bonds one electrode to the wiring pattern as described above and connects the other electrode to the wiring pattern through the wire bonding.

The first region 606 and the second region 607 inside the reflector 604 house fluorescent members (wavelength conversion members) respectively having different wavelength conversion characteristics such that the fluorescent members cover the LED chips 603. The present example employs four types of the fluorescent members, and employs two types of light emitting sections of a light emitting section containing the two types of the fluorescent members thereof and a light emitting section containing the remaining two types of the fluorescent members thereof. Accordingly, in the description below, one light emitting section is referred to as a first light emitting section 601A, and the other light emitting section is referred to as a second light emitting section 601B.

The first light emitting section 601A and the second light emitting section 601B have the same structure mentioned above except the fluorescent members, and all the LED chips 603 also have the same type. Here, for convenience of description, regarding the first light emitting section 601A, the reference sign 603a is assigned to each LED chip positioned in the first region 606, and the reference sign 603b is assigned to each LED chip positioned in the second region 607. Further, regarding the second light emitting section 601B, the reference sign 603c is assigned to each LED chip positioned in the first region 606, and the reference sign 603d is assigned to each LED chip positioned in the second region 607. The respective members other than the fluorescent members and the LED chips are represented by common reference signs and numerals in the first light emitting section 601A and the second light emitting section 601B.

Fig. 75 is a cross-sectional view of the first light emitting section 601A taken along the line LXXV-LXXV of Fig. 74. As shown in Fig. 75, in the first light emitting section 601A, the first region 606 inside the reflector 604 houses the first fluorescent member (wavelength conversion member) 612a such that the member covers the four LED chips 603a. In addition, the second region 607 inside the reflector 604 houses the second fluorescent member (wavelength conversion member) 612b such that the member covers the four LED chips 603b.

The first fluorescent member 612a is excited by the light emitted by the LED chips 603a, and is formed of a first phosphor 613, which emits light with a wavelength different from that of the light emitted by the LED chips 603a, and a first filler 614 for holding the first phosphor 613 in a distributed manner. Further, the second fluorescent member 612b is excited by the light emitted by the LED chips 603b, and is formed of a second phosphor 615, which emits light with a wavelength different from that of the light emitted by the LED chips 603b, and a second filler 616 for holding the second phosphor 615 in a distributed manner.

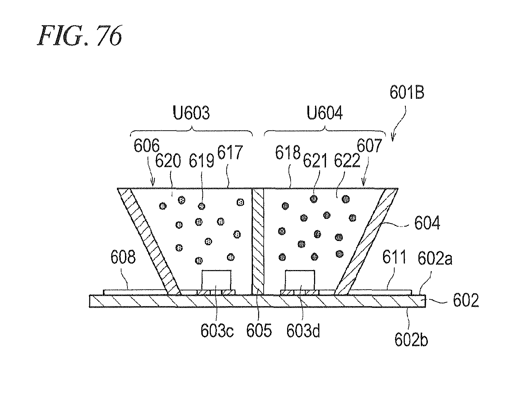

Fig. 76 is a cross-sectional view of the second light emitting section 601B taken along the line LXXV-LXXV of Fig. 74. As shown in Fig. 76, in the second light emitting section 601B, the first region 606 inside the reflector 604 houses the third fluorescent member (wavelength conversion member) 617 such that the member covers the four LED chips 603c. In addition, the second region 607 inside the reflector 604 houses the fourth fluorescent member (wavelength conversion member) 618 such that the member covers the four LED chips 603d.

The third fluorescent member 617 is excited by the light emitted by the LED chips 603c, and is formed of a third phosphor 619, which emits light with a wavelength different from that of the light emitted by the LED chips 603c, and a third filler 620 for holding the third phosphor 619 in a distributed manner. Further, the fourth fluorescent member 618 is excited by the light emitted by the LED chips 603d, and is formed of a fourth phosphor 621, which emits light with a wavelength different from that of the light emitted by the LED chips 603d, and a fourth filler 622 for holding the fourth phosphor 621 in a distributed manner.

Accordingly, in the present example, the respective combinations of the first fluorescent member 612a, the second fluorescent member 612b, the third fluorescent member 617, and the fourth fluorescent member 618 and the LED chips 603a, 603b, 603c, and 603d, which are used to correspond thereto, correspond to the respective light emitting units of the present invention. That is, the LED chips 603a and the first fluorescent member 612a constitute a first light emitting unit U60 1, and the LED chips 603b and the second fluorescent member 612b constitute a second light emitting unit U602. In addition, the LED chips 603c and the third fluorescent member 617 constitute a third light emitting unit U603, and the LED chips 603d and the fourth fluorescent member 618 constitute a fourth light emitting unit U604. Further, integrated one of the four types of the light emitting units corresponds to the light emitting unit group of the present invention. Note that, in the description below, light, which is emitted by each of the first to fourth light emitting units U601 to U604, is referred to as first-order light, and light, which is formed by synthesizing the first-order light emitted by each of the first to fourth light emitting units U601 to U604 and is emitted from the first light emitting section 601A and the second light emitting section 601B, is referred to as synthetic light.

(LED Chip)

As the LED chips 603a, 603b, 603c, and 603d, in the present example, the LED chips emitting the blue light with a peak wavelength of 460 nm are used. Specifically, as such an LED chip, there is a GaN LED chip in which for example an InGaN semiconductor is used in a light emitting layer. Note that, the emission wavelength characteristic and the type of the LED chip 503 is not limited to this, and it may be possible to employ the semiconductor light emitting elements such as various LED chips without departing from the technical scope of the present invention. In the present example, it is preferable that the peak wavelengths of the light emitted by the LED chips 603a, 603b, 603c, and 603d be in the wavelength range of 420 nm to 500 nm.

(Fluorescent Member)

In a similar manner to the first wavelength conversion region P51 of the fluorescent member 505 of the fifth example, the first fluorescent member 612a is configured to emit the first-order light with the chromaticity of the chromaticity point WP1 in the XY chromaticity diagram of Fig. 57. Specifically, three types of phosphors of the red phosphor, the green phosphor, and the yellow phosphor as the first phosphor 613 are mixed, and are held in the first filler 614 in a distributed manner. The red phosphor, the green phosphor, and the yellow phosphor convert the wavelength of the blue light emitted by each LED chip 603a so as to respectively emit red light, green light, and yellow light, and various phosphors of which specific examples are described in the fifth example can be used. Further, as the first filler 614, it may be possible to use thermoplastic resin, thermosetting resin, photo curable resin, glass, or the like.

The wavelength of a part of the blue light emitted by the LED chip 603a is converted by the red phosphor, the green phosphor, and the yellow phosphor included in the first fluorescent member 612a, and red light, green light, and yellow light are emitted from the first fluorescent member 612a. At this time, the blue light, which is emitted from the LED chip 603a and transmitted through the first fluorescent member 612a without wavelength conversion performed by the first fluorescent member 612a, is emitted from the first fluorescent member 612a together with the red light, the green light, and the yellow light. Accordingly, the first-order light, in which the red light, the green light, the yellow light, and the blue light emitted in such a manner are synthesized, is emitted from the first light emitting unit U601.

In the first fluorescent member 612a, the densities and the mixture ratio of the red phosphor, the green phosphor, and the yellow phosphor of the first filler 614 are determined on the basis of, as shown in Fig. 55, the red cells 506r, the green cells 506g, the yellow cells 506y, and the blue cells 506b included in the first wavelength conversion region P51 of the fifth example such that the first-order light with the chromaticity of the chromaticity point WP1 in the XY chromaticity diagram of Fig. 57 is emitted from the first light emitting unit U601.

In a similar manner to the second wavelength conversion region P52 of the fluorescent member 505 of the first example, the second fluorescent member 612b is configured to emit the first-order light with the chromaticity of the chromaticity point WP2 in the XY chromaticity diagram of Fig. 57. Specifically, two types of phosphors of the green phosphor and the yellow phosphor as the second phosphor 615 are mixed, and are held in the second filler 616 in a distributed manner. The green phosphor and the yellow phosphor convert the wavelength of the blue light emitted by each LED chip 603b so as to respectively emit green light and yellow light, and various phosphors of which specific examples are described in the fifth example can be used. Further, as the second filler 616, in a similar manner to the first filler 614, it may be possible to use thermoplastic resin, thermosetting resin, photo curable resin, glass, or the like.

The wavelength of a part of the blue light emitted by the LED chip 603b is converted by the green phosphor and the yellow phosphor included in the second fluorescent member 612b, and green light and yellow light are emitted from the second fluorescent member 612b. At this time, the blue light, which is emitted from the LED chip 603b and transmitted through the second fluorescent member 612b without wavelength conversion performed by the second fluorescent member 612b, is emitted from the second fluorescent member 612b together with the green light and the yellow light. Accordingly, the first-order light, in which the green light, the yellow light, and the blue light emitted in such a manner are synthesized, is emitted from the second light emitting unit U602.

In the second fluorescent member 612b, the densities and the mixture ratio of the green phosphor and the yellow phosphor of the second filler 616 are determined on the basis of, as shown in Fig. 55, the green cells 506g, the yellow cells 506y, and the blue cells 506b included in the second wavelength conversion region P52 of the fifth example such that the first-order light with the chromaticity of the chromaticity point WP2 in the XY chromaticity diagram of Fig. 57 is emitted from the second light emitting unit U602. Note that, as shown in Fig. 55, in the fifth example, the number of red cells 506r in the second wavelength conversion region P52 is 0. Accordingly, in the present example, the red phosphor is not used in the second phosphor 615.

In a similar manner to the third wavelength conversion region P53 of the fluorescent member 505 of the fifth example, the third fluorescent member 617 is configured to emit the first-order light with the chromaticity of the chromaticity point WP3 in the XY chromaticity diagram of Fig. 57. Specifically, three types of phosphors of the red phosphor, the green phosphor, and the yellow phosphor as the third fluorescent member 617 are mixed, and are held in the third filler 620 in a distributed manner. The red phosphor, the green phosphor, and the yellow phosphor convert the wavelength of the blue light emitted by each LED chip 603c so as to respectively emit red light, green light, and yellow light, and various phosphors of which specific examples are described in the fifth example can be used. Further, as the third filler 620, in a similar manner to the first filler 614 and the second filler 616, it may be possible to use thermoplastic resin, thermosetting resin, photo curable resin, glass, or the like.

The wavelength of a part of the blue light emitted by the LED chip 603c is converted by the red phosphor, the green phosphor, and the yellow phosphor included in the third fluorescent member 617, and red light, green light, and yellow light are emitted from the third fluorescent member 617. At this time, the blue light, which is emitted from the LED chip 603c and transmitted through the third fluorescent member 617 without wavelength conversion performed by the third fluorescent member 617, is emitted from the third fluorescent member 617 together with the red light, the green light, and the yellow light. Accordingly, the first-order light, in which the red light, the green light, the yellow light, and the blue light emitted in such a manner are synthesized, is emitted from the third light emitting unit U603.

In the third fluorescent member 617, the densities and the mixture ratio of the red phosphor, the green phosphor, and the yellow phosphor of the third filler 620 are determined on the basis of, as shown in Fig. 55, the red cells 506r, the green cells 506g, the yellow cells 506y, and the blue cells 506b included in the third wavelength conversion region P53 of the fifth example such that the first-order light with the chromaticity of the chromaticity point WP3 in the XY chromaticity diagram of Fig. 57 is emitted from the third light emitting unit U603. Note that, as shown in Fig. 55, in the fifth example, the number of blue cells 506b in the third wavelength conversion region P53 is 0, but the light emitted from the third wavelength conversion region P53 includes the blue light which is respectively transmitted through the red cells 506r, the green cells 506g, and the yellow cells 506y. Accordingly, in the present example, in view of this point, the densities and the mixture ratio of the red phosphor, the green phosphor, and the yellow phosphor of the third filler 620 are determined.

In a similar manner to the fourth wavelength conversion region P54 of the fluorescent member 505 of the fifth example, the fourth fluorescent member 618 is configured to emit the first-order light with the chromaticity of the chromaticity point WP4 in the XY chromaticity diagram of Fig. 57. Specifically, three types of phosphors of the red phosphor, the green phosphor, and the yellow phosphor as the fourth phosphor 621 are mixed, and are held in the fourth filler 622 in a distributed manner. The red phosphor, the green phosphor, and the yellow phosphor convert the wavelength of the blue light emitted by each LED chip 603d so as to respectively emit red light, green light, and yellow light, and various phosphors of which specific examples are described in the fifth example can be used. Further, as the fourth filler 622, in a similar manner to the first filler 614, the second filler 616, and the third filler 620, it may be possible to use thermoplastic resin, thermosetting resin, photo curable resin, glass, or the like.

The wavelength of a part of the blue light emitted by the LED chip 603d is converted by the red phosphor, the green phosphor, and the yellow phosphor included in the fourth fluorescent member 618, and red light, green light, and yellow light are emitted from the fourth fluorescent member 618. At this time, the blue light, which is emitted from the LED chip 603d and transmitted through the fourth fluorescent member 618 without wavelength conversion performed by the fourth fluorescent member 618, is emitted from the fourth fluorescent member 618 together with the red light, the green light, and the yellow light. Accordingly, the first-order light, in which the red light, the green light, the yellow light, and the blue light emitted in such a manner are synthesized, is emitted from the fourth light emitting unit U604.

In the fourth fluorescent member 618, the densities and the mixture ratio of the red phosphor, the green phosphor, and the yellow phosphor of the fourth filler 622 are determined on the basis of, as shown in Fig. 55, the red cells 506r, the green cells 506g, the yellow cells 506y, and the blue cells 506b included in the fourth wavelength conversion region P54 of the fifth example such that the first-order light with the chromaticity of the chromaticity point WP4 in the XY chromaticity diagram of Fig. 57 is emitted from the fourth light emitting unit U604.

(Electric Circuit Configuration of Illumination Apparatus)

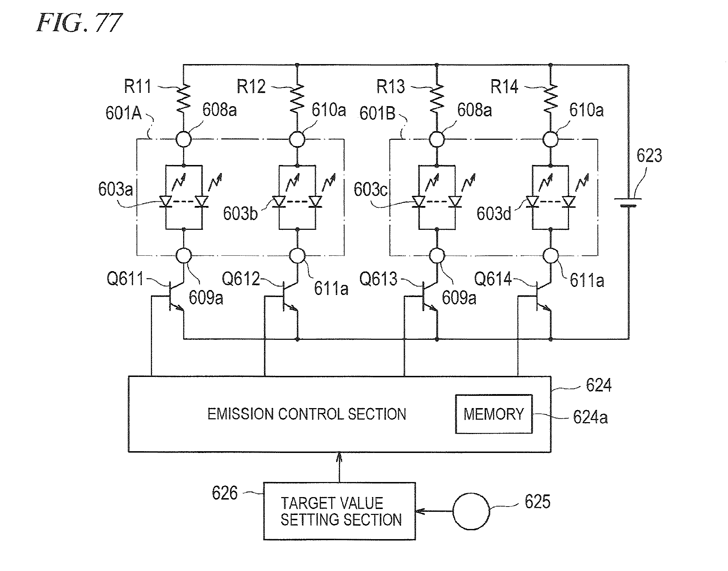

In the illumination apparatus of the present example, at least one of each of the first to fourth light emitting units U601 to U604 is necessary. Thus, at least one first light emitting section 601A and at least one second light emitting section 601B are used in combination in the illumination apparatus. In addition, in a similar manner to the fifth example, the synthetic light, which is generated by synthesizing the first-order light emitted from each of the first to fourth light emitting units U601 to U604, is emitted as the illumination hght of the illumination apparatus. Accordingly, by adjusting the intensity of the first-order light, which is emitted from each of the first to fourth light emitting units U601 to U604, in a similar manner to the fifth example, it is possible to emit white light with various color temperatures as the illumination light. Referring to Fig. 77, a description will be given below of an electric circuit configuration of the illumination apparatus which is configured so as to change the intensity of the first-order light emitted from each light emitting unit as described above.

Fig. 77 is an electric circuit diagram illustrating an overview of the electric circuit configuration of the illumination apparatus according to the present example. As shown in Fig. 77, the electric circuit of the illumination apparatus of the present example has practically the same configuration as the electric circuit of the illumination apparatus of the fifth example. That is, in the present example, one first light emitting section 601A and one second light emitting section 601B mentioned above are used. Therefore, in addition to them, there are further provided current-limiting resistors R11, R12, R13, and R14, and transistors Q611, Q612, Q613, and Q614 which respectively supply the driving currents to the LED chips 603a to 603d. Note that, the resistors R611 to R614 are provided to limit the currents, which flow in the LED chips respectively corresponding thereto, to an appropriate magnitude (for example, 60 mA per one LED chip).

In the first light emitting section 601A, the LED chips 603a and 103b are mounted on the wiring board 602 as described above. Thereby, the LED chips 603a are connected to one another in parallel, the anode thereof is connected to the connection terminal 608a, and the cathode thereof is connected to the connection terminal 609a. Further, the LED chips 603b are connected to one another in parallel, the anode thereof is connected to the connection terminal 610a, and the cathode thereof is connected to the connection terminal 611a.

In a similar manner to the first light emitting section 601A, in the second light emitting section 601B, the LED chips 603c are connected to one another in parallel, the anode thereof is connected to the connection terminal 608a, and the cathode thereof is connected to the connection terminal 609a. Further, the LED chips 603d are connected to one another in parallel, the anode thereof is connected to the connection terminal 610a, and the cathode thereof is connected to the connection terminal 611a.

In the first light emitting section 601A, the connection terminal 608a is connected to the positive terminal of the power supply 623 through the resistor R11, and the connection terminal 609a is connected to the collector of the transistor Q611. Further, the connection terminal 610a is connected to the positive terminal of the power supply 623 through R12, and the connection terminal 611a is connected to the collector of the transistor Q612. On the other hand, in the second light emitting section 601B, the connection terminal 608a is connected to the positive terminal of the power supply 623 through the resistor R13, and the connection terminal 609a is connected to the collector of the transistor Q613. Further, the connection terminal 610a is connected to the positive terminal of the power supply 623 through R14, and the connection terminal 611a is connected to the collector of the transistor Q614. In addition, each emitter of the transistors Q611 to 614 is connected to the negative terminal of the power supply 623.

In such an electric circuit configuration, by turning on the transistor Q611, forward currents supplied from the power supply 623 flow in the respective LED chips 603a of the first light emitting section 601A, and thereby the LED chips 603a respectively emit light. Accordingly, by turning on the transistor Q611, the first light emitting unit U601, which is formed of the LED chips 603a and the first fluorescent member 611, emits the first-order light with the chromaticity of the chromaticity point WP1 in the XY chromaticity diagram of Fig. 57.

Likewise, by turning on the transistor Q612, forward currents supplied from the power supply 623 flow in the respective LED chips 603b of the first light emitting section 601A, and thereby the LED chips 603b respectively emit light. Accordingly, by turning on the transistor Q612, the second light emitting unit U602, which is formed of the LED chips 603b and the second fluorescent member 612, emits the first-order light with the chromaticity of the chromaticity point WP2 in the XY chromaticity diagram of Fig. 57.

Further, by turning on the transistor Q613, forward currents supplied from the power supply 623 flow in the respective LED chips 603c of the second light emitting section 601B, and thereby the LED chips 603c respectively emit light. Accordingly, by turning on the transistor Q613, the third light emitting unit U603, which is formed of the LED chips 603c and the third fluorescent member 617, emits the first-order light with the chromaticity of the chromaticity point WP3 in the XY chromaticity diagram of Fig. 57.

Furthermore, by turning on the transistor Q614, forward currents supplied from the power supply 623 flow in the respective LED chips 603d of the second light emitting section 601B, and thereby the LED chips 603d respectively emit light. Accordingly, by turning on the transistor Q614, the fourth light emitting unit U604, which is formed of the LED chips 603d and the fourth fluorescent member 618, emits the first-order light with the chromaticity of the chromaticity point WP4 in the XY chromaticity diagram of Fig. 57.

In order to control on/off states of the transistors Q611 to Q614, the illumination apparatus of the present example is provided with an emission control section 624. All the transistors Q611 to Q614 are able to switch the on/off states in response to the respective base signals, and the emission control section 624 is configured to individually transmit the base signals to the respective bases. The emission control section 624 has practically the same configuration as the emission control section 513 of the fifth example, and thus performs the same emission control as the emission control section 513.

Hence, the emission control section 624 has own memory (storage device) 624a used in storing information necessary for the emission control and the like. Further, in a similar manner to the case of the fifth example, the illumination apparatus of the present example is also provided with an operation unit (operation member) 625 by which a user sets the total luminous flux or the color temperature of the illumination light, and a target value setting section 626 that sets the target correlation color temperature or the target total luminous flux in accordance with the operation performed on the operation unit 625. In the present example, the emission control section 624, the operation unit 625, and the target value setting section 626 constitute the control means of the present invention.

The emission control section 624 performs the emission control in the same manner as the case of the fifth example. Thereby, in the illumination apparatus of the present example, it is also possible to generate illumination light the same as that of the illumination apparatus of the fifth example. Accordingly, it is possible to change the color temperature of the illumination light emitted from the illumination apparatus in the range from the lower limit color temperature T1 to the upper limit color temperature T2. At this time, the chromaticity of the illumination light is approximate to the black-body radiation locus BL. As a result, it is possible to make the illumination light be white light which is natural without sense of discomfort.

Note that, in the present example, the electric circuit of the illumination apparatus is also not limited to the configuration shown in Fig. 77. That is, for example, it may be possible to apply the electric circuit configuration of Fig. 61 described in the fifth example and the modified example.

(Arrangement Example of Light Emitting Section)

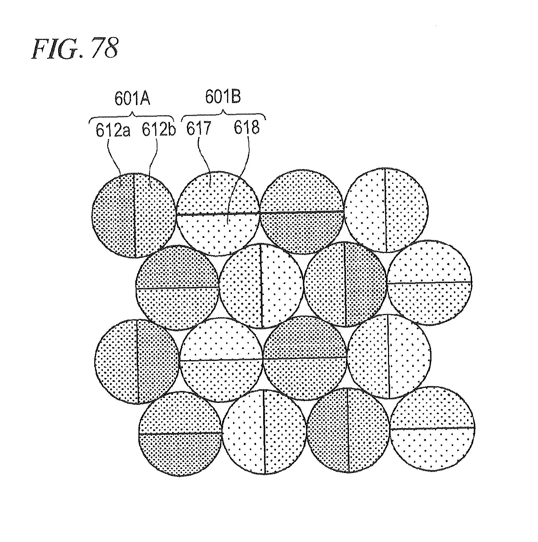

In the electric circuit configuration of Fig. 77, one first light emitting section 601A and one second light emitting section 601B are used, but a plurality of light emitting sections may be used in combination of them. Fig. 78 is a schematic diagram illustrating an example of arrangement of the first light emitting sections 601A and the second light emitting sections 601B. Note that, in Fig. 78, in order to distinguish emission colors of the respective phosphors, the respective phosphors are represented by dot hatch patterns. As shown in Fig. 78, the first light emitting sections 601A and the second light emitting sections 601B are alternately arranged such that the same light emitting sections are not arranged to be biased, and the rotation angles of the same type light emitting sections adjacent to one another are different by 90 degrees from one another. By performing such arrangement, it is possible to satisfactorily synthesize the first-order light which is emitted from each light emitting unit of each light emitting section. Note that, the arrangement of the first light emitting sections 601A and the second light emitting sections 601B are not limited to the form of Fig. 78, and may be modified into various forms.

(Modified Example of Light Emitting Section)

Further, in the present example, the first light emitting unit U601 and the second light emitting unit U602 are formed in the first light emitting section 601A, and the third light emitting unit U603 and the fourth light emitting unit U604 are formed in the second light emitting section 601B. However, the combination of the light emitting units is not limited to this, and the four types of the light emitting units may be arbitrarily combined into two pairs. Furthermore, the combination of four types of the light emitting units is not limited to the two groups of the first light emitting section 601A and the second light emitting section 601B in a similar manner to the present example, and a different combination may be used, and three or more light emitting sections may be used.

Note that, in the present example, instead of the LED chips emitting the blue light, it may be possible to use the LED chips emitting the near-ultraviolet light. In this case, in order to generate the blue light, in addition to the red phosphor, the green phosphor, and the yellow phosphor used in the present example, the blue phosphor, which converts the wavelength of the near-ultraviolet light emitted by the LED chips so as to emit blue light, may be used. In this case, instead of the blue light respectively emitted through the first fluorescent member 612a, the second fluorescent member 612b, the third fluorescent member 617, and the fourth fluorescent member 618, the blue light emitted from the blue phosphor is used. Therefore, in view of this point, it is preferable to adjust the densities and the content percentages of the phosphors in the fluorescent members.

Further, in the case of using the LED chips emitting the near-ultraviolet light, it is preferable to use a material, which has durability and transparency sufficient for the near-ultraviolet light emitted by the LED chips, in the first filler 614, the second filler 616, the third filler 620, and the fourth filler 622 respectively used in the first fluorescent member 612a, the second fluorescent member 612b, the third fluorescent member 617, and the fourth fluorescent member 618. Specifically, for example, examples of the fillers include: an (meth)acryl resin such as poly(meth)acrylate methyl; a styrene resin such as polystyrene or styrene-acrylonitrile copolymer; a polycarbonate resin; a polyester resin; a phenoxy resin; a butyral resin; polyvinyl alcohol; a cellulosic resin such as ethyl cellulose, cellulose acetate, or cellulose acetate butyrate; an epoxy resin; a phenol resin; and a silicon resin. Further, it may be possible to use an inorganic material such as metal alkoxide, ceramic precursor polymer, a solution which is obtained by hydrolytically polymerizing a solution containing metal alkoxide, or an inorganic material, in which such a combination is solidified, such as an inorganic material having a siloxane bond or glass.

As described above, in the present example and modified example thereof, the light emitting unit group is formed of the light emitting sections each of which has two light emitting units integrally formed. Therefore, it becomes easy to treat the light emitting unit group, and it is possible to reduce the manufacturing costs and the number of manufacturing processes of the illumination apparatus.

<Seventh Example>

In the above-mentioned sixth example, the illumination apparatus is configured by using the light emitting unit groups in which the first light emitting section 601A and the second light emitting section 601B each of which is formed of two light emitting units are combined. However, the light emitting units formed in the first light emitting section 601A and the second light emitting section 601B can be integrated. Accordingly, an example of the illumination apparatus, which is configured by integrating the light emitting units which are formed in the same manner as the light emitting units of the sixth example, will be described below as a seventh example of the present invention.

(Configuration of Light Emitting Section)

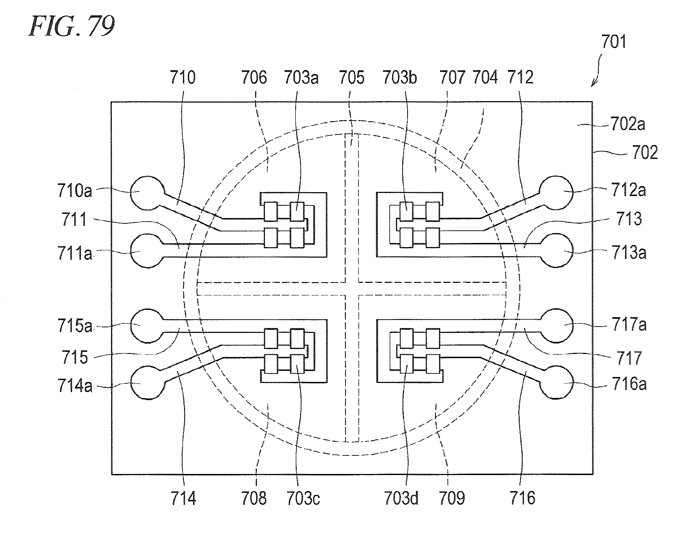

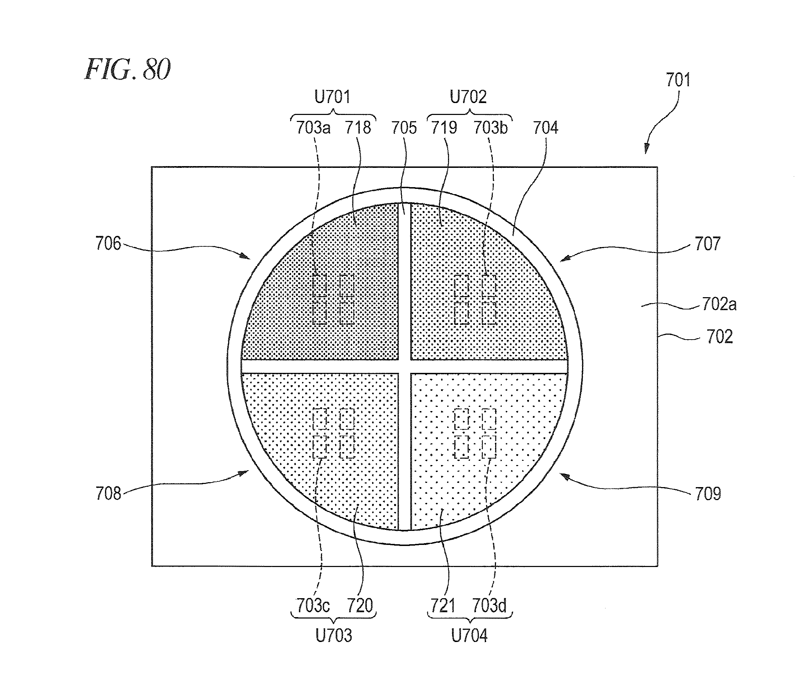

Fig. 79 is a top plan view illustrating a schematic configuration of a light emitting section 701, in which some members are omitted, in an illumination apparatus according to the present example. Fig. 80 is a top plan view illustrating an overall configuration of the light emitting section 701. Note that, in Fig. 80, in order to distinguish emission colors of the respective phosphors, the respective phosphors are represented by dot hatch patterns. The light emitting section 701 includes four LED chips that are grouped into four LED groups and are mounted on a chip mounting surface 702a of a wiring board 702 made of alumina ceramic which is excellent in electrical insulation and has a favorable heat dissipation ability. The LED chips are the same as the LED chips 603 used in the sixth example, but for convenience of description, the LED chips of the respective LED groups are hereinafter represented by 703a, 703b, 703c and 703d.

A reflector (wall member) 704, which is similar to the reflector 604 of the sixth example and has an annular and truncated cone shape, is provided on the chip mounting surface 702a of the wiring board 702 so as to surround the LED chips 703a to 703d. The partition member 705 having a cross-shape partitions the inside of the reflector 704 into four regions of a first region 706, a second region 707, a third region 708, and a fourth region 709. Note that, in Fig. 79, for convenience of description, the reflector 704 and the partition member 705 are indicated by the dashed lines. The four LED chips 703a are disposed in the first region 706, and the four LED chips 703b are disposed in the second region 707. Further, the four LED chips 703c are disposed in the third region 708, and the four LED chips 703d are disposed in the fourth region 709.

In a similar manner to the reflector 604 and the partition member 605 of the sixth example, the reflector 704 and the partition member 705 can be formed of resin, metal, ceramic, or the like, and is fixed onto the wiring board 702 through an adhesive or the like. Further, when a conductive material is used in the reflector 704 and the partition member 705, a process for providing electrical insulation to a wiring pattern to be described later is necessary.

Note that, in the present example, the number of each of the LED chips 703a to 703d is just an example, may be increased or decreased as necessary, may be one for each of the first to fourth regions 706 to 709, and may be different for each region. Further, the material of the wiring board 702 is not limited to the alumina ceramic, and may use various kinds of materials. For example, it may be possible to use a material selected from ceramic, resin, glass epoxy, and composite resin containing a filler as materials with excellent electrical insulation. Furthermore, in order to improve a light emitting efficiency of the light emitting section 701 by enhancing reflectivity of light on the chip mounting surface 702a of the wiring board 702, it is preferable to use silicon resin including a white pigment such as alumina powder, silica powder, magnesium oxide, or titanium oxide. On the other hand, by using a substrate made of metal such as copper or aluminum, it is possible to improve a heat dissipation ability. However, in this case, it is necessary to form the wiring patterns on the wiring board with electrical insulation performed thereon.

Further, the shapes of the above-mentioned reflector 704 and partition member 705 are also just exemplary shapes, may be modified into various shapes as necessary. For example, instead of the reflector 704 and the partition member 705 formed in advance, an annular wall portion (wall member) corresponding to the reflector 704 may be formed on the chip mounting surface 702a of the wiring board 702 by using a dispenser or the like, and thereafter a partition wall (partition member) corresponding to the partition member 705 may be formed. In this case, the material used in the annular wall portion and the partition wall portion is, for example, a UV curable resin material or a thermosetting resin material having a paste form, and thus silicon resin containing an inorganic filter is appropriate therefor.

The wiring patterns 710, 711, 712, 713, 714, 715, 716, and 717 for respectively supplying driving currents to the LED chips 703a, 703b, 703c, and 703d are formed on the chip mounting surface 702a of the wiring board 702, as shown in Fig. 79. Each of connection terminals 710a, 711a, 712a, 713a, 714a, 715a, 716a, and 717a for external connection is formed at one end of each of the wiring patterns 710, 711, 712, 713, 714, 715, 716, and 717 outside the reflector 704.

The four LED chips 703a inside the first region 706 are connected in parallel between the wiring pattern 710 and the wiring pattern 711 in the first region 706 such that the directions of polarities thereof are the same. More specifically, the LED chip 703a has two electrodes (not shown in the drawing) for supplying driving currents on the surface of the wiring board 702 side. In addition, one electrode (p electrode) of the LED chip 703a is connected to the wiring pattern 710, and the other electrode (n electrode) thereof is connected to the wiring pattern 711.

Likewise, the four LED chips 703b inside the second region 707 are connected in parallel between the wiring pattern 712 and the wiring pattern 713 in the second region 707 such that the directions of polarities thereof are the same. More specifically, the LED chip 703b has two electrodes (not shown in the drawing) for supplying driving currents on the surface of the wiring board 702 side. In addition, one electrode (p electrode) of the LED chip 703b is connected to the wiring pattern 712, and the other electrode (n electrode) thereof is connected to the wiring pattern 713.

Furthermore, the four LED chips 703c inside the third region 708 are connected in parallel between the wiring pattern 714 and the wiring pattern 715 in the third region 708 such that the directions of polarities thereof are the same. More specifically, the LED chip 703c has two electrodes (not shown in the drawing) for supplying driving currents on the surface of the wiring board 702 side. In addition, one electrode (p electrode) of the LED chip 703c is connected to the wiring pattern 714, and the other electrode (n electrode) thereof is connected to the wiring pattern 715.

Further, the four LED chips 703d inside the fourth region 709 are connected in parallel between the wiring pattern 716 and the wiring pattern 717 in the fourth region 709 such that the directions of polarities thereof are the same. More specifically, the LED chip 703d has two electrodes (not shown in the drawing) for supplying driving currents on the surface of the wiring board 702 side. In addition, one electrode (p electrode) of the LED chip 703d is connected to the wiring pattern 716, and the other electrode (n electrode) thereof is connected to the wiring pattern 717.

By using flip chip mounting, the LED chips 703a to 703d are mounted and both electrodes are connected to the respective wiring patterns with an unillustrated metal bump interposed therebetween through the eutectic solder. Note that, the method of mounting the LED chips 703a to 703d on the wiring board 702 is not limited to this, and it may be possible to select a method appropriate for the type, the structure, or the like of the LED chips 703a to 703d. For example, it may be possible to employ double wire bonding which connects the electrodes of the LED chips 703a to 703d to the corresponding wiring patterns through wire bonding after the LED chips 703a to 703d are fixedly attached to predetermined positions of the wiring board 702 mentioned above. In addition, it may be possible to employ single wire bonding which bonds one electrode to the wiring pattern as described above and connects the other electrode to the wiring pattern through the wire bonding.

As shown in Fig. 80, the first region 706 inside the reflector 704 houses the first fluorescent member (wavelength conversion member) 718 such that the member covers the four LED chips 703a. The first fluorescent member 718 has the same configuration as the first fluorescent member 612a of the sixth example. Accordingly, in the case of the present example, the combination of the four LED chips 703a and the first fluorescent member 718 in the first region 706 corresponds to the light emitting unit of the present invention. That is, the LED chip 703a and the first fluorescent member 718 constitute the first light emitting unit U701.

Further, as shown in Fig. 80, the second region 707 inside the reflector 704 houses the second fluorescent member (wavelength conversion member) 719 such that the member covers the four LED chips 703b. The second fluorescent member 719 has the same configuration as the second fluorescent member 612b of the sixth example. Accordingly, in the case of the present example, the combination of the four LED chips 703b and the second fluorescent member 719 in the second region 707 corresponds to the light emitting unit of the present invention. That is, the LED chip 703b and the second fluorescent member 719 constitute the second light emitting unit U702.

Furthermore, as shown in Fig. 80, the third region 708 inside the reflector 704 houses the third fluorescent member (wavelength conversion member) 720 such that the member covers the four LED chips 703c. The third fluorescent member 720 has the same configuration as the third fluorescent member 617 of the sixth example. Accordingly, in the case of the present example, the combination of the four LED chips 703c and the third fluorescent member 720 in the third region 708 corresponds to the light emitting unit of the present invention. That is, the LED chip 703c and the third fluorescent member 720 constitute the third light emitting unit U703.

Further, as shown in Fig. 80, the fourth region 709 inside the reflector 704 houses the fourth fluorescent member (wavelength conversion member) 721 such that the member covers the four LED chips 703d. The fourth fluorescent member 721 has the same configuration as the fourth fluorescent member 618 of the sixth example. Accordingly, in the case of the present example, the combination of the four LED chips 703d and the fourth fluorescent member 721 in the fourth region 709 corresponds to the light emitting unit of the present invention. That is, the LED chip 703d and the fourth fluorescent member 721 constitute the fourth light emitting unit U704.

As described above, in the present example, the four first to fourth light emitting units U701 to U704 are integrally provided, and the light emitting section 701, which has the first to fourth light emitting units U701 to U704, forms the light emitting unit group of the present invention. Note that, in the description below, light, which is emitted by each of the first to fourth light emitting units U701 to U704, is referred to as first-order light, and light, which is formed by synthesizing the first-order light emitted by each of the first to fourth light emitting units U701 to U704 and is emitted from the light emitting section 701, is referred to as synthetic light.

(LED Chip)

As the LED chips 703a to 703d, in the present example, the LED chips emitting the blue light with a peak wavelength of 460 nm are used. Specifically, as such an LED chip, there is a GaN LED chip in which for example an InGaN semiconductor is used in a light emitting layer. Note that, the emission wavelength characteristic and the type of the LED chip 503 is not limited to this, and it may be possible to employ the semiconductor light emitting elements such as various LED chips without departing from the technical scope of the present invention. In the present example, it is preferable that the peak wavelengths of the light emitted by the LED chips 703a, 703b, 703c, and 703d be in the wavelength range of 420 nm to 500 nm.

(Fluorescent Member)

As described above, the first fluorescent member 718 has the same configuration as the first fluorescent member 612a of the sixth example, and employs three type phosphors of the red phosphor, the green phosphor, and the yellow phosphor in a mixed manner. In addition, in a similar manner to the first fluorescent member 612a of the sixth example, red light, green light, and yellow light, which are generated by converting the wavelength of the blue light emitted by the LED chips 703a through the red phosphor, the green phosphor, and the yellow phosphor, and blue light of the LED chips 703a, which is transmitted through the first fluorescent member 718, are synthesized. Thereby, the densities and the mixture ratio of the red phosphor, the green phosphor, and the yellow phosphor in the first fluorescent member 718 are determined such that the first-order light with the chromaticity of the chromaticity point WP1 in the XY chromaticity diagram of Fig. 57 is emitted from the first fluorescent member 718. Accordingly, the first light emitting unit U701 emits the first-order light with the chromaticity of the chromaticity point WP 1 in the XY chromaticity diagram of Fig. 57 by emitting light from the LED chips 703a. Note that, as the red phosphor, the green phosphor, and the yellow phosphor, it is possible to use various phosphors of which specific examples are described in the fifth example.

Further, the second fluorescent member 719 has the same configuration as the second fluorescent member 612b of the sixth example, and employs two type phosphors of the green phosphor and the yellow phosphor in a mixed manner. In addition, in a similar manner to the second fluorescent member 612b of the sixth example, red light, green light, and yellow light, which are generated by converting the wavelength of the blue light emitted by the LED chips 703b through the green phosphor and the yellow phosphor, and blue light of the LED chips 703b, which is transmitted through the second fluorescent member 719, are synthesized. Thereby, the densities and the mixture ratio of the green phosphor and the yellow phosphor in the second fluorescent member 719 are determined such that the first-order light with the chromaticity of the chromaticity point WP2 in the XY chromaticity diagram of Fig. 57 is emitted from the second fluorescent member 719. Accordingly, the second light emitting unit U702 emits the first-order light with the chromaticity of the chromaticity point WP2 in the XY chromaticity diagram of Fig. 57 by emitting light from the LED chips 703b. Note that, as the green phosphor and the yellow phosphor, it is possible to use various phosphors of which specific examples are described in the fifth example.

Furthermore, the third fluorescent member 720 has the same configuration as the third fluorescent member 617 of the sixth example, and employs three type phosphors of the red phosphor, the green phosphor, and the yellow phosphor in a mixed manner. In addition, in a similar manner to the third fluorescent member 617 of the sixth example, red light, green light, and yellow light, which are generated by converting the wavelength of the blue light emitted by the LED chips 703c through the red phosphor, the green phosphor, and the yellow phosphor, and blue light of the LED chips 703c, which is transmitted through the third fluorescent member 720, are synthesized. Thereby, the densities and the mixture ratio of the red phosphor, the green phosphor, and the yellow phosphor in the third fluorescent member 720 are determined such that the first-order light with the chromaticity of the chromaticity point WP3 in the XY chromaticity diagram of Fig. 57 is emitted from the third fluorescent member 720. Accordingly, the third light emitting unit U703 emits the first-order light with the chromaticity of the chromaticity point WP3 in the XY chromaticity diagram of Fig. 57 by emitting light from the LED chips 703c. Note that, as the red phosphor, the green phosphor, and the yellow phosphor, it is possible to use various phosphors of which specific examples are described in the fifth example.

In addition, the fourth fluorescent member 721 has the same configuration as the fourth fluorescent member 618 of the sixth example, and employs three type phosphors of the red phosphor, the green phosphor, and the yellow phosphor in a mixed manner. In addition, in a similar manner to the fourth fluorescent member 618 of the sixth example, red light, green light, and yellow light, which are generated by converting the wavelength of the blue light emitted by the LED chips 703d through the red phosphor, the green phosphor, and the yellow phosphor, and blue light of the LED chips 703d, which is transmitted through the fourth fluorescent member 721, are synthesized. Thereby, the densities and the mixture ratio of the red phosphor, the green phosphor, and the yellow phosphor in the fourth fluorescent member 721 are determined such that the first-order light with the chromaticity of the chromaticity point WP4 in the XY chromaticity diagram of Fig. 57 is emitted from the fourth fluorescent member 721. Accordingly, the fourth light emitting unit U704 emits the first-order light with the chromaticity of the chromaticity point WP4 in the XY chromaticity diagram of Fig. 57 by emitting light from the LED chips 703d. Note that, as the red phosphor, the green phosphor, and the yellow phosphor, it is possible to use various phosphors of which specific examples are described in the fifth example.

(Electric Circuit Configuration of Illumination Apparatus)

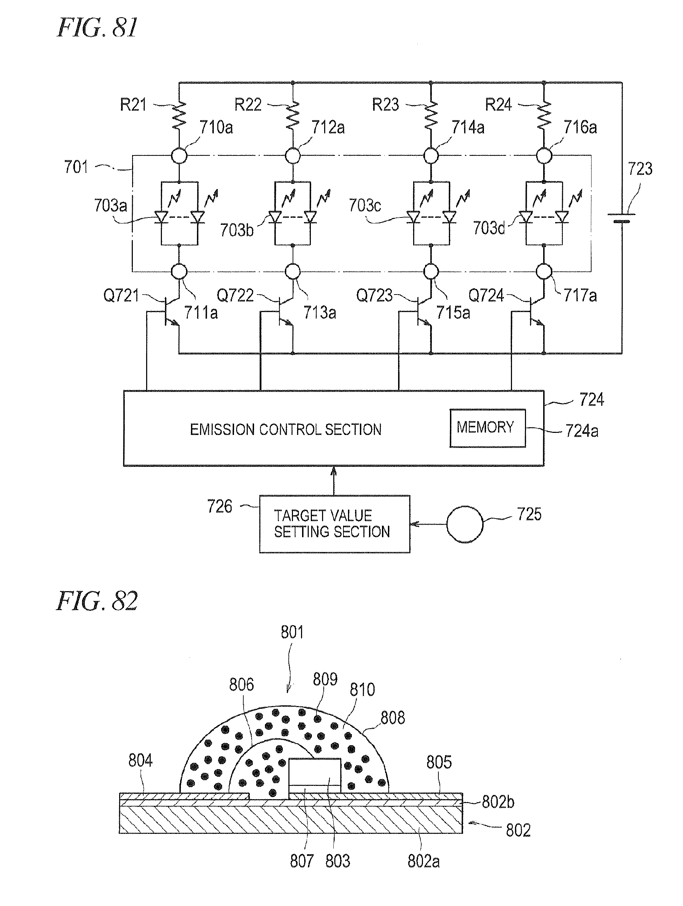

Since the light emitting section 701 is configured as described above, also in the illumination apparatus of the present example, in a similar manner to the illumination apparatus of the first and sixth examples, the synthetic light, which is generated by synthesizing the first-order light respectively emitted from the first to fourth light emitting units U701 to U704, is emitted as the illumination light of the illumination apparatus. Accordingly, by adjusting the intensity of the first-order light, which is emitted from each of the first to fourth light emitting units U701 to U704, in a similar manner to the illumination apparatus of the first and sixth examples, it is possible to emit white light with various color temperatures as the illumination light. Referring to Fig. 81, a description will be given below of an electric circuit configuration of the illumination apparatus which is configured so as to change the intensity of the first-order light emitted from each light emitting unit as described above.

Fig. 81 is an electric circuit diagram illustrating an overview of the electric circuit configuration of the illumination apparatus according to the present example. As shown in Fig. 81, the electric circuit of the illumination apparatus of the present example has practically the same configuration as the electric circuit of the illumination apparatus of the sixth example. That is, in addition to the above-mentioned light emitting section 701, there are further provided current-limiting resistors R21, R22, R23, and R24, and transistors Q721, Q722, Q723, and Q724 which respectively supply the driving currents to the LED chips 703a to 703d. Note that, the resistors R21 to R24 are provided to limit the currents, which flow in the LED chips respectively corresponding thereto, to an appropriate magnitude (for example, 60 mA per one LED chip).

In the light emitting section 701, the LED chips 703a to 703d are mounted on the wiring board 702 as described above. Thereby, the LED chips 703a are connected to one another in parallel, the anode thereof is connected to the connection terminal 710a, and the cathode thereof is connected to the connection terminal 711a. Further, the LED chips 703b are connected to one another in parallel, the anode thereof is connected to the connection terminal 712a, and the cathode thereof is connected to the connection terminal 713a. Furthermore, the LED chips 703c are connected to one another in parallel, the anode thereof is connected to the connection terminal 714a, and the cathode thereof is connected to the connection terminal 715a. In addition, the LED chips 703d are connected to one another in parallel, the anode thereof is connected to the connection terminal 716a, and the cathode thereof is connected to the connection terminal 717a.

As shown in Fig. 81, the connection terminals 710a, 712a, 714a, and 716a are connected to the positive terminal of the power supply 723 through the resistors R21, R22, R23, and R24 respectively corresponding thereto. On the other hand, the connection terminals 711a, 713a, 715a, and 717a are connected to the collectors of the transistors Q721, Q722, Q723, and Q724 respectively corresponding thereto. Further, the emitters of the transistor Q721 to 724 are connected to the negative terminal of the power supply 723.

In such an electric circuit configuration, by turning on the transistor Q721, forward currents supplied from the power supply 723 flow in the respective LED chips 703a, and thereby the LED chips 703a respectively emit light. Accordingly, by turning on the transistor Q721, the first light emitting unit U701, which is formed of the LED chips 703a and the first fluorescent member 718, emits the first-order light with the chromaticity of the chromaticity point WP1 in the XY chromaticity diagram of Fig. 57.

Likewise, by turning on the transistor Q722, forward currents supplied from the power supply 723 flow in the respective LED chips 703b, and thereby the LED chips 703b respectively emit light. Accordingly, by turning on the transistor Q722, the second light emitting unit U702, which is formed of the LED chips 703b and the second fluorescent member 719, emits the first-order light with the chromaticity of the chromaticity point WP2 in the XY chromaticity diagram of Fig. 57.

Further, by turning on the transistor Q723, forward currents supplied from the power supply 723 flow in the respective LED chips 703c, and thereby the LED chips 703c respectively emit light. Accordingly, by turning on the transistor Q723, the third light emitting unit U703, which is formed of the LED chips 703c and the third fluorescent member 720, emits the first-order light with the chromaticity of the chromaticity point WP3 in the XY chromaticity diagram of Fig. 57.

Furthermore, by turning on the transistor Q724, forward currents supplied from the power supply 723 flow in the respective LED chips 703d, and thereby the LED chips 703d respectively emit light. Accordingly, by turning on the transistor Q724, the fourth light emitting unit U704, which is formed of the LED chips 703d and the fourth fluorescent member 721, emits the first-order light with the chromaticity of the chromaticity point WP4 in the XY chromaticity diagram of Fig. 57.

In order to control on/off states of the transistors Q721 to Q724, the illumination apparatus of the present example is provided with an emission control section 724. All the transistors Q721 to Q724 are able to switch the on/off states in response to the respective base signals, and the emission control section 724 is configured to individually transmit the base signals to the respective bases. The emission control section 724 has practically the same configuration as the emission control section 513 of the fifth example, and thus performs the same emission control as the emission control section 513. Hence, the emission control section 724 has own memory (storage device) 724a used in storing information necessary for the emission control and the like.

Further, in a similar manner to the case of the fifth example, the illumination apparatus of the present example is also provided with an operation unit (operation member) 725 by which a user sets the total luminous flux or the color temperature of the illumination light, and a target value setting section 726 that sets the target correlation color temperature or the target total luminous flux in accordance with the operation performed on the operation unit 725. In the present example, the emission control section 724, the operation unit 725, and the target value setting section 726 constitute the control means of the present invention.

The emission control section 724 performs the emission control in the same manner as the case of the fifth example. Thereby, in the illumination apparatus of the present example, it is also possible to generate illumination light the same as that of the illumination apparatus of the fifth example. Accordingly, it is possible to change the color temperature of the illumination light emitted from the illumination apparatus in the range from the lower limit color temperature T1 to the upper limit color temperature T2. At this time, the chromaticity of the illumination light is approximate to the black-body radiation locus BL. As a result, it is possible to make the illumination light be white light which is natural without sense of discomfort.

Note that, in the present example, the electric circuit of the illumination apparatus is also not limited to the configuration shown in Fig. 81. That is, for example, it may be possible to apply the electric circuit configuration of Fig. 61 described in the fifth example and the modified example.

In the electric circuit configuration of Fig. 81, only one light emitting section 701 is used, but a plurality of light emitting sections 701 can be used. In the light emitting section 701 used in the present example, as shown in Fig. 80, the first to fourth light emitting units U701 to U704 are disposed in the regions which are divided into four parts by the partition member 705. Therefore, it is not necessary for the light emitting sections to be disposed in consideration of favorable synthesis of light in a similar manner to the case of the sixth example. Accordingly, when a plurality of light emitting sections 701 are arranged in the same direction, it is possible to satisfactorily synthesize the first-order light which is respectively emitted from the first to fourth light emitting units U701 to U704.

(Modified Example of Light Emitting Section)

In the present example, instead of the LED chips emitting the blue light, it may also be possible to use the LED chips emitting the near-ultraviolet light. In this case, in order to generate the blue light, in addition to the red phosphor, the green phosphor, and the yellow phosphor used in the present example, the blue phosphor, which converts the wavelength of the near-ultraviolet light emitted by the LED chips so as to emit blue light, may be used. In this case, instead of the blue light respectively emitted through the first fluorescent member 718, the second fluorescent member 719, the third fluorescent member 720, and the fourth fluorescent member 721, the blue light emitted from the blue phosphor is used. Therefore, in view of this point, it is preferable to adjust the densities and the mixture ratio of the phosphors in the fluorescent members.

Further, in the case of using the LED chips emitting the near-ultraviolet light, as described in the sixth example, it is preferable to use a material, which has durability and transparency sufficient for the near-ultraviolet light emitted by the LED chips, in the fillers respectively used in the first to fourth fluorescent members 718 to 721. As specific examples of the filters, it may be possible to use the fillers described in the sixth example.

As described above, in the present example and modified example thereof, the light emitting unit group is formed of the light emitting sections each of which has four light emitting units integrally formed. Therefore, it becomes easier to treat the light emitting unit group, and it is possible to reduce the manufacturing costs and the number of manufacturing processes of the illumination apparatus.

<Eighth Example>

In the fifth to seventh examples, the light emitting section, which is configured such that some or all the four light emitting units are integrated therein, is used in the illumination apparatus. However, the light emitting units may be individually formed, and used in the illumination apparatus. Therefore, one examples thereof will be hereinafter described as an eighth example.

(Configuration of Light Emitting Unit)

Fig. 82 is a cross-sectional view illustrating a basic configuration of a light emitting unit 801 in an illumination apparatus according to the present example. As shown in Fig. 82, the light emitting unit 801 includes the LED chips 803 mounted on the wiring board 802. Note that, in the present example, the substrate main body 802a of the wiring board 802 employs a substrate which is made of metal excellent in a heat dissipation ability.

As the metallic substrate, it is preferable to use an aluminum substrate, a copper substrate, or the like which is excellent in a heat dissipation ability. However, among them, the aluminum substrate is more preferable in terms of costs, a lightweight property, and a heat dissipation ability. In addition, since the substrate main body 802a made of metal is used, the wiring pattern 804 and the wiring pattern 805 are formed on the surface of the wiring board 802, on which the LED chips 803 are mounted, with the electrical insulation layer 802b interposed between the substrate main body 802a and the patterns. Note that, the material of the substrate main body 802a is not limited to such a metallic substrate, and in a similar manner to the cases of the fifth to seventh examples, it may be possible to use the material with the electrical insulation property such as alumina ceramic which is excellent in electrical insulation and has a favorable heat dissipation ability.

The LED chip 803 has two electrodes for supplying the driving currents, one electrode (for example, the p electrode) is provided on the upper surface thereof, and the other electrode (for example, the n electrode) is provided on the lower surface. The electrode on the upper surface is connected to the wiring pattern 804 through the metal wire 806, and the electrode on the lower surface is directly connected to the wiring pattern 805 by using the eutectic solder 807. Note that, a method of mounting the LED chips 803 on the wiring board 802 is not limited to this, and an appropriate method may be selected in accordance with the position and the like of the electrodes provided in the LED chips 803. For example, it may be possible to employ double wire bonding which connects the two electrodes provided on the upper surface of each LED chip 803 to the corresponding wiring patterns of the wiring board 802 through the metal wire after the LED chips 803 are fixedly attached to predetermined positions of the wiring board 802. In addition, in a similar manner to the fifth to seventh examples, it may be possible to employ flip chip mounting which respectively connects the two electrodes positioned on the lower side of the LED chip 803 to the corresponding wiring patterns with the metal bump interposed therebetween.

As shown in Fig. 82, the LED chips 803 mounted on the wiring board 802 are provided with a fluorescent member (wavelength conversion member) 808 which converts the wavelength of the light emitted by the LED chips 803. The fluorescent member 808 is provided to cover the LED chips 803 by using, for example, a dispenser. The fluorescent member 808 is formed of a phosphor 809, which is excited by the light emitted by the LED chips 803 so as to emit light with a wavelength different from that of the light emitted by the LED chips 803, and a filler 810 which holds the phosphor 809 in a distributed manner.

The basic configuration of the light emitting unit of the present example has been hitherto described, but in the present example, in a similar manner to the cases of the second and seventh examples, the light emitting unit group of the present invention is configured by using four types of light emitting units. In addition, the wavelength conversion characteristics of the fluorescent member 808 are different between the four types of light emitting units. Accordingly, hereinafter four types of light emitting units are respectively referred to as a first light emitting unit 801a, a second light emitting unit 801b, a third light emitting unit 801c, and a fourth light emitting unit 801d.

The fluorescent member 808, which is provided in the first light emitting unit 801a, is referred to as a first fluorescent member which holds a first phosphor in the filler 810 in a distributed manner. Likewise, the fluorescent member 808, which is provided in the second light emitting unit 801b, is referred to as a second fluorescent member which holds a second phosphor in the filler 810 in a distributed manner, and the fluorescent member 808, which is provided in the third light emitting unit 801c, is referred to as a third fluorescent member which holds a third phosphor in the filler 810 in a distributed manner. Furthermore, the fluorescent member 808, which is provided in the fourth light emitting unit 801d, is referred to as a fourth fluorescent member which holds a fourth phosphor in the filler 810 in a distributed manner. Note that, in the description below, light, which is emitted by each of the first to fourth light emitting units U801a to U801d, is referred to as first-order light, and light, which is generated by synthesizing the first-order light emitted by each of the first to fourth light emitting units U801a to U801d, is referred to as synthetic light.

(LED Chip)

In a similar manner to the illumination apparatuses of the fifth to seventh examples, the LED chips 803, the LED chips emitting the blue light with a peak wavelength of 460 nm are used. For example, there is a GaN LED chip in which for example an InGaN semiconductor is used in a light emitting layer. Note that, the emission wavelength characteristic and the type of the LED chip 803 is not limited to this, and it may be possible to employ the semiconductor light emitting elements such as various LED chips without departing from the technical scope of the present invention. In the present modified example, it is preferable that the peak wavelengths of the light emitted by the LED chips 803 be in the wavelength range of 420 nm to 500 nm.

(Fluorescent Member)

In a similar manner to the first wavelength conversion region P51 of the fluorescent member 505 of the fifth example, the first fluorescent member as the fluorescent member 808 of the first light emitting unit 801a is configured to emit the first-order light with the chromaticity of the chromaticity point WP1 in the XY chromaticity diagram of Fig. 57. Specifically, three types of phosphors of the red phosphor, the green phosphor, and the yellow phosphor as the first phosphor are mixed, and are held in the filler 810 in a distributed manner. The red phosphor, the green phosphor, and the yellow phosphor convert the wavelength of the blue light emitted by each LED chip 803 so as to respectively emit red light, green light, and yellow light, and various phosphors of which specific examples are described in the fifth example can be used. Further, as the filler 810 of each light emitting unit, it may be possible to use thermoplastic resin, thermosetting resin, photo curable resin, glass, or the like.

The wavelength of a part of the blue light emitted by the LED chip 803 of the first light emitting unit 801a is converted by the red phosphor, the green phosphor, and the yellow phosphor included in the first fluorescent member, and red light, green light, and yellow light are emitted. At this time, the blue light of the LED chip 803, which is transmitted through the first fluorescent member without wavelength conversion performed by the first fluorescent member, is emitted from the first fluorescent member together with the red light, the green light, and the yellow light. Accordingly, the first-order light, in which the red light, the green light, the yellow light, and the blue light emitted in such a manner are synthesized, is emitted from the first light emitting unit 801a.

In the first fluorescent member, the densities and the mixture ratio of the red phosphor, the green phosphor, and the yellow phosphor of the filler 810 are determined on the basis of, as shown in Fig. 55, the red cells 506r, the green cells 506g, the yellow cells 506y, and the blue cells 506b included in the first wavelength conversion region P51 of the fifth example such that the first-order light with the chromaticity of the chromaticity point WP 1 in the XY chromaticity diagram of Fig. 57 is emitted from the first light emitting unit U801a.

In a similar manner to the second wavelength conversion region P52 of the fluorescent member 505 of the fifth example, the second fluorescent member as the fluorescent member 808 of the second light emitting unit 801b is configured to emit the first-order light with the chromaticity of the chromaticity point WP2 in the XY chromaticity diagram of Fig. 57. Specifically, two types of phosphors of the green phosphor and the yellow phosphor as the second phosphor are mixed, and are held in the filler 810 in a distributed manner. The green phosphor and the yellow phosphor convert the wavelength of the blue light emitted by each LED chip 803 so as to respectively emit green light and yellow light, and various phosphors of which specific examples are described in the fifth example can be used.

The wavelength of a part of the blue light emitted by the LED chip 803 of the second light emitting unit 801b is converted by the green phosphor and the yellow phosphor included in the second fluorescent member, and green light and yellow light are emitted. At this time, the blue light of the LED chip 803, which is transmitted through the second fluorescent member without wavelength conversion performed by the second fluorescent member, is emitted from the second fluorescent member together with the green light and the yellow light. Accordingly, the first-order light, in which the green light, the yellow light, and the blue light emitted in such a manner are synthesized, is emitted from the second light emitting unit 801b.

In the second fluorescent member, the densities and the mixture ratio of the green phosphor and the yellow phosphor of the filler 810 are determined on the basis of, as shown in Fig. 55, the green cells 506g, the yellow cells 506y, and the blue cells 506b included in the second wavelength conversion region P52 of the fifth example such that the first-order light with the chromaticity of the chromaticity point WP2 in the XY chromaticity diagram of Fig. 57 is emitted from the second light emitting unit 801b. Note that, as shown in Fig. 55, in the fifth example, the number of red cells 506r in the second wavelength conversion region P52 is 0. Accordingly, in the present example, the red phosphor is not used in the second phosphor.

In a similar manner to the third wavelength conversion region P53 of the fluorescent member 505 of the fifth example, the third fluorescent member as the fluorescent member 808 of the third light emitting unit 801c is configured to emit the first-order light with the chromaticity of the chromaticity point WP3 in the XY chromaticity diagram of Fig. 57. Specifically, three types of phosphors of the red phosphor, the green phosphor, and the yellow phosphor as the third phosphor are mixed, and are held in the filler 810 in a distributed manner. The red phosphor, the green phosphor, and the yellow phosphor convert the wavelength of the blue light emitted by each LED chip 803 so as to respectively emit red light, green light, and yellow light, and various phosphors of which specific examples are described in the fifth example can be used.

The wavelength of a part of the blue light emitted by the LED chip 803 of the third light emitting unit 801c is converted by the red phosphor, the green phosphor, and the yellow phosphor included in the third fluorescent member, and red light, green light, and yellow light are emitted. At this time, the blue light of the LED chip 803, which is transmitted through the third fluorescent member without wavelength conversion performed by the third fluorescent member, is emitted from the third fluorescent member together with the red light, the green light, and the yellow light. Accordingly, the first-order light, in which the red light, the green light, the yellow light, and the blue light emitted in such a manner are synthesized, is emitted from the third light emitting unit 801c.

In the third fluorescent member, the densities and the mixture ratio of the red phosphor, the green phosphor, and the yellow phosphor of the filler 810 are determined on the basis of, as shown in Fig. 55, the red cells 506r, the green cells 506g, the yellow cells 506y, and the blue cells 506b included in the third wavelength conversion region P53 of the fifth example such that the first-order light with the chromaticity of the chromaticity point WP3 in the XY chromaticity diagram of Fig. 57 is emitted from the third light emitting unit 801c. Note that, as shown in Fig. 55, in the fifth example, the number of blue cells 506b in the third wavelength conversion region P53 is 0, but the light emitted from the third wavelength conversion region P53 includes the blue light which is respectively transmitted through the red cells 506r, the green cells 506g, and the yellow cells 506y. Accordingly, in the third fluorescent member of the present example, in view of this point, the densities and the mixture ratio of the red phosphor, the green phosphor, and the yellow phosphor of the filler 810 are determined.

In a similar manner to the fourth wavelength conversion region P54 of the fluorescent member 505 of the fifth example, the fourth fluorescent member as the fluorescent member 808 of the fourth light emitting unit 801d is configured to emit the first-order light with the chromaticity of the chromaticity point WP4 in the XY chromaticity diagram of Fig. 57. Specifically, three types of phosphors of the red phosphor, the green phosphor, and the yellow phosphor as the fourth phosphor are mixed, and are held in the filler 810 in a distributed manner. The red phosphor, the green phosphor, and the yellow phosphor convert the wavelength of the blue light emitted by each LED chip 803 so as to respectively emit red light, green light, and yellow light, and various phosphors of which specific examples are described in the fifth example can be used.

The wavelength of a part of the blue light emitted by the LED chip 803 of the fourth light emitting unit 801d is converted by the red phosphor, the green phosphor, and the yellow phosphor included in the fourth fluorescent member, and red light, green light, and yellow light are emitted. At this time, the blue light of the LED chip 803, which is transmitted through the fourth fluorescent member without wavelength conversion performed by the fourth fluorescent member, is emitted from the fourth fluorescent member together with the red light, the green light, and the yellow light. Accordingly, the first-order light, in which the red light, the green light, the yellow light, and the blue light emitted in such a manner are synthesized, is emitted from the fourth light emitting unit 801d.

In the fourth fluorescent member, the densities and the mixture ratio of the red phosphor, the green phosphor, and the yellow phosphor of the filler 810 are determined on the basis of, as shown in Fig. 55, the red cells 506r, the green cells 506g, the yellow cells 506y, and the blue cells 506b included in the fourth wavelength conversion region P54 of the fifth example such that the first-order light with the chromaticity of the chromaticity point WP4 in the XY chromaticity diagram of Fig. 57 is emitted from the fourth light emitting unit 801d.

(Electric Circuit Configuration of Illumination Apparatus)

By adopting the above-mentioned configuration of the first to fourth light emitting units 801a to 801d, it is possible to make the electric circuit of the illumination apparatus of the present example have the same configuration as the electric circuit of the seventh example shown in Fig. 81. That is, in the electric circuit configuration of Fig. 81, it is preferable to replace the four light emitting units constituting the light emitting section 701 with the first to fourth light emitting units 801a to 801d of the present example.

Accordingly, by adjusting the intensity of the first-order light, which is emitted from each of the first to fourth light emitting units 801a to 801d, in a similar manner to the seventh example, it is possible to emit white light with various color temperatures as the illumination light. Accordingly, by performing the same emission control as the fifth to seventh examples, it is possible to change the color temperature of the illumination light emitted from the illumination apparatus in the range from the lower limit color temperature T1 to the upper limit color temperature T2. At this time, the chromaticity of the illumination light is approximate to the black-body radiation locus BL. As a result, it is possible to make the illumination light be white light which is natural without sense of discomfort.

(Modified Example of Light Emitting Unit)

In the present example, instead of the LED chips emitting the blue light, it may be possible to use the LED chips emitting the near-ultraviolet light. In this case, in order to generate the blue light, in addition to the red phosphor, the green phosphor, and the yellow phosphor used in the present example, the blue phosphor, which converts the wavelength of the near-ultraviolet light emitted by the LED chips so as to emit blue light, may be used. In this case, instead of the blue light respectively emitted through the first fluorescent member, the second fluorescent member, the third fluorescent member, and the fourth fluorescent member, the blue light emitted from the blue phosphor is used. Therefore, in view of this point, it is preferable to adjust the densities and the content percentages of the phosphors in the fluorescent members.

Further, in the case of using the LED chips emitting the near-ultraviolet light, it is preferable to use a material, which has durability and transparency sufficient for the near-ultraviolet light emitted by the LED chips, in the filler 810. As the filler 810 in this case, it may be possible to use the filler of which a specific example is described in sixth example.

(Arrangement Example of Light Emitting Unit)

In addition, in the present example, the numbers of first to fourth light emitting units 801a to 801d can be arbitrarily determined on the basis of specification necessary for the illumination apparatus, characteristics of the light emitting units, or the like. For example, when using the plurality of first to fourth light emitting units 801a to 801d, it is preferable to evenly distribute the light emitting units with the same type in terms of favorable synthesis of the first-order light. Fig. 83 is a schematic diagram illustrating an example of arrangement of the first to fourth light emitting units 801a to 801d. Note that, in the example of Fig. 83, the light emitting units share the wiring board 802. Further, in Fig. 83, in order to distinguish emission colors of the respective phosphors, the respective phosphors are represented by dot hatch patterns.

In the arrangement example of Fig. 83, the light emitting units are distributed such that the light emitting units with the same type is not adjacent to one another, and the individual centers of the light emitting units are deviated between two lateral rows thereof adjacent to each other by the radius thereof in the lateral direction, thereby arranging the light emitting units as closely as possible. With such arrangement, it is possible to satisfactorily synthesize the first-order light emitted from each light emitting unit. In addition, it is possible to reduce the occupied area of the light emitting units in the illumination apparatus as much as possible. Note that, the number of light emitting units and the distribution method thereof are not limited to the form of Fig. 83, and may be modified into various forms. Further, in the present example, the shape of each light emitting unit is a circle, but may be a shape such as a rectangle or a hexagon other than the circle.

<Modified Example of Eighth Example>

In an eighth example, by adopting the basic configuration shown in Fig. 82, four types of light emitting units 801 are configured. However, instead of using the basic configuration shown in Fig. 82 in the light emitting units, it can be used in substitution for the combination of the cell regions and the LED chips 503 of the fifth example. That is, since both the LED chip 503 of the fifth example and the LED chip 803 in the basic configuration of the eighth example emit blue light, when the fluorescent member 808 with the basic configuration of the eighth example is used instead of the cell regions of the fifth example, it is possible to obtain a combination the same as the combination of the LED chips 503 and the cell regions of the fifth example.

Specifically, the red phosphor used in the red cell 506r of the fifth example is used in the phosphor 809, and is held in the filler 810 in a distributed manner, thereby forming a red light emitting section, and the green phosphor used in the green cell 506g of the fifth example is used in the phosphor 809, and is held in the filler 810 in a distributed manner, thereby forming a green light emitting section. In addition, the yellow phosphor used in the yellow cell 506y of the fifth example is used in the phosphor 809, and is held in the filler 810 in a distributed manner, thereby forming a yellow light emitting section, and the diffusing particles used in the blue cell 506b of the fifth example is used instead of the phosphor 809, and is held in the filler 810 in a distributed manner, thereby forming a blue light emitting section.

The red light emitting section, the green light emitting section, the yellow light emitting section, and the blue light emitting section configured as described above are respectively disposed in the wavelength conversion regions of the first to fourth wavelength conversion regions P51 to P54 in place of the red cells 506r, the green cells 506g, the yellow cells 506y, and the blue cells 506b of the fifth example, on the basis of the numbers of cell regions thereof shown in the table of Fig. 55. In this case, the illumination apparatus can be configured in a similar manner to the illumination apparatus of the fifth example.

Note that, in the modified example, by further changing the LED chips 803 used in the red light emitting section, the green light emitting section, and the yellow light emitting section, the LED chips, which emit red light, may be used in the red light emitting section, the LED chips, which emit green light, may be used in the green light emitting section, and the LED chips, which emit yellow light, may be used in the yellow light emitting section. In this case, as the phosphor 809, in a similar manner to the blue light emitting section, it is preferable to use diffusing particles, instead of the red phosphor, the green phosphor, and the yellow phosphor used in the red light emitting section, the green light emitting section, and the yellow light emitting section. Furthermore, each LED chip may emit light directly without using the diffusing particles.

Further, as the LED chips 803 respectively used in the red light emitting section, the green light emitting section, the yellow light emitting section, and the blue light emitting section, the LED chips emitting the near-ultraviolet light may be used instead of the LED chips emitting the blue light. In this case, in the blue light emitting section, instead of the diffusing particles, it is preferable to use the blue phosphor as the phosphor 809.

The illumination apparatus according to the embodiment of the present invention has hitherto been described, but the present invention is not limited to the above-mentioned examples and modified examples. For example, in each example and each modified example, the first-order light, which is emitted from each light emitting unit, is generated by using the four types of light of the red light, the green light, the yellow light, and the blue light, but the type of the light used in synthesis of the first-order light emitted from each light emitting unit is not limited to this, and various types of light may be used without departing from the technical scope of the present invention. Further, such a configuration for emitting light is not limited to the LED chips or the combination of the LED chips and the fluorescent member of the above-mentioned examples and modified examples. For example, it is also possible to obtain the same emission colors by using organic EL elements or the like.

Further, the electric circuit configuration of the illumination apparatus of each of the examples and modified examples is just an example, and may be modified into various forms without departing from the sheet of the present invention. For example, instead of connecting the LED chips in parallel, they may be connected in series, and the serial connection and the parallel connection may be used in combination. Further, in place of the current-limiting resistor, a low current circuit may be used. Furthermore, at the time of on/off control of the transistors to control the current supply, the currents flowing in the transistors may also be controlled. In this case, the current-limiting resistor is also not necessary.

Although the present invention has been described in detail with reference to specific embodiments, it will be readily apparent to those skilled in the art that various modifications and alterations can be applied to the embodiments without departing from the technical scope and spirit of the present invention.

The present application is based on Japanese Patent Application (No. 2010-202493) filed on September 9, 2010, Japanese Patent Application (No. 2011-051854) filed on March 9, 2011, and Japanese Patent Application (No. 2011-184551) filed on August 29, 2011, the entire contents of which are incorporated herein by reference.

Reference Signs List

1, 1', 1", 21: LIGHT EMITTING SECTION (LIGHT EMITTING UNIT GROUP)
2, 102: WIRING BOARD
3, 3a, 3b, 3c, 3d: LED CHIP
5, 5', 5": FLUORESCENT MEMBER (WAVELENGTH CONVERSION MEMBER)
11, 11', 11": LIGHT EMISSION APPARATUS (ILLUMINATION APPARATUS)
12, 12', 12": ILLUMINATION SYSTEM
13: LIGHT CONTROL SECTION
14: INSTRUCTION SECTION
15, 15', 15": CURRENT SUPPLY SECTION
16: CONTROL SECTION
101: LIGHT EMITTING SECTION
102: WIRING BOARD
103, 103a, 103b: LED CHIP
104: REFLECTOR (WALL MEMBER)
105: PARTITION MEMBER
112a: FIRST FLUORESCENT MEMBER (WAVELENGTH CONVERSION MEMBER)
112b: SECOND FLUORESCENT MEMBER (WAVELENGTH CONVERSION MEMBER)
201: LIGHT EMITTING SECTION

203a, 203b, 203c, 203d: LED CHIP
205: PARTITION MEMBER
211: FIRST FLUORESCENT MEMBER (WAVELENGTH CONVERSION MEMBER)
212: SECOND FLUORESCENT MEMBER (WAVELENGTH CONVERSION MEMBER)
213: THIRD FLUORESCENT MEMBER (WAVELENGTH CONVERSION MEMBER)
214: FOURTH FLUORESCENT MEMBER (WAVELENGTH CONVERSION MEMBER)
301: LIGHT EMITTING SECTION
303a, 303b, 303c, 303d, 303e: LED CHIP
305: PARTITION MEMBER
311: FIRST FLUORESCENT MEMBER (WAVELENGTH CONVERSION MEMBER)
312: SECOND FLUORESCENT MEMBER (WAVELENGTH CONVERSION MEMBER)
313: THIRD FLUORESCENT MEMBER (WAVELENGTH CONVERSION MEMBER)
314: FOURTH FLUORESCENT MEMBER (WAVELENGTH CONVERSION MEMBER)
315: FIFTH FLUORESCENT MEMBER (WAVELENGTH CONVERSION MEMBER)

**Claims**

1. Alight emission apparatus of which a luminance is changed in accordance with change of a light control level, the light emission apparatus comprising:

   a wiring board;
   a plurality of LED chips that are disposed on an LED chip mounting surface of the wiring board and emit light with a predetermined wavelength range of a wavelength region ranging from a visible light region to a near-ultraviolet region, wherein the plurality of LED chips are grouped into a plurality of LED groups;
   a wavelength conversion member that is disposed at a position corresponding to the LED chip mounting surface of the wiring board, and is partitioned into a plurality of wavelength conversion regions corresponding to the plurality of LED chips, where the plurality of wavelength conversion regions are grouped into a plurality of wavelength conversion regions corresponding to the LED groups, and each wavelength conversion region has a different wavelength conversion characteristic, converts a wavelength of light emitted by the corresponding LED chips, and emits first-order light with a different color temperature;
   a current supply section that supplies a driving current to the LED chips independently for each of the LED groups through the wiring board; and
   a control section that controls the current supplied for each of the LED groups in response to a control signal input from outside, wherein
   the control section independently controls timing of starting to light the LED groups in accordance with the light control level.

2. The light emission apparatus according to claim 1, wherein
   the control section sequentially lights on the LED groups, in accordance with an increase in a total amount of the currents which are supplied from the current supply section to the plurality of LED groups.

3. The light emission apparatus according to claim 2, wherein
   the plurality of LED chips are grouped into three or more LED groups.

4. The light emission apparatus according to claim 2, wherein
   in accordance with the increase in the total amount of the currents which are supplied from the current supply section to the plurality of LED groups, the control section sequentially lights on the LED groups in an order from an LED group which corresponds to the wavelength conversion region emitting the first-order light with a lower color temperature, to an LED group which corresponds to the wavelength conversion region emitting the first-order light with a higher color temperature.

5. The light emission apparatus according to claim 4, wherein
   the control section increases the number of LED groups which are being lighted on, in accordance with the increase in the total amount of the currents which are supplied from the current supply section to the plurality of LED groups.

6. The light emission apparatus according to claim 2, wherein
   the control section includes a phase angle detector that receives a control signal as a voltage waveform of which a conduction phase angle changes in accordance with the light control level and detects the conduction phase angle, and a selection circuit that selects an LED group to be lighted on in accordance with the conduction phase angle.

7. The light emission apparatus according to claim 2, wherein
the control section receives a control signal as a voltage waveform in which an amplitude voltage value changes in accordance with the light control level, and selects an LED group to be lighted on in accordance with the amplitude voltage value.

8. A light emission apparatus, comprising:

a wiring board;
a plurality of LED chips that are disposed on an LED chip mounting surface of the wiring board and emit light with a predetermined wavelength range of a wavelength region ranging from a visible light region to a near-ultraviolet region, wherein the plurality of LED chips are grouped into a plurality of LED groups;
a wavelength conversion member that is disposed at a position corresponding to the LED chip mounting surface of the wiring board, and is partitioned into a plurality of wavelength conversion regions corresponding to the plurality of LED chips, where the plurality of wavelength conversion regions are grouped into a plurality of wavelength conversion regions corresponding to the LED groups, and each wavelength conversion region has a different wavelength conversion characteristic, converts a wavelength of light emitted by the corresponding LED chips, and emits first-order light with a different color temperature;
a current supply section that supplies a driving current to the LED chips independently for each of the LED groups through the wiring board; and
a control section that controls an amount of the current supplied for each of the LED groups in response to a control signal which is input from outside, wherein
the control section sequentially lights on the LED groups, in accordance with an increase in a luminance of synthetic white light which is formed by synthesizing first-order light emitted from the plurality of wavelength conversion regions.

9. The light emission apparatus according to claim 8, wherein
in accordance with the increase in the luminance of the synthetic white light, the control section sequentially lights on the LED groups in an order from an LED group which corresponds to the wavelength conversion region emitting the first-order light with a lower color temperature, to an LED group which corresponds to the wavelength conversion region emitting the first-order light with a higher color temperature.

10. The light emission apparatus according to claim 9, wherein
the plurality of LED chips and the wavelength changing member are separately provided from one another,
a plurality of light emitting units are formed of the respective LED groups and the respective wavelength conversion regions corresponding to the LED groups, and
each of the plurality of light emitting units is integrally provided, and the light emitting units form a light emitting unit group.

11. The light emission apparatus according to claim 9, wherein
the wavelength changing member is provided to cover the plurality of LED chips,
a plurality of light emitting units are formed of the respective LED groups and the respective wavelength conversion regions corresponding to the LED groups, and
each of the plurality of light emitting units is individually provided, and the light emitting units form a light emitting unit group.

12. The light emission apparatus according to claim 9, wherein
the plurality of LED chips and the wavelength conversion member form one package, and
a plurality of packages are provided.

13. An illumination system, comprising:

a wiring board;
a plurality of LED chips that are disposed on an LED chip mounting surface of the wiring board and emit light with a predetermined wavelength range of a wavelength region ranging from a visible light region to a near-ultraviolet region, wherein the plurality of LED chips are grouped into a plurality of LED groups;

a wavelength conversion member that is disposed at a position corresponding to the LED chip mounting surface of the wiring board, and is partitioned into a plurality of wavelength conversion regions corresponding to the plurality of LED chips, where the plurality of wavelength conversion regions are grouped into a plurality of wavelength conversion regions corresponding to the LED groups, and each wavelength conversion region has a different wavelength conversion characteristic, converts a wavelength of light emitted by the corresponding LED chips, and emits first-order light with a different color temperature;

a current supply section that supplies a driving current to the LED chips independently for each of the LED groups through the wiring board;

an instruction section that gives an instruction to generate synthetic white light with a desired luminance by synthesizing the first-order light;

a light control section that outputs a control signal for changing a luminance of the synthetic white light in response to the instruction from the instruction section; and

a control section that controls an amount of the current supplied for each of the LED groups in response to a control signal which is output from the light control section, wherein

the control section sequentially lights on the LED groups, in accordance with an increase in the luminance of the synthetic white light.

14. The illumination system according to claim 13, wherein
in accordance with the increase in the luminance of the synthetic white light, the control section sequentially lights on the LED groups in an order from an LED group which corresponds to the wavelength conversion region emitting the first-order light with a lower color temperature, to an LED group which corresponds to the wavelength conversion region emitting the first-order light with a higher color temperature.

15. The illumination system according to claim 14, wherein
the control section increases the number of LED groups which are being lighted on, in accordance with the increase in the luminance of the synthetic white light.

16. The illumination system according to claim 13, wherein
the control signal is a voltage waveform, and a conduction phase angle of the voltage waveform changes in accordance with the instruction from the instruction section, and
the control section includes a phase angle detector that detects the conduction phase angle, and a selection circuit that selects an LED group to be lighted on in accordance with the conduction phase angle.

17. The illumination system according to claim 13, wherein
the control signal is a voltage waveform, and an amplitude voltage value of the voltage waveform changes in accordance with the instruction from the instruction section, and
the control section selects an LED group to be lighted on in accordance with the amplitude voltage value.

18. The illumination system according to any one of claims 13 to 17, wherein
the control section increases a sum of the driving currents, each of which is supplied for each of the LED groups, in accordance with change of a light control level toward increasing the luminance of the synthetic white light.

19. The illumination system according to any one of claims 13 to 17, wherein
the control section changes a target luminous flux $\phi$ in accordance with a target correlation color temperature T, and sets the target correlation color temperature and a target total luminous flux such that a constant A0, at which the following inequality expression is established, is present:

$$-80743 \cdot (1000/T)^5 + 164973 \cdot (1000/T)^4 - 135260 \cdot (1000/T)^3 + 57994 \cdot (1000/T)^2 - 13995 \cdot (1000/T) + 1632.9 < \phi/A0 <$$
$$\exp\{-342.11 \cdot (1000/T)^3 + 450.43 \cdot (1000/T)^2 - 212.19 \times (1000/T) + 39.47\}.$$

20. An illumination method, comprising:

supplying a current independently to each LED group of a plurality of LED chips grouped into a plurality of LED groups so as to cause each LED group to emit light;
supplying the light emitted by the LED chip to a wavelength conversion member that is partitioned into a plurality of wavelength conversion regions corresponding to the plurality of LED chips, where the plurality of wavelength conversion regions are grouped into a plurality of wavelength conversion regions corresponding to the LED groups, wherein each wavelength conversion region has a different wavelength conversion characteristic, and emits first-order light with a different color temperature; and
forming synthetic white light by synthesizing the first-order light, wherein
the LED groups are sequentially lighted on by controlling an amount of the current supplied for each LED group in accordance with an increase in a luminance of the synthetic white light.

21. The illumination method according to claim 20, wherein
in accordance with the increase in the luminance of the synthetic white light, the LED groups are sequentially lighted on in an order from an LED group corresponding to the wavelength conversion region emitting the first-order light with a lower color temperature to an LED group corresponding to the wavelength conversion region emitting the first-order light with a higher color temperature.

22. Alight emission apparatus, comprising:

a light emitting unit group that is formed of two or more light emitting units, each of which emits light with a different chromaticity, wherein the light emitting unit group emits synthetic light which is formed by synthesizing first-order light emitted from the respective light emitting units; and
control means for controlling light emission of each light emitting unit such that a chromaticity point of the synthetic light emitted from the light emitting unit group is positioned on a control curve which is set in advance in a range from a first color temperature in an XY chromaticity diagram of a CIE (1931) XYZ color coordinate system to a second color temperature higher than the first color temperature, wherein
the control means includes a target value setting section that sets one parameter of a target total luminous flux $\phi$ and a target correlation color temperature T of the synthetic light emitted from the light emitting unit group and sets the other parameter in accordance with the one parameter, and an emission control section that controls light emission of each light emitting unit such that a color temperature and a total luminous flux of the synthetic light emitted from the light emitting unit group are equal to the target total luminous flux $\phi$ and the target correlation color temperature T set by the target value setting section, and
the target setting section sequentially changes the target correlation color temperature T in at least a range from 3500 K to 4500 K, and sets the target total luminous flux $\phi$ at 4500 K not less than twice and not more than thirty times the target total luminous flux $\phi$ at 3500 K in correspondence with a desired illuminance of an irradiated object, which is irradiated with the synthetic light, with respect to the light emission apparatus.

23. The light emission apparatus according to claim 1, wherein
the target setting section sets the target total luminous flux $\phi$ such that an illuminance of the irradiated object at 3500 K is in a range from 100 Lux to 500 Lux and an illuminance of the irradiated object at 4500 K is in a range from 300 Lux to 40000 Lux.

24. The light emission apparatus according to claim 22 or 23, wherein
the target setting section sequentially changes the target correlation color temperature T in a range from 2000 K to 4500 K, and sets the target total luminous flux $\phi$ at 4500 K not less than ten times and not more than one hundred times the target total luminous flux $\phi$ at 2000 K in correspondence with a range of the desired illuminance.

25. The light emission apparatus according to any one of claims 22 to 24, wherein
the target setting section sets the target total luminous flux $\phi$ such that an illuminance of the irradiated object at 2000 K is in a range from 15 Lux to 20 Lux and an illuminance of the irradiated object at 4500 K is in a range from 300 Lux to 40000 Lux.

26. The light emission apparatus according to any one of claims 22 to 25, wherein
the target value setting section sets the target total luminous flux $\phi$, in a setting range from a lower limit to an upper limit of the target correlation color temperature T, such that a constant A0, at which the following inequality expression is established, is present:

$$-80743 \cdot (1000/T)^5 + 164973 \cdot (1000/T)^4 - 135260 \cdot (1000/T)^3 + 57994 \cdot (1000/T)^2 - 13995 \cdot (1000/T) + 1632.9 < \phi/A0 <$$
$$\exp\{-342.11 \cdot (1000/T)^3 + 450.43 \cdot (1000/T)^2 - 212.19 \times (1000/T) + 39.47\}.$$

27. The light emission apparatus according to any one of claims 22 to 26, wherein the number of the light emitting units is three or more.

28. Alight emission apparatus, comprising:

a light emitting unit group that is formed of three or more light emitting units, each of which emits light with a different chromaticity, wherein the light emitting unit group emits synthetic light which is formed by synthesizing first-order light emitted from the respective light emitting units; and

control means for controlling light emission of each light emitting unit such that a chromaticity point of the synthetic light emitted from the light emitting unit group is positioned on an upwardly convex control curve which is set in advance in a range from a first color temperature in an XY chromaticity diagram of a CIE (1931) XYZ color coordinate system to a second color temperature higher than the first color temperature, wherein

the control means includes a target value setting section that sets a target correlation color temperature T and a target total luminous flux $\phi$ of the synthetic light emitted from the light emitting unit group, and an emission control section that controls light emission of each light emitting unit such that a color temperature and a total luminous flux of the synthetic light emitted from the light emitting unit group are equal to the target correlation color temperature T and the target total luminous flux $\phi$ set by the target value setting section,

the target value setting section changes the target luminous flux $\phi$ in accordance with the target correlation color temperature T, and sets the target correlation color temperature T and a target total luminous flux $\phi$ such that a constant A0, at which the following inequality expression is established, is present:

$$-80743 \cdot (1000/T)^5 + 164973 \cdot (1000/T)^4 - 135260 \cdot (1000/T)^3 + 57994 \cdot (1000/T)^2 - 13995 \cdot (1000/T) + 1632.9 < \phi/A0 <$$
$$\exp\{-342.11 \cdot (1000/T)^3 + 450.43 \cdot (1000/T)^2 - 212.19 \times (1000/T) + 39.47\}, \text{ and}$$

in the XY chromaticity diagram, chromaticity of the first-order light emitted by each light emitting unit is determined such that the control curve is included in a polygon defined by vertices of chromaticity points of the first-order light emitted by the respective light emitting units.

FIG. 1

*FIG. 2*

*FIG. 3*

*FIG. 4*

## FIG. 5

## FIG. 6

| WAVELENGTH CONVERSION REGION | PHOSPHOR MIXTURE RATIO | | | FILM THICKNESS ($\mu$m) |
|---|---|---|---|---|
| | RED PHOSPHOR | GREEN PHOSPHOR | YELLOW PHOSPHOR | |
| FIRST WAVELENGTH CONVERSION REGION P1 | 0.05 | 1.00 | 0.24 | 110 |
| SECOND WAVELENGTH CONVERSION REGION P2 | 0.10 | 0.90 | 0.00 | 35 |

*FIG.7*

*FIG.8*

*FIG. 9*

*FIG. 10*

FIG. 11

| LIGHTING PATTERN | LED GROUP BEING LIGHTED ON | CORRELATION COLOR TEMPERATURE (K) | Cx | Cy | AVERAGE COLOR RENDERING INDEX (Ra) | TOTAL LUMINOUS FLUX (lm) |
|---|---|---|---|---|---|---|
| FIRST LIGHTING PATTERN | FIRST LED GROUP D1 | 2679.1 | 0.4608 | 0.4092 | 95.1 | 39.9 |
| SECOND LIGHTING PATTERN | FIRST LED GROUP D1, SECOND LED GROUP D2 | 5306.0 | 0.3370 | 0.3469 | 93.1 | 92.5 |

EP 2 615 364 A1

*FIG. 12*

*FIG. 13*

*FIG. 14*

*FIG. 15*

(a)

(b)

(c)

(d)

FIG. 16

*FIG. 17*

18a      18b      18c    17

19a      19b    17

(a)

(b)

*FIG. 18*

FIG. 19

FIG. 20

## FIG. 21

## FIG. 22

| WAVELENGTH CONVERSION REGION | PHOSPHOR MIXTURE RATIO | | | FILM THICKNESS ($\mu$m) |
|---|---|---|---|---|
| | RED PHOSPHOR | GREEN PHOSPHOR | YELLOW PHOSPHOR | |
| FIRST WAVELENGTH CONVERSION REGION P1' | 0.24 | 1.00 | 0.05 | 110 |
| SECOND WAVELENGTH CONVERSION REGION P2' | 0.15 | 1.00 | 0.05 | 80 |
| THIRD WAVELENGTH CONVERSION REGION P3' | 0.05 | 1.00 | 0.05 | 45 |
| FOURTH WAVELENGTH CONVERSION REGION P4' | 0.00 | 0.90 | 0.10 | 30 |

*FIG. 23*

LIGHT EMITTING SECTION ~1'

D1'    D2'    D3'    D4'

3a'    3b'    3c'    3d'

3a'    3b'    3c'    3d'

Vs—Q1  Vs—Q2  Vs—Q3  Vs—Q4    ~15c'

15b— VOLTAGE CURRENT CONVERSION CIRCUIT

$V_{DIM(DC)}$

15a— RECTIFIER CIRCUIT

CURRENT SUPPLY SECTION    ~15'

$V_{DIM(AC)}$

*FIG. 24*

EMISSION INTENSITY

24H

24G

24F

C

24E

B

24D

24C

B

24B

24A

B

A

100%    0%    LIGHT CONTROL LEVEL

START OF LIGHTING OF FIRST LED GROUP

START OF LIGHTING OF SECOND LED GROUP

START OF LIGHTING OF FOURTH LED GROUP

START OF LIGHTING OF THIRD LED GROUP

FIG. 25

*FIG. 26*

| LIGHTING PATTERN | LED GROUP BEING LIGHTED ON | CORRELATION COLOR TEMPERATURE (K) | Cx | Cy | AVERAGE COLOR RENDERING INDEX (Ra) | TOTAL LUMINOUS FLUX (lm) |
|---|---|---|---|---|---|---|
| FIRST LIGHTING PATTERN | FIRST LED GROUP D1' | 2700.1 | 0.4592 | 0.4093 | 95.0 | 20.1 |
| SECOND LIGHTING PATTERN | FIRST LED GROUP D1', SECOND LED GROUP D2' | 3205.0 | 0.4243 | 0.4015 | 95.0 | 43.3 |
| THIRD LIGHTING PATTERN | FIRST LED GROUP D1', SECOND LED GROUP D2', THIRD LED GROUP D3' | 4252.9 | 0.3702 | 0.3711 | 94.9 | 68.6 |
| FOURTH LIGHTING PATTERN | FIRST LED GROUP D1', SECOND LED GROUP D2', THIRD LED GROUP D3', FOURTH LED GROUP D4' | 5484.0 | 0.3327 | 0.3499 | 92.7 | 94.4 |

## FIG. 27

## FIG. 28

FIG. 29

FIG. 30

*FIG. 31*

*FIG. 32*

*FIG. 33*

*FIG. 34*

| WAVELENGTH CONVERSION REGION | PHOSPHOR MIXTURE RATIO | | | FILM THICKNESS ($\mu$m) |
|---|---|---|---|---|
| | RED PHOSPHOR | GREEN PHOSPHOR | YELLOW PHOSPHOR | |
| FIRST WAVELENGTH CONVERSION REGION P1" | 0.350 | 1.00 | 0.05 | 140 |
| SECOND WAVELENGTH CONVERSION REGION P2" | 0.300 | 1.00 | 0.05 | 120 |
| THIRD WAVELENGTH CONVERSION REGION P3" | 0.200 | 1.00 | 0.05 | 110 |
| FOURTH WAVELENGTH CONVERSION REGION P4" | 0.175 | 1.00 | 0.05 | 95 |
| FIFTH WAVELENGTH CONVERSION REGION P5" | 0.150 | 1.00 | 0.05 | 80 |

*FIG. 35*

LIGHT EMITTING SECTION — 1"

D1"    D2"    D3"    D4"    D5"

3a"  3b"  3c"  3d"  3e"

3a"  3b"  3c"  3d"  3e"

Vs—Q1   Vs—Q2   Vs—Q3   Vs—Q4   Vs—Q5   — 15c"

15b — VOLTAGE CURRENT CONVERSION CIRCUIT

$V_{DIM(DC)}$

15a — RECTIFIER CIRCUIT

CURRENT SUPPLY SECTION — 15"

$V_{DIM(AC)}$

*FIG. 36*

EMISSION INTENSITY

36J
36I
36H
36G
36F
36E
36D
36C
36B
36A

A    B    C    D    E    F

100%                                    0%

LIGHT CONTROL LEVEL

START OF LIGHTING OF FIRST LED GROUP

START OF LIGHTING OF SECOND LED GROUP

START OF LIGHTING OF FOURTH LED GROUP

START OF LIGHTING OF THIRD LED GROUP

START OF LIGHTING OF FIFTH LED GROUP

115

*FIG. 37*

FIG. 38

| LIGHTING PATTERN | LED GROUP BEING LIGHTED ON | CORRELATION COLOR TEMPERATURE (K) | Cx | Cy | AVERAGE COLOR RENDERING INDEX (Ra) | TOTAL LUMINOUS FLUX (lm) |
|---|---|---|---|---|---|---|
| FIRST LIGHTING PATTERN | FIRST LED GROUP D1" | 2037.3 | 0.5212 | 0.4117 | 92.4 | 7.6 |
| SECOND LIGHTING PATTERN | FIRST LED GROUP D1", SECOND LED GROUP D2" | 2206.1 | 0.5037 | 0.4130 | 93.6 | 16.1 |
| THIRD LIGHTING PATTERN | FIRST LED GROUP D1", SECOND LED GROUP D2", THIRD LED GROUP D3" | 2466.8 | 0.4818 | 0.4167 | 93.8 | 34.6 |
| FOURTH LIGHTING PATTERN | FIRST LED GROUP D1", SECOND LED GROUP D2", THIRD LED GROUP D3", FOURTH LED GROUP D4" | 2668.3 | 0.4646 | 0.4148 | 94.7 | 53.7 |
| FIFTH LIGHTING PATTERN | FIRST LED GROUP D1", SECOND LED GROUP D2", THIRD LED GROUP D3", FOURTH LED GROUP D4", FIFTH LED GROUP D5" | 2933.3 | 0.4429 | 0.4078 | 95.0 | 83.3 |

*FIG. 39*

*FIG. 40*

## FIG. 41

## FIG. 42

# FIG. 43

(a)

(b)

*FIG. 44*

*FIG. 45*

FIG. 46

*FIG. 47*

FIG. 48

FIG. 49

FIG. 50

TOTAL
LUMINOUS
FLUX (lm)

START OF LIGHTING OF
FIFTH LED GROUP

START OF LIGHTING OF
FOURTH LED GROUP

START OF LIGHTING OF
THIRD LED GROUP

START OF LIGHTING OF
SECOND LED GROUP

START OF LIGHTING OF
FIRST LED GROUP

120
100
80
60
40
20

50C
50B
50A

A
B
C
D
E
F

50D
50E

3000  4000  5000  6000

COLOR
TEMPERATURE (K)

*FIG.51*

EP 2 615 364 A1

*FIG. 52*

*FIG. 53*

## FIG.54

## FIG.55

| REGION | THE NUMBER OF RED CELLS | THE NUMBER OF GREEN CELLS | THE NUMBER OF YELLOW CELLS | THE NUMBER OF BLUE CELLS |
|--------|--------|--------|--------|--------|
| P51 | 14 | 18 | 7 | 1 |
| P52 | 0 | 30 | 2 | 8 |
| P53 | 27 | 7 | 6 | 0 |
| P54 | 11 | 16 | 6 | 7 |

FIG. 56

FIG. 57

EP 2 615 364 A1

*FIG. 58*

*FIG. 59*

514b

514

WARM WHITE

WHITE

DAY WHITE

ELECTRIC BULB COLOR

DAYLIGHT COLOR

514c  514a

*FIG. 60*

FIG. 61

## FIG. 62

| COLOR TEM-PERATURE (K) | SUPPLY POWER (W) | | | |
|---|---|---|---|---|
| | U1 | U2 | U3 | U4 |
| 2500 | 0.51 | 0.00 | 4.00 | 0.00 |
| 2600 | 0.64 | 0.02 | 4.00 | 0.02 |
| 2700 | 0.77 | 0.04 | 4.00 | 0.04 |
| 2800 | 0.91 | 0.06 | 4.00 | 0.06 |
| 2900 | 1.05 | 0.09 | 4.00 | 0.09 |
| 3000 | 1.20 | 0.13 | 4.00 | 0.13 |
| 3100 | 1.34 | 0.17 | 4.00 | 0.17 |
| 3200 | 1.50 | 0.23 | 4.00 | 0.23 |
| 3300 | 1.65 | 0.30 | 4.00 | 0.30 |
| 3400 | 1.85 | 0.37 | 4.00 | 0.37 |
| 3500 | 2.02 | 0.45 | 3.99 | 0.45 |
| 3600 | 2.26 | 0.52 | 3.98 | 0.52 |
| 3700 | 2.50 | 0.61 | 3.96 | 0.61 |
| 3800 | 2.70 | 0.70 | 3.91 | 0.70 |
| 3900 | 2.80 | 0.78 | 3.80 | 0.78 |
| 4000 | 2.84 | 0.85 | 3.60 | 0.85 |
| 4100 | 2.85 | 0.91 | 3.38 | 0.91 |
| 4200 | 2.83 | 1.00 | 3.18 | 1.00 |
| 4300 | 2.80 | 1.09 | 3.00 | 1.09 |
| 4400 | 2.77 | 1.18 | 2.90 | 1.18 |
| 4500 | 2.72 | 1.27 | 2.80 | 1.27 |
| 4600 | 2.67 | 1.36 | 2.70 | 1.36 |
| 4700 | 2.60 | 1.44 | 2.60 | 1.44 |
| 4800 | 2.50 | 1.52 | 2.50 | 1.52 |
| 4900 | 2.40 | 1.60 | 2.40 | 1.60 |
| 5000 | 2.32 | 1.68 | 2.32 | 1.68 |
| 5100 | 2.25 | 1.76 | 2.25 | 1.76 |
| 5200 | 2.18 | 1.84 | 2.18 | 1.84 |
| 5300 | 2.10 | 1.92 | 2.10 | 1.92 |
| 5400 | 2.00 | 2.00 | 2.00 | 2.00 |
| 5500 | 1.91 | 2.08 | 1.91 | 2.08 |
| 5600 | 1.84 | 2.15 | 1.84 | 2.15 |
| 5700 | 1.75 | 2.23 | 1.75 | 2.23 |
| 5800 | 1.67 | 2.31 | 1.67 | 2.31 |
| 5900 | 1.60 | 2.38 | 1.60 | 2.38 |
| 6000 | 1.50 | 2.45 | 1.55 | 2.45 |
| 6100 | 1.40 | 2.53 | 1.53 | 2.53 |
| 6200 | 1.30 | 2.60 | 1.52 | 2.60 |
| 6300 | 1.20 | 2.67 | 1.51 | 2.67 |
| 6400 | 1.10 | 2.72 | 1.505 | 2.72 |
| 6500 | 1.00 | 2.79 | 1.50 | 2.79 |

FIG. 63

*FIG. 64*

FIG. 65

*FIG. 66*

*FIG. 67*

EP 2 615 364 A1

*FIG. 68*

*FIG. 69*

514'

514b'

DARK | BRIGHT

514a'

*FIG. 70*

TOTAL LUMINOUS
FLUX (lm)

600
500
400
300
200
100
LIGHT OFF

3000  4000  5000  6000

T1        COLOR         T2
        TEMPERATURE (K)

## FIG. 71

| COLOR TEMP-ERATURE (K) | SUPPLY POWER (W) | | | |
|---|---|---|---|---|
| | U1 | U2 | U3 | U4 |
| 2500 | 0.12 | 0.00 | 1.40 | 0.00 |
| 2600 | 0.31 | 0.02 | 1.85 | 0.02 |
| 2700 | 0.50 | 0.04 | 2.20 | 0.04 |
| 2800 | 0.69 | 0.06 | 2.70 | 0.06 |
| 2900 | 0.88 | 0.09 | 3.15 | 0.09 |
| 3000 | 1.07 | 0.13 | 3.55 | 0.13 |
| 3100 | 1.26 | 0.17 | 3.85 | 0.17 |
| 3200 | 1.45 | 0.23 | 3.95 | 0.23 |
| 3300 | 1.65 | 0.30 | 4.00 | 0.30 |
| 3400 | 1.85 | 0.37 | 4.00 | 0.37 |
| 3500 | 2.08 | 0.45 | 3.99 | 0.45 |
| 3600 | 2.29 | 0.52 | 3.98 | 0.52 |
| 3700 | 2.50 | 0.61 | 3.96 | 0.61 |
| 3800 | 2.70 | 0.70 | 3.91 | 0.70 |
| 3900 | 2.80 | 0.78 | 3.80 | 0.78 |
| 4000 | 2.84 | 0.85 | 3.60 | 0.85 |
| 4100 | 2.85 | 0.91 | 3.38 | 0.91 |
| 4200 | 2.83 | 1.00 | 3.18 | 1.00 |
| 4300 | 2.80 | 1.09 | 3.00 | 1.09 |
| 4400 | 2.77 | 1.18 | 2.90 | 1.18 |
| 4500 | 2.72 | 1.27 | 2.80 | 1.27 |
| 4600 | 2.67 | 1.36 | 2.70 | 1.36 |
| 4700 | 2.60 | 1.44 | 2.60 | 1.44 |
| 4800 | 2.50 | 1.52 | 2.50 | 1.52 |
| 4900 | 2.40 | 1.60 | 2.40 | 1.60 |
| 5000 | 2.32 | 1.68 | 2.32 | 1.68 |
| 5100 | 2.25 | 1.76 | 2.25 | 1.76 |
| 5200 | 2.18 | 1.84 | 2.18 | 1.84 |
| 5300 | 2.10 | 1.92 | 2.10 | 1.92 |
| 5400 | 2.00 | 2.00 | 2.00 | 2.00 |
| 5500 | 1.91 | 2.08 | 1.91 | 2.08 |
| 5600 | 1.84 | 2.15 | 1.84 | 2.15 |
| 5700 | 1.75 | 2.23 | 1.75 | 2.23 |
| 5800 | 1.67 | 2.31 | 1.67 | 2.31 |
| 5900 | 1.60 | 2.38 | 1.60 | 2.38 |
| 6000 | 1.50 | 2.45 | 1.55 | 2.45 |
| 6100 | 1.40 | 2.53 | 1.53 | 2.53 |
| 6200 | 1.30 | 2.60 | 1.52 | 2.60 |
| 6300 | 1.20 | 2.67 | 1.51 | 2.67 |
| 6400 | 1.10 | 2.72 | 1.505 | 2.72 |
| 6500 | 1.00 | 2.79 | 1.50 | 2.79 |

*FIG. 72*

*FIG. 73*

*FIG. 74*

*FIG. 75*

*FIG. 76*

EP 2 615 364 A1

*FIG. 77*

FIG. 78

FIG. 79

FIG. 80

FIG. 81

R21   R22   R23   R24
710a  712a  714a  716a
701
703a  703b  703c  703d
723
Q721  Q722  Q723  Q724
711a  713a  715a  717a

EMISSION CONTROL SECTION          MEMORY          724
                                                  724a

726          TARGET VALUE
             SETTING SECTION          725

FIG. 82

801
806  809  810  808
804          805
             802b
             802
807  803     802a

## FIG. 83

801a  801b  801c  801d  801a  801b  801c  801d

## FIG. 84

E 50000
20000
10000
5000
2000
ILLUMINANCE 1000
(lux) 500
200
100
50
20
10
0

D1        C1

D2

1750  2000  2250 2500  3000  4000 5000  10000

COLOR
TEMPERATURE (K)          → Tc

## INTERNATIONAL SEARCH REPORT

| | International application No. |
|---|---|
| | PCT/JP2011/070523 |

**A. CLASSIFICATION OF SUBJECT MATTER**
*F21S2/00*(2006.01)i, *F21S10/00*(2006.01)i, *F21Y101/02*(2006.01)n

According to International Patent Classification (IPC) or to both national classification and IPC

**B. FIELDS SEARCHED**

Minimum documentation searched (classification system followed by classification symbols)
F21S2/00, F21S10/00, F21Y101/02

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2009/063915 A1 (Mitsubishi Chemical Corp.), 22 May 2009 (22.05.2009), | 1-5,8-15,18, 20,21 |
| Y | entire text; all drawings & JP 2009-238729 A     & US 2010/0295464 A1 & EP 2211083 A1     & AU 2008321873 A & CN 101855492 A     & KR 10-2010-0080930 A | 19,22-28 |
| Y | JP 2009-032524 A (Panasonic Electric Works Co., Ltd.), 12 February 2009 (12.02.2009), paragraphs [0013] to [0024]; fig. 1, 3 & US 2010/0207134 A1     & EP 2172984 A1 & WO 2009/014219 A1     & KR 10-2010-0044869 A & CN 101765923 A | 19,22-28 |

☒ Further documents are listed in the continuation of Box C.   ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 30 November, 2011 (30.11.11) | 13 December, 2011 (13.12.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.

PCT/JP2011/070523

C (Continuation). DOCUMENTS CONSIDERED TO BE RELEVANT

| Category* | Citation of document, with indication, where appropriate, of the relevant passages | Relevant to claim No. |
|---|---|---|
| A | US 7288902 B1 (John L. Melanson),<br>30 October 2007 (30.10.2007),<br>entire text; all drawings<br>& US 2008/0224631 A1 & US 2008/0224629 A1<br>& US 2008/0224633 A1 & US 2008/0224636 A1<br>& US 2010/0060202 A1 & US 2010/0253305 A1<br>& US 2010/0308742 A1 & US 7852017 B1<br>& EP 2130405 A & EP 2130406 A<br>& EP 2130407 A & EP 2135487 A<br>& WO 2008/112733 A2 & WO 2008/112735 A2<br>& WO 2008/112820 A2 & WO 2008/112822 A2<br>& CN 101637064 A & CN 101653042 A<br>& CN 101663918 A & CN 101707874 A | 1-28 |
| A | JP 2008-305759 A (Rohm Co., Ltd.),<br>18 December 2008 (18.12.2008),<br>entire text; all drawings<br>& US 2010/0148703 A1 & WO 2008/108468 A1 | 1-28 |
| A | JP 2007-250350 A (Stanley Electric Co., Ltd.),<br>27 September 2007 (27.09.2007),<br>entire text; all drawings<br>(Family: none) | 1-28 |

Form PCT/ISA/210 (continuation of second sheet) (July 2009)

## INTERNATIONAL SEARCH REPORT

| | |
|---|---|
| International application No. | |
| PCT/JP2011/070523 | |

**Box No. II    Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III    Observations where unity of invention is lacking (Continuation of item 3 of first sheet)**

This International Searching Authority found multiple inventions in this international application, as follows:
    The common technical feature of the inventions in independent claims 1, 8, 13, 20, 22 and 28 is a feature of "having a light emitting unit group, which is composed of a plurality of light emitting units that respectively emit light having different chromaticity, and which emits synthesized light formed by synthesizing primary light emitted from each of the light emitting units, and a control unit, which controls the light emission of each of the light emitting units".  (Continued to extra sheet)

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**    ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

**INTERNATIONAL SEARCH REPORT**

International application No.

PCT/JP2011/070523

Continuation of Box No.III of continuation of first sheet(2)

This technical feature, however, is disclosed in document 1 (WO 2009/063915 A1 (Mitsubishi Chemical Corp.), 22 May 2009 (22. 05.2009), entire text and all drawings), and does not make a contribution over the prior art. Therefore, this technical feature is not a special technical feature. Furthermore, there is no same or corresponding special technical feature. Consequently, the claims include the invention groups stated below.
Invention group 1: Claims 1-21
A light emitting device, which is provided with the above-mentioned common technical feature, and which independently drives the light emitting units sequentially, and an illuminating method.

Invention group 2: Claims 22-28
A light emitting device, which is provided with the above-mentioned technical feature, and which controls light emission of each of the light emitting units so that the synthesized light becomes a target total luminous flux and has a target correlated color temperature.

Form PCT/ISA/210 (extra sheet) (July 2009)

# EP 2 615 364 A1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006004839 A
- JP 2007122950 A
- US 7288902 B
- WO 2009063915 A
- JP 2010202493 A
- JP 2011051854 A
- JP 2011184551 A

**Non-patent literature cited in the description**

- **KRUITHOF AA.** Tubular Luminescence Lamps for General Illumination. *Philips Technical Review,* 1941, vol. 6, 65-96